(19) Europäisches Patentamt
European Patent Office
Office européen des brevets

(11) **EP 2 463 929 A1**

(12) **EUROPEAN PATENT APPLICATION**
published in accordance with Art. 153(4) EPC

(43) Date of publication:
**13.06.2012 Bulletin 2012/24**

(21) Application number: **10806429.6**

(22) Date of filing: **02.08.2010**

(51) Int Cl.:
***H01L 51/42*** *(2006.01)* ***C07F 9/53*** *(2006.01)*
***C09D 11/00*** *(2006.01)* ***H01L 51/50*** *(2006.01)*

(86) International application number:
**PCT/JP2010/063047**

(87) International publication number:
**WO 2011/016430 (10.02.2011 Gazette 2011/06)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **04.08.2009 JP 2009181888**
**05.08.2009 JP 2009182300**
**19.08.2009 JP 2009190069**
**16.09.2009 JP 2009214966**
**30.10.2009 JP 2009251099**

(71) Applicant: **Mitsubishi Chemical Corporation**
**Tokyo 108-0014 (JP)**

(72) Inventor: **The designation of the inventor has not yet been filed**

(74) Representative: **Einmayr, Peter**
**Vossius & Partner**
**Siebertstrasse 4**
**DE-81675 München (DE)**

(54) **PHOTOELECTRIC CONVERSION ELEMENT AND SOLAR CELL USING SAME**

(57) There is provides a photoelectric conversion device material which can be used as an electrode buffer material for a solar cell or the like and can improve durability while maintaining the interaction with an electrode and mobility; a photoelectric conversion device using the photoelectric conversion device material; and a solar cell using the photoelectric conversion device. A photoelectric conversion device containing a buffer layer and an active layer, wherein the buffer layer contains a compound represented by the following general formula (I), the active layer contains an n-type semiconductor, and the n-type semiconductor is a compound having a solubility in toluene of 0.5% by weight or more at 25°C and having an electron mobility of $1.0 \times 10^{-6}$ $cm^2/Vs$ or more.

[Chem 1]

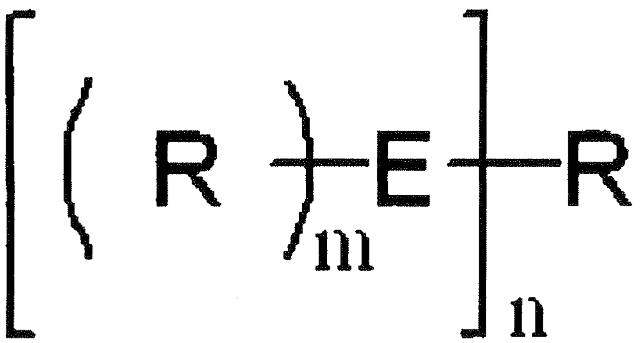

(I)

EP 2 463 929 A1

[Fig. 1]

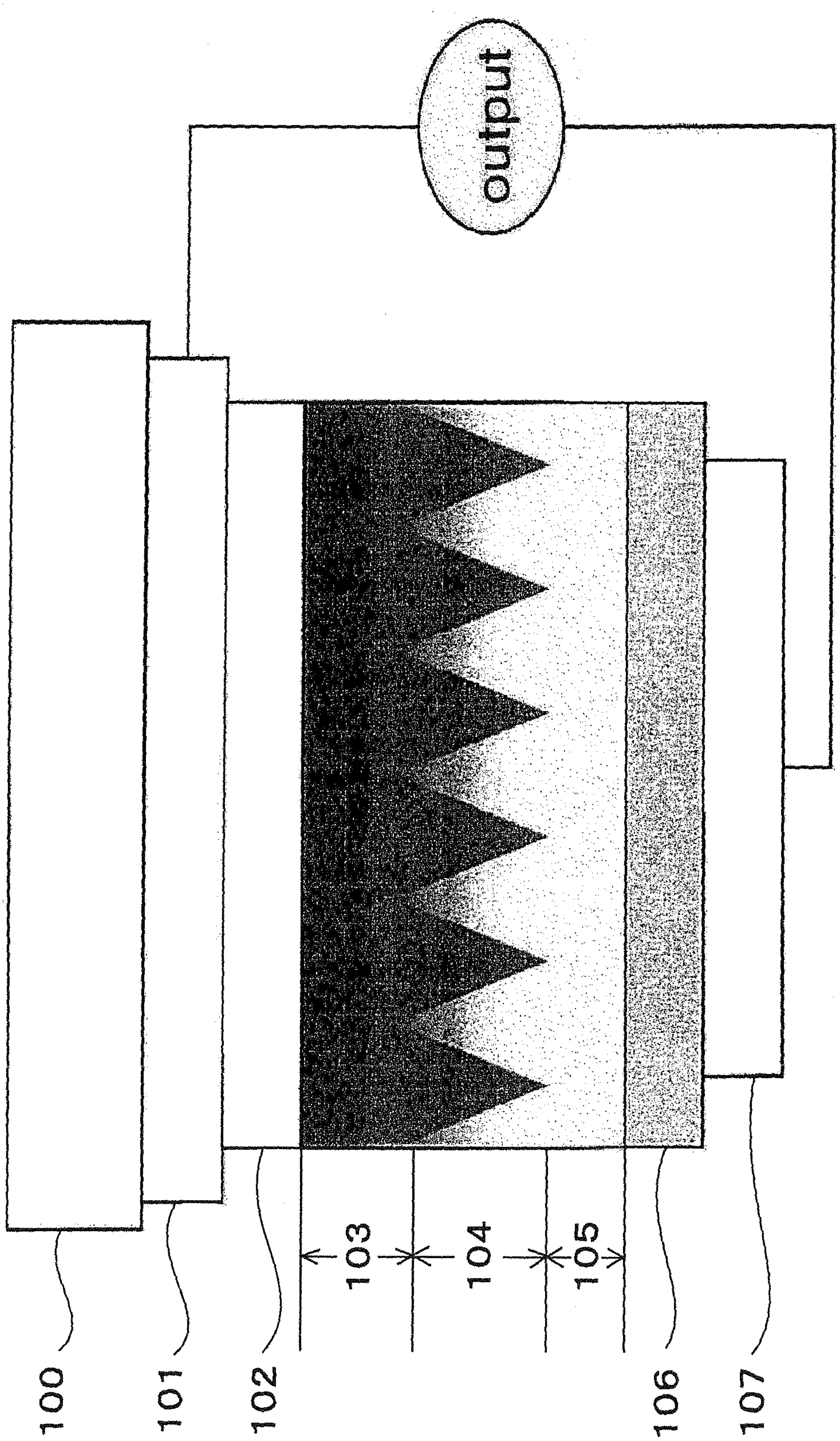

## Description

### Technical Field

The present invention relates to a photoelectric conversion device containing a phosphine oxide compound in a buffer layer and a solar cell using the photoelectric conversion device.

### Background Art

Recently, efficiency of organic thin-film solar cells using an organic semiconductor is remarkably increased and solar cells having a photoelectric conversion efficiency of 5% or more have been developed. However, it has been known that organic thin-film solar cells are degraded by light, heat, and oxygen and water in the air and, for practical use, it is extremely important to improve durability of the device.

As a semiconductor for the organic thin-film solar cells, one using a polymer-solution-processed or small molecule vapor-deposited organic semiconductor layer is known. Recently, there is proposed an organic thin-film solar cell using a solution processed transformation-type organic semiconductor layer employing a tetrabenzoporphyrin (BP) and the like (Patent Document 1).

As the polymer-solution-processed organic semiconductor layer, polyhexylthiophene (P3HT) or the like that is a soluble conjugated polymer is frequently used as a p-type semiconductor and a solubility-enhanced derivative of fullerene, such as PCBM, is used frequently as an n-type semiconductor. In addition, the polymer-solution-processed organic semiconductor layer is mainly composed of only a bulk hetero layer in which a p-type molecule and an n-type molecule are coexistent.

As the small molecule vapor-deposited organic semiconductor layer, a phthalocyanine, pentacene, or oligothiophene is frequently used as a p-type semiconductor and $C_{60}$ is frequently used as an n-type semiconductor. Moreover, there is one composed of a p-i-n stacked structure in which an i layer where a p-type semiconductor and an n-type semiconductor are coexistent is introduced into the p-n-connection interface. The solution processed transformation-type organic thin-film solar cell is composed of the same stacked structure as the small molecule vapor-deposited one, and BP or the like is used as a p-type semiconductor and a fullerene derivative or the like is used as an n-type semiconductor.

Moreover, as a construction of an organic thin-film solar cell, there is known a method where an electrode is not directly contacted to the organic semiconductor layer but a buffer layer is sandwiched therebetween. The total thickness of the organic semiconductor layer is generally as very thin as several hundreds nm and also the surface of a transparent electrode (ITO) or the like is not sufficiently flat. Therefore, there is a possibility of short circuit unless the buffer layer is provided.

Hitherto, as an electron collection layer that is one kind of the buffer layer, the case of using an organic compound such as 2,9-dimethyl-4,7-diphenyl-l,10-phenanthroline (BCP) or a phosphine oxide compound (Non-Patent Document 1, Patent Document 2) and the case of using an inorganic compound such as lithium fluoride (LiF) or titania oxide (TiOx) (Non-Patent Documents 2 and 3) have been reported.

As an example of using BCP as an electron collection layer of an organic compound material, Non-Patent Document 1 reports a small molecule vapor-deposited organic thin-film solar cell in which pentacene and fullerene $C_{60}$ are used. However, there is a problem that cell properties are degraded for a short period of time (about 70 minutes) under solar simulator at room temperature and hence further improvement is needed.

Moreover, Patent Document 2 reports a small molecule vapor-deposited organic thin-film solar cell in which a phosphine oxide compound is used. However, the cell exhibits poor photoelectric conversion properties, so that it is necessary for practical use to improve conversion efficiency.

As an example of using LiF as an electron collection layer of an inorganic compound material, Non-Patent Document 2 reports a polymer-solution-processed organic thin-film solar cell in which a polymer semiconductor (MEH-PPVV) and a fullerene derivative (PCBM) are coexisted. However, there is a problem that cell properties are deteriorated for a short period of time (about 8000 seconds) under solar simulator at 72°C and photoelectric conversion properties are poor, so that it is necessary for practical use to improve durability and conversion efficiency.

As an example of using TiOx, Non-Patent Document 3 reports that a polymer-solution-processed organic thin-film solar cell where a polymer semiconductor (P3HT) and a fullerene derivative (PCBM) are coexisted is excellent in durability. However, it only reports durability of about 20 hours under solar simulator at room temperature, and durability against light irradiation at high temperature and weather resistance under high humidity conditions, and the like required for practical use of organic thin-film solar cells are not reported.

Background Art Documents

Patent Documents

Patent Document 1: JP-A-2008-016834
Patent Document 2: JP-A-2006-073583

Non-Patent Documents

Non-Patent Document 1: Organic Electronics 2008, Vol. 9, p. 656-660
Non-Patent Document 2: Sol. Energy Mater. Sol. Cells 2005, Vol. 86, p. 499-516
Non-Patent Document 3: Sol. Energy Mater. Sol. Cells 2008, Vol. 92, p. 1476-1482

Summary of the Invention

Problems that the Invention is to Solve

According to the investigation of the present inventors, it was found that the combination of an organic semiconductor layer containing a compound having a high solubility and a high electron mobility as an n-type semiconductor and an electron collection layer containing BCP and an inorganic compound such as LiF is insufficient for application to organic thin-film solar cells in view of photoelectric conversion efficiency and durability.

For application to uses as organic thin-film solar cells which are exposed to solar light for a long period of time, the above finding may be a large problem on practical use. Accordingly, in consideration of the above conventional actual situations, an object of the present invention is to provide a photoelectric conversion device having a high performance and a solar cell using the photoelectric conversion device, by using an organic semiconductor layer containing a compound having a high solubility and a high electron mobility as an n-type semiconductor and a prescribed compound together with a material for an electron collection layer.

Means for Solving the Problems

As a result of the extensive studies for solving the above problems, the present inventors have found a photoelectric conversion device having a high efficiency and a high durability by containing a compound having an electron-withdrawing group or an electron-withdrawing atom in a buffer layer, a compound having a high solubility and a high electron mobility as an n-type semiconductor in an active layer, and a porphyrin compound or a polymer semiconductor as a p-type semiconductor, and thus have accomplished the invention.

Namely, the gist of the invention is as follows.

1. A photoelectric conversion device comprising a buffer layer and an active layer, wherein the buffer layer contains a compound represented by the following general formula (I), the active layer contains an n-type semiconductor, and the n-type semiconductor is a compound having a solubility in toluene of 0.5% by weight or more at 25°C and an electron mobility of $1.0\times10^{-6}$ $cm^2/Vs$ or more:

[Chem 1]

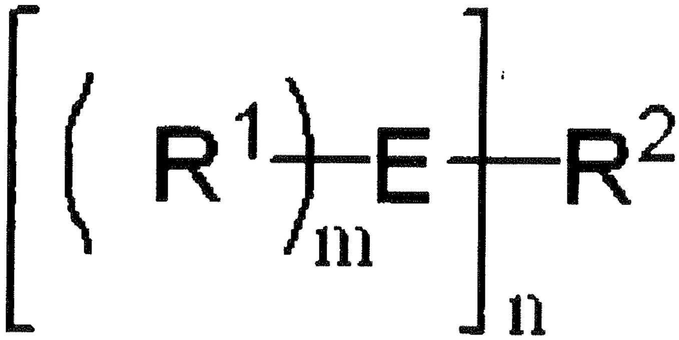

(I)

wherein E represents a divalent or higher valent electron-withdrawing group or electron-withdrawing atom selected from the group shown below; $R^1$ represents an alkyl group which may have a substituent, a cycloalkyl group which may have a substituent, a heterocyclic group which may have a substituent, an alkenyl group which may have a substituent, a cycloalkenyl group which may have a substituent, an alkynyl group which may have a substituent, an alkoxy group which may have a substituent, or an aromatic group which may have a substituent; $R^2$ represents an aliphatic hydrocarbon group which may have a substituent, an aromatic hydrocarbon group which may have a substituent, a heterocyclic group which may have a substituent, or a group where at least one of an aromatic hydrocarbon group which may have a substituent and a heterocyclic group which may have a substituent is linked; and m and n each independently represent an integer of 1 or more; and $R^1$ may be independently different when either m or n is 2 or more, electron-withdrawing group: a silolediyl group, an oxazolediyl group, an oxadiazolediyl group, a thiazolediyl group, a thiadiazolediyl group, a diazolediyl group, a triazolediyl group, a thiazolediyl group, an isooxazolediyl group, an isothiazolediyl group, a pyrazinediyl group, a pyrimidinediyl group, a pyridazinediyl group, a pyridinediyl group, a benzothiadiazolediyl group, a quinolinediyl group, a carbonyl group, a sulfonyl group, and a phosphine oxide group;
electron-withdrawing atom: silicon and boron.

2. The photoelectric conversion device according to the above item 1, wherein LUMO of the n-type semiconductor calculated by cyclic voltammetry is -5 eV or more to -3 eV or less relative to vacuum level.

3. The photoelectric conversion device according to the above item 1 or 2, wherein the compound represented by the above general formula (I) is a compound represented by the following general formula (II):

[Chem 2]

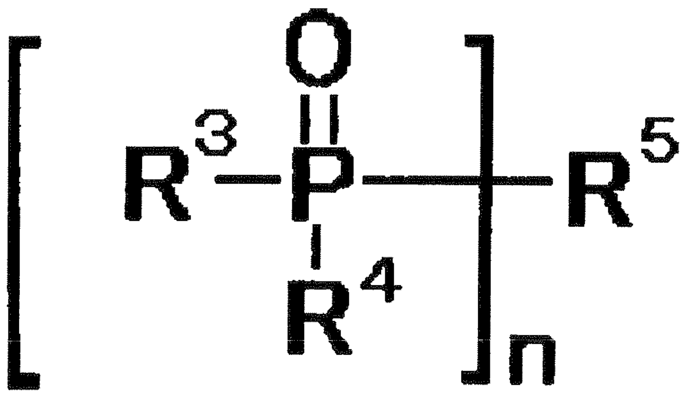

(II)

wherein $R^3$ and $R^4$ each independently represent an alkyl group which may have a substituent, a cycloalkyl group which may have a substituent, a heterocyclic group which may have a substituent, an alkenyl group which may have a substituent, a cycloalkenyl group which may have a substituent, an alkynyl group which may have a substituent,

an alkoxy group which may have a substituent, or an aromatic group which may have a substituent; $R^5$ represents an aliphatic hydrocarbon group which may have a substituent, an aromatic hydrocarbon group which may have a substituent, a heterocyclic group which may have a substituent, or a group where at least one of an aromatic hydrocarbon group which may have a substituent and a heterocyclic group which may have a substituent is linked; and n represents an integer of 1 or more.

4. The photoelectric conversion device according to the above item 3, wherein $R^3$ and $R^4$ each independently represent a condensed polycyclic aromatic group or aromatic group, which may have a substituent and $R^5$ represents an aromatic group.
5. The photoelectric conversion device according to the above item 1 or 2, wherein the compound represented by the above general formula (I) is a compound represented by the following general formula (III):

[Chem 3]

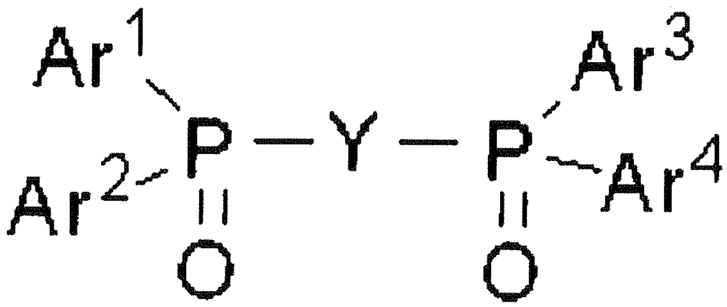

(III)

wherein $Ar^1$ to $Ar^4$ each independently represent an aromatic group which may have a substituent; $Ar^1$ and $Ar^2$ or $Ar^3$ and $Ar^4$ may form a ring directly or through a substituent; Y represents an aliphatic hydrocarbon group containing a spiro skeleton, which may have a substituent, an aromatic hydrocarbon group containing a spiro skeleton, which may have a substituent, or a heterocyclic group containing a spiro skeleton, which may have a substituent.

6. The photoelectric conversion device according to the above item 1 or 2, wherein the compound represented by the above general formula (I) is a compound represented by the following general formula (IV):

[Chem 4]

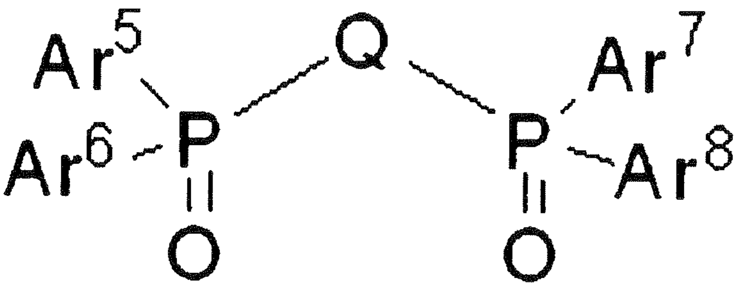

(IV)

wherein Q is a condensed ring group having a plurality of aromatic rings and represents a connecting group capable of taking a conformation in which an angle formed by extension lines of two bonding lines between two atoms bonded to the phosphorus atoms in Q and the respective phosphorus atoms is 120° or less; and $Ar^5$ to $Ar^8$ each

independently represent an aromatic group which may have a substituent.

7. The photoelectric conversion device according to the above item 6, wherein, in the above general formula (IV), $Ar^5$ to $Ar^8$ each independently represent an aromatic hydrocarbon group which may have a substituent or an aromatic heterocyclic group which may have a substituent.

8. The photoelectric conversion device according to the above item 1 or 2, wherein the compound represented by the above general formula (I) is a compound represented by the following general formula (V):

[Chem 5]

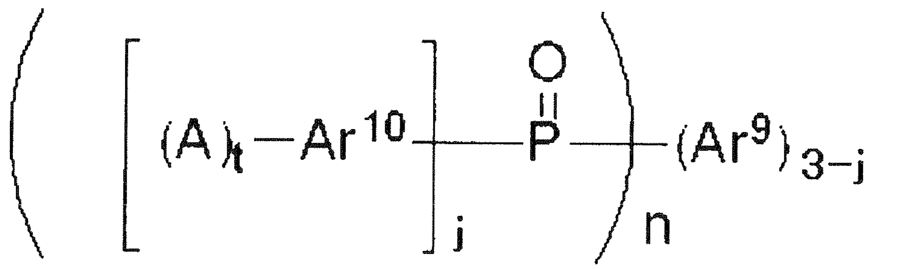

(V)

wherein $Ar^9$ is an aromatic hydrocarbon group which may have a substituent, an aromatic heterocyclic group which may have a substituent, or a group where they are linked; $Ar^{10}$ is an aromatic hydrocarbon group which may have a substituent or an aromatic heterocyclic group which may have a substituent; A represents a fluorine atom or a perfluoroalkyl group; t represents an integer of 1 to 5; j represents an integer of 1 to 3; n represents an integer of 1 or more; and $Ar^{10}$ may be independently different when either j or n is 2 or more, but n is 1 when j is 3.

9. The photoelectric conversion device according to any one of the above items 1 to 8, wherein the active layer contains at least either of a porphyrin compound and a polymer semiconductor.

10. The photoelectric conversion device according to any one of the above items 1 to 9, which at least comprises an electron collection layer and a hole collection layer as the buffer layer, wherein the electron collection layer contains a compound represented by any one of the above general formulae (I) to (V) and the hole collection layer contains a sulfonic acid group-containing compound.

11. The photoelectric conversion device according to any one of the above items 1 to 10, wherein the n-type semiconductor is a fullerene compound.

12. The photoelectric conversion device according to the above item 11, wherein LUMO of the fullerene compound calculated by cyclic voltammetry is -3.85 eV or more relative to vacuum level.

13. The photoelectric conversion device according to the above item 11 or 12, wherein the fullerene compound has at least one of partial structures represented by the following general formulae (n4) to (n7):

[Chem 6]

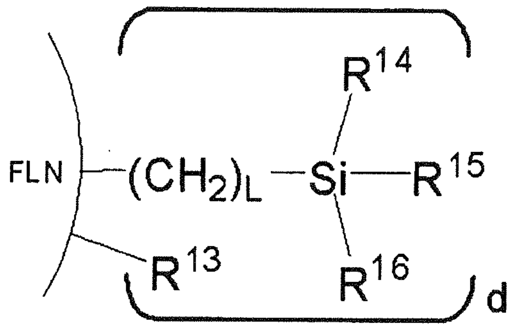

(n4)

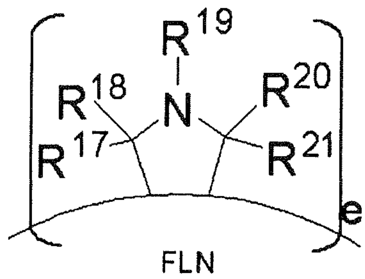

(n5)

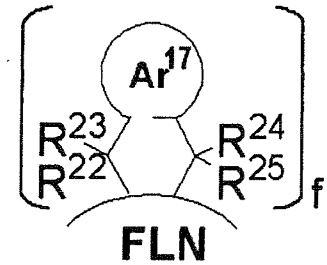

(n6)

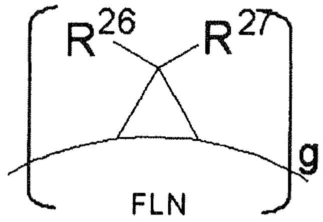

(n7)

wherein FLN in the general formulae (n4), (n5), (n6), and (n7) represents fullerene; the additional group in the general formulae (n4), (n5), (n6), and (n7) is added to the same five-membered ring or six-membered ring in the fullerene skeleton; d, e, f, and g each independently are an integer, L is an integer of 1 to 8; the number of the additional group in the general formulae (n4), (n5), (n6), and (n7) is 1 or more to 5 or less per molecule of the fullerene compound;
in the general formula (n4), $R^{13}$ is an alkyl group having 1 to 14 carbon atoms which may have a substituent, an alkoxy group having 1 to 14 carbon atoms which may have a substituent; $R^{14}$ to $R^{16}$ each independently are a hydrogen atom, an alkyl group having 1 to 14 carbon atoms which may have a substituent, a fluorinated alkyl group having 1 to 14 carbon atoms which may have a substituent, or an aromatic group which may have a substituent;
in the general formula (n5), $R^{17}$ to $R^{21}$ each independently are a hydrogen atom, an alkyl group having 1 to 14 carbon atoms which may have a substituent, or an aromatic group which may have a substituent;
in the general formula (n6), $Ar^{17}$ is an aromatic hydrocarbon group having 6 to 20 carbon atoms which may have a substituent or an aromatic heterocyclic group having 2 to 20 carbon atoms which may have a substituent; $R^{22}$ to $R^{25}$ each independently are a hydrogen atom, an alkyl group which may have a substituent, an amino group which may have a substituent, an alkoxy group which may have a substituent, or an alkylthio group which may have a substituent; $R^{22}$ or $R^{23}$ may be bonded to either one of $R^{24}$ or $R^{25}$ to form a ring; and
in the general formula (n7), $R^{26}$ to $R^{27}$ each independently are a hydrogen atom, an alkoxycarbonyl group, an alkyl group having 1 to 14 carbon atoms which may have a substituent, or an aromatic group which may have a substituent.

14. A solar cell comprising the photoelectric conversion device according to any one of the above item 1 to 13.
15. An ink comprising: a compound which has a glass transition temperature of 90°C or higher and is represented by the following general formula (IX); and a polar solvent:

[Chem 7]

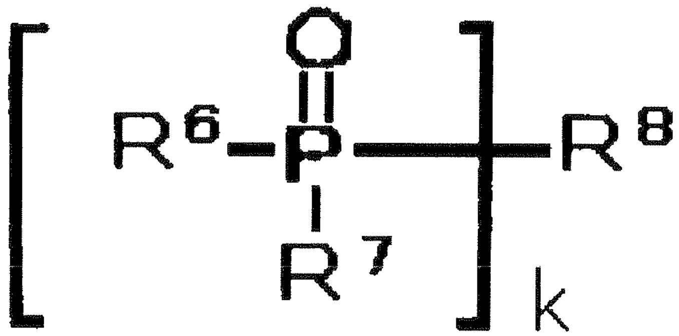

(IX)

wherein $R^6$ to $R^7$ each independently are an aromatic group which may have a substituent; k represents an integer of 2 or more; $R^8$ is a divalent or higher valent aromatic ring group in which the total number of rings is 3 or more.

16. The ink according to the above item 15, wherein the solubility parameter of the polar solvent is 9.5 or more.

Advantage of the Invention

The photoelectric conversion device of the invention is a photoelectric conversion device having an improved durability by using a compound having an electron-withdrawing group or an electron-withdrawing atom as a material of the buffer layer and also using a compound having a high solubility and a high electron mobility in the active layer, and can be used for solar cells.

Brief Description of the Drawings

Fig. 1 is a cross-sectional drawing schematically showing constitution of a photoelectric conversion device as one embodiment of the invention.
Fig. 2 is a cross-sectional drawing schematically showing constitution of a solar cell as one embodiment of the invention.
Fig. 3 is a cross-sectional drawing schematically showing constitution of a solar cell unit as one embodiment of the invention.

Mode for Carrying Out the Invention

The following will explain modes for carrying out the present invention in detail. The following explanation of constitutional requirements described in the following is one example (representative example) of the embodiments of the invention and the modes are not specified to these contents unless they exceed the gist of the invention.

<Photoelectric conversion device>

The photoelectric conversion device according to the invention contains at least one pair of electrodes, an active layer, and a buffer layer. The active layer and the buffer layer are disposed between the electrodes. Fig. 1 shows a photoelectric conversion device for use in common organic thin-film solar cells but the photoelectric conversion device is not limited thereto.

(Buffer layer)

The photoelectric conversion device of the invention is characterized by using a compound containing a divalent or higher valent electron-withdrawing group or electron-withdrawing atom, which is represented by the following general formula (I).

General formula (I):

[Chem 8]

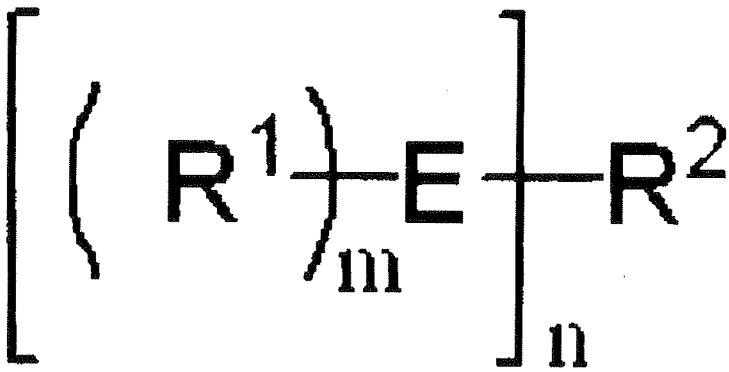

(I)

In the general formula (I), E represents a divalent or higher valent electron-withdrawing group or electron-withdrawing atom. E is a divalent or higher valent electron-withdrawing group or electron-withdrawing atom. It is preferred from the viewpoint of easy transportation of electrons from the n-type semiconductor to the corresponding electrode.

The electron-withdrawing group is a silolediyl group, an oxazolediyl group, an oxadiazolediyl group, a thiazolediyl group, a thiadiazolediyl group, a diazolediyl group, a triazolediyl group, a thiazolediyl group, an isooxazolediyl group, an isothiazolediyl group, a pyrazinediyl group, a pyrimidinediyl group, a pyridazinediyl group, a pyridinediyl group, a benzothiadiazolediyl group, a quinolinediyl group, a carbonyl group, a sulfonyl group, or a phosphine oxide group. In this regard, the silolediyl group, oxazolediyl group, oxadiazolediyl group, thiazolediyl group, thiadiazolediyl group, diazolediyl group, triazolediyl group, thiazolediyl group, isooxazolediyl group, isothiazolediyl group, pyrazinediyl group, pyrimidinediyl group, pyridazinediyl group, pyridinediyl group, benzothiadiazolediyl group, quinolinediyl group, or phosphine oxide group may be trivalent or higher valent one thereof.

Of these, the oxazolediyl group, oxadiazolediyl group, diazolediyl group, triazolediyl group, pyridinediyl group, benzothiadiazolediyl group, quinolinediyl group, and phosphine oxide group are preferred, the oxazolediyl group, triazolediyl group, oxadiazolediyl group, pyridinediyl group, and phosphine oxide group are more preferred, the oxazolediyl group, triazolediyl group, and phosphine oxide group are further preferred, and the phosphine oxide group is particularly preferred.

The electron-withdrawing atom is silicon or boron. Of these, boron is preferred.

In the general formula (I), $R^1$ represents an alkyl group which may have a substituent, a cycloalkyl group which may have a substituent, a heterocyclic group which may have a substituent, an alkenyl group which may have a substituent, a cycloalkenyl group which may have a substituent, an alkynyl group which may have a substituent, an alkoxy group which may have a substituent, or an aromatic group which may have a substituent.

Of these, the alkyl group which may have a substituent, the cycloalkyl group which may have a substituent, the heterocyclic group which may have a substituent, the alkoxy group which may have a substituent, and the aromatic group which may have a substituent are preferred, the alkyl group which may have a substituent, the cycloalkyl group which may have a substituent, the heterocyclic group which may have a substituent, and the aromatic group which may have a substituent are more preferred, and the alkyl group which may have a substituent, the cycloalkyl group which may have a substituent, the heterocyclic group which may have a substituent, and the aromatic group which may have a substituent are particularly preferred.

The alkyl group is preferably an alkyl group having 1 to 20 carbon atoms and examples thereof include a methyl group, an ethyl group, an i-propyl group, a t-butyl group, a hexyl group, and the like.

Examples of the cycloalkyl group include a cyclopropyl group, a cyclopentyl group, a cyclohexyl group, and the like.

The heterocyclic group is preferably a heterocyclic group having 2 to 20 carbon atoms and examples thereof include a pyridyl group, a thienyl group, a furyl group, an oxazolyl group, a thiazolyl group, an oxadiazolyl group, a benzothienyl group, a dibenzofuryl group, a dibenzothienyl group, a pyrazinyl group, a pyrimidinyl group, a pyrazolyl group, an imidazolyl group, a phenanthridinyl group, a phenanthrolinyl group, a phenylcarbazolyl group, and the like.

The heterocyclic group is more preferably an aromatic heterocyclic group and examples thereof include a pyridyl group, a thienyl group, a benzothienyl group, a dibenzofuryl group, a dibenzothienyl group, a phenanthridinyl group, and a phenanthrolinyl group.

The alkenyl group is preferably an alkenyl group having 2 to 20 carbon atoms and examples thereof include a vinyl group, a styryl group, a diphenylvinyl group, and the like.
Examples of the cycloalkenyl group include a cyclopropenyl group, a cyclopentenyl group, a cyclohexenyl group, and the like.
The alkynyl group is preferably an alkynyl group having 2 to 20 carbon atoms and examples thereof include a methylethynyl group, a phenylethynyl group, and a trimethylsilylethynyl group, and the like.
The alkoxy group is preferably an alkoxy group having 2 to 20 carbon atoms and examples thereof include linear or branched alkoxy groups such as a methoxy group, an ethoxy group, an n-propoxy group, an i-propoxy group, an n-butoxy group, an i-butoxy group, a t-butoxy group, a benzyloxy group, and an ethylhexyloxy group.
The aromatic group is preferably an aromatic hydrocarbon group or an aromatic heterocyclic group.
Examples of the aromatic hydrocarbon group include a phenyl group, a naphthyl group, a phenanthryl group, a biphenylenyl group, a triphenylenyl group, an anthryl group, a pyrenyl group, a fluorenyl group, an azulenyl group, an acenaphthenyl group, a fluoranthenyl group, a naphthacenyl group, a perylenyl group, a pentacenyl group, a quaterphenyl group, and the like. Of these, a phenyl group, a naphthyl group, a phenanthryl group, a triphenylenyl group, an anthryl group, a pyrenyl group, a fluorenyl group, an acenaphthenyl group, a fluoranthenyl group, and a perylenyl group are preferred.
Examples of the aromatic heterocyclic group include a pyridyl group, a thienyl group, a furyl group, a pyrrolyl group, an oxazolyl group, a thiazolyl group, an oxadiazolyl group, a thiadiazolyl group, a pyrazinyl group, a pyrimidinyl group, a pyrazolyl group, an imidazolyl group, a benzothienyl group, a dibenzofuryl group, a dibenzothienyl group, a phenylcarbazolyl group, a phenoxathiinyl group, a xanthenyl group, a benzofuranyl group, a thianthrenyl group, an indolidinyl group, a phenoxazinyl group, a phenothiadinyl group, an acridinyl group, a phenanthridinyl group, a phenanthrolinyl group, a quinolyl group, an isoquinolyl group, an indolyl group, a quinoxalinyl group, and the like. Of these, a pyridyl group, a pyrazinyl group, a pyrimidinyl group, a pyrazolyl group, a quinolyl group, an isoquinolyl group, an imidazolyl group, an acridinyl group, a phenanthridinyl group, a phenanthrolinyl group, a quinoxalinyl group, a dibenzofuryl group, a dibenzothienyl group, a phenylcarbazolyl group, a xanthenyl group, and a phenoxazinyl group are preferred.
Moreover, the aromatic group may be a condensed polycyclic aromatic group. As a ring forming the condensed polycyclic aromatic group, a cyclic alkyl group which may have a substituent, an aromatic hydrocarbon group which may have a substituent, and an aromatic heterocyclic group which may have a substituent are preferred.
Examples of the cyclic alkyl group include a cyclopentyl group and a cyclohexyl group.
Examples of the aromatic hydrocarbon group include a phenyl group.
Examples of the aromatic heterocyclic group include a pyridyl group, a thienyl group, a furyl group, a pyrrolyl group, an oxazolyl group, a thiazolyl group, an oxadiazolyl group, a thiadiazolyl group, a pyrazinyl group, a pyrimidinyl group, a pyrazolyl group, an imidazolyl group, and the like. Of these, a pyridyl group and a thienyl group are preferred.
The condensed polycyclic aromatic group is a group in which the above rings are condensed. Examples of the condensed polycyclic aromatic group include condensed polycyclic aromatic hydrocarbon groups and condensed polycyclic aromatic heterocyclic groups. Examples of the condensed polycyclic aromatic hydrocarbon group suitably include a phenanthryl group, an anthryl group, a pyrenyl group, a fluoranthenyl group, a naphthacenyl group, a perylenyl group, a pentacenyl group, a triphenylenyl group, and the like.
Moreover, examples of the condensed polycyclic aromatic heterocyclic group suitably include a phenoxazinyl group, a phenothiazinyl group, an acridinyl group, a phenanthridinyl group, a phenanthrolinyl group, and the like.
As specific examples of the condensed polycyclic aromatic group, the following may be mentioned but the group is not limited thereto. Moreover, in the following condensed polycyclic aromatic groups, the position of the atom bonding to E is not particularly limited.
[Chem 9]

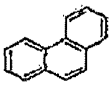 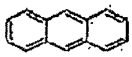 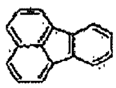 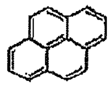 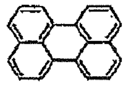 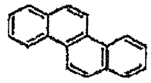 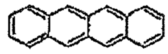

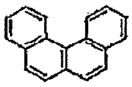 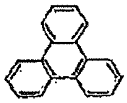 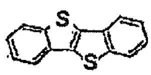 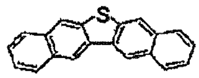

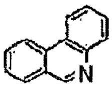 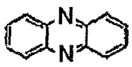 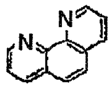 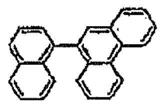 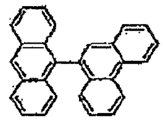 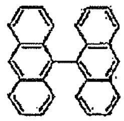

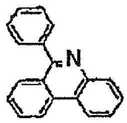 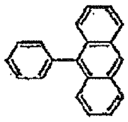 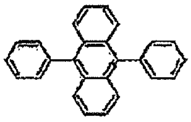 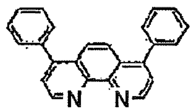

In the general formula (I), $R^2$ represents an aliphatic hydrocarbon group which may have a substituent, an aromatic hydrocarbon group which may have a substituent, a heterocyclic group which may have a substituent, or a group where at least one of an aromatic hydrocarbon group which may have a substituent and a heterocyclic group which may have a substituent is linked.

Examples of the aliphatic hydrocarbon group include an alkyl group, a cycloalkyl group, an alkenyl group, a cycloalkenyl group, and an alkynyl group.

The alkyl group is preferably an alkyl group having 1 to 20 carbon atoms and examples thereof include a methyl group, an ethyl group, an i-propyl group, a t-butyl group, a hexyl group, and the like.

Examples of the cycloalkyl group include a cyclopropyl group, a cyclopentyl group, a cyclohexyl group, and the like.

The alkenyl group is preferably an alkenyl group having 2 to 20 carbon atoms and examples thereof include a vinyl group, a styryl group, a diphenylvinyl group, and the like.

Examples of the cycloalkenyl group include a cyclopropenyl group, a ; cyclopentenyl group, a cyclohexenyl group, and the like.

The alkynyl group is preferably an alkynyl group having 2 to 20 carbon atoms and examples thereof include a methylethynyl group, a phenylethynyl group, and a trimethylsilylethynyl group, and the like.

Examples of the aromatic hydrocarbon group include a phenyl group, a naphthyl group, a phenanthryl group, a biphenylenyl group, a triphenylenyl group, an anthryl group, a pyrenyl group, a fluorenyl group, an azulenyl group, an acenaphthenyl group, a fluoranthenyl group, a naphthacenyl group, a perylenyl group, a pentacenyl group, a triphenylenyl group, a quaterphenyl group, and the like. Of these, a phenyl group, a naphthyl group, a phenanthryl group, a triphenylenyl group, an anthryl group, a pyrenyl group, a fluorenyl group, an acenaphthenyl group, a fluoranthenyl group, and a perylenyl group are preferred.

The heterocyclic group is preferably a heterocyclic group having 5 to 20 carbon atoms and examples thereof include a pyridyl group, a thienyl group, a furyl group, a pyrrolyl group, an oxazolyl group, a thiadiazolyl group, a thiazolyl group, an oxadiazolyl group, a benzothienyl group, a dibenzofuryl group, a dibenzothienyl group, a pyrazinyl group, a pyrimidinyl group, a pyrazol group, an imidazolyl group, a phenylcarbazolyl group, a phenoxathiinyl group, a xanthenyl group, a benzofuranyl group, a thianthrenyl group, an indolidinyl group, a phenoxazinyl group, a phenothiadinyl group, an acridinyl group, a phenanthridinyl group, a phenanthrolinyl group, a quinoxalinyl group, a quinolyl group, an isoquinolyl group, an indolyl group, a quinoxalinyl group, and the like.

As the heterocyclic group, an aromatic heterocyclic group is more preferred. Examples thereof include a pyridyl group, a thienyl group, a benzothienyl group, a dibenzofuryl group, a dibenzothienyl group, a pyrazinyl group, a pyrimidinyl group, a pyrazolyl group, an imidazolyl group, a phenylcarbazolyl group, a xanthenyl group, a phenoxazinyl group, an acridinyl group, a phenanthridinyl group, a phenanthrolinyl group, a quinoxalinyl group, a quinolyl group, and an isoquinolyl group.

Specific examples of $R^2$ are the same groups as in the case of $R^1$ or divalent or higher valent groups thereof.

$R^2$ preferably contains a spiro skeleton to be mentioned below and is more preferably an aliphatic hydrocarbon group containing a spiro skeleton which may have a substituent, an aromatic hydrocarbon group containing a spiro skeleton which may have a substituent, or a heterocyclic group containing a spiro skeleton which may have a substituent.

Moreover, $R^2$ is more preferably an aliphatic hydrocarbon group which may have a substituent, an aromatic hydrocarbon group which may have a substituent, a heterocyclic group which may have a substituent, or a condensed ring group having a plurality of aromatic rings, which is formed by condensing a group where at least one of an aromatic hydrocarbon group which may have a substituent and a heterocyclic group which may have a substituent is linked.

In the general formula (I), m and n each independently represent an integer of 1 or more, and $R^1$ may be independently different when either m or n is 2 or more. m is usually preferably 3 or less and more preferably 2 or less. n is usually preferably 6 or less, more preferably 5 or less, further preferably 3 or less, and particularly preferably 2 or less.

In the invention, the phrase of "which may have a substituent" means that (the group) may have one or more substituents. The substituent in the phrase of "which may have a substituent" is not particularly limited but a halogen atom, a hydroxyl group, a cyano group, an amino group, a carboxyl group, a carbonyl group, an acetyl group, a sulfonyl group, a silyl group, a boryl group, a nitrile group, an alkyl group, a perfluoroalkyl group, an alkenyl group, an alkynyl group, an alkoxy group, an aromatic hydrocarbon group, and an aromatic heterocyclic group are preferred.

The aromatic hydrocarbon group is preferably an aromatic hydrocarbon group having 6 to 20 carbon atoms and the group is not limited to a monocyclic group and may be any of a monocyclic group, a condensed polycyclic hydrocarbon group, and a ring-condensed hydrocarbon group.

Examples of the monocyclic group include a phenyl group and the like. Examples of the condensed polycyclic hydrocarbon group include a biphenyl group, a phenanthryl group, a naphthyl group, an anthryl group, a fluorenyl group, a pyrenyl group, a perylenyl group, and the like. Examples of the ring-condensed hydrocarbon group include a biphenyl group, a terphenyl group, and the like. Of these, a phenyl group and a naphthyl group are preferred.

The aromatic heterocyclic group is preferably an aromatic heterocyclic group having 5 to 20 carbon atoms and examples thereof include a pyridyl group, a thienyl group, a furyl group, an oxazolyl group, a thiazolyl group, an oxadiazolyl group, a benzothienyl group, a dibenzofuryl group, a dibenzothienyl group, a pyrazinyl group, a pyrimidinyl group, a pyrazolyl group, an imidazolyl group, a phenylcarbazolyl group, and the like. Of these, a pyridyl group, a thienyl group, a benzothienyl group, a dibenzofuryl group, a dibenzothienyl group, and a phenanthryl group are preferred.

The halogen atom is preferably a fluorine atom.

The alkyl group is preferably an alkyl group having 1 to 20 carbon atoms and examples thereof include a methyl group, an ethyl group, an i-propyl group, a t-butyl group, a cyclohexyl group, and the like.

The perfluoroalkyl group is preferably a trifluoromethyl group.

The alkenyl group is preferably an alkenyl group having 2 to 20 carbon atoms and examples thereof include a vinyl group, a styryl group, a diphenylvinyl group, and the like.

The alkynyl group is preferably an alkynyl group having 2 to 20 carbon atoms and examples thereof include a methylethynyl group, a phenylethynyl group, and a trimethylsilylethynyl group, and the like.

The silyl group is preferably a silyl group having 2 to 20 carbon atoms and examples thereof include a trimethylsilyl group, a triphenylsilyl group, and the like.

Examples of the boryl group include dimesitylboryl group substituted with an aryl group, and the like.

The alkoxy group is preferably an alkoxy group having 2 to 20 carbon atoms and examples thereof include linear or branched alkoxy groups such as a methoxy group, an ethoxy group, an n-propoxy group, an i-propoxy group, an n-butoxy group, an i-butoxy group, an ethylhexyloxy group, a benzyloxy group, and a t-butoxy group.

Examples of the amino group include arylamines such as a diphenylamino group, a ditolylamino group, and a carbazolyl group, which are substituted with an aryl group.

These substituents may further have a substituent. Examples of the substituent which may be had include an aryl group, an arylamino group, an alkyl group, a perfluoroalkyl group, a halide group, a carboxyl group, a cyano group, an alkoxyl group, an aryloxy group, a carbonyl group, an oxycarbonyl group, a carboxylic acid group, a heterocyclic group, and the like.

The aryl group is preferably an aryl group having 6 to 16 carbon atoms and examples thereof include a phenyl group, a naphthyl group, a phenanthryl group, a pyrenyl group, a perylenyl group, an anthryl group, and the like.

The arylamino group is preferably an arylamino group having 12 to 30 carbon atoms and examples thereof include a diphenylamino group, a carbazolyl group, a phenylcarbazolyl group, and the like.

The alkyl group is preferably an alkyl group having 1 to 12 carbon atoms and examples thereof include a methyl group, an ethyl group, a butyl group, an ethylhexyl group, a t-butyl group, and the like.

The perfluoroalkyl group is preferably one having 1 to 12 carbon atoms and examples thereof include a trifluoromethyl group and the like.

The oxycarbonyl group is preferably an oxycarbonyl group having 1 to 10 carbon atoms and examples thereof include a methoxycarbonyl group, an ethoxycarbonyl group, and the like.

The alkoxy group is preferably an alkoxy group having 1 to 12 carbon atoms and examples thereof include a

methoxy group, an ethoxy group, and the like.

The aryloxy group is preferably an aryloxy group having 6 to 16 carbon atoms and examples thereof include a phenyloxy group, and the like.

The carbonyl group is preferably a carbonyl group having 2 to 16 carbon atoms and examples thereof include an acetyl group, a phenylcarbonyl group, and the like.

The aromatic heterocyclic group is preferably an aromatic heterocyclic group having 5 to 20 carbon atoms and examples thereof include a pyridyl group, a thienyl group, an oxazolyl group, an oxadiazolyl group, a benzothienyl group, a dibenzofuryl group, a dibenzothienyl group, a pyrazinyl group, a pyrimidinyl group, a pyrazolyl group, an imidazolyl group, and the like.

In the general formula (I), preferred compounds include compounds represented by the following general formulae (II) to (VII). However, the compound of the invention is not limited to the following compounds.

General formula (II):

[Chem 10]

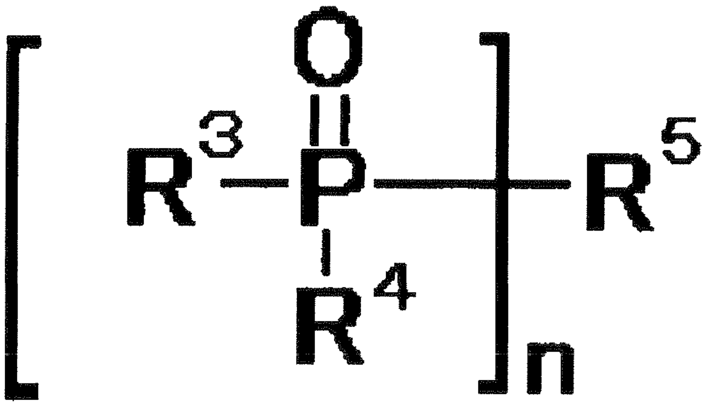

(II)

In the general formula (II), $R^3$ and $R^4$ each independently represent an alkyl group which may have a substituent, a cycloalkyl group which may have a substituent, a heterocyclic group which may have a substituent, an alkenyl group which may have a substituent, a cycloalkenyl group which may have a substituent, an alkynyl group which may have a substituent, an alkoxy group which may have a substituent, or an aromatic group which may have a substituent.

Of these, an alkyl group which may have a substituent, a cycloalkyl group which may have a substituent, a heterocyclic group which may have a substituent, an alkoxy group which may have a substituent, and an aromatic group which may have a substituent are preferred, an alkyl group which may have a substituent, a cycloalkyl group which may have a substituent, a heterocyclic group which may have a substituent, and an aromatic group which may have a substituent are more preferred, and an alkyl group which may have a substituent, a cycloalkyl group which may have a substituent, and an aromatic group which may have a substituent are particularly preferred. These groups are preferred in view of better interaction with the active layer.

$R^5$ represents an aliphatic hydrocarbon group which may have a substituent, an aromatic hydrocarbon group which may have a substituent, a heterocyclic group which may have a substituent, or a group where at least one of an aromatic hydrocarbon group which may have a substituent and a heterocyclic group which may have a substituent is linked. n is the same as described above. Specific examples of $R^5$ include the same groups as in the case of $R^3$ and $R^4$ or divalent or higher valent groups thereof.

Particularly preferably, $R^3$ and $R^4$ each independently represent a condensed polycyclic aromatic group or aromatic group which may have a substituent, and $R^5$ represents an aromatic group. An aromatic group is preferred in view of improving heat stability as a compound. Furthermore, since the aromatic group is highly flat, the group is particularly preferred in view of better interaction with a $\pi$-conjugated system of the active layer and easier charge transfer.

With regard to the alkyl group, cycloalkyl group, heterocyclic group, alkenyl group, cycloalkenyl group, alkynyl group, alkoxy group, aromatic group, and condensed polycyclic aromatic group are the same as described above in the general formula (I).

In the case where $R^5$ is a divalent connecting group, the following specific examples may be mentioned but it is not limited thereto.

[Chem 11]

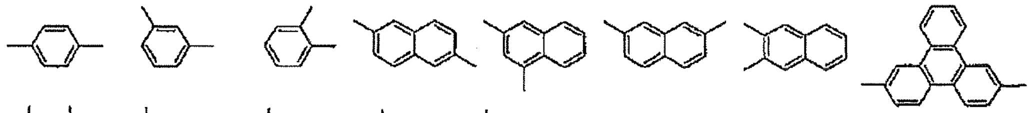

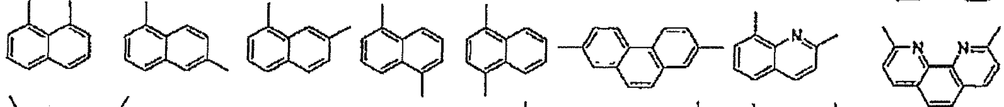

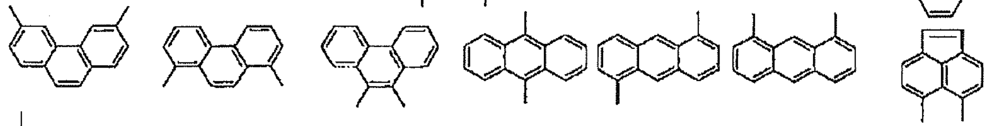

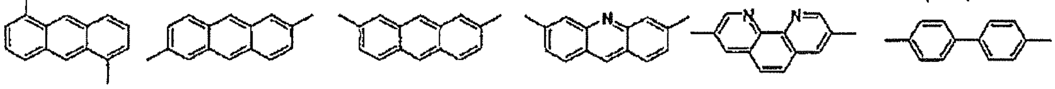

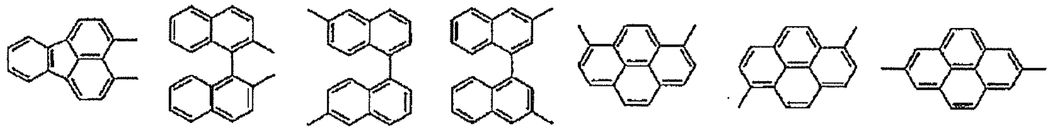

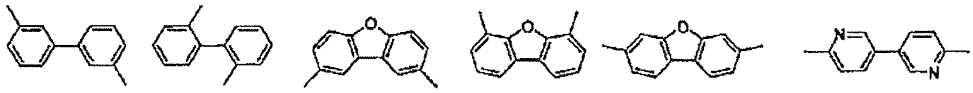

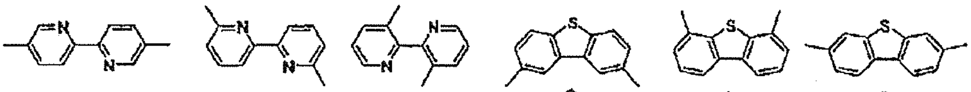

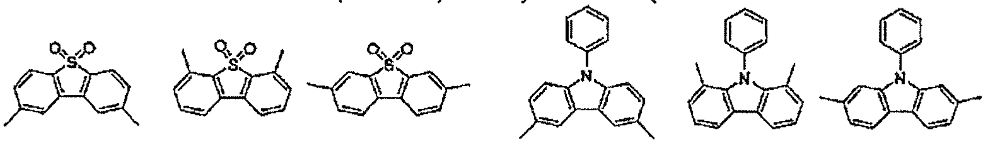

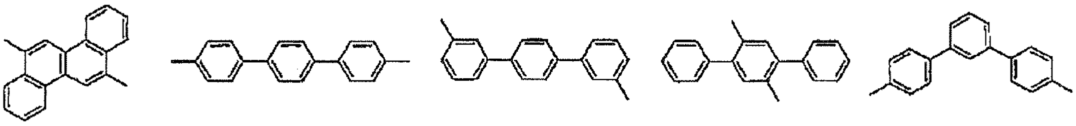

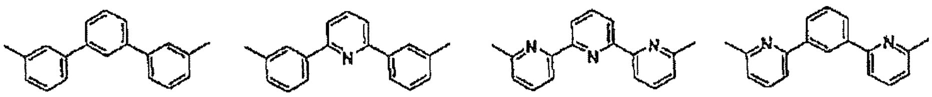

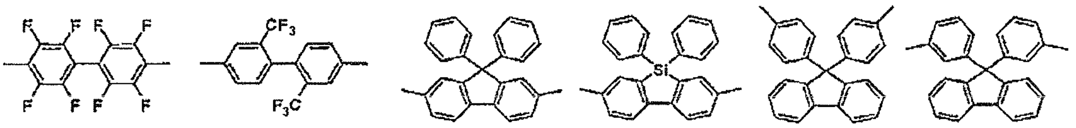

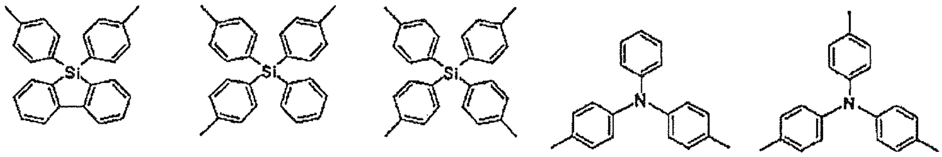

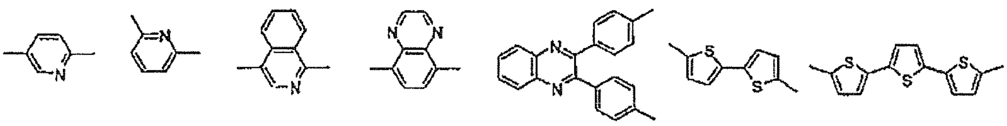

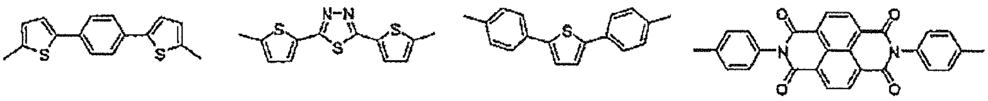

[Chem 12]

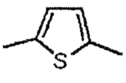 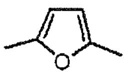 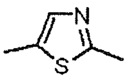 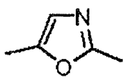 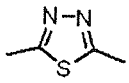 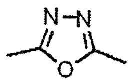

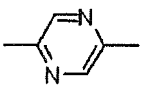 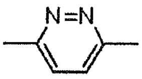 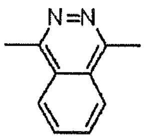 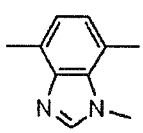 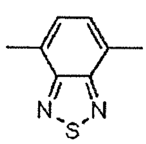 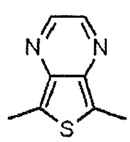

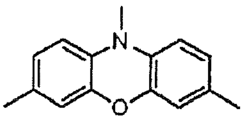 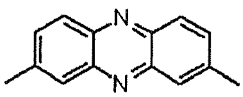 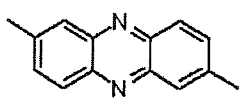 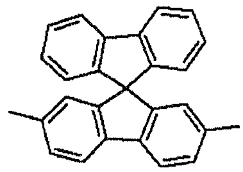

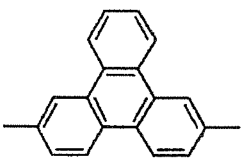 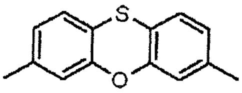 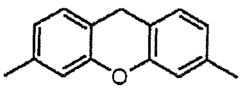

In the general formula (II), n represents an integer of 1 or more, and is preferably 5 or less, more preferably 3 or less, and particularly preferably 2 or less.
The phrase of "which may have a substituent" in the general formula (II) is the same as the definition in the general formula (I).
General formula (III):
[Chem 13]

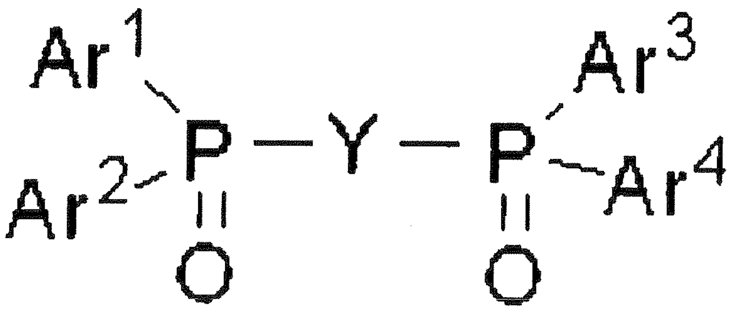 (III)

In the general formula (III), $Ar^1$ to $Ar^4$ each independently represent an aromatic group which may have a substituent. The aromatic group has the same meanings as in the case of the aromatic group of $R^1$, $R^2$ in the general formula (I).
As the aromatic group, an aromatic hydrocarbon group and an aromatic heterocyclic group are preferred.
Examples of the aromatic hydrocarbon group suitably include a phenyl group, a naphthyl group, a phenanthryl group, a triphenylenyl group, a pyrenyl group, a fluorenyl group, and a fluoranthenyl group.
Examples of the aromatic heterocyclic group suitably include a pyridyl group, a quinolyl group, an isoquinolyl group, an acridinyl group, a phenanthridinyl group, a phenanthrolinyl group, a quinoxalinyl group, a dibenzofuryl group, a dibenzothienyl group, a phenylcarbazolyl group, a xanthenyl group, and a phenoxazinyl group.
In the general formula (III), $Ar^1$ and $Ar^2$ or $Ar^3$ and $Ar^4$ may form a ring directly or through a substituent. $Ar^1$ to $Ar^4$ may be linked through adjacent substituents each other to form a ring.
With regard to $Ar^1$ to $Ar^4$, $Ar^1$ and $Ar^2$ are preferably the same or $Ar^3$ and $Ar^4$ are preferably the same. More

preferably, $Ar^1$, $Ar^2$, $Ar^3$, and $Ar^4$ are the same.

<Explanation of connecting group containing spiro skeleton>

In the general formula (III), Y represents an aliphatic hydrocarbon group containing a spiro skeleton which may have a substituent, an aromatic hydrocarbon group containing a spiro skeleton which may have a substituent, or a heterocyclic group containing a spiro skeleton which may have a substituent. By the presence of the spiro skeleton, a high Tg is expected and also improvement in heat resistance is expected.

The spiro skeleton means a structure represented by the following formula (VIII).

[Chem 14]

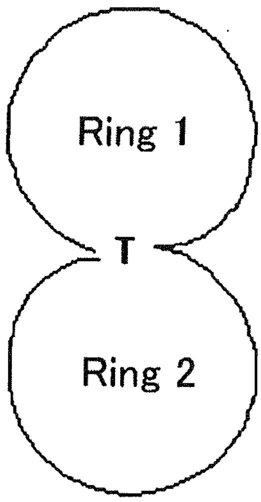

(VIII)

In the formula (VIII), T represents C or Si and the ring 1 and the ring 2 are ring structures. The ring 1 and the ring 2 each independently are preferably a 5-membered ring or a 6-membered ring or a condensed polycycle thereof.

The ring 1 is more preferably a 5-membered ring or a 6-membered ring. Examples of the 5-membered ring include cyclopentane. Examples of the 6-membered ring include cyclohexane. Moreover, in the case of the condensed polycycle, the number of condensed ring is usually preferably two or more and more preferably three or more.

Particularly preferable examples as the ring 1 may be mentioned below but it is not limited thereto.

[Chem 15]

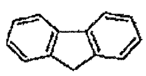 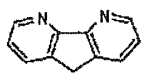 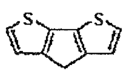 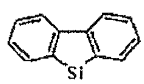 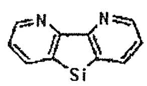 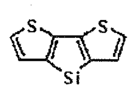

The ring 2 is more preferably condensed polycycle. The number of condensed ring is usually preferably two or more and more preferably three or more.

Particularly preferable examples as the ring 2 may be mentioned below but it is not limited thereto.

[Chem 16]

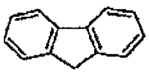 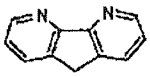 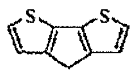 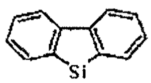 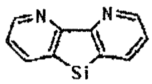 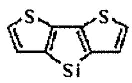

Specific examples of Y may be mentioned below but it is not limited thereto. Moreover, in Y, the position of the atom to be bonded to P is not particularly limited.

[Chem 17]

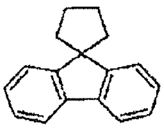 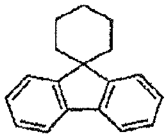 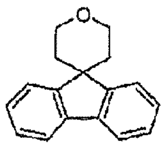 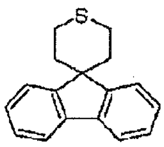 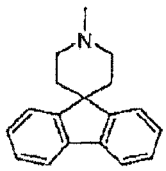

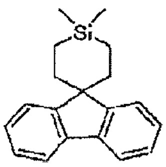 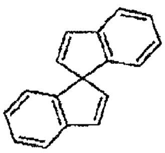 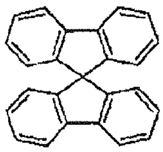 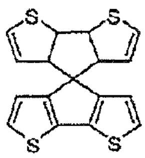 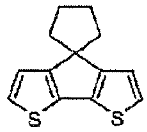 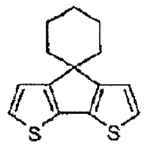

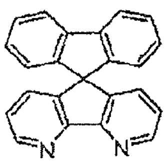 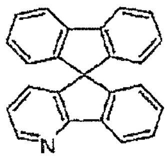 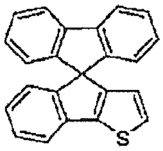 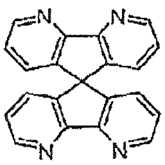 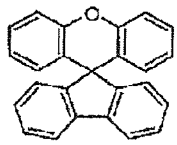

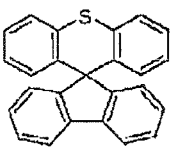 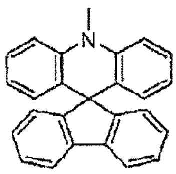 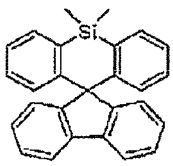 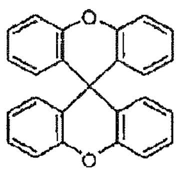

[Chem 18]

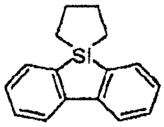 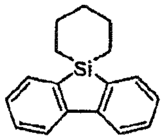 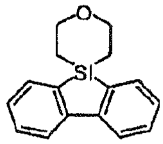 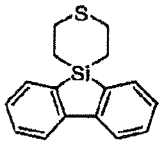 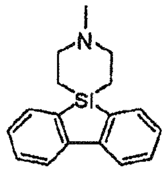

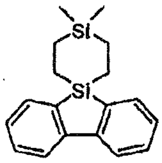 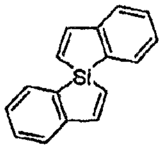 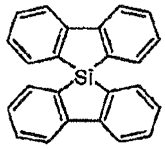 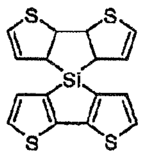 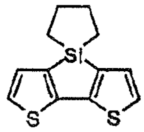 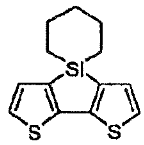

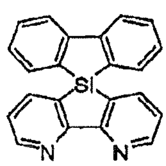 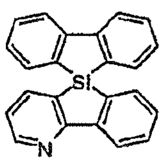 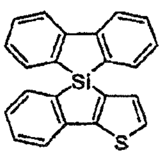 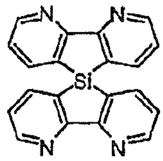 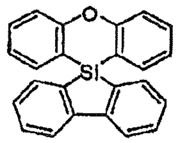

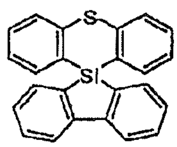 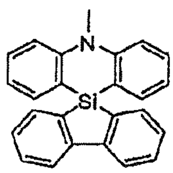 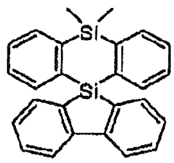 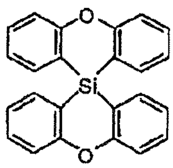

The spiro skeleton may further have a connecting group. The connecting group represents a divalent connecting group composed of an aromatic hydrocarbon group.

The following show specific examples of the connecting group, but it is not limited thereto.

[Chem 19]

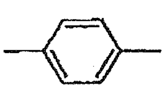 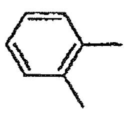 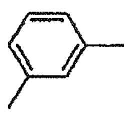 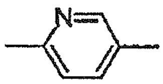 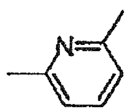 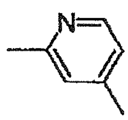

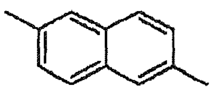 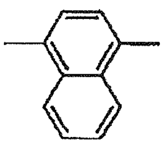 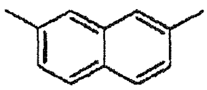

The connecting group having a spiro skeleton may have a substituent.

The general formula (IV):

[Chem 20]

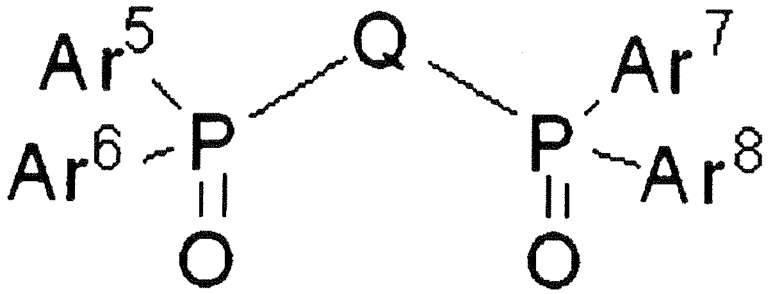

(IV)

In the general formula (IV), Q represents a condensed ring group having a plurality of aromatic rings and a connecting group capable of taking a conformation in which an angle formed by extension lines of two bonding lines between two atoms bonded to phosphorus atoms in Q and the respective phosphorus atoms is 120° or less.

The condensed ring group having a plurality of aromatic rings is preferably a condensed ring group formed of an aromatic hydrocarbon group which may have a substituent or an aromatic heterocyclic group which may have a substituent.

Examples of the aromatic hydrocarbon group include a naphthyl group, a phenanthryl group, a triphenylenyl group, an anthryl group, a pyrenyl group, a fluorenyl group, an azulenyl group, an acenaphthenyl group, a fluoranthenyl group, a naphthacenyl group, a perylenyl group, a pentacenyl group, a binaphthyl group, a phenylnaphthyl group, a diphenylnaphthyl group, a phenylphenanthryl group, and the like. Of these, a naphthyl group, a phenanthryl group, an anthryl group, a pyrenyl group, a fluorenyl group, an acenaphthenyl group, a fluoranthenyl group, a perylenyl group, and a triphenylenyl group are preferred.

Examples of the aromatic heterocyclic group include a benzothiadiazolyl group, a benzothienyl group, a dibenzofuryl group, a dibenzothienyl group, a phenylcarbazolyl group, a phenoxathiinyl group, a xanthenyl group, a benzofuranyl group, a thianthrenyl group, an indolidinyl group, a phenoxazinyl group, a phenothiadinyl group, an acridinyl group, a phenanthridinyl group, a phenanthrolinyl group, a quinolyl group, an isoquinolyl group, an indolyl group, and the like. Of these, a quinolyl group, an isoquinolyl group, an acridinyl group, a phenanthridinyl group, a phenanthrolinyl group, a quinoxalinyl group, a dibenzofuryl group, a dibenzothienyl group, a phenylcarbazolyl group, a xanthenyl group, and a phenoxazinyl group are preferred.

Moreover, examples of the condensed ring group having a plurality of aromatic rings include a phenylbenzothienyl group.

In the general formula (IV), $Ar^5$ to $Ar^8$ each independently represent an aromatic hydrocarbon group which may have a substituent. The aromatic group has the same meanings as in the case of the aromatic group of $R^1$, $R^2$. As the aromatic group, an aromatic hydrocarbon group and an aromatic heterocyclic group are preferred.

As the aromatic hydrocarbon group, a phenyl group, a naphthyl group, a phenanthryl group, a triphenylene group, a pyrenyl group, a fluorenyl group, and a triphenylenyl group are preferred. As the aromatic heterocyclic group, a pyridyl group, a quinolyl group, an isoquinolyl group, an imidazolyl group, an acridinyl group, a phenanthridinyl group, a phenanthrolinyl group, and a quinoxalinyl group are preferred.

$Ar^5$ to $Ar^8$ may have a substituent and may be linked with adjacent substituents each other to form a ring.

With regard to $Ar^5$ to $Ar^8$, $Ar^5$ and $Ar^6$ are preferably the same or $Ar^7$ and $Ar^8$ are preferably the same. More preferably, $Ar^5$, $Ar^6$, $Ar^7$, and $Ar^8$ are the same.

As the case of "taking a conformation in which an angle formed by extension lines of two bonding lines between two atoms bonded to phosphorus atoms in Q and the respective phosphorus atoms is 120° or less", specifically, examples of the following general formulae (IV-1) a to c may be mentioned.

[Chem 21]

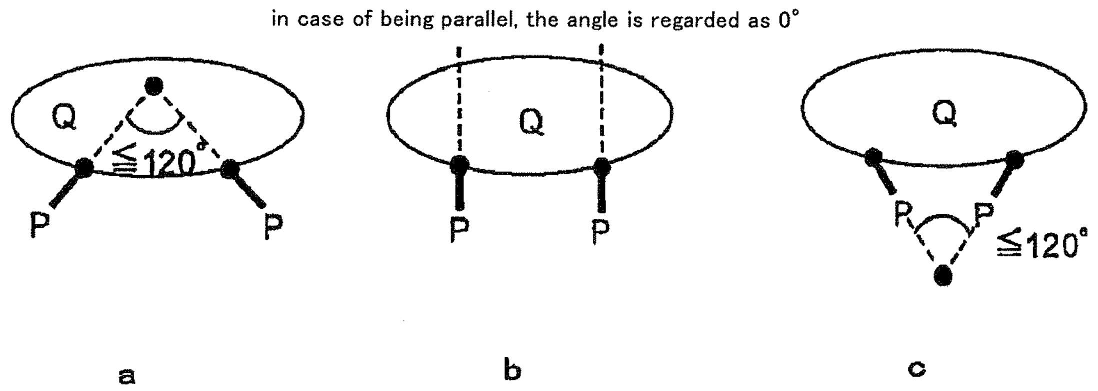


General formula (IV-1)

By taking such a conformation, it is expected to have an effect of strengthening coordination ability.

Specific examples of Q may be mentioned below, but it is not limited thereto.

[Chem 22]

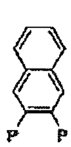 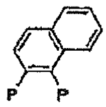 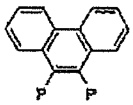 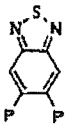 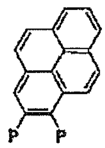 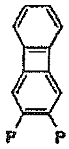 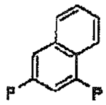 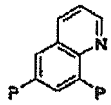

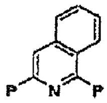 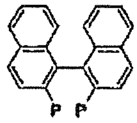 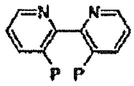 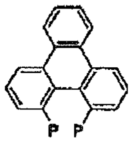 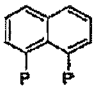 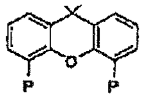 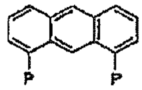

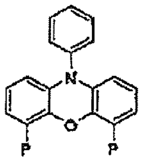 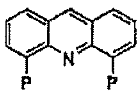 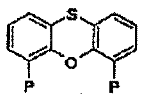 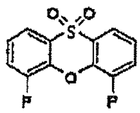 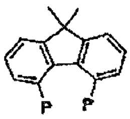 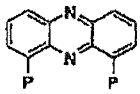

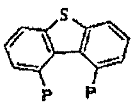 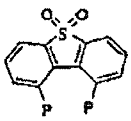 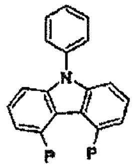 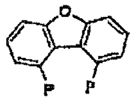 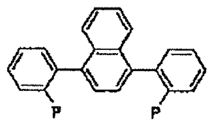

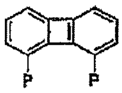 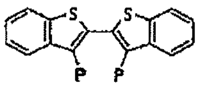 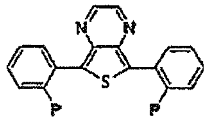 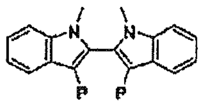 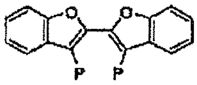

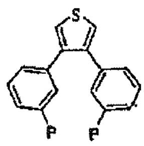 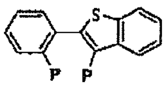 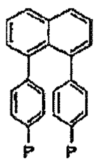 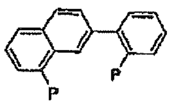

The phosphine compound represented by the above general formula (IV) of the invention is a compound capable of being a multidentate ligand to a metal atom. The compound capable of being a multidentate ligand toward a metal atom means a compound capable of being a ligand which can multiply coordinate to a coordination site of a metal. Here, as the metal, Al, Ag, Au, Mg, Ca, Pt, and Li are preferred, which may be in a salt.

Specifically, the possibility of being a multidentate ligand to a metal atom can be investigated by performing molecular orbital calculation or the like whether it is possible to do multiple coordination to a coordination site of a metal or not. Examples of the molecular orbital calculation include an MM method (molecular force field method), an MOPAC method (molecular orbital method), and the like. The bond distance between a metal atom and a ligand is calculated and it is sufficient that the distance satisfies coordination-capable distance of the metal.

Specifically, when the metal is assumed to be Au, the bond distance with a ligand is calculated and it is sufficient that each coordination site can be present within the range of 2 angstrom in radius from the Au atom.

General formula (V):

[Chem 23]

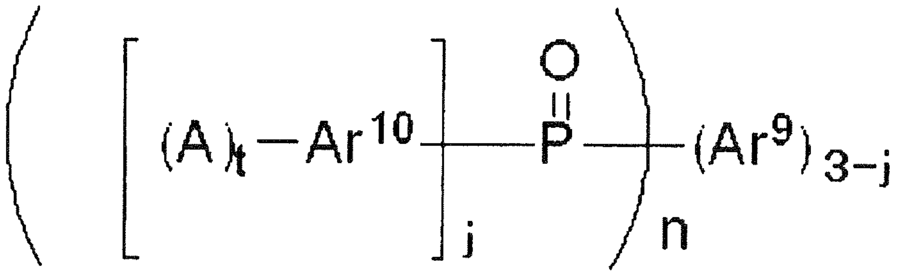

(V)

In the general formula (V), $Ar^9$ is an aromatic hydrocarbon group which may have a substituent, an aromatic heterocyclic group which may have a substituent, or a group where they are linked. Examples thereof include an aromatic hydrocarbon group such as a monovalent group or a divalent group of an aromatic hydrocarbon ring and an aromatic heterocyclic group such as a monovalent group or a divalent group of an aromatic heterocycle.

Examples of the aromatic hydrocarbon ring include a benzene ring, a naphthalene ring, an azulene ring, a biphenylene ring, an acenaphthylene ring, a fluorene ring, a phenanthrene ring, an anthracene ring, a fluoranthene ring, a triphenylene ring, a pyrene ring, a chrysene ring, a naphthacene ring, a perylene ring, a pentacene ring, and the like.

Examples of the aromatic heterocycle include an aromatic heterocycle having one oxygen atom, an aromatic heterocycle having one nitrogen atom, an aromatic heterocycle having two nitrogen atoms, an aromatic heterocycle having three nitrogen atoms, an aromatic heterocycle having two sulfur atoms, an aromatic heterocycle having an oxygen atom and a nitrogen atom, an aromatic heterocycle having a sulfur atom and a nitrogen atom, an aromatic heterocycle having a sulfur atom and an oxygen atom, and the like.

Examples of the aromatic heterocycle having one oxygen atom include a furan ring, a benzofuran ring, a dibenzofuran ring, a xanthene ring, and the like. Examples of the aromatic heterocycle having one nitrogen atom include a pyrrole ring, an indole ring, an indolidine ring, a carbazole ring, a pyridine ring, a quinoline ring, an isoquinoline ring, an acridine ring, a phenanthridine ring, a phenanthroline ring, and the like. Examples of the aromatic heterocycle having two nitrogen atoms include an imidazole ring, a pyrazole ring, a pyrimidine ring, a pyrazine ring, a quinoxaline ring, and the like. Examples of the aromatic heterocycle having three nitrogen atoms include triazine ring and the like.

Examples of the aromatic heterocycle having one sulfur atom include a thiophene ring, a benzothiophene ring, a dibenzothiophene ring, and the like. Examples of the aromatic heterocycle having two sulfur atoms include thianthrene ring and the like. Examples of the aromatic heterocycle having an oxygen atom and a nitrogen atom include an oxazole ring, an oxadiazole ring, a phenoxazine ring, and the like. Examples of the aromatic heterocycle having a sulfur atom and a nitrogen atom include a thiazole ring, a thiadiazole ring, a phenothiazine ring, and the like. Examples of the aromatic heterocycle having a sulfur atom and an oxygen atom include phenoxthine and the like.

$Ar^9$ may be one in which these aromatic hydrocarbon groups and aromatic heterocyclic groups are directly linked singly or mutually or they are linked through an alkylene group, a silylene group, an amino group, an oxygen atom, a sulfur atom, and the like.

Incidentally, the above aromatic hydrocarbon group and the above aromatic heterocyclic group as $Ar^9$ may have a substituent.

In the general formula (V), $Ar^{10}$ is an aromatic hydrocarbon group which may have a substituent or an aromatic heterocyclic group which may have a substituent. For example, an aromatic hydrocarbon group such as a monovalent group of an aromatic hydrocarbon ring, an aromatic heterocyclic group such as a monovalent group of an aromatic heterocyclic ring, and the like may be mentioned, and an aromatic heterocyclic group such as a monovalent group and the like are preferred.

Examples of the aromatic hydrocarbon ring include a benzene ring, a naphthalene ring, an azulene ring, a biphenylene ring, an acenaphthylene ring, a fluorene ring, a phenanthrene ring, an anthracene ring, a fluoranthene ring, a triphenylene ring, a pyrene ring, a chrysene ring, a naphthacene ring, a perylene ring, a pentacene ring, and the like. Of these, a benzene ring, a naphthalene ring, an acenaphthylene ring, a fluorene ring, a phenanthrene ring, an anthracene ring, a fluoranthene ring, a triphenylene ring, a pyrene ring, a chrysene ring, and a perylene ring are preferred, and a benzene ring, a naphthalene ring, a fluorene ring, a phenanthrene ring, a triphenylene ring, a pyrene ring, and a chrysene ring are preferred.

Examples of the aromatic heterocyle include an aromatic heterocycle having one oxygen atom, an aromatic heterocycle having one nitrogen atom, an aromatic heterocycle having two nitrogen atoms, an aromatic heterocycle

having two nitrogen atoms, an aromatic heterocycle having one sulfur atom, an aromatic heterocycle having two sulfur atoms, an aromatic heterocycle having an oxygen atom and a nitrogen atom, an aromatic heterocycle having a sulfur atom and a nitrogen atom, an aromatic heterocycle having a sulfur atom and an oxygen atom, and the like.

Examples of the aromatic heterocycle having one oxygen atom include a furan ring, a benzofuran ring, a dibenzofuran ring, a xanthene ring, and the like. Examples of the aromatic heterocycle having one nitrogen atom include a pyrrole ring, an indole ring, an indolidine ring, a carbazole ring, a pyridine ring, a quinoline ring, an isoquinoline ring, an acridine ring, a phenanthridine ring, a phenanthroline ring, and the like. Examples of the aromatic heterocycle having two nitrogen atoms include an imidazole ring, a pyrazole ring, a pyrimidine ring, a pyrazine ring, a quinoxaline ring, and the like.

Examples of the aromatic heterocycle having one sulfur atom include a thiophene ring, a benzothiophene ring, a dibenzothiophene ring, and the like. Examples of the aromatic heterocycle having two sulfur atoms include thianthrene ring and the like. Examples of the aromatic heterocycle having an oxygen atom and a nitrogen atom include an oxazole ring, an oxadiazole ring, a phenoxazine ring, and the like. Examples of the aromatic heterocycle having a sulfur atom and a nitrogen atom include a thiazole ring, a thiadiazole ring, a phenothiazine ring, and the like. Examples of the aromatic heterocycle having a sulfur atom and an oxygen atom include phenoxthine and the like.

As the aromatic heterocycle, a silole ring, a dibenzofuran ring, a xanthene ring, a carbazole ring, a pyridine ring, a quinoline ring, an isoquinoline ring, an acridine ring, a phenanthridine ring, a phenanthroline ring, an imidazole ring, a pyrazole ring, a pyrimidine ring, a pyrazine ring, a quinoxaline ring, a dibenzothiophene ring, and a phenoxazine ring are preferred, and a dibenzofuran ring, a carbazole ring, a pyridine ring, a quinoline ring, an isoquinoline ring, an acridine ring, a phenanthridine ring, a phenanthroline ring, an imidazole ring, a quinoxaline ring, and a dibenzothiophene ring are more preferred.

As $Ar^{10}$, the above aromatic hydrocarbon ring and aromatic heterocyclic ring are particularly preferably a monovalent group of a monocyclic aromatic ring, and most preferably a monovalent group of a benzene ring, i.e., a phenyl group.

$Ar^{10}$ may be one in which these aromatic hydrocarbon groups and aromatic heterocyclic groups are directly linked singly or a plurality of them are linked directly or through an alkylene group, a silylene group, an amino group, an oxygen atom, a sulfur atom, and the like.

In the general formula (V), the substituent A present in $Ar^{10}$ is a fluorine atom or a perfluoroalkyl group. Examples of the perfluoroalkyl group include a trifluoromethyl group, a pentafluoroethyl group, and the like and a trifluoromethyl group is particularly preferred.

Moreover, the above aromatic hydrocarbon group such as the monovalent group and the above aromatic heterocyclic group such as the monovalent group as $Ar^{10}$ may further have a substituent other than the above A. Examples of the substituent include a cyano group, a carbonyl group, an acetyl group, a sulfonyl group, an alkyl group, an alkenyl group, an alkynyl group, an alkoxy group, an aryloxy group, and the like.

In the general formula (V), t is an integer of 1 to 5 and is preferably 1 to 3. j is an integer of 1 to 3, and n is an integer of 1 or more. $Ar^{10}$ may be independently different when either j or n is 2 or more. However, n is 1 when j is 3.

In the phosphine oxide compound represented by the above general formula (V), when j is 2 and p is 2 or more, $Ar^9$ is a divalent or higher valent connecting group. Specific examples in that case are shown below but it is not limited thereto.

[Chem 24]

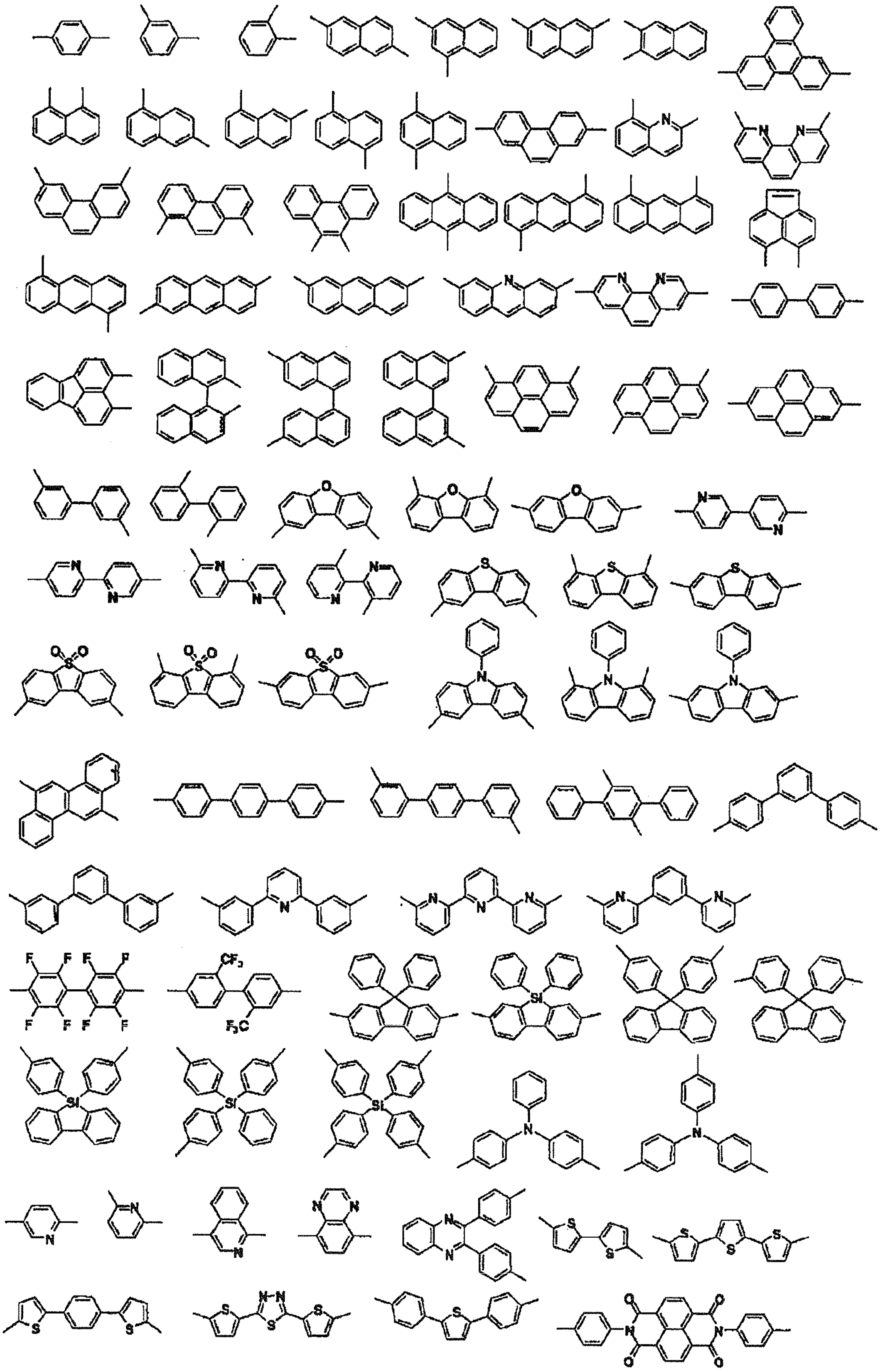

General formula (VI):

[Chem 25] $Ar^{11}$-$Ar^{13}$-$Ar^{12}$ (VI)

In the general formula (VI), $Ar^{11}$ and $Ar^{12}$ are aromatic groups which may have a substituent. The aromatic group has the same meanings as in the case of the aromatic group of $R^1$. As the aromatic groups, a phenyl group, a naphthyl group, a phenanthryl group, a pyrenyl group, a biphenyl group, a pyridyl group, a bipyridyl group, and a phenanthryl group. $Ar^{11}$ and $Ar^{12}$ may be linked with adjacent substituents each other to form a ring.

In the general formula (VI), $Ar^{13}$ is a silolediyl group, an oxazolediyl group, an oxadiazolediyl group, a thiadiazolediyl group, a triazolediyl group, a thiazolediyl group, an isooxazolediyl group, and an isothiazolediyl group. As $Ar^{13}$, an oxazolediyl group, an oxadiazolediyl group, a diazolediyl group, and a triazolediyl group are preferred, an oxazolediyl group, a triazolediyl group, and an oxadiazolediyl group are more preferred, and an oxazolediyl group and a triazolediyl group are further preferred.

General formula (VII):

[Chem 26]

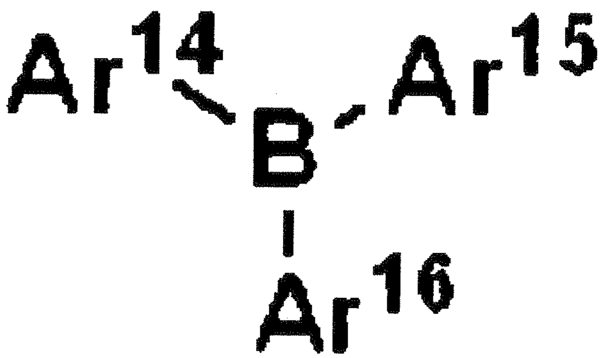

(VII)

In the general formula (VII), $Ar^{14}$ to $Ar^{16}$ are aromatic groups which may have a substituent. The aromatic group has the same meanings as in the case of the aromatic group of $R^1$. As the aromatic groups, a phenyl group, a naphthyl group, a phenanthryl group, and a pyrenyl group are preferred. $Ar^{14}$ to $Ar^{16}$ may be linked with adjacent substituents each other to form a ring.

In the general formula (VII), B is boron.

Specific examples of compounds represented by the above general formulae (I) to (VII) are shown below but they are not limited thereto.

[Chem 27]

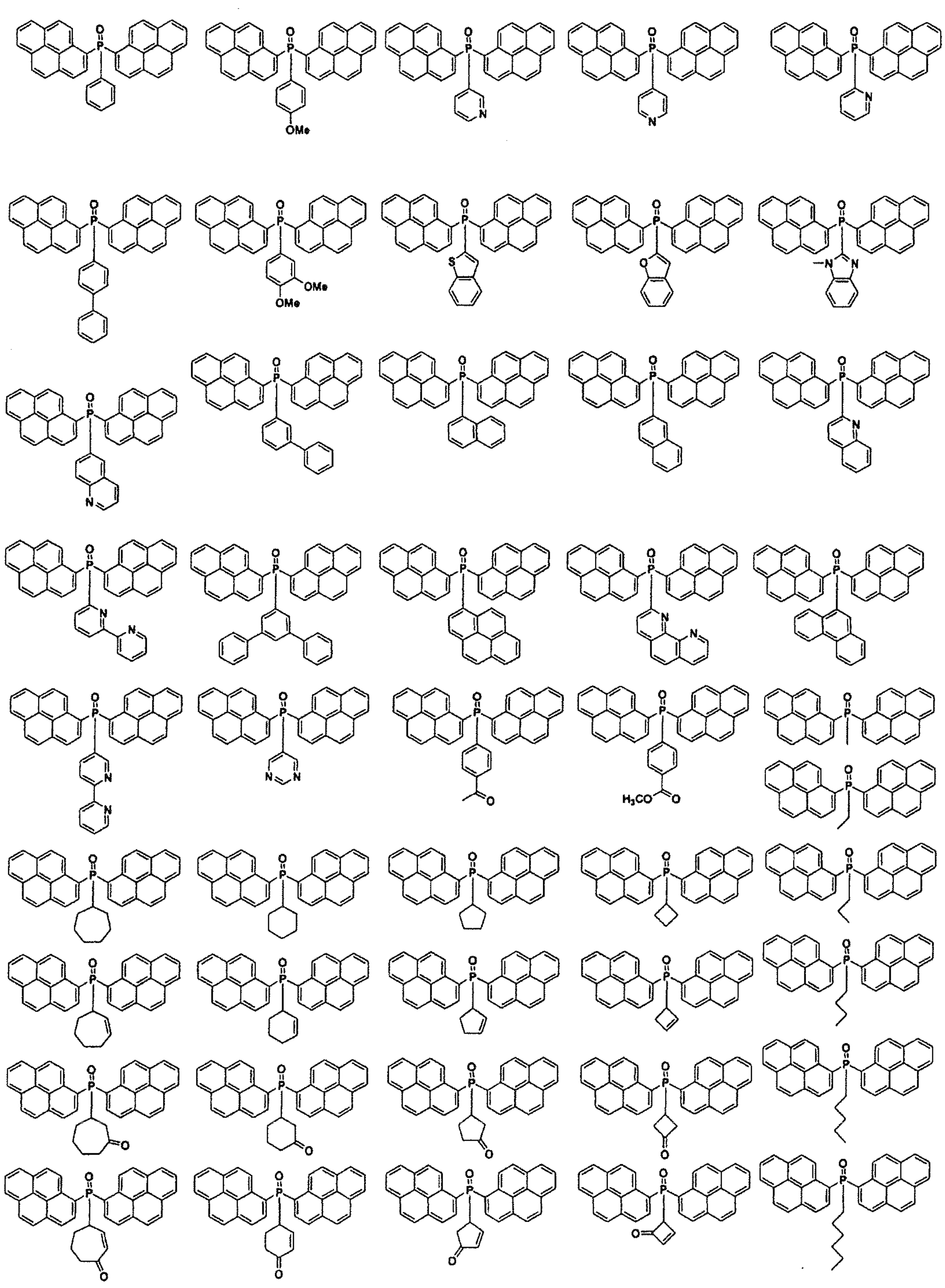

[Chem 28]

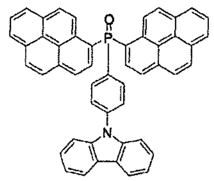 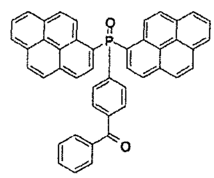 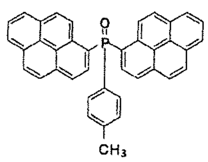 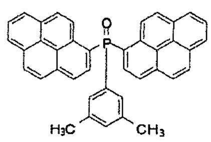 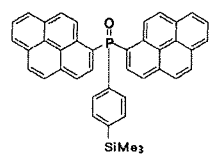

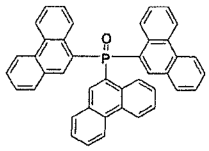 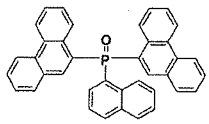 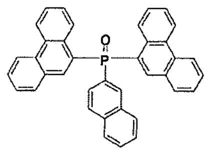 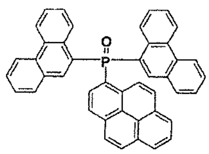 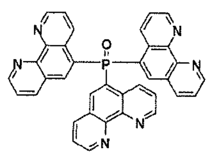

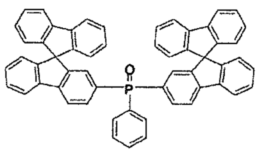 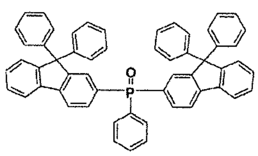 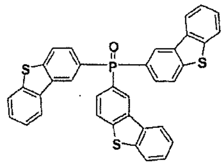 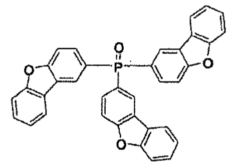

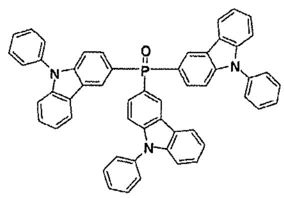 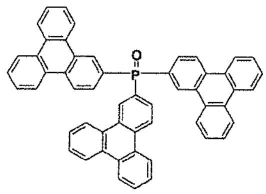 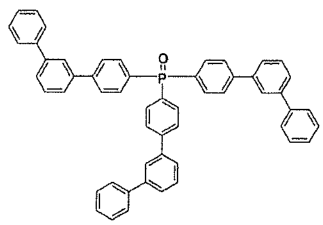

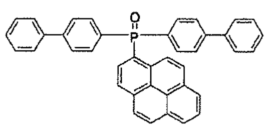 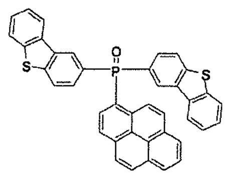 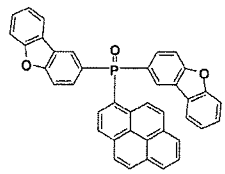 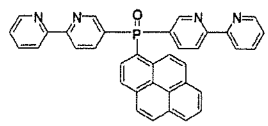

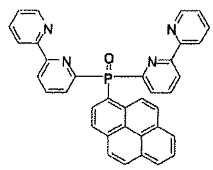 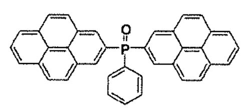 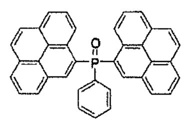 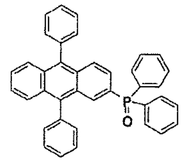

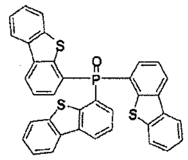 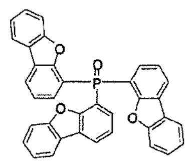 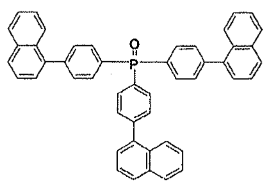 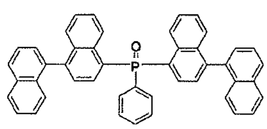

[Chem 29]

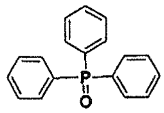
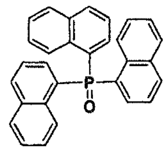
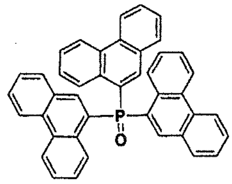
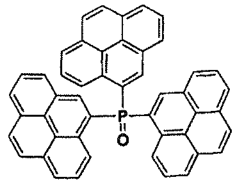

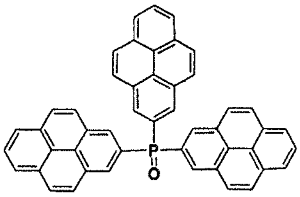
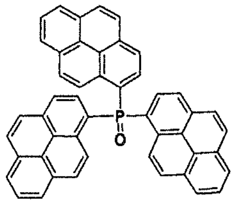
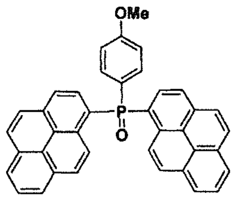
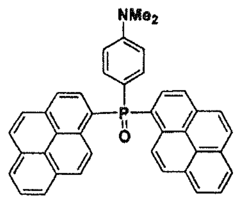

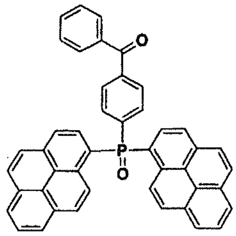
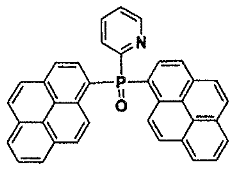
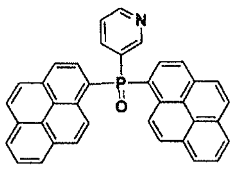
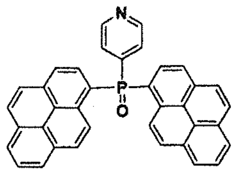

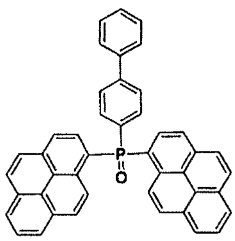
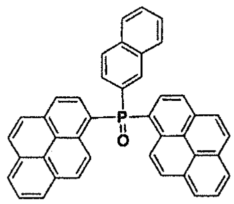
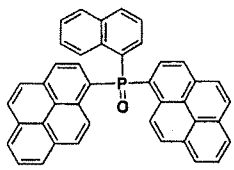
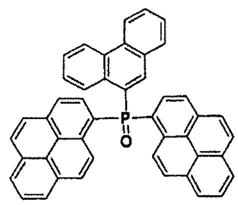

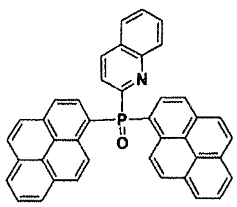
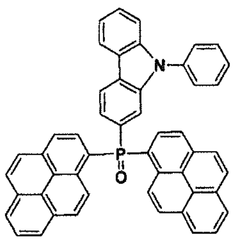
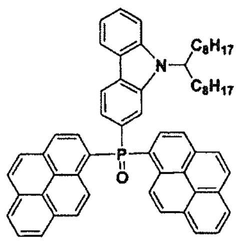
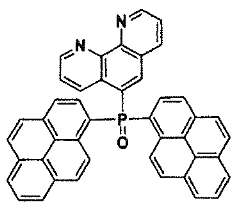

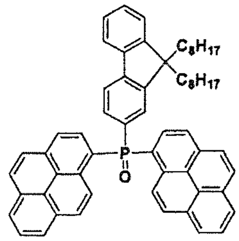
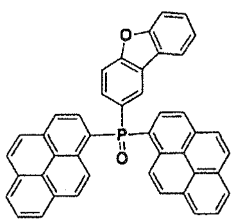
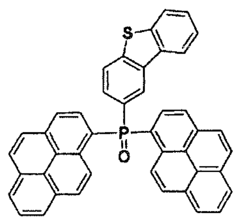
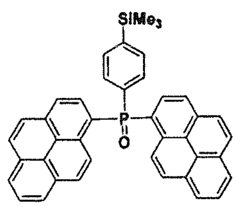

[Chem 30]

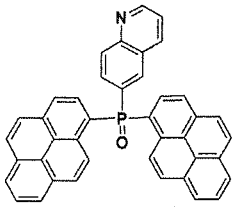
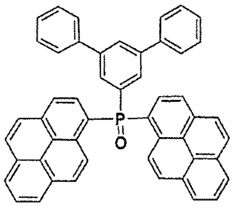
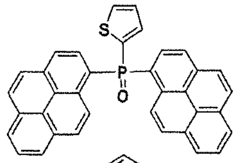
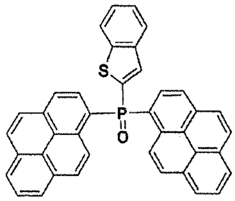
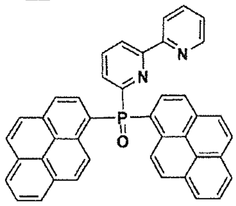
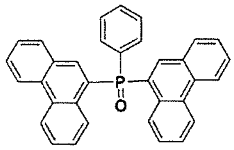
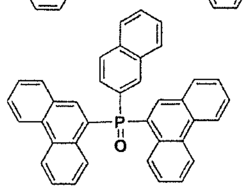
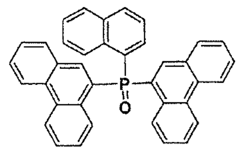
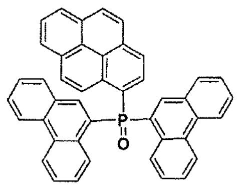
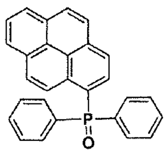
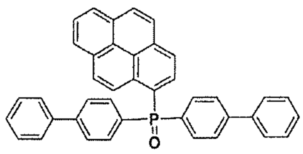
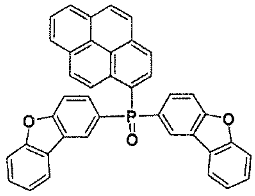
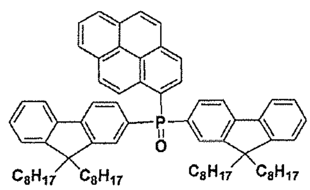
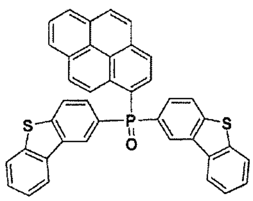
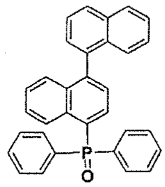
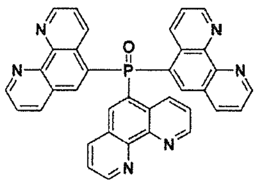
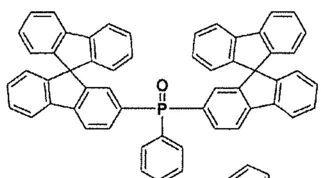
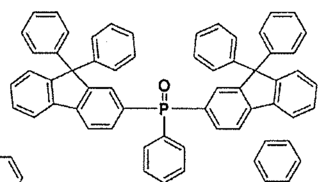
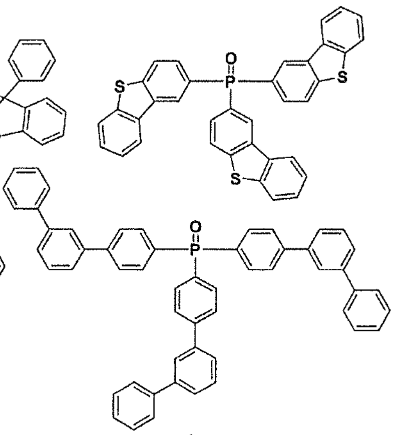
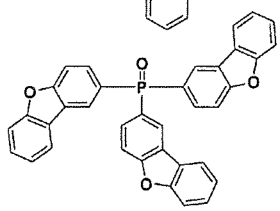
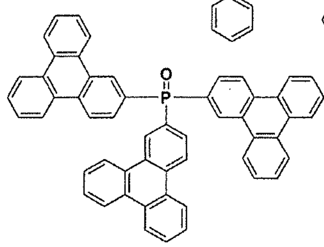
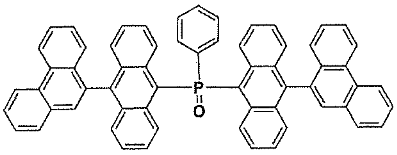
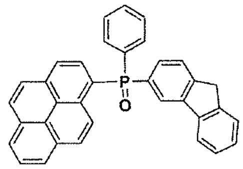
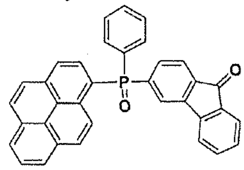

[Chem 31]

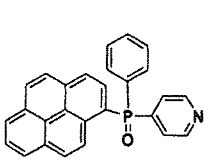 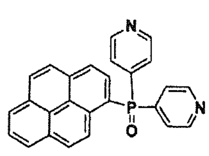 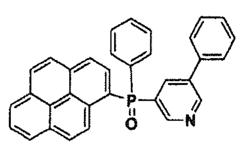 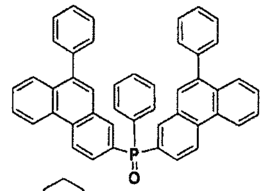

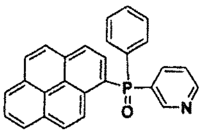 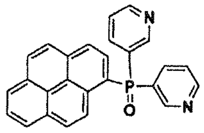 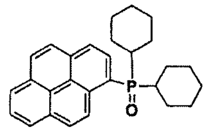 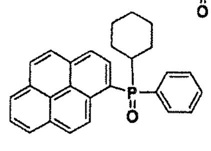

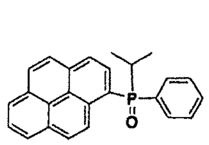 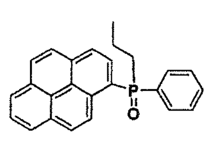 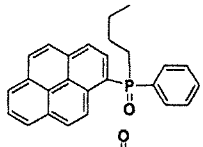 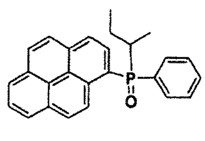

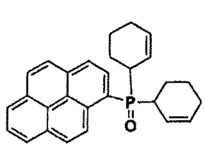 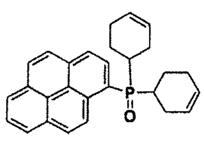 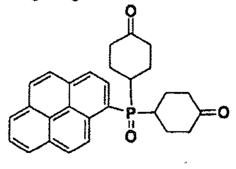 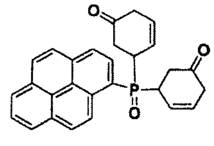

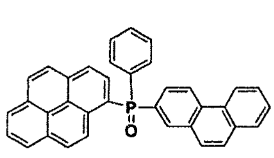 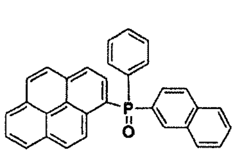 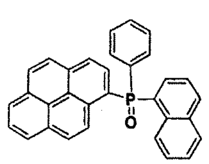 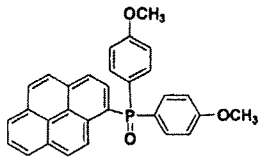

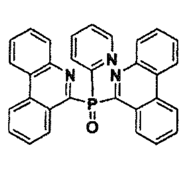 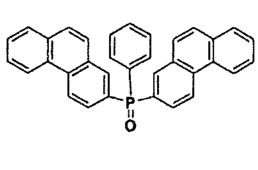 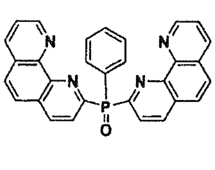 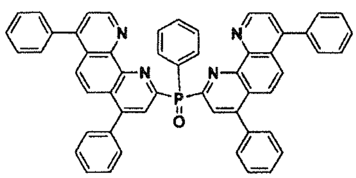

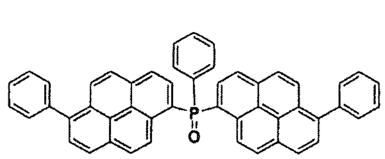 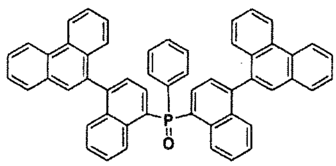 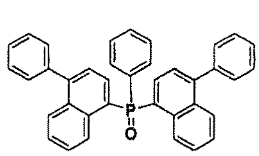

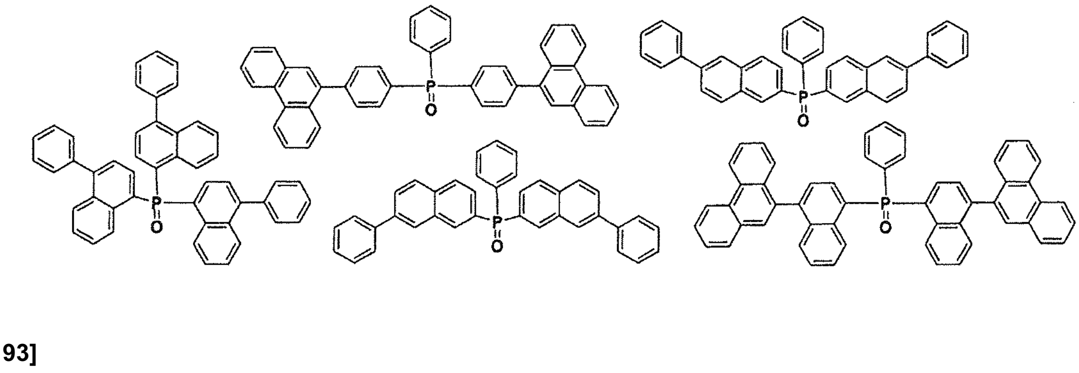

[Chem 32]

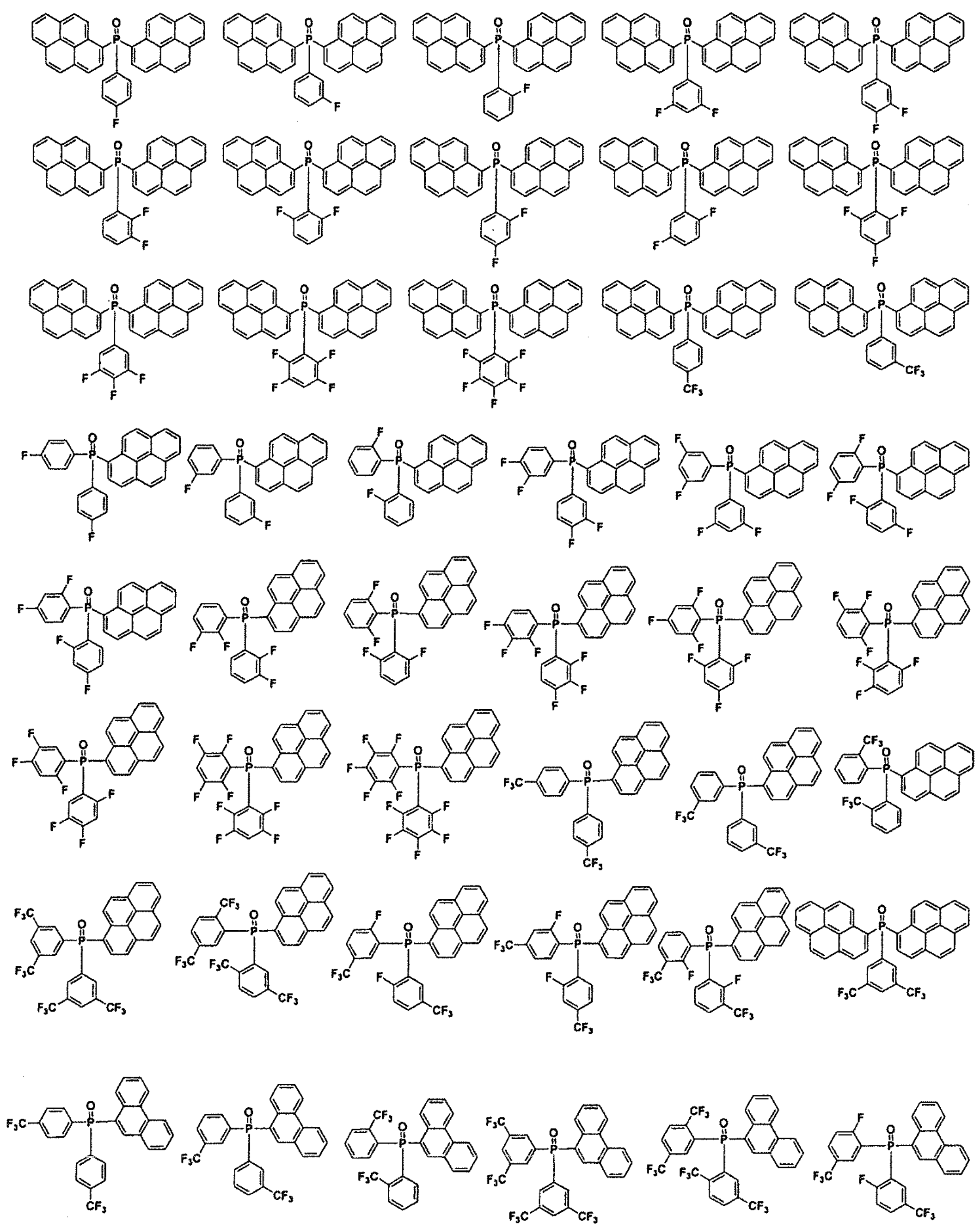

[Chem 33]

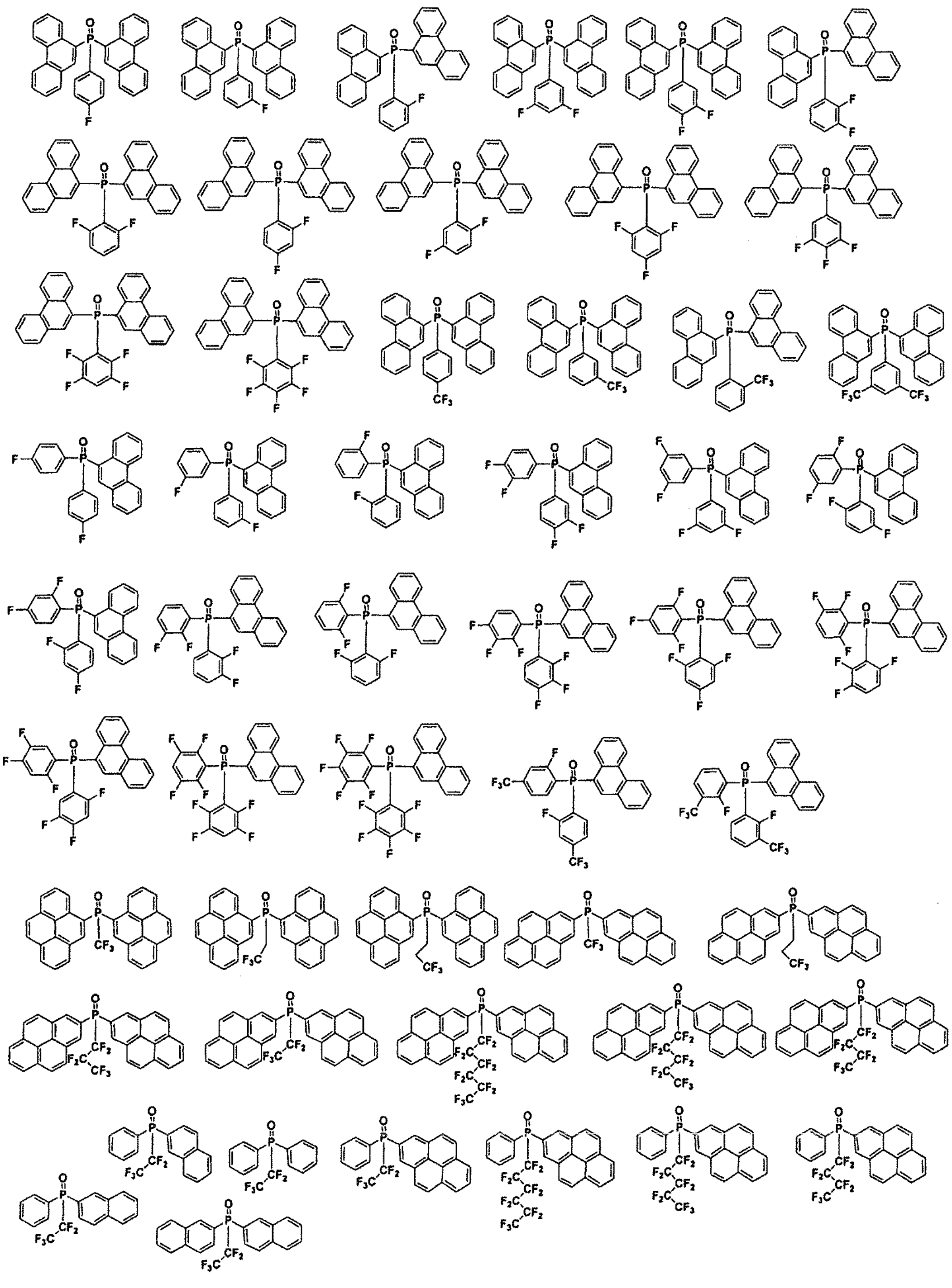

[Chem 34]

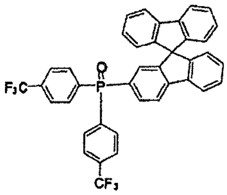 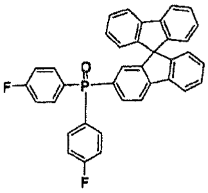 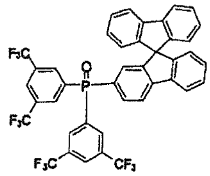 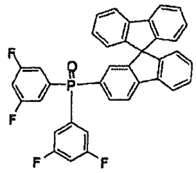

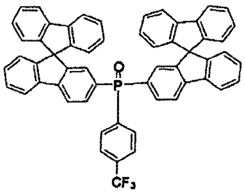 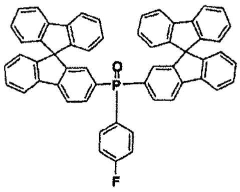 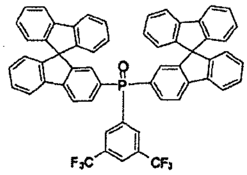 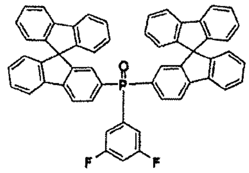

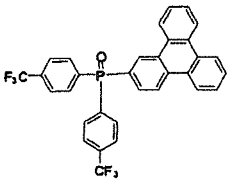 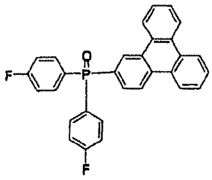 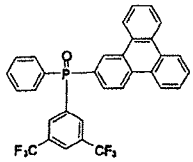 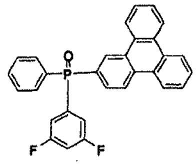

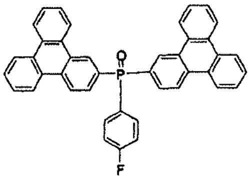 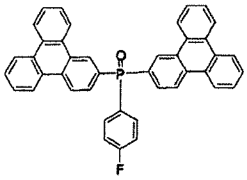 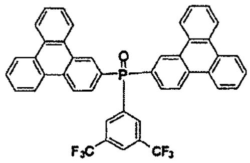 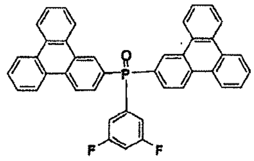

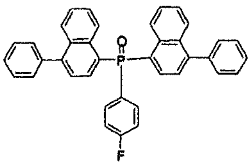 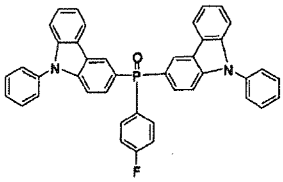 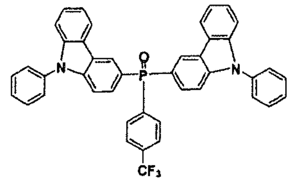 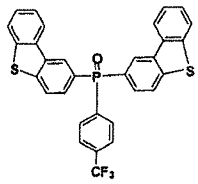

[Chem 35]

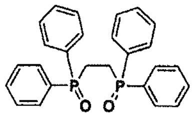
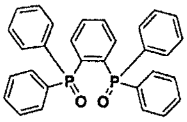
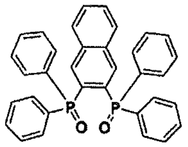
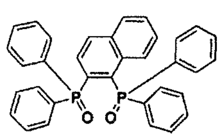
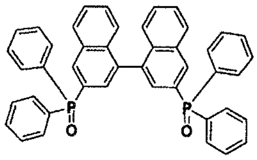
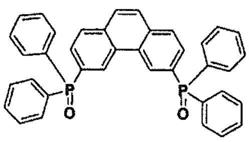
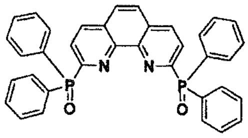
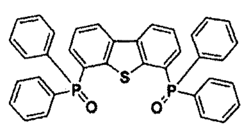
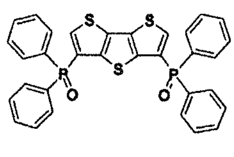
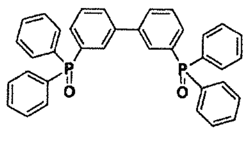
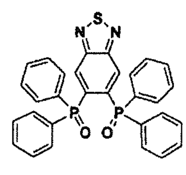
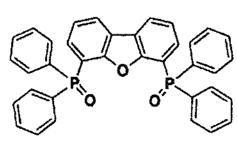
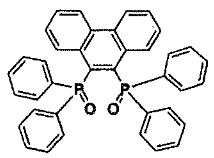
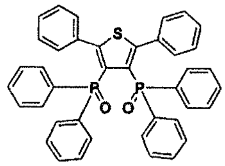
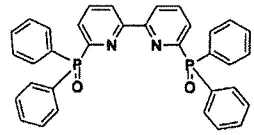
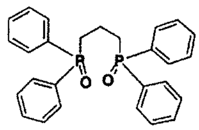
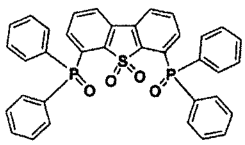
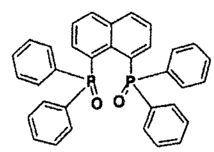
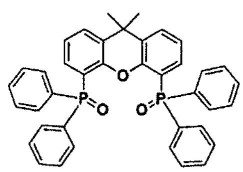
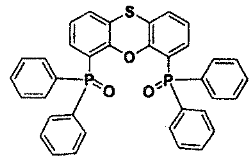
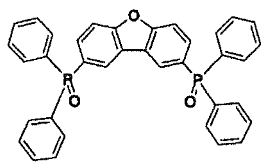
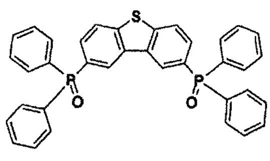
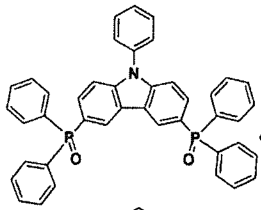
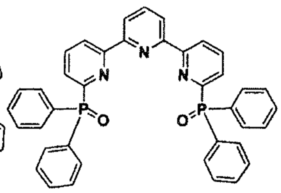
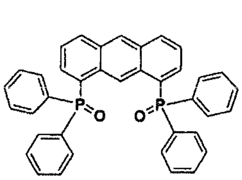
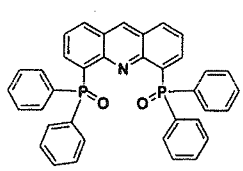
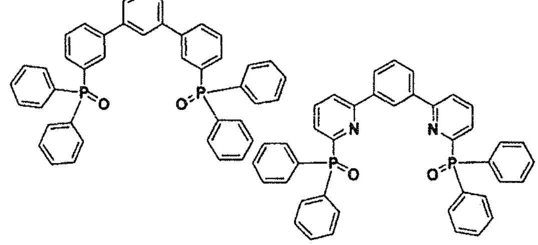

[Chem 36]

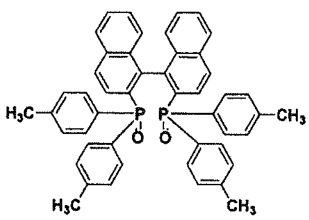
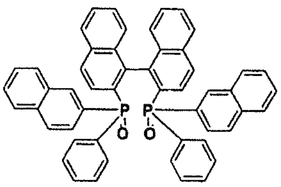
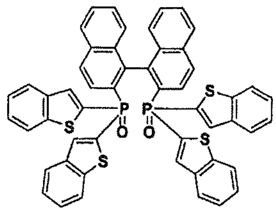
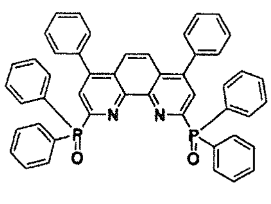
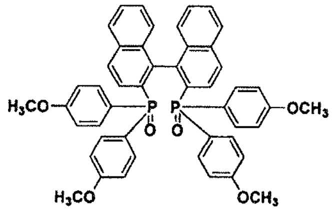
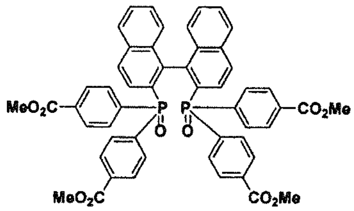
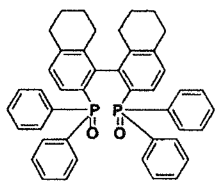
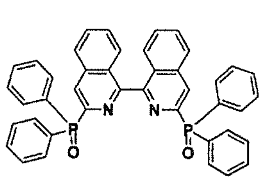
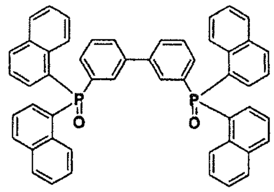
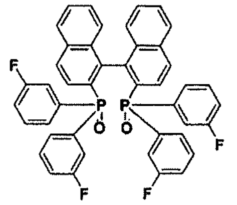
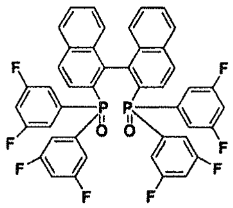
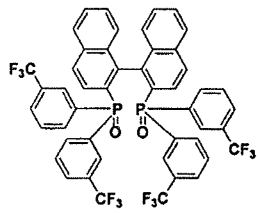
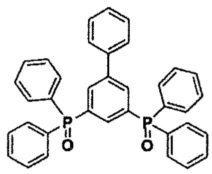
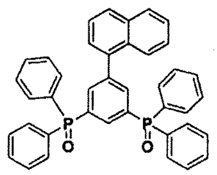
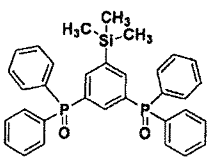
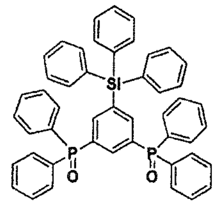
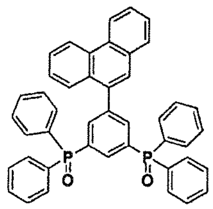
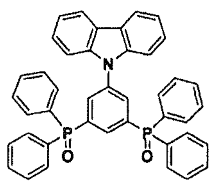
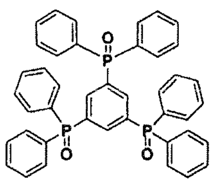
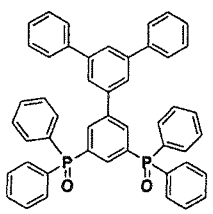
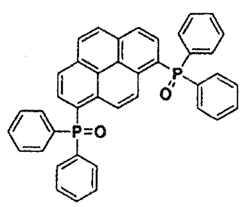
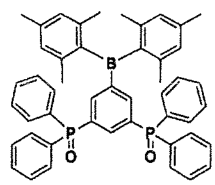

[Chem 37]

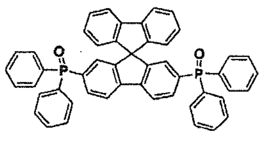
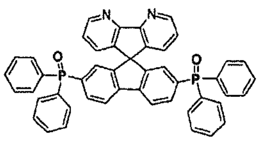
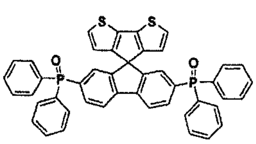
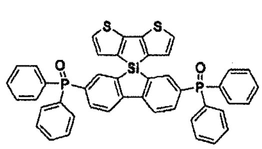
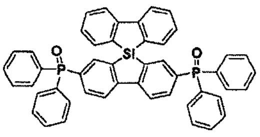
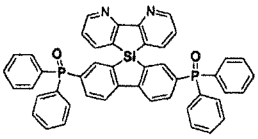
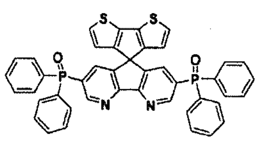
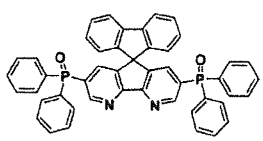
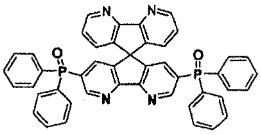
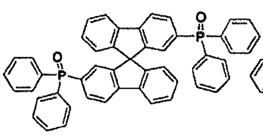
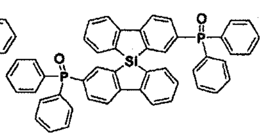
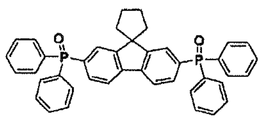
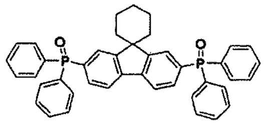
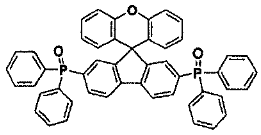
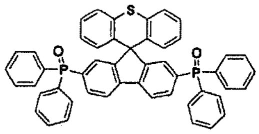
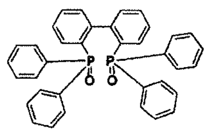
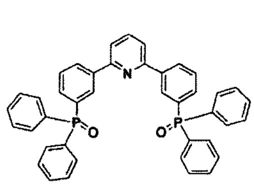
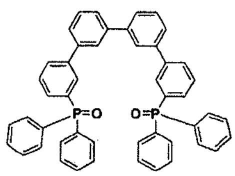
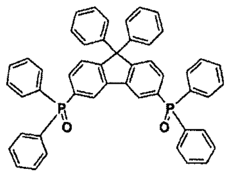
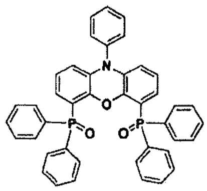
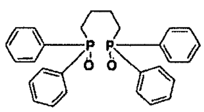
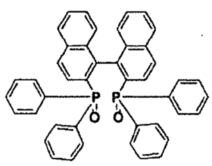
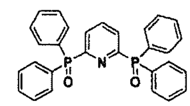
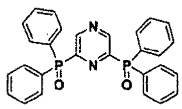
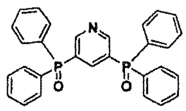
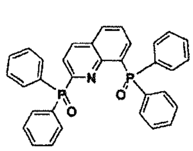
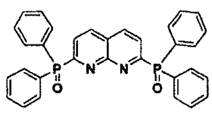
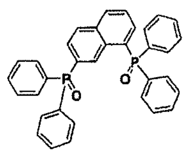
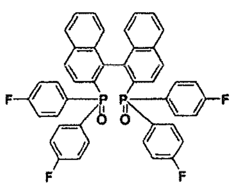
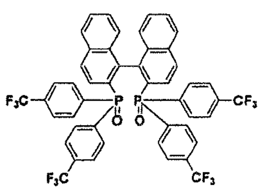
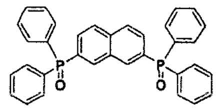
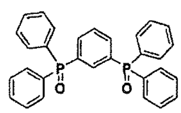
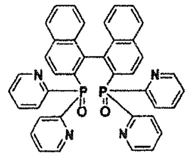

[Chem 38]

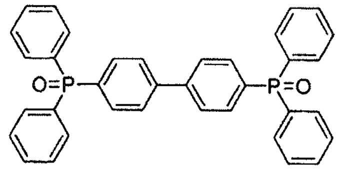
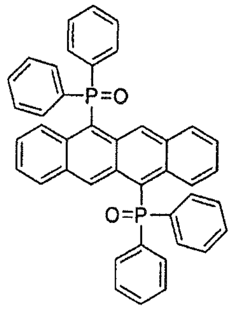
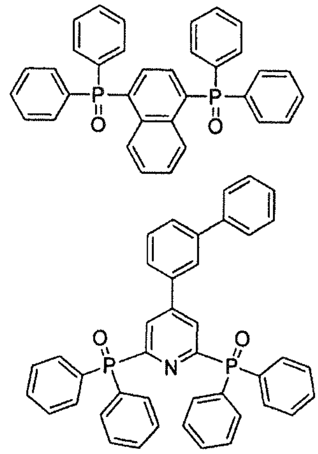
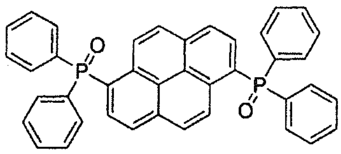
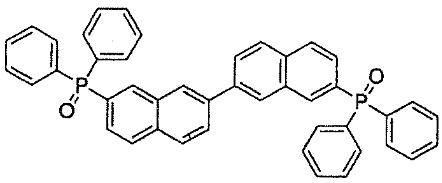
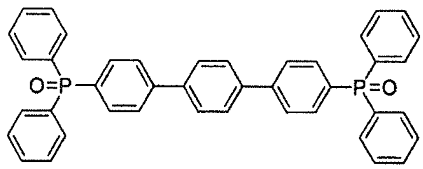
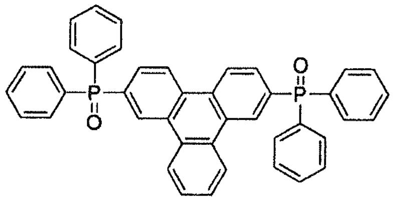
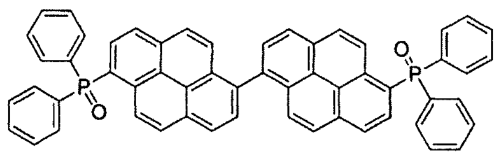
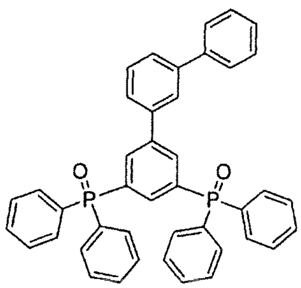
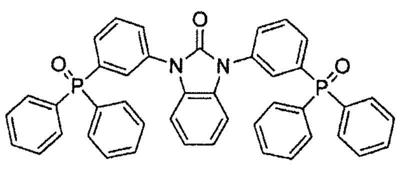
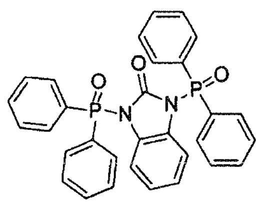
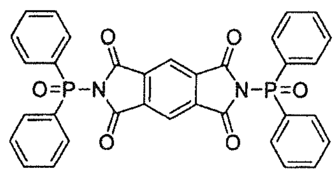
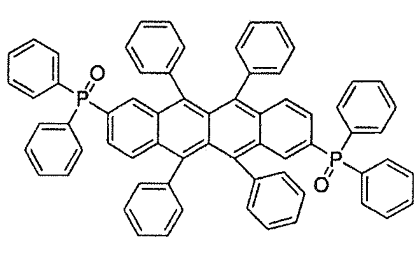

[Chem 39]

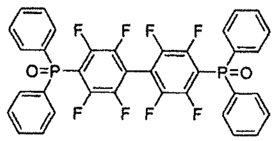
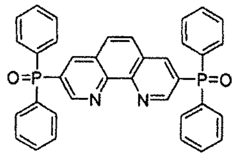
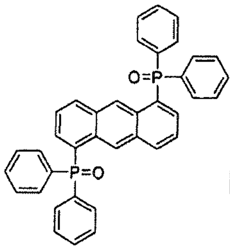
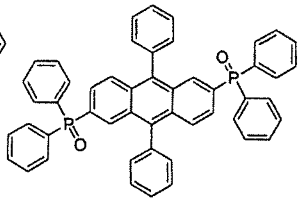
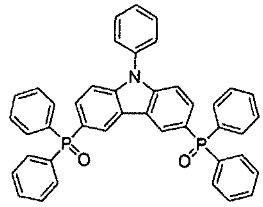
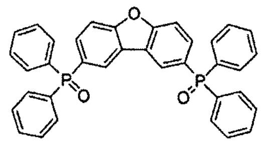
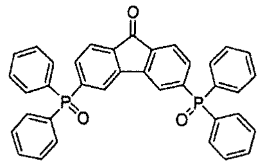
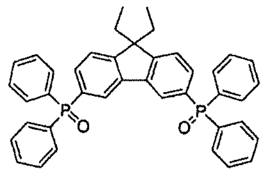
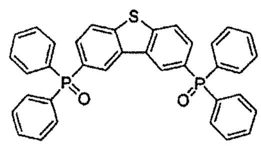
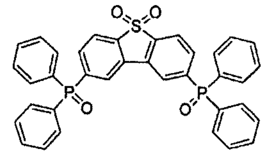
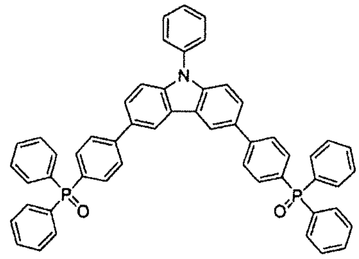
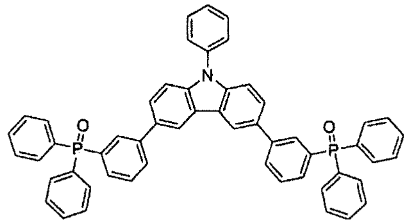
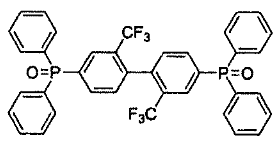
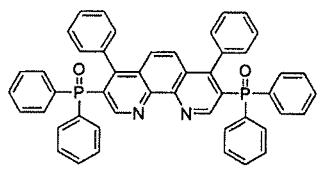
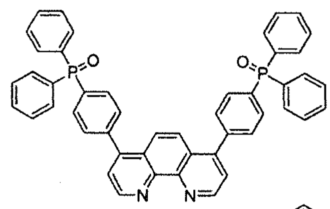
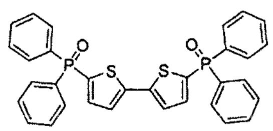
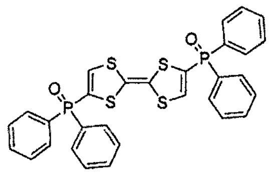
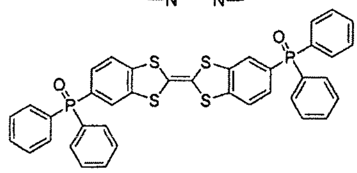
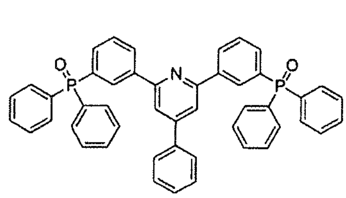
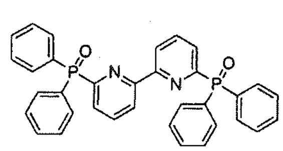
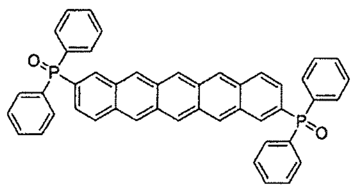

[Chem 40]

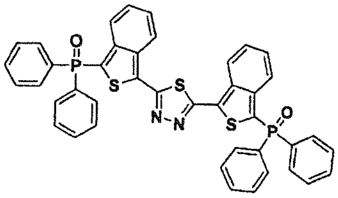
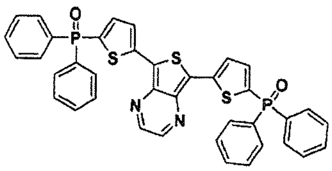
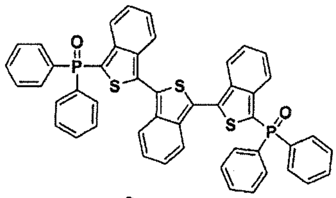
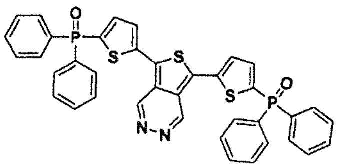
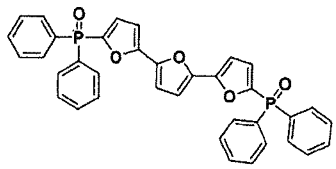
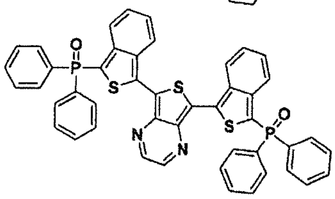
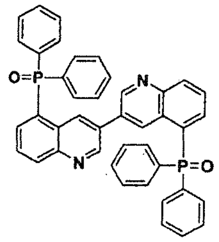
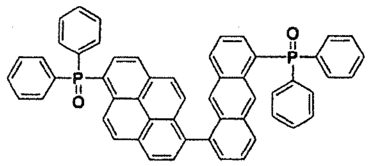
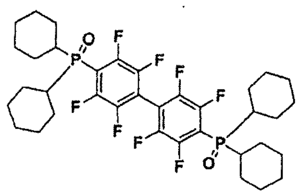
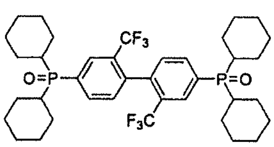
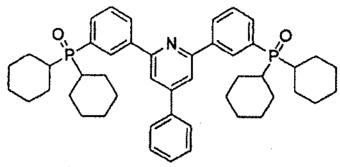
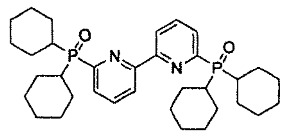
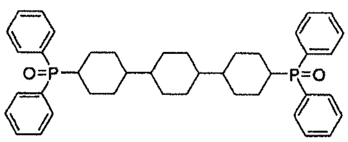
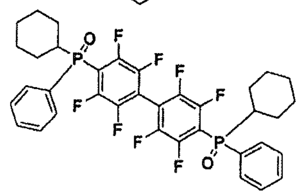

[Chem 41]

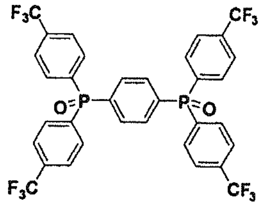
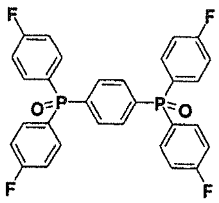
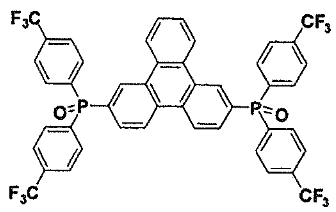
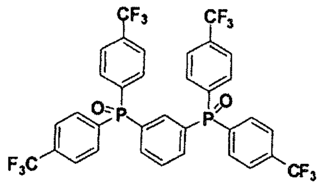
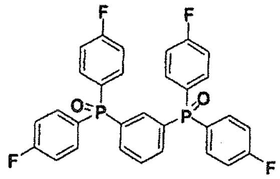
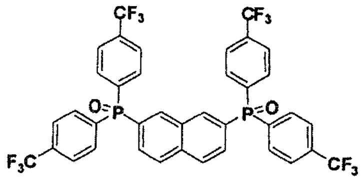
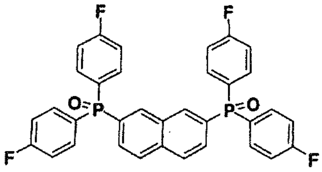
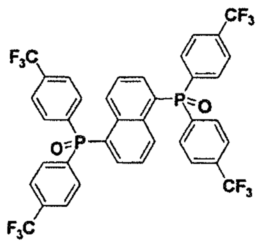
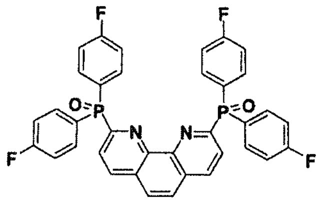
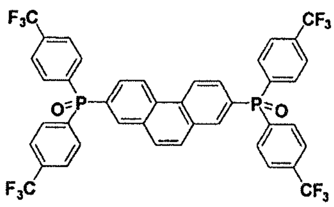
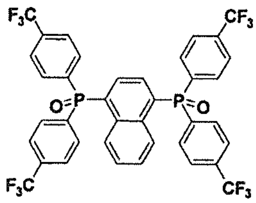
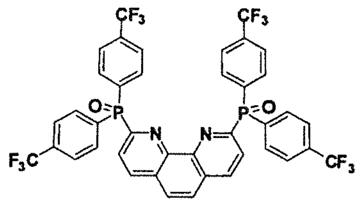
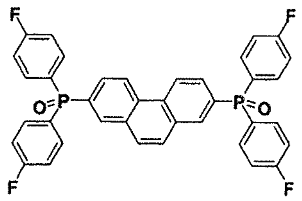
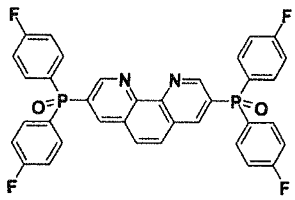
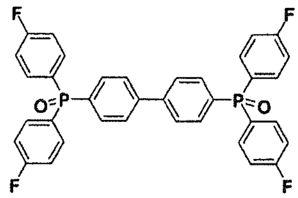
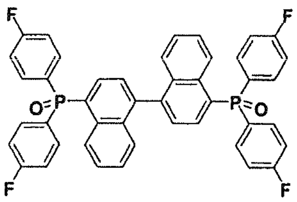
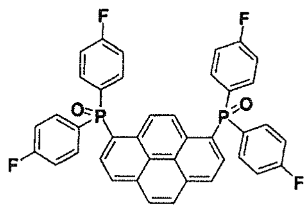
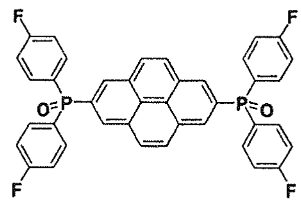

[Chem 42]

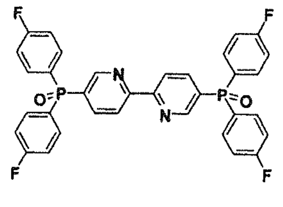

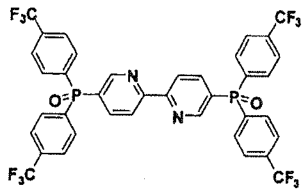

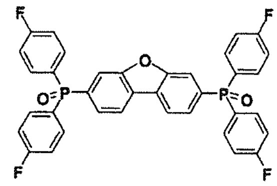

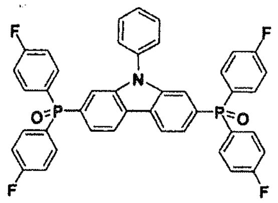

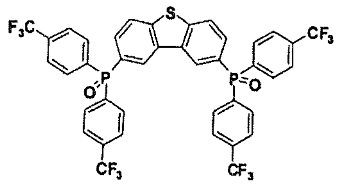

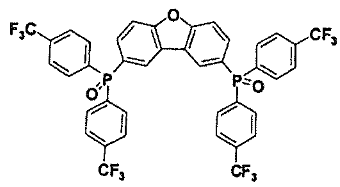

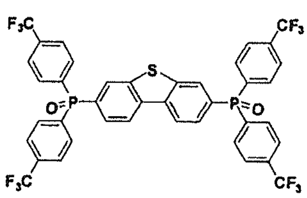

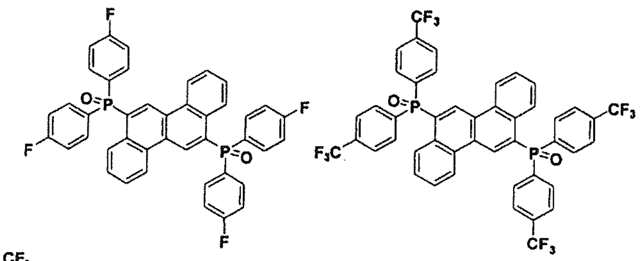

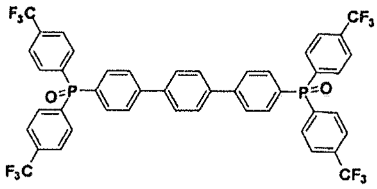

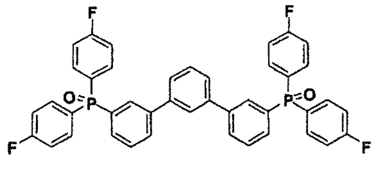

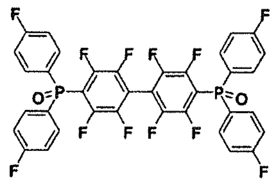

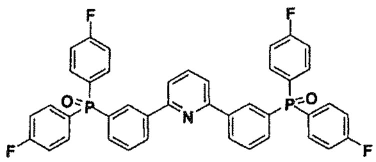

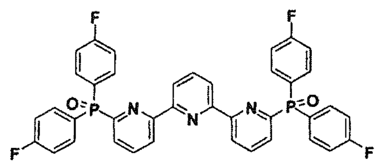

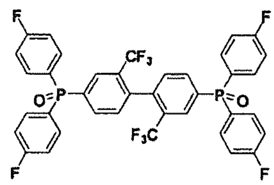

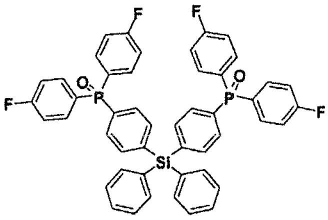

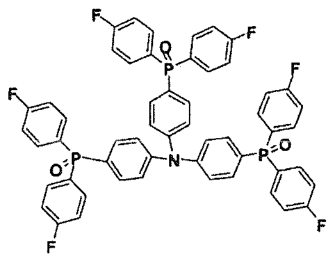

[Chem 43]

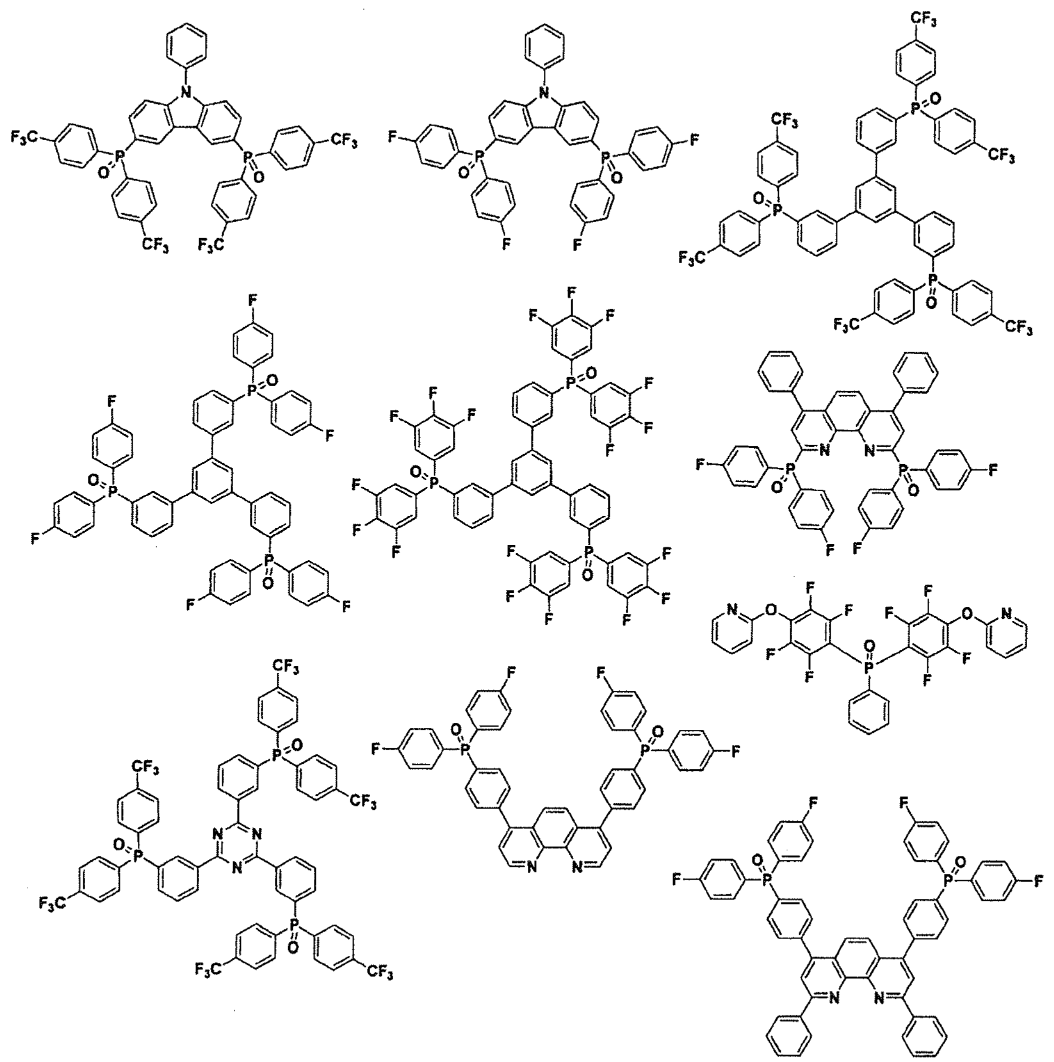

[Chem 44]

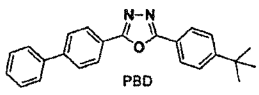
PBD
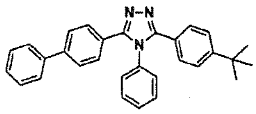
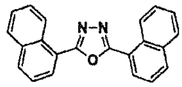
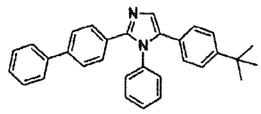
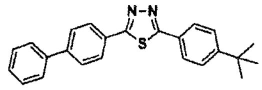
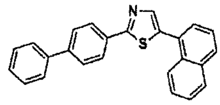
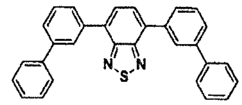
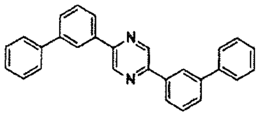
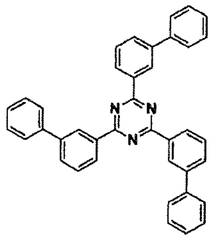
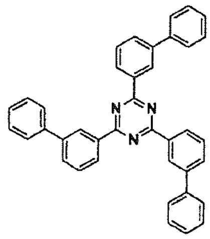
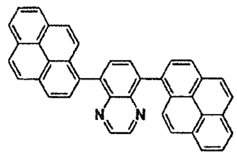
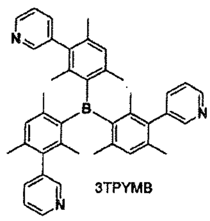
3TPYMB
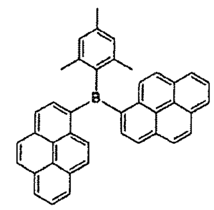
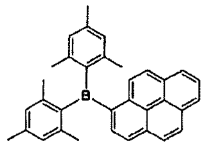
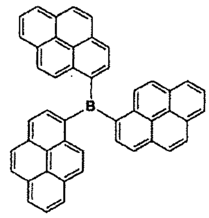
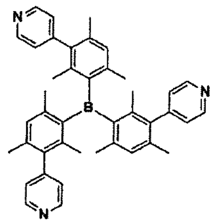
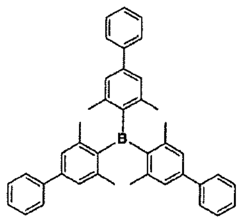
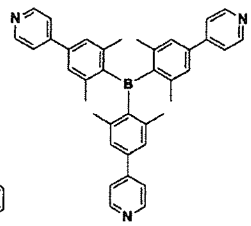
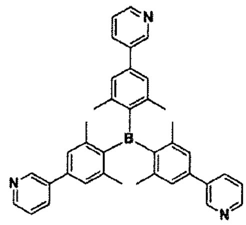
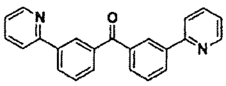
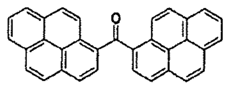
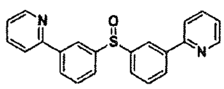
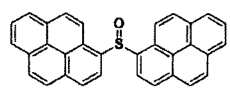

<Process for producing buffer material>

The process for producing a compound to be a starting material for the compound represented by the above general formula (I) is not particularly limited. For example, with regard to one of the compounds represented by the general formula (II), the compound represented by the general formula (II) can be obtained by obtaining P-$R^3R^4R^5$ according to the following scheme described in Synthesis 2006, 2, 354 and subsequently reacting the resulting compound with an oxidizing agent such as hydrogen peroxide.

[Chem 45]

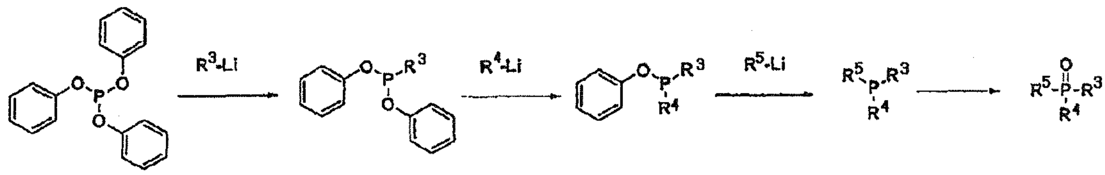

A phosphine compound in which $R^3$ and $R^4$ are the same can be specifically produced also by the following scheme.

[Chem 46]

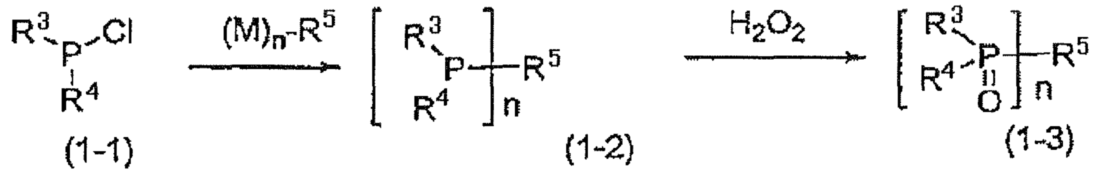


(1-1) (1-2) (1-3)

Namely, (1-2) can be obtained by reacting an aryl dihalide with a metal reagent such as butyllithium or magnesium to synthesize a metal compound: (M)n-$R^3$ and subsequently reacting it with a phosphine chloride (1-1) in an organic solvent.

The above organic solvent is preferably diethyl ether, tetrahydrofuran (THF), or the like. Moreover, the reaction temperature for the above reaction varies depending on the metal reagent used, but is preferably -78°C to 110°C.

Then, the compound represented by the formula (1-3) can be obtained by reacting the compound represented by the formula (1-2) obtained by the above reaction with hydrogen peroxide in an organic solvent. Moreover, the compound represented by the formula (1-4) can be obtained by reacting the compound represented by the formula (1-2) with sulfur in an organic solvent.

Incidentally, as the above organic solvent, acetone, tetrahydrofuran (THF), dichloromethane, and the like are preferred. Moreover, the reaction temperature for the above reaction varies depending on the organic solvent used, but is preferably 0°C to 110°C.

Furthermore, among the compounds represented by the general formula (I), a compound in which E is an oxadiazole group can be synthesized by the method described in Journal of the American Chemical Society (1955), 77, 1850-2 without particular limitation. Also, a compound in which E is boron (B) can be synthesized by the method described in Journal of Organic Chemistry (1986), 51 (4), 427-32 without particular limitation.

As the buffer layer, a hole collection layer and an electron collection layer may be mentioned. The phosphine oxide compound of the invention can be used in either layer. Preferred is an electron collection layer.

Among the compounds represented by the general formula (II), compounds soluble in a polar solvent may be mentioned. Without particular limitation, a compound represented by the following general formula (IX) is preferred.

[Chem 47]

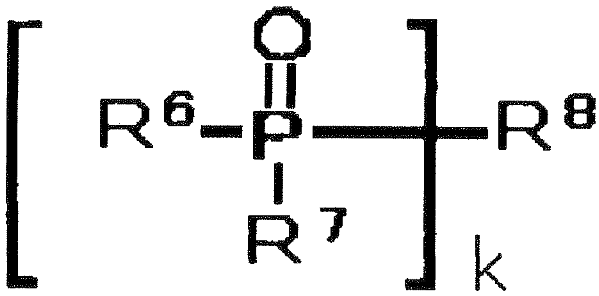

(IX)

In the general formula (IX), k represents an integer of 2 or more and is preferably 2 or more. Moreover, the upper limit thereof is not particularly limited but it is preferably 5 or less and more preferably 4 or less.

$R^6$ to $R^7$ each independently represent an aromatic group which may have a substituent, and the aromatic rings of $R^6$ to $R^7$ have the same meanings as in the case of the aromatic rings of the above $R^1$ and $R^2$. $R^6$ to $R^7$ are preferably the same.

$R^8$ is a divalent or higher valent aromatic ring group in which the total number of the rings is 3 or more. $R^8$ has

a ring valency of 5 or less, more preferably 4 or less. Moreover, the total number of the rings in $R^8$ is preferably 8 or less and more preferably 6 or less. Incidentally, the valency of $R^8$ is the same as k.

Furthermore, $R^8$ is preferably a substituent composed of an aromatic group in which the total number of the rings is 3 or more, which may have a substituent. The aromatic group in which the total number of the rings is 3 or more is preferably an aromatic hydrocarbon group or an aromatic heterocyclic group in which aromatic carbon rings and aromatic heterocyclic rings are linked singly or they are linked mutually or through an alkylene group, a silylene group, an amino group, an oxygen atom, a sulfur atom, and the like and in which the total number of the rings is 3 or more.

Examples of the aromatic carbon ring include a benzene ring, a naphthalene ring, an azulene ring, a biphenylene ring, an acenaphthylene ring, a fluorene ring, a phenanthrene ring, an anthracene ring, a fluoranthene ring, a triphenylene ring, a pyrene ring, a chrysene ring, a naphthacene ring, a perylene ring, a pentacene ring, and the like.

Examples of the aromatic heterocyle include an aromatic heterocycle having one oxygen atom, an aromatic heterocycle having one nitrogen atom, an aromatic heterocycle having two nitrogen atoms, an aromatic heterocycle having three nitrogen atoms, an aromatic heterocycle having two sulfur atoms, an aromatic heterocycle having an oxygen atom and a nitrogen atom, an aromatic heterocycle having a sulfur atom and a nitrogen atom, an aromatic heterocycle having a sulfur atom and an oxygen atom, and the like.

Examples of the aromatic heterocycle having one oxygen atom include a furan ring, a benzofuran ring, a dibenzofuran ring, a xanthene ring, and the like. Examples of the aromatic heterocycle having one nitrogen atom include a pyrrole ring, an indole ring, an indolidine ring, a carbazole ring, a pyridine ring, a quinoline ring, an isoquinoline ring, an acridine ring, a phenanthridine ring, a phenanthroline ring, and the like. Examples of the aromatic heterocycle having two nitrogen atoms include an imidazole ring, a pyrazole ring, a pyrimidine ring, a pyrazine ring, a quinoxaline ring, and the like. Examples of the aromatic heterocycle having three nitrogen atoms include triazine ring and the like.

Examples of the aromatic heterocycle having one sulfur atom include a thiophene ring, a benzothiophene ring, a dibenzothiophene ring, and the like. Examples of the aromatic heterocycle having two sulfur atoms include thianthrene ring and the like. Examples of the aromatic heterocycle having an oxygen atom and a nitrogen atom include an oxazole ring, an oxadiazole ring, a phenoxazine ring, and the like. Examples of the aromatic heterocycle having a sulfur atom and a nitrogen atom include a thiazole ring, a thiadiazole ring, a phenothiazine ring, and the like. Examples of the aromatic heterocycle having a sulfur atom and an oxygen atom include phenoxthine and the like.

As $R^8$, the following may be preferably mentioned. However, it is not limited thereto unless it exceeds the gist of the invention. Also, in $R^8$, the position of the atom which bonds to P is not particularly limited.

[Chem 48]

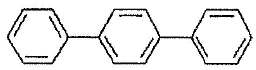
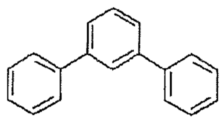
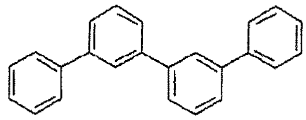

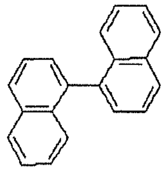
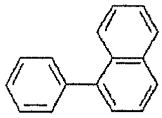
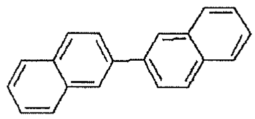
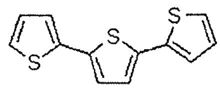

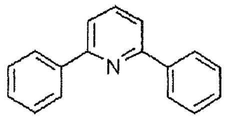
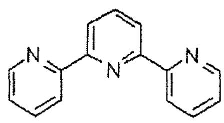
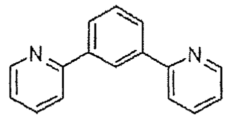
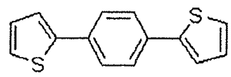

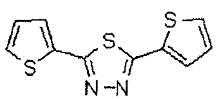
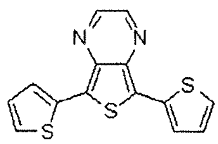
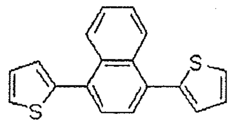
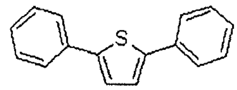

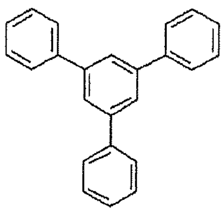
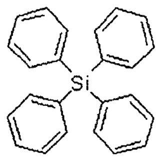
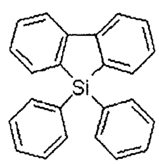
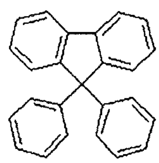

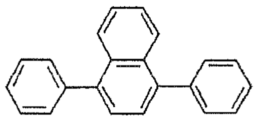
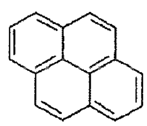

Among the phosphine compounds represented by the general formula (IX), preferred specific examples capable of being dissolved in a polar solvent include those exemplified below. However, the compound is not limited thereto unless it exceeds the gist of the invention.

[Chem 49]

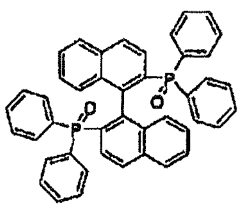
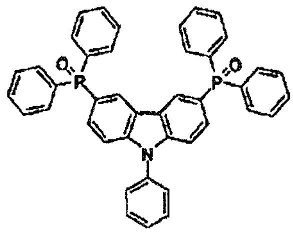
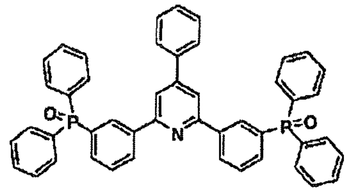
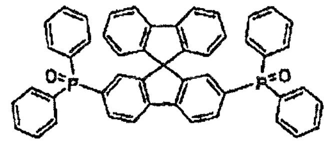
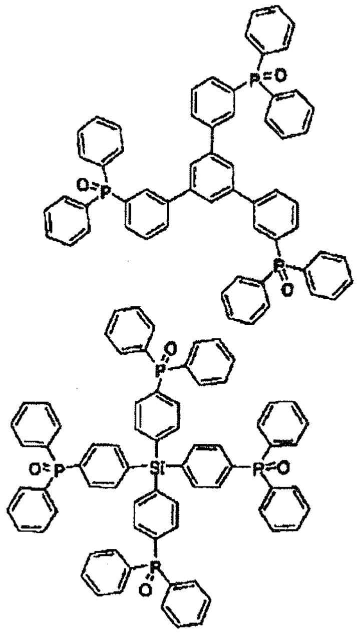
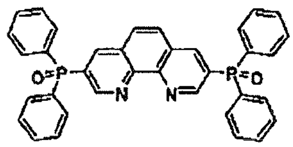
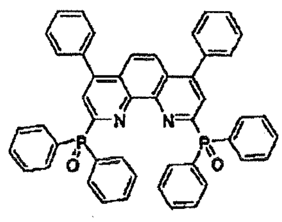
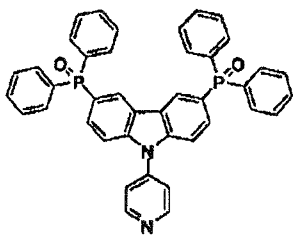
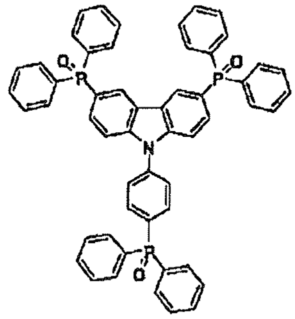
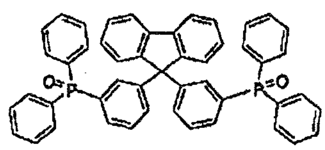
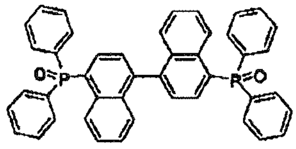
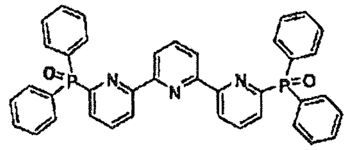
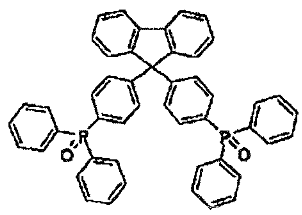
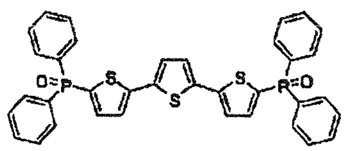
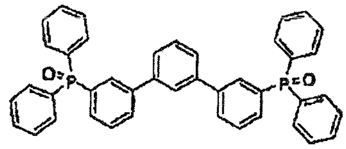
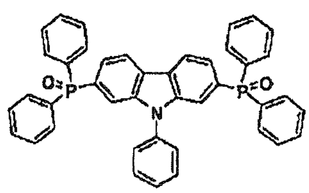

<Ink>

The ink of the invention contains a compound represented by the general formula (IX) and having a glass transition temperature of 90°C or higher and a polar solvent. The polar solvent is not particularly limited but preferably has a solubility parameter of 9.5 or more. The parameter is more preferably 10.0 or more and more preferably 11.0 or more.

Examples of the solvent include acetone (10.0), isopropanol (11.5), acetonitrile (11.9), dimethylformamide (12.0), acetic acid (12.6), ethanol (12.7), ethylene glycol (14.2), methanol (14.5), water (23.4), and the like. In this regard, the value in parenthesis is the solubility parameter of each solvent.

The content of the compound of the general formula (VI) in the ink is not particularly limited but is preferably 0.01% by weight, further preferably 0.02% by weight, and more preferably 0.05% by weight. By controlling the content to 0.01% by weight or more, problems such as precipitation of the compound owing to short pot-life of the ink can be prevented. The upper limit thereof is not particularly limited.
The ink may contain other ingredients. The other ingredients include polymers such as poly-3-hexylthiophene (P3HT), fullerene derivatives such as [6,6]phenyl-C61-butyric acid methyl ester (PCBM), n-type semiconductors explained below, such as perylenediimide and naphthalenediimide, and inorganic alkoxides such as $Ti(OR)_3$, $SiOR_4$, and $Al(OR)_4$.
The content of the other ingredients is preferably 0.1% by weight or more, more preferably 0.2% by weight or more, further preferably 0.3% by weight or more and preferably 40% by weight or less, more preferably 30% by weight or less.

<Glass transition temperature of ink>

The glass transition temperature of the compound represented by the above general formula (IX) is preferably 90°C or higher, more preferably 100°C or higher, and further preferably 110°C or higher. Moreover, it is preferably 500°C or lower, more preferably 450°C or lower, and further preferably 430°C or lower. By controlling the glass transition temperature to 90°C, problems such as crystallization can be prevented at the preparation of a layer formed using the present ink, such as a device. Moreover, by controlling the glass transition temperature to 500°C or lower, it becomes easy to dissolve the compound in a polar solvent and it can be prevented to damage a lower layer thereof at the preparation of a layer formed using the present ink.
The glass transition temperature may be measured by a known method and, for example, DSC method may be mentioned. The DSC method is a method of measuring thermophysical properties (differential scanning calorimetry) defined in JIS K-0129 "Netsu Bunseki Tsuusoku". The glass transition temperature in an amorphous solid state of an organic material is a temperature at which a molecular movement is started from a grass state thereof and can be measured by DSC as a temperature at which specific heat changes. In order to more clearly determine the glass transition temperature, it is preferred to measure the glass transition temperature after a sample once heated to a temperature higher than the glass transition temperature is rapidly cooled.

(Electron collection layer)

Into the electron collection layer, an alkali metal or an alkaline earth metal may be doped in addition to the materials of the invention.
The film thickness of the electron collection layer is not particularly limited but is preferably 0.01 nm or more. Moreover, it is preferably 50 nm or less, more preferably 40 nm or less, further preferably 30 nm or less, and particularly preferably 20 nm or less. By controlling the film thickness to 50 nm or less, difficulty in electron collection is prevented and thus a problem of decreasing the photoelectric conversion efficiency can be prevented. Moreover, by controlling the film thickness to 0.01 nm or more, a problem that the layer does not play a function as a buffer material can be presented.

(Hole collection layer)

The material of the hole collection layer is not particularly limited and, as long as it is a material capable of improving hole collection efficiency from the active layer to the electrode, it is not particularly limited. Specifically, conductive polymers such as polythiophene, polypyrrole, polyacetylene, triphenylenediaminepolypyrrole, and polyaniline to which sulfonic acid and iodine are doped, polythiophene derivatives having a sulfonyl group as a substituent, conductive organic compounds such as arylamine, aforementioned p-type semiconductors, and the like may be mentioned.
Of these, a conductive polymer doped with a sulfonic acid is preferred and PEDOT/PSS which is a polythiophene derivative doped with polystyrenesulfonic acid is more preferred. Moreover, a thin film of a metal such as gold, indium, silver, or palladium can be also used. Furthermore, the thin film of the metal or the like may be formed singly or can be simultaneously used in combination with the above organic materials.
The film thickness of the hole collection layer is not particularly limited but is usually preferably 10 nm or more and more preferably 30 nm or more. On the other hand, it is usually preferably 200 nm or less. By controlling the film thickness of the hole collection layer of the hole collection layer to 10 nm or more, homogeneity becomes sufficient and short circuit becomes difficult to occur.
In general, poly(3,4-ethylenedioxythiophene)poly(styrenesulfonic acid) (PEDOT:PSS) is used as a hole collection layer on the transparent electrode (ITO) surface. The compound contributes to improvement of cell properties such as photoelectric conversion efficiency but PEDOT:PSS is poor in stability against heat and light and structural destruction occurs with heat and light irradiation. A decomposition ingredient of PEDOT:PSS diffuses to the electron

collection electrode (Al) side and there is a possibility of inviting destabilization of performance and short circuit. Although the mechanism of action is not yet clear, it is considered as one primary factor that the electron collection layer having a phosphine oxide compound of the invention blocks migration of the decomposition ingredient of PEDOT:PSS to the electrode (Al) side to thereby improve durability and the like.

The hole collection layer and the electron collection layer are disposed so as to sandwich the active layer between one pair of electrodes. Namely, in the case where the photoelectric conversion device according to the invention contains both of the hole collection layer and the electron collection layer, the electrode, the hole collection layer, the active layer, the electron collection layer, and the electrode are disposed in this order.

In the case where the photoelectric conversion device according to the invention contains the electron collection layer and does not contain the hole collection layer, the electrode, the active layer, the electron collection layer, and the electrode are disposed in this order. The hole collection layer and the electron collection layer may be reversed in the lamination order. Moreover, at least one of the hole collection layer and the electron collection layer may be composed of a plurality of different films.

Methods for forming the hole collection layer and the electron collection layer are not limited. For example, in the case where a material having sublimability is used, the layers can be formed by vacuum deposition or the like. Moreover, for example, in the case where a material soluble in a solvent is used, they can be formed by a wet coating method such as spin coating or ink jet or the like.

In the case where a semiconductor material is used in the hole collection layer, a precursor may be converted to the semiconductor material after a layer is formed using the precursor, as in the case of a small molecule compound of the active layer.

With regard to the photoelectric conversion device of the invention, in order to improve the conversion efficiency, the photoelectric conversion device may be laminated. Moreover, after the photoelectric conversion device is formed, the device may be subjected to annealing treatment in the temperature range of 50°C to 250°C.

(Semiconductor layer)

The photoelectric conversion device according to the invention is **characterized in that** the active layer (hereinafter sometimes expressed as a semiconductor layer) contains a compound having a solubility in toluene of 0.5% by weight or more at 25°C and having an electron mobility of $1.0\times10^{-6}$ $cm^2/Vs$ or more as an n-type semiconductor. The active layer contains a p-type semiconductor and an n-type semiconductor. In the photoelectric conversion device, light is absorbed in the active layer, electricity is generated at the interface between the p-type semiconductor and the n-type semiconductor, and the generated electricity is taken out from the electrodes.

<n-type semiconductor>

The n-type semiconductor is **characterized in that** the compound having a solubility in toluene of 0.5% by weight or more at 25°C and having an electron mobility of $1.0\times10^{-6}$ $cm^2/Vs$ or more is used. The solubility of the compound in toluene at 25°C is preferably 0.6% by weight or more and more preferably 0.7% by weight or more. On the other hand, it is usually preferably 90% by weight or less, more preferably 80% by weight or less, and further preferably 70% by weight or less. By controlling the solubility of the compound in toluene at 25°C to 0.5% by weight or more, dispersion stability of the n-type semiconductor material in a solvent is improved and aggregation, precipitation, separation, and the like are difficult to occur, so that the case is preferred.

The electron mobility of the compound is preferably $1.0\times10^{-5}$ $cm^2/Vs$ or more, more preferably $5.0\times10^{-5}$ $cm^2/Vs$ or more, and further preferably $1.0\times10^{-4}$ $cm^2/Vs$ or more. On the other hand, the upper limit thereof is not particularly limited. By controlling the electron mobility of the compound to $1.0\times10^{-6}$ $cm^2/Vs$ or more, the electron diffusion rate, short-circuit current, and conversion efficiency of the photoelectric conversion device are improved, so that the case is preferred.

The electron mobility can be, for example, measured by the IV property of a field-effect transistor (FET), a time-of-flight method, or the like.

The n-type semiconductor is not particularly limited so long as it has the above performance but there may be mentioned fullerene compounds, condensed ring tetracarboxylic diimides such as N-alkyl-substituted naphthalenetetracarboxylic diimide and N-alkyl-substituted perylenetetracarboxylic diimide, perinone derivatives, benzimidazole derivatives, benzoxazole derivatives, benzothiazole derivatives, benzothiadiazole derivatives, oxadiazole derivatives, thiadiazole derivatives, thiazole derivatives, triazole derivatives, aldazine derivatives, pyrazine derivatives, phenanthroline derivatives, quinoxaline derivatives, benzoquinoline derivatives, bipyridine derivatives, borane derivatives, and the like. Moreover, there may be mentioned n-type polymers containing them as constituting units.

Of these, borane derivatives, thiazole derivatives, benzotiazole derivatives, benzothiadiazole derivatives, fullerene compounds, N-alkyl-substituted naphthalenetetracarboxylic diimide and N-alkyl-substituted perylenetetracarboxylic

diimide, and polymers using them as constituting units are preferred, and fullerene compounds, N-alkyl-substituted perylenetetracarboxylic diimide derivatives and N-alkyl-substituted naphthalenetetracarboxylic diimide, and n-type polymers using them as constituting units are more preferred. One or more kinds of these compounds may be contained.

<Fullerene compound>

The fullerene compound of the invention is a fullerene having one or more additional groups represented by the general formula (n1).

[Chem 50]

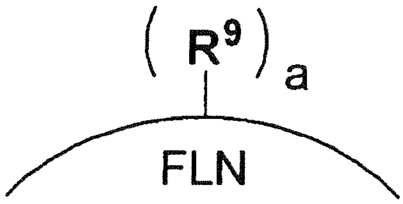

(n1)

In the general formula (n1), a is usually preferably an integer of 1 to 10 and more preferably an integer of 2 to 6. In the case where a plurality of the additional groups are present, they may be the same or different and may form a ring directly or through a substituent, but one in which all the additional groups are hydrogen is not included. In the case where a plurality of the additional groups are present, isomers may be present depending on the position to be added and a single isomer may be used or a mixture of a plurality of isomers may be used.

The fullerene (FLN) according to the invention is a carbon cluster having a closed shell structure. The number of carbon atoms may be any one so long as it is usually an even number of 60 to 130. Examples of the fullerene include $C_{60}$, $C_{70}$, $C_{76}$, $C_{78}$, $C_{82}$, $C_{84}$, $C_{90}$, $C_{94}$, and $C_{96}$, as well as higher carbon clusters having larger number of carbon atoms as compared with them and the like. Of these, $C_{60}$ and $C_{70}$ are preferred and $C_{60}$ is more preferred.

As the fullerene, a part of carbon-carbon bonds on the fullerene ring may be cleaved. Moreover, a part of carbon atoms may be substituted with other atoms. Furthermore, a metal atom or a non-metal atom or an atomic group composed thereof may be included in the fullerene cage.

In the general formula (n1), $R^9$ is an additional group to be added to the above fullerene. Examples thereof include a hydrogen atom, a halogen atom, an oxygen atom, a sulfur atom, a hydroxyl group, a cyano group, an amino group, an ester group, a carboxyl group, a carbonyl group, an acetyl group, a sulfonyl group, a silyl group, a boryl group, a nitrile group, an alkyl group, an alkenyl group, an alkynyl group, an alkoxy group, an aryloxy group, an alkylthio group, an arylthio group, an aromatic group, and the like.

The alkyl group is preferably an alkyl group having 1 to 20 carbon atoms and examples thereof include a methyl group, an ethyl group, an i-propyl group, an n-propyl group, an n-butyl group, a t-butyl group, an n- hexyl group, a cyclohexyl group, and the like.

The alkenyl group is preferably an alkenyl group having 2 to 20 carbon atoms and examples thereof include a vinyl group, a styryl group, a diphenylvinyl group, and the like.

The alkynyl group is preferably an alkynyl group having 2 to 20 carbon atoms and examples thereof include a methylethynyl group, a phenylethynyl group, and a trimethylsilylethynyl group, and the like.

The alkoxy group is preferably an alkoxy group having 1 to 20 carbon atoms and examples thereof include linear or branched alkoxy groups such as a methoxy group, an ethoxy group, an n-propoxy group, an i-propoxy group, an n-butoxy group, an i-butoxy group, an ethylhexyloxy group, a benzyloxy group, a t-butoxy group, and the like.

The aryloxy group is an aryloxy group having 2 to 20 carbon atoms and examples thereof include a phenoxy group and the like.

The alkylthio group is an alkylthio group having 1 to 20 carbon atoms and examples thereof include a methylthio group, an ethylthio group, and the like.

The arylthio group is an arylthio group having 2 to 20 carbon atoms and examples thereof include a phenylthio group and the like.

Examples of the amino group include alkylamino groups such as a dimethylamino group, a diethylamino group, and a diisopropylamino group, and arylamino groups such as a diphenylamino group, a ditolylamino group, and a carbazolyl group.

Examples of the silyl group include silyl groups having alkyl group(s) or aryl group(s) as substituents, such as a trimethylsilyl group, a dimethylphenyl group, and a triphenylsilyl group.

Examples of the boryl group include a dimesitylboryl group substituted with an aryl group, and the like.

The aromatic group is preferably an aromatic hydrocarbon group or an aromatic heterocyclic group.

Examples of the aromatic hydrocarbon group include a phenyl group, a naphthyl group, a phenanthryl group, a biphenylenyl group, an anthryl group, a pyrenyl group, a fluorenyl group, an azulenyl group, an acenaphthenyl group, a fluoranthenyl group, a naphthacenyl group, a perylenyl group, a pentacenyl group, a triphenylenyl group, a quaterphenyl group, and the like. Of these, a phenyl group, a naphthyl group, a phenanthryl group, an anthryl group, a pyrenyl group, a fluorenyl group, an acenaphthenyl group, a fluoranthenyl group, a perylenyl group, and a triphenylenyl group are preferred.

Examples of the aromatic heterocyclic group include a pyridyl group, a thienyl group, a furyl group, a pyrrolyl group, an oxazolyl group, a thiazolyl group, an oxadiazolyl group, a thiadiazolyl group, a pyrazinyl group, a pyrimidinyl group, a pyrazolyl group, an imidazolyl group, a benzothienyl group, a dibenzofuryl group, a dibenzothienyl group, a phenylcarbazolyl group, a phenoxathienyl group, a xanthenyl group, a benzofuranyl group, a thianthrenyl group, an indolidinyl group, a phenoxazinyl group, a phenothiadinyl group, an acridinyl group, a phenanthridinyl group, a phenanthrolinyl group, a quinolyl group, an isoquinolyl group, an indolyl group, a quinoxalinyl group, and the like. Of these, a pyridyl group, a pyrazinyl group, a pyrimidinyl group, a pyrazolyl group, a quinolyl group, an isoquinolyl group, an imidazolyl group, an acridinyl group, a phenanthridinyl group, a phenanthrolinyl group, a quinoxalinyl group, a dibenzofuryl group, a dibenzothienyl group, a phenylcarbazolyl group, a xanthenyl group, and a phenoxazinyl group are preferred.

The above additional group may further have a substituent. The substituent which may be present is not particularly limited but a halogen atom, a hydroxyl group, a cyano group, an amino group, a carboxyl group, an ester group, a carbonyl group, an acetyl group, a sulfonyl group, a silyl group, a boryl group, a nitrile group, an alkyl group, an alkenyl group, an alkynyl group, an alkoxy group, an aryloxy group, an alkylthio group, an arylthio group, an aromatic hydrocarbon group, and an aromatic heterocyclic group are preferred. They may be linked with adjacent substituents each other to form a ring.

The aromatic hydrocarbon group is preferably an aromatic hydrocarbon group having 6 to 20 carbon atoms and is not limited to a monocyclic group and may be any of a monocyclic group, a condensed polycyclic hydrocarbon group, and a ring-condensed hydrocarbon group.

Examples of the monocyclic group include a phenyl group and the like. Examples of the condensed polycyclic hydrocarbon group include a biphenyl group, a phenanthryl group, a naphthyl group, an anthryl group, a fluorenyl group, a pyrenyl group, a perylenyl group, and the like. Examples of the ring-condensed hydrocarbon group include a biphenyl group, a terphenyl group, and the like. Of these, a phenyl group and a naphthyl group are preferred.

The aromatic heterocyclic group is preferably an aromatic heterocyclic group having 2 to 20 carbon atoms and examples thereof include a pyridyl group, a thienyl group, a furyl group, an oxazolyl group, a thiazolyl group, an oxadiazolyl group, a benzothienyl group, a dibenzofuryl group, a dibenzothienyl group, a pyrazinyl group, a pyrimidinyl group, a pyrazolyl group, an imidazolyl group, a phenylcarbazolyl group, and the like. Of these, a pyridyl group, a thienyl group, a benzothienyl group, a dibenzofuryl group, a dibenzothienyl group, and a phenanthryl group are preferred.

These substituents may further have a substituent. Examples of the substituent which may be present include an aryl group, an arylamino group, an alkyl group, a perfluoroalkyl group, a halide group, a carboxyl group, a cyano group, an alkoxyl group, an aryloxy group, a carbonyl group, an oxycarbonyl group, a carboxylic acid group, an aromatic heterocyclic group, and the like.

The aryl group is preferably an aryl group having 6 to 16 carbon atoms and examples thereof include a phenyl group, a naphthyl group, a phenanthryl group, a pyrenyl group, a perylenyl group, an anthryl group, and the like.

The arylamino group is preferably an arylamino group having 12 to 30 carbon atoms and examples thereof include a diphenylamino group, a carbazolyl group, a phenylcarbazolyl group, and the like.

The alkyl group is preferably an alkyl group having 1 to 12 carbon atoms and examples thereof include a methyl group, an ethyl group, a butyl group, an isopropyl group, a t-butyl group, and the like.

The perfluoroalkyl group is preferably a perfluoroalkyl group having 1 to 12 carbon atoms and examples thereof include a trifluoromethyl group and the like.

The oxycarbonyl group is preferably an oxycarbonyl group having 1 to 10 carbon atoms and examples thereof include a methoxycarbonyl group, an ethoxycarbonyl group, and the like.

The alkoxy group is preferably an alkoxy group having 1 to 10 carbon atoms and examples thereof include a methoxy group, an ethoxy group, an ethylhexyloxy group, and the like.

The aryloxy group is preferably an aryloxy group having 6 to 16 carbon atoms and examples thereof include a phenyloxy group, and the like.

The carbonyl group is preferably a carbonyl group having 2 to 16 carbon atoms and examples thereof include an acetyl group, a phenylcarbonyl group, and the like.

The aromatic heterocyclic group is preferably an aromatic heterocyclic group having 2 to 20 carbon atoms and examples thereof include a pyridyl group, a thienyl group, an oxazolyl group, an oxadiazolyl group, a benzothienyl group, a dibenzofuryl group, a dibenzothienyl group, a pyrazinyl group, a pyrimidinyl group, a pyrazolyl group, an imidazolyl group, and the like.

In the case where an additional group or a substituent present in the additional group has coordinating ability to a metal, a metal complex may be formed through a coordination bond with a metal atom.

A preferred embodiment of the additional group is one in which fullerene has a partial structure represented by at least one of the following general formulae (n2) and (n3).

[Chem 51]

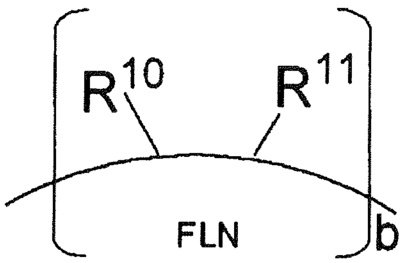

(n2)

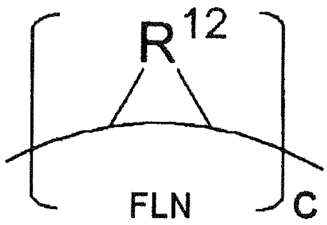

(n3)

FLN in the general formulae (n2) and (n3) represents the above fullerene. In the formulae, b and c each are an integer, and the sum of b and c is usually 1 to 5 and preferably 1 to 3. The additional group in the general formulae (n2) and (n3) is added to the same five-membered ring or six-membered ring in the fullerene skeleton.

$R^{10}$ to $R^{12}$ each independently represent an additional group to be added to the fullerene skeleton. $R^{10}$ and $R^{11}$ may form a ring directly or through a substituent. $R^{10}$ to $R^{12}$ are the same as defined in the above $R^9$.

Among the partial structures of the general formulae (n2) and (n3), preferred are partial structures represented by the general formulae (n4), (n5), (n6), and (n7).

[Chem 52]

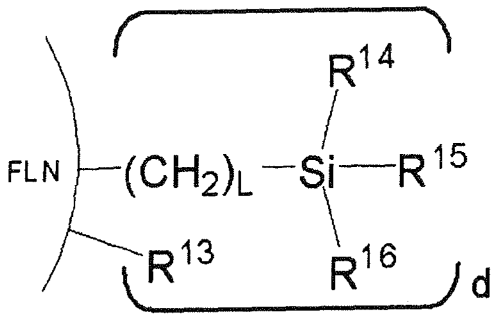

(n4)

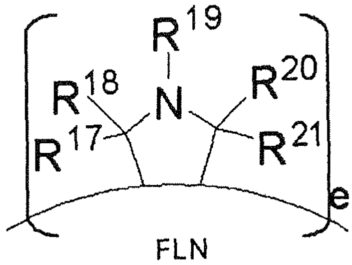

(n5)

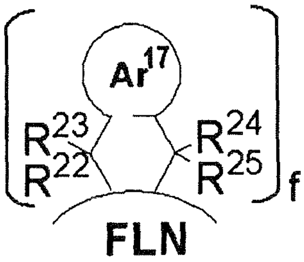

(n6)

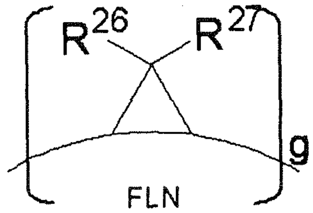

(n7)

FLN in the general formulae (n4), (n5), (n6), and (n7) represents the above fullerene. d, e, f, and g is an integer. The sum of d, e, f, and g is usually 1 to 5 and preferably 1 to 3. The additional group in (n4), (n5), (n6), and (n7) is added to the same five-membered ring or six-membered ring in the fullerene skeleton. L is an integer of 1 to 8, preferably an integer of 1 or more to 4 or less, and more preferably an integer of 1 or more to 2 or less.

$R^{13}$ in the general formula (n4) is an alkyl group having 1 to 14 carbon atoms which may have a substituent, an alkoxy group having 1 to 14 carbon atoms which may have a substituent, or an aromatic group which may have a substituent.

The alkyl group is preferably an alkyl group having 1 to 10 carbon atoms, more preferably a methyl group, an ethyl group, an n-propyl group, an isopropyl group, an n-butyl group, or an isobutyl group, and particularly preferably a methyl group or an ethyl group.

The alkoxy group is preferably an alkoxy group having 1 to 10 carbon atoms, more preferably an alkoxy group having 1 to 8 carbon atoms, further preferably an alkoxy group having 1 to 6 carbon atoms, and particularly preferably a methoxy group or an ethoxy group.

The aromatic group is preferably an aromatic hydrocarbon group having 6 to 20 carbon atoms or an aromatic heterocyclic group having 2 to 20 carbon atoms, preferably a phenyl group, a thienyl group, a furyl group, or a pyridyl group, and further preferably a phenyl group or a thienyl group.

The substituent with which the above alkyl group may be substituted is a halogen atom or a silyl group. The halogen atom with which the alkyl group is substituted is preferably a fluorine atom.

The silyl group is preferably a diarylalkylsilyl group, a dialkylarylsilyl group, a triarylsilyl group, or a trialkylsilyl group, more preferably a dialkylarylsilyl group, and further preferably a dimethylarylsilyl group.

$R^{14}$ to $R^{16}$ in the general formula (n4) each represent an independent substituent and are a hydrogen atom, an alkyl group having 1 to 14 carbon atoms which may have a substituent, a fluorinated alkyl group having 1 to 14 carbon atoms which may have a substituent, or an aromatic group which may have a substituent.

The alkyl group is preferably an alkyl group having 1 to 10 carbon atoms and preferably a methyl group, an ethyl group, an n-propyl group, an isopropyl group, an n-butyl group, an isobutyl group, a t-butyl group, or an n-hexyl group.

The perfluoroalkyl group is preferably a perfluorooctyl group, a perfluorohexyl group, or a perfluorobutyl group.

The aromatic group is preferably an aromatic hydrocarbon group having 6 to 20 carbon atoms or an aromatic heterocyclic group having 2 to 20 carbon atoms, preferably a phenyl group, a thienyl group, a furyl group, or a pyridyl group, and further preferably a phenyl group or a thienyl group.

The substituent which the aromatic group may have is a fluorine atom, an alkyl group having 1 to 14 carbon

atoms, a fluorinated alkyl group having 1 to 14 carbon atoms, an alkoxy group having 1 to 14 carbon atoms, or an aromatic group having 3 to 10 carbon atoms, more preferably a fluorine atom or an alkoxy group having 1 to 14 carbon atoms, and further preferably a methoxy group, an n-butoxy group, or a 2-ethylhexyloxy group.

In the case where the aromatic group has a substituent, the number thereof is not limited but is preferably 1 to 3 and more preferably 1. In the case where the aromatic group has a plurality of substituents, the kind of the substituents may be different from each other but is preferably the same.

$R^{17}$ to $R^{21}$ in the general formula (n5) each independently are a hydrogen atom, an alkyl group having 1 to 14 carbon atoms which may have a substituent, or an aromatic group which may have a substituent.

The alkyl group is preferably a methyl group, an ethyl group, an n-propyl group, an isopropyl group, an n-butyl group, an isobutyl group, an n-hexyl group, or an octyl group and more preferably a methyl group.

The aromatic group is preferably an aromatic hydrocarbon group having 6 to 20 carbon atoms or an aromatic heterocyclic group having 2 to 20 carbon atoms, more preferably a phenyl group or a pyridyl group, and further preferably a phenyl group.

The substituent which the aromatic group may have is not particularly limited but is preferably a fluorine atom, an alkyl group having 1 to 14 carbon atoms, a fluorinated alkyl group having 1 to 14 carbon atoms, or an alkoxy group having 1 to 14 carbon atoms, more preferably an alkoxy group having 1 to 14 carbon atoms, and further preferably a methoxy group.

In the case where a substituent is present, the number thereof is not limited but is preferably 1 to 3, and more preferably 1. The kind of the substituent may be different but is preferably the same.

$Ar^{17}$ in the general formula (n6) is an aromatic hydrocarbon group having 6 to 20 carbon atoms which may have a substituent or an aromatic heterocyclic group having 2 to 20 carbon atoms which may have a substituent and is preferably a phenyl group, a naphthyl group, a phenanthryl group, an anthryl group, a fluorenyl group, a pyrenyl group, a perylenyl group, a biphenyl group, a terphenyl group, a thienyl group, a furyl group, a pyridyl group, a pyrimidinyl group, a quinolyl group, a quinoxalyl group, a pyrazinyl group, an imidazolyl group, a pyrazolyl group, an oxazolyl group, a thiazolyl group, an oxadiazolyl group, a pyrrolyl group, a triazolyl group, a thiadiazolyl group, a benzothienyl group, a benzofuryl group, a furfuryl group, a dibenzothienyl group, a thienothienyl group, a dibenzofuryl group, a phenanthryl group, a carbazolyl group, a benzoquinoxalinyl group, or a phenylcarbazolyl group, and further preferably a phenyl group, a thienyl group, a furyl group, a thiazolyl group, a pyrrolyl group, a triazolyl group, or a thiadiazolyl group.

The substituent which may be present is not limited but is preferably a fluorine atom, a chlorine atom, a hydroxyl group, a cyano group, a silyl group, a boryl group, an amino group which may be substituted with alkyl group(s), an alkyl group having 1 to 14 carbon atoms, a fluorinated alkyl group having 1 to 14 carbon atoms, an alkoxy group having 1 to 14 carbon atoms, an alkylcarbonyl group having 1 to 14 carbon atoms, an alkylthio group having 1 to 14 carbon atoms, an alkenyl group having 1 to 14 carbon atoms, an alkynyl group having 1 to 14 carbon atoms, an ester group, an arylcarbonyl group, an arylthio group, an aryloxy group, an aromatic hydrocarbon group having 6 to 20 carbon atoms, or a heterocyclic group having 2 to 20 carbon atoms, and more preferably a fluorine atom, an alkyl group having 1 to 14 carbon atoms, an alkoxy group having 1 to 14 carbon atoms, an ester group, an alkylcarbonyl group having 1 to 14 carbon atoms, or an arylcarbonyl group.

As the alkyl group having 1 to 14 carbon atoms, a methyl group, an ethyl group, and a propyl group are preferred. As the alkoxy group having 1 to 14 carbon atoms, a methoxy group, an ethoxy group, and a propoxyl group are preferred. As the alkylcarbonyl group having 1 to 14 carbon atoms, an acetyl group is preferred.

The ester group is preferably a methyl ester group or an n-butyl ester group. The aryl carbonyl group is preferably a benzoyl group.

In the case where a substituent is present, the number thereof is not limited but is preferably 1 to 4, and more preferably 1 to 3. In the case where a plurality of substituents are present, the kind of the substituents may be different but is preferably the same.

$R^{22}$ to $R^{25}$ in the general formula (n6) each independently are a hydrogen atom, an alkyl group which may have a substituent, an amino group which may have a substituent, an alkoxy group which may have a substituent, or an alkylthio group which may have a substituent. $R^{22}$ or $R^{23}$ may form a ring together with either one of $R^{24}$ or $R^{25}$.

The structure in the case where the ring is formed can be represented by the following general formula (n8) that is a bicyclo structure in which an aromatic group is condensed.

[Chem 53]

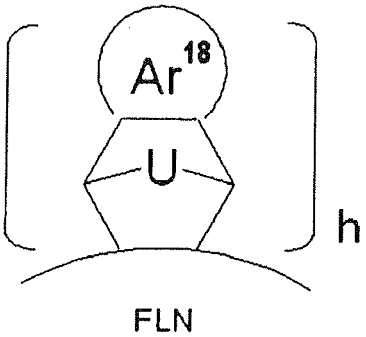

(n8)

h in the general formula (n8) is the same as the above f, and U is an oxygen atom, a sulfur atom, an amino group which may be substituted with an alkyl group having 1 to 6 carbon atoms such as a methyl group or an ethyl group, an alkylene group having 1 or 2 carbon atoms, which may be substituted with an alkoxyl group having 1 to 6 carbon atoms such as a methoxy group, a hydrocarbon group having 1 to 5 carbon atoms, an aromatic hydrocarbon group having 6 to 20 carbon atoms, or an aromatic heterocyclic group having 2 to 20 carbon atoms, or an arylene group such as a phenylene group. Moreover, $Ar^{18}$ is the same as the above $Ar^{17}$.

$R^{26}$ to $R^{27}$ in the general formula (n7) each independently are a hydrogen atom, an alkoxycarbonyl group, an alkyl group having 1 to 14 carbon atoms which may have a substituent, or an aromatic group which may have a substituent.

The alkoxy group in the alkoxycarbonyl group is preferably a hydrocarbon group having 1 to 12 carbon atoms or a fluorinated alkyl group, more preferably a hydrocarbon group having 1 to 12 carbon atoms, further preferably a methyl group, an ethyl group, an n-propyl group, an isopropyl group, an n-butyl group, an isobutyl group, an n-hexyl group, an octyl group, a 2-propylpentyl group, a 2-ethylhexyl group, a 2-ethylhexyl group, a cyclohexylmethyl group, or a benzyl group, and particularly preferably a methyl group, an ethyl group, an isopropyl group, an n-butyl group, an isobutyl group, and an n-hexyl group.

The alkyl group is preferably a linear alkyl group having 1 to 8 carbon atoms and more preferably an n-propyl group. The substituent which the alkyl group may have is not particularly limited but is preferably an alkoxycarbonyl group. The alkoxy group in the alkoxycarbonyl group is preferably a hydrocarbon group having 1 to 14 carbon atoms or a fluorinated alkyl group, more preferably a hydrocarbon group having 1 to 14 carbon atoms, further preferably a methyl group, an ethyl group, an n-propyl group, an isopropyl group, an n-butyl group, an isobutyl group, an n-hexyl group, an octyl group, a 2-propylpentyl group, a 2-ethylhexyl group, a cyclohexylmethyl group, or a benzyl group, and particularly preferably a methyl group or an n-butyl group.

The aromatic group is preferably an aromatic hydrocarbon group having 6 to 20 carbon atoms or an aromatic heterocyclic group having 2 to 20 carbon atoms, preferably a phenyl group, a biphenyl group, a thienyl group, a furyl group, or a pyridyl group, and further preferably a phenyl group or a thienyl group. The substituent which the aromatic group may have is preferably an alkyl group having 1 to 14 carbon atoms, a fluorinated alkyl group having 1 to 14 carbon atoms, or an alkoxy group having 1 to 14 carbon atoms, more preferably an alkoxy group having 1 to 14 carbon atoms, and further preferably a methoxy group or a 2-ethylhexyloxy group. In the case where a substituent is present, the number thereof is not limited but is preferably 1 to 3, and more preferably 1. The kind of the substituents may be different from each other but is preferably the same.

The structure of the general formula (n7) is preferably a structure in which $R^{26}$ and $R^{27}$ both are an alkoxycarbonyl group, a structure in which $R^{26}$ and $R^{27}$ both are an aromatic group, or a structure in which $R^{26}$ is an aromatic group and $R^{27}$ is a 3-(alkoxycarbonyl)propyl group.

Incidentally, the fullerene compound may be a single compound or a mixture of a plurality of the above compounds.

Although a detailed mechanism is not clear, it is considered that the effect particularly induced by the combination of the fullerene compound and the buffer layer material of the invention is attributable to the fact that the conjugated part of the n-semiconductor layer containing the fullerene compound with the buffer layer containing the compound containing a divalent or higher valent electron-withdrawing group or electron-withdrawing atom of the invention is stabilized by a $\pi\pi$-interaction between the conjugated ring contained in the buffer material and the fullerene and thus the electron transporting ability through $\pi$-$\pi$ electron bond in each substance is stabilized. In the case where linking is performed

with a boron compound or a phosphine oxide group, the conjugated ring is disposed in a propeller shape, so that it is considered that the interaction is effected so that the fullerene is encompassed.

The fullerene compound is formed into a film by a vapor deposition method or a method through coating. Particularly, for enabling application of the coating method, it is preferred that the fullerene compound itself is liquid and applicable or the fullerene compound is highly soluble in some solvent and is applicable as a solution.

The solvent for the fullerene compound of the invention is not particularly limited as long as it is a non-polar organic solvent but is preferably non-halogenated solvent. Although a halogenqted solvent such as dichlorobenzene is also possible, it has been desired to replace it from the viewpoint of environmental burden and the like.

Examples of the non-halogenated solvent include non-halogenated aromatic hydrocarbons. Of these, toluene, xylene, cyclohexylbenzene, tetralin, and the like are preferred.

[Process for producing fullerene compound]

The process for producing the fullerene compound of the invention is not particularly limited but, as a synthetic method of fullerene having a partial structure (n4), the process can be, for example, carried out according to the known literatures described in WO2008/059771 and J. Am. Chem. Soc., 2008, 130 (46), 15429-15436.

As a synthetic method of fullerene having a partial structure (n5), the synthesis can be, for example, carried out according to the known literatures described in J. Am. Chem. Soc., 1993, 115, 9798-9799, Chem. Mater. 2007, 19, 5363-5372, and Chem. Mater. 2007, 19, 5194-5199.

As a synthetic method of fullerene having a partial structure (n6), the synthesis can be, for example, carried out according to the known literatures described in Angew. Chem. Int. Ed. Engl. 1993, 32, 78-80, Tetrahedron Lett. 1997, 38, 285-288, W02008/018931, and WO2009/086210.

As a synthetic method of fullerene having a partial structure (n7), the synthesis can be, for example, carried out according to the known literatures described in J. Chem. Soc., Perkin Trans. 1, 1997, 1595, Thin Solid Films 489 (2005) 251-256, Adv. Funct. Mater. 2005, 15, 1979-1987, and J. Org. Chem. 1995, 60, 532-538.

<N-alkyl-substituted perylenediimide derivative>

The N-alkyl-substituted perylenediimide derivative according to the invention is not particularly limited but specifically, compounds described in WO2008/063609, WO2009/115513, WO2009/098250, WO2009/000756, and WO2009/091670 may be mentioned. Since they have a high electron mobility and have absorption in a visible range, they are preferred from the viewpoint of contribution to both of charge transportation and power generation.

<Naphthalenetetracarboxylic diimide>

The naphthalenetetracarboxylic diimide according to the invention is not particularly limited but specifically, compounds described in WO2008/063609, WO2007/146250, and WO2009/000756 may be mentioned. They are preferred from the viewpoint of a high electron mobility, a high solubility, and an excellent coating ability.

<n-type polymer>

The n-type polymer according to the invention is not particularly limited but specifically, compounds described in WO2009/098253, WO2009/098250, WO2010/012710, and WO2009/098250 may be mentioned. Since they have absorption in a visible range, they are preferred from the viewpoint of contribution to power generation, a high viscosity, and an excellent coating ability.

The value of lowest unoccupied molecular orbital (LUMO) of the n-type semiconductor is not particularly limited but is, for example, a value calculated by cyclic voltammetry is preferably -5.0 eV or more, more preferably -3.85 eV or more, and further preferably -3.80 eV or more relative to vacuum level. On the other hand, the value is usually preferably -1.0 eV or less, more preferably -2.0 eV or less, and further preferably -3.0 eV or less.

In order to migrate electron from the electron-donor layer (p-type semiconductor layer) to the electron acceptor layer (n-type semiconductor layer) efficiently, a relative relationship between lowest unoccupied molecular orbitals (LUMO) of materials of the individual electron-donor layer and electron acceptor layer. Specifically, it is preferred that LUMO of the material of the electron-donor layer is higher than LUMO of the material of the electron acceptor layer by a prescribed energy. In other words, it is preferred that electron affinity of the electron acceptor is larger than the electron affinity of the electron donor by a prescribed energy.

By controlling LUMO of the electron acceptor to the above upper limit or less, the migration of electrons is prone to occur, so that lowering of a short-circuit current (Jsc) is sometimes prevented. An open circuit voltage (Voc) is determined by a difference between highest occupied molecular orbital (HOMO) of the material of the electron donor

layer and LUMO of the material of the electron acceptor layer. Therefore, by controlling LUMO of the electron acceptor layer to the above lower limit or more, lowering of Voc can be prevented.

As the method for calculating the value of LUMO of the n-type semiconductor, a method of theoretically determining the value as a calculation value and a method of actually measuring the value may be mentioned. As the method of theoretically determining the value as a calculation value, semi-empirical molecular orbital method and non-empirical molecular orbital method may be mentioned. As the method of actually measuring the value, for example, an ultraviolet-visible absorption spectrometry and a cyclic voltammetry may be mentioned. Of these, the cyclic voltammetry is preferred.

The p-type semiconductor is not particularly limited and small molecule based materials and polymer based materials may be mentioned. Examples of the small molecule based materials include condensed aromatic hydrocarbons such as naphthacene, pentacene, and pyrene; oligothiophenes containing 4 or more thiophene rings such as α-sexithiophene; those in which 4 or more of thiophene rings, benzene rings, fluorene rings, naphthalene rings, anthracene rings, thiazole rings, thiadiazole rings, and benzothiazole rings are linked in total; macrocyclic compounds, e.g., porphyrin compounds such as tetrabenzoporphyrin and metal complexes thereof and metal salts thereof; and the like.

Of these, the porphyrin compounds such as tetrabenzoporphyrin and metal complexes thereof are preferred. In this regard, the p-type semiconductor may be a single compound of the above ones or a mixture of a plurality of the compounds. The small molecule based material is formed into a film by a vapor deposition method or by a method of converting a soluble precursor of the semiconductor into the semiconductor after coating.

The semiconductor compound precursor according to the invention is one to be converted into the semiconductor compound through change in chemical structure of the semiconductor compound precursor, for example, by imparting external stimulus such as superheating or light irradiation.

Moreover, the semiconductor compound precursor according to the invention is preferably one excellent in film formability. Particularly, for enabling application of the coating method, it is preferred that the semiconductor compound precursor itself is liquid and applicable or the semiconductor compound precursor is highly soluble in some solvent and is applicable as a solution.

With regard to a preferred range of solubility, the solubility in a solvent for the semiconductor compound precursor is usually preferably 0.1 % by weight or more, more preferably 0.5% by weight or more, and particularly preferably 1% by weight or more.

The kind of the solvent is not particularly limited as long as it can dissolve or disperse the semiconductor precursor compound homogeneously. Examples thereof include aliphatic hydrocarbons such as hexane, heptane, octane, isooctane, nonane, and decane; aromatic hydrocarbons such as toluene, xylene, chlorobenzene, and o-dichlorobenzene; lower alcohols such as methanol, ethanol, and propanol; ketones such as acetone, methyl ethyl ketone, cyclopentanone, and cyclohexanone; esters such as ethyl acetate, butyl acetate, and methyl lactate; halogenated hydrocarbons such as chloroform, methylene chloride, dichloroethane, trichloroethane, and trichloroethylene; ethers such as ethyl ether, tetrahydrofuran, and dioxane; amides such as dimethylformamide and dimethylacetamide; and the like.

Of these, aromatic hydrocarbons such as toluene, xylene, chlorobenzene, and o-dichlorobenzene and halogenated hydrocarbons such as chloroform, methylene chloride, dichloroethane, trichloroethane, and trichloroethylene are preferred.

Furthermore, it is preferred that the semiconductor compound precursor according to the invention can be easily converted into the semiconductor compound. In the conversion step of the semiconductor compound precursor into the semiconductor compound to be mentioned below, although it is arbitrary what external stimulus is imparted to the semiconductor precursor, it is usually preferred to perform heat treatment, light treatment, or the like, and heat treatment is more preferred. In this case, a semiconductor compound precursor having a solvent-philic group to a prescribed solvent in a part of the skeleton of the precursor is preferred, the group being capable of being eliminated by a retro Diels-Alder reaction.

Moreover, the semiconductor compound precursor according to the invention is preferably converted into the semiconductor compound in high yields through the conversion step. On this occasion, the yield of the semiconductor compound obtained by the conversion from the semiconductor compound precursor is arbitrary unless it impairs the performance of the organic photoelectric conversion device.

With regard to a preferable range of the yield, the yield of the semiconductor compound obtained by the conversion from the semiconductor compound precursor is usually preferably 90% by mol or more, more preferably 95% by mol or more, and further preferably 99% by mol or more.

The semiconductor compound precursor according to the invention is not particularly limited as long as it has the above characteristics but, as specific semiconductor compound precursors, compounds described in JP-A-2007-324587 may be used. Of these, for example, a compound represented by the following formula (1) may be preferably mentioned.

[Chem 54]

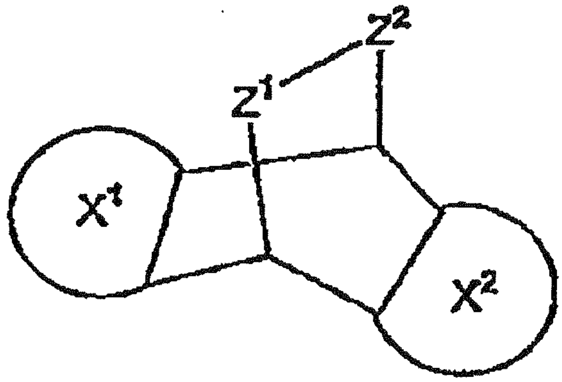

(1)

In the formula (1), at least one of $X^1$ and $X^2$ represents a group which forms a π-conjugated divalent aromatic ring, and $Z^1$-$Z^2$ represents a group capable of being eliminated by heat or light and a group such that a π-conjugated compound obtained by elimination of $Z^1$-$Z^2$ forms a pigment molecule. Moreover, of $X^1$ and $X^2$, a group which does not form a π-conjugated divalent aromatic ring represents a substituted or unsubstituted ethenylene group.

The compound represented by the formula (1) forms a highly planar π-conjugated compound through elimination of $Z^1$-$Z^2$ by heat or light, as shown in the following chemical reaction formula. The formed π-conjugated compound is the semiconductor compound according to the invention. In the invention, it is preferred that the semiconductor compound shows semiconducting properties.

[Chem 55]

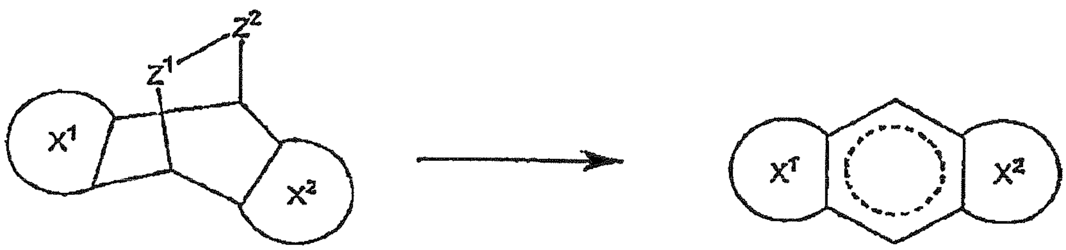

π-conjugated compound

As examples of the compound represented by the formula (1), the following may be mentioned. Incidentally, t-Bu represents a t-butyl group. M represents a divalent metal atom or an atomic group in which a trivalent or higher valent metal is bonded to the other atom.

[Chem 56]

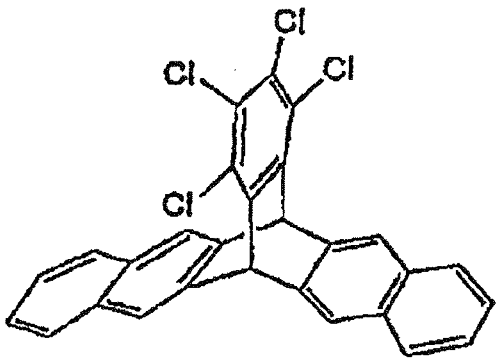

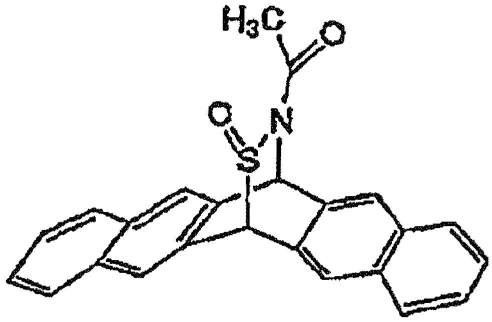

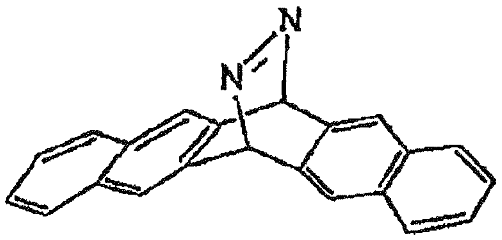

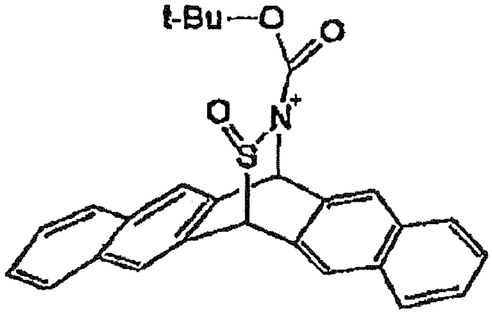

[Chem 57]

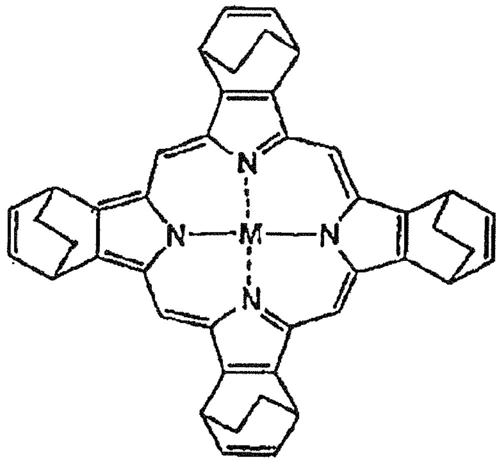

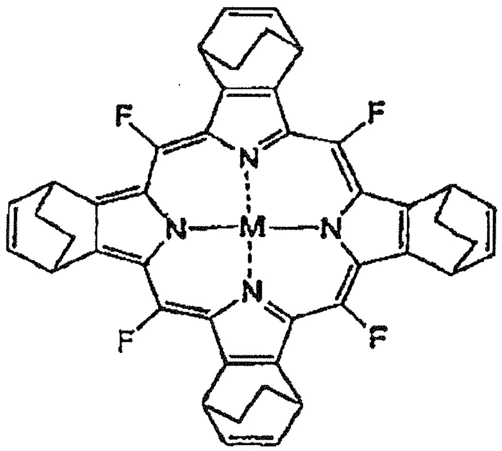

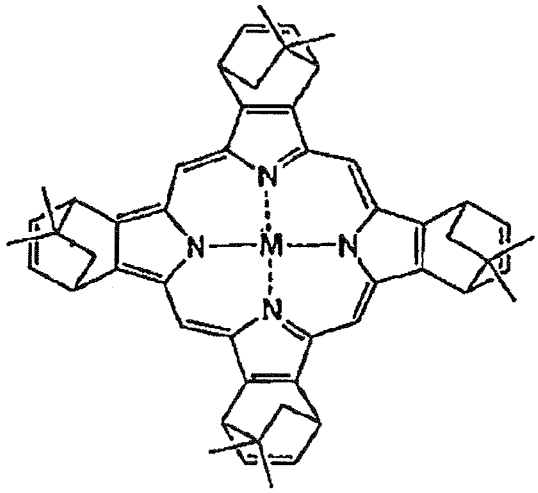

[Chem 58]

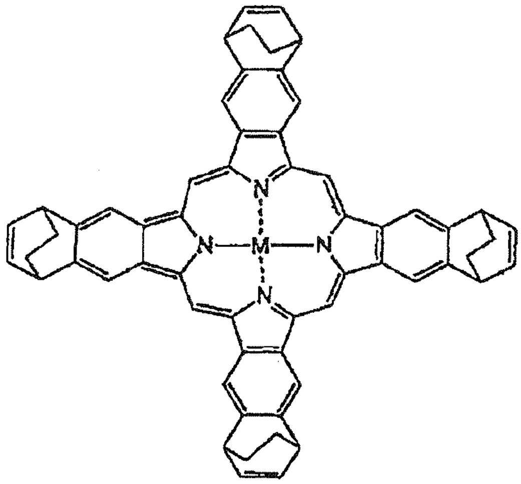

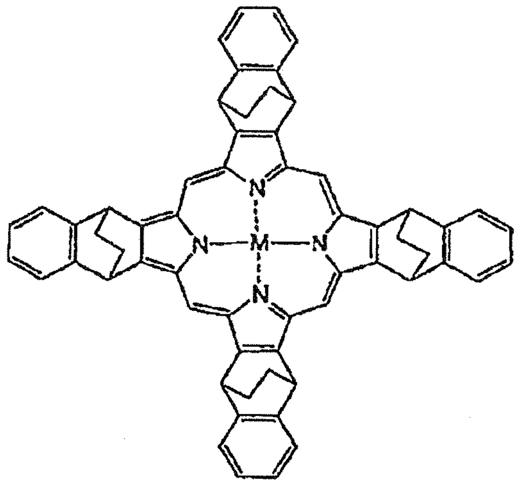

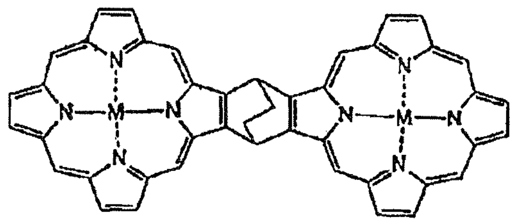

For example, as specific examples of the conversion of the above semiconductor compound precursor, the following may be mentioned.

[Chem 59]

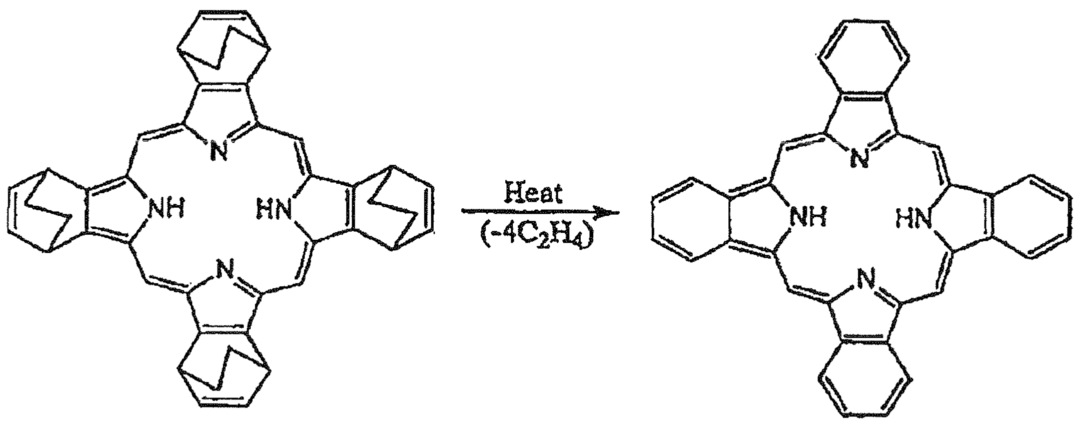


[Chem 60]

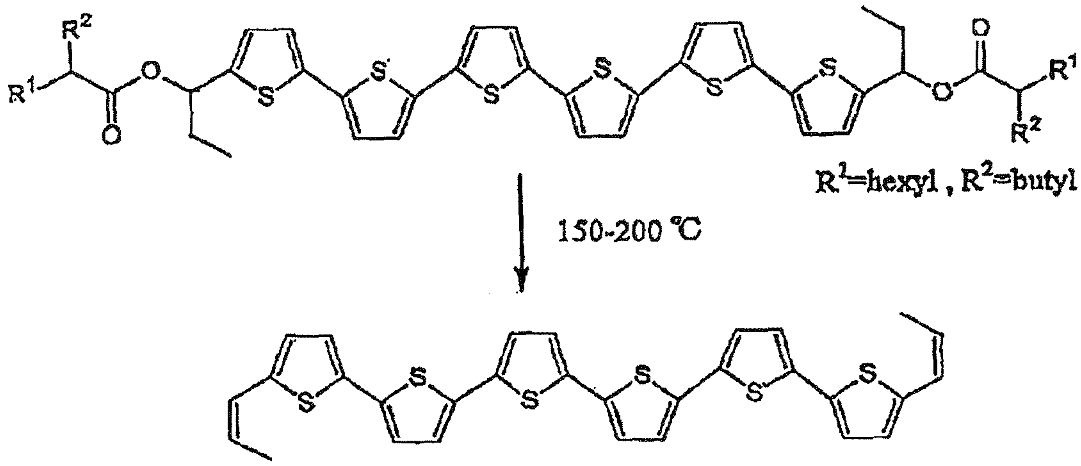


[Chem 61]

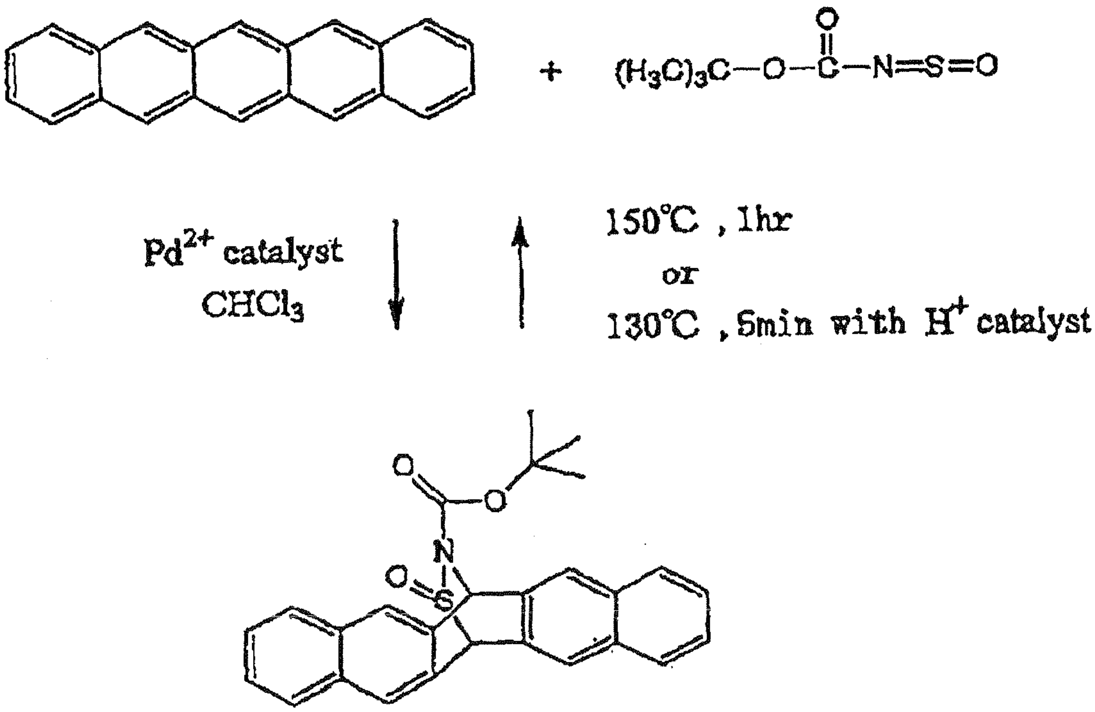


[Chem 62]

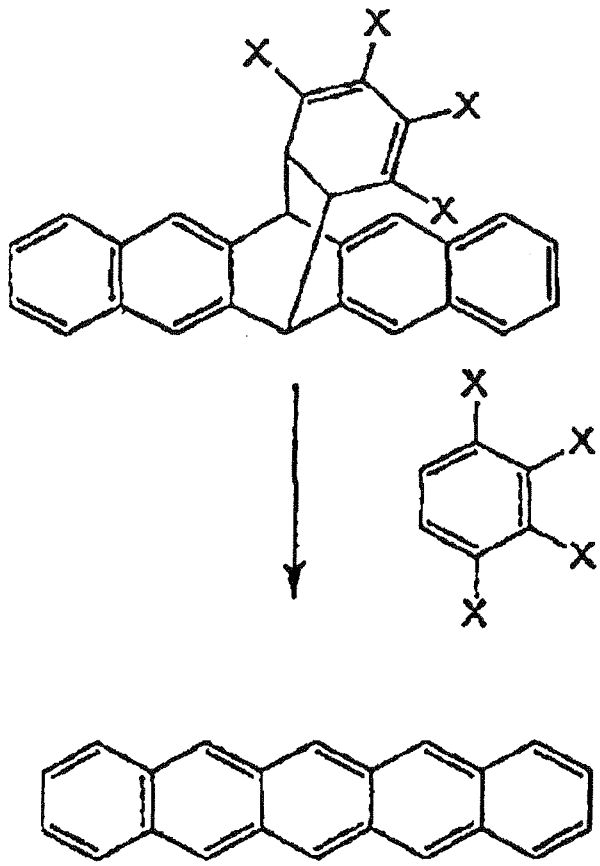

X = Cl, Br

The polymer based materials are not particularly limited and also include conjugated polymer semiconductors such as polythiophene, polyfluorene, polyphenylenevinylene, polythienylenevinylene, polyacetylene, and polyaniline; polymer semiconductors such as oligothiophenes substituted with an alkyl group and the other substituent(s). Moreover, polymer semiconductors in which two or more monomer units are copolymerized may be also mentioned.

As the conjugated polymer semiconductors, polymers described in known literatures such as Handbook of Conducting Polymers, 3rd Ed. (two volumes in total), 2007, Materials Science and Engineering, 2001, 32, 1-40, Pure Appl. Chem. 2002, 74, 2031-3044, Handbook of THIOPHENE-BASED MATERIALS (two volumes in total), 2009 and derivatives thereof, or polymers capable of being synthesized using monomers described therein in combination. The substituents of the polymers and monomers can be selected for controlling solubility, crystallinity, film-forming property, HOMO levels, or LUMO levels.

A polymer based material soluble in an organic solvent is preferred since a coating method can be used in the production process of the organic solar cell device. In this regard, the material may be a single compound or a mixture of a plurality of the above compounds. The polymer based material may have some self-organized structure or may be in an amorphous state.

As specific examples of the polymer based material, the following may be mentioned but the material is not limited thereto.

[Chem 63]

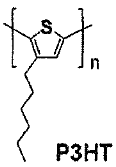

P3HT

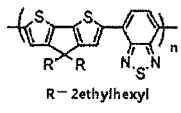

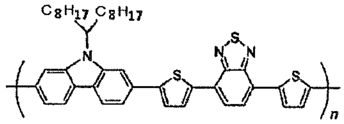

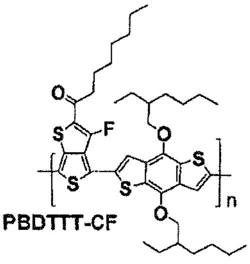

PBDTTT-CF

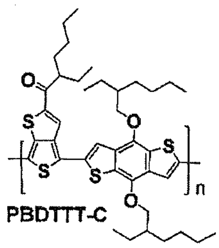

PBDTTT-C

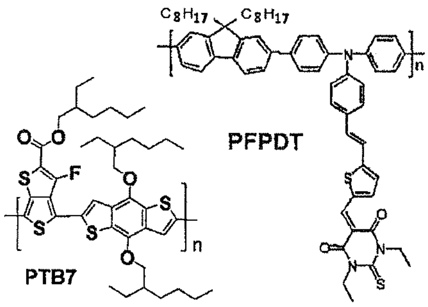

PTB7

PFPDT

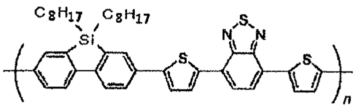

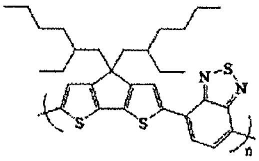

PCPDTBT

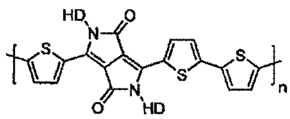

PDPP3T

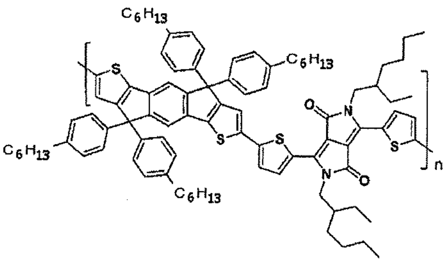

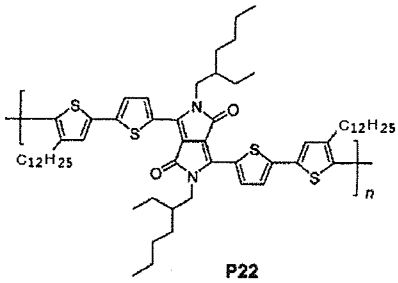

P22

[Chem 64]

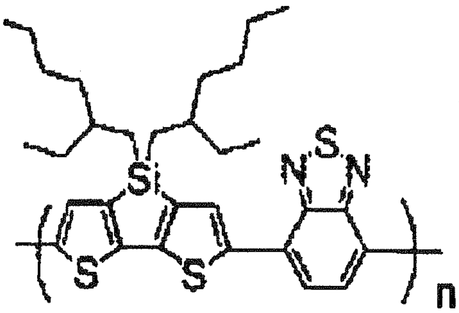

PSBTBT

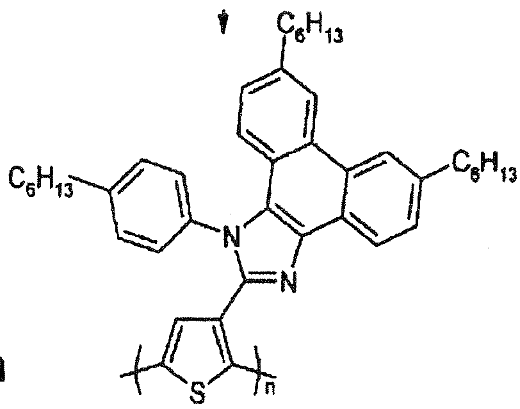

PHPIT

As the p-type semiconductor, it is preferred to use at least one of the porphyrin compound and the polymer semiconductor.

Examples of layer constitution of the active layer include a thin-film lamination type in which the p-type semiconductor and the n-type semiconductor are stacked, a bulk hetero-junction type in which the p-type semiconductor and the n-type semiconductor are mixed, a structure in which a layer (i layer) containing the p-type semiconductor and the n-type semiconductor mixed therein is present in an intermediate layer of the thin-film lamination type, and the like.

Of these, in the case where the p-type semiconductor is a polymer based material, the bulk hetero-conjugation type in which the p-type semiconductor and the n-type semiconductor are mixed is preferred and, in the case where the p-type semiconductor is a small molecule based material, the structure in which a layer (i layer) containing the p-type semiconductor and the n-type semiconductor mixed therein is present in an intermediate layer of the thin-film lamination type is preferred.

The film thickness of the active layer is not particularly limited but is preferably 10 to 1000 nm and further preferably 50 to 200 nm. By controlling the film thickness of the active layer to 10 nm or more, homogeneity becomes sufficient and short circuit is difficult to occur. Moreover, by controlling the film thickness of the active layer to 1000 nm or less, an increase of internal resistance is prevented and a problem that charge diffusion get worse owing to the increase of the distance between the electrodes is difficult to occur, so that the case is preferred.

(Electrode)

In the photoelectric conversion device according to the present invention, as for a pair of electrodes, it is sufficient that either one is transparent but both may be transparent. The word " transparent" means that solar light is transmitted in a degree of 40% or more. Moreover, the solar light transmittance through the transparent electrode of 70% or more is preferred for the arrival of the solar light at the active layer with transmitting the light through the transparent electrode. The transmittance of the light can be measured by a usual spectrophotometer.

Materials to be used for electrodes are not particularly limited as long as they have conductive properties. Examples thereof include conductive metal oxides such as nickel oxide, tin oxide, indium oxide, indium tin oxide (ITO), indium-zirconium oxide (IZO), titanium oxide, indium oxide, and zinc oxide; metals such as gold, platinum, silver, and chromium and alloys thereof; PEDOT/PSS in which polythiophene derivatives are doped with polystyrenesulfonic acid; conductive polymers in which polypyrrol, polyaniline, and the like are doped with iodine or the like; and the like.

These electrode materials may be use singly or may be used as a mixture of a plurality of the materials. Among them, for an electrode located at a position where light is transmitted, a transparent electrode of an oxide such as ITO, tin oxide, zinc oxide, or indium zinc oxide (IZO) is preferably used.

Moreover, a material having a high work function such as ITO (indium tin oxide), tin oxide, zinc oxide, gold, cobalt, nickel, or platinum may be simultaneously used with aluminum, silver, lithium, indium, calcium, magnesium, or the like.

The film thickness of the transparent electrode is not limited and can be arbitrarily selected depending on the resistance value. However, the film thickness is usually preferably 10 nm or more and particularly, more preferably 50 nm or more. Moreover, it is usually preferably 1000 nm or less, particularly, more preferably 500 nm or less, further preferably 300 nm or less, and particularly preferably 100 nm or less. By controlling the film thickness of the electrode to 1000 nm or less, a decrease in transparency is prevented and the cost may not be high. Moreover, by controlling the film thickness to 10 nm or more, an increase in serial resistance is prevented and a decrease in performance is suppressed.

The sheet resistance of the transparent electrode is preferably 300 Ω/□ or less and more preferably 200 Ω/□ or less from the viewpoint of increasing a short-circuit current.

The electrode has a function of collecting holes and electrons generated by light absorption. Therefore, for the electrodes, it is preferred to use electrode materials suitable for collecting holes and electrons.

As electrode material suitable for collecting holes, for example, materials having a high work function such as Au and ITO may be mentioned. On the other hand, as electrode material suitable for collecting electrons, for example, materials having a low work function, such as Al, may be mentioned.

A method for forming the electrodes is not limited. For example, they can be formed by dry processes such as vacuum deposition and spattering.

Moreover, for example, they can be formed by a wet process using a conductive ink. On this occasion, as the conductive ink, any one can be used and, for example, conductive polymers, metal particle dispersions, and the like can be used.

Furthermore, the electrode may be formed by laminating two or more layers and the properties (electric properties, wetting properties, etc.) may be improved by surface treatment.

Examples of a counter electrode preferably include metals such as platinum, gold, silver, copper, iron, tin, zinc, aluminum, indium, chromium, lithium, sodium, potassium, cesium, calcium, and magnesium and alloys thereof; inorganic salts such as lithium fluoride and cesium fluoride; metal oxides such as nickel oxide, aluminum oxide, lithium oxide, and

cesium oxide; and the like.

From the viewpoint of electrode protection, metals such as platinum, gold, silver, copper, iron, tin, aluminum, and indium and alloys using the metals are preferred.

The film thickness of the counter electrode is not limited and can be arbitrarily selected depending on the resistance value. However, the film thickness is usually preferably 10 nm or more and more preferably 50 nm or more. Moreover, it is usually preferably 1000 nm or less, particularly, more preferably 500 nm or less, further preferably 300 nm or less, and particularly preferably 100 nm or less.

A method for forming the electrode is not limited. For example, it can be formed by dry processes such as vacuum deposition, electron beam, spattering, plating, and CVD.

Moreover, for example, it can be formed by wet processes such as ion plating coating, sol-gel, spin coating, and ink-jet. On this occasion, as the conductive ink, any one can be used and, for example, conductive polymers, metal particle dispersions, and the like can be used.

Furthermore, the electrode may be formed by laminating two or more layers, and the properties (electric properties, wetting properties, etc.) may be improved by surface treatment.

(Substrate)

The photoelectric conversion device according to the invention usually has a substrate which serves as a support. Namely, the electrodes, the active layer, and the buffer layer are formed on the substrate. The material of the substrate (substrate material) is arbitrary unless it seriously impairs the effect of the invention.

Examples of the substrate material include inorganic materials such as quartz, glass, sapphire and titania; organic materials such as polyethylene terephthalate, polyethylene naphthalate, polyether sulfones, polyimides, nylons, polystyrene, polyvinyl alcohol, ethylene-vinyl alcohol copolymers, fluororesin films, vinyl chloride, polyolefins such as polyethylene, cellulose, polyvinylidene chloride, aramid, polyphenylene sulfide, polyurethanes, polycarbonate, polyarylates, polynorbornene, and epoxy resins; paper materials such as paper and synthetic paper; and composite materials such as those in which the surface of a metal such as stainless steel, titanium, and aluminum is coated or laminated to impart insulation properties; and the like.

As the glass, soda glass, blue sheet glass, non-alkali glass, and the like may be mentioned. With regard to the material of the glass, the non-alkali glass is preferred since the amount of eluted ions from the glass is preferably small.

The shape of the substrate is not limited and, for example, shapes such as a plate, a film, and a sheet can be used. The thickness of the substrate is not limited. However, it is usually preferably 5 μm or more and more preferably 20 μm or more. Moreover, it is usually preferably 20 mm or less and more preferably 10 mm or less.

By controlling the thickness of the substrate to 5 μm or more, insufficient strength of the semiconductor device can be prevented. By controlling it to 20 mm or less, the cost is suppressed and an excessive increase in weight can be prevented.

Moreover, in the case where the substrate is glass, the thickness is preferably 0.01 mm or more and more preferably 0.1 mm or more. Also, it is preferably 1 cm or less and more preferably 0.5 cm or less. By controlling the thickness to 0.01 mm or more, a decrease in mechanical strength is prevented and thus the substrate can be made difficult to break. By controlling the thickness to 1 cm or less, an increase in weight can be prevented.

The photoelectric conversion efficiency of the photoelectric conversion device of the invention is not particularly limited but is usually preferably 1% or more, more preferably 1.5% or more, and particularly preferably 2% or more. On the other hand, the upper limit is not particularly limited and higher efficiency is better.

<Performance evaluation of photoelectric conversion device>

The solar cell according to the invention is characterized by the following performance.

For example, the performance can be evaluated by performing an acceleration test shown below and comparing a change in photoelectric conversion properties before and after the test.

Evaluation method: for the acceleration test, the cell is placed under a high-temperature and high-humidity environment in an environmental testing machine (e.g., SH-241 manufactured by Espec Corporation). The high-temperature and high-humidity environment is preferably 40°C and 90%RH or 85°C and 85%RH. The test period can be appropriately selected depending on device-constituting materials but it is preferred to perform the test for 22 hours or more.

Moreover, with regard to the photoelectric conversion properties, an organic thin-film solar cell is irradiated with a light of AM 1.5G condition in an irradiation intensity of 100 mW/$cm^2$ by means of a solar simulator (i.e., under a continuous irradiation with a solar simulator) to measure current/voltage properties. Based on a current/voltage curve obtained from such measurement, energy conversion efficiency (PCE), short-circuit current, open circuit voltage, FF (fill factor), serial resistance, and shunt resistance can be determined.

As an expression for comparing the photoelectric conversion properties before and after the acceleration test, for example, the following may be mentioned: Durability = (PCE after acceleration test)/(PCE before acceleration test).
Namely, as the durability that is a change ratio of the energy conversion efficiency (PCE) of the solar cell according to the invention, in the case where the p-type semiconductor material is a small molecule compound, a relative value of the photoelectric conversion efficiency after 22 or 24 hours is usually preferably 81 % or more, more preferably 83% or more, and further preferably 85% or more. On the other hand, the upper limit is not particularly limited.
In the case where the p-type semiconductor material is a polymer based compound, the relative value of the photoelectric conversion efficiency after 72 hours is usually preferably 60% or more, more preferably 65% or more, and further preferably 70% or more. Moreover, the relative value of the photoelectric conversion efficiency after 2000 hours is particularly preferably 70% or more. On the other hand, the upper limit is not particularly limited.
As a reason why the photoelectric conversion device of the invention has a remarkably excellent durability under a vigorous condition such as continuous irradiation with a solar simulator at a substrate temperature of 85°C, although the detail is not clear, there may be mentioned a fact that charge migration is smoothly achieved by the buffer material and decomposition of an exciton, reverse electron migration from the metal electrode to the n-type semiconductor, and decomposition of the n-type semiconductor on the metal electrode surface are suppressed to thereby suppress deterioration. Moreover, it is considered that, when the electron-withdrawing group that is a characteristic of the present application is present, it may trap water and decomposition products through hydrogen bonding, electrostatic interaction, and the like and thus the durability is improved.
For practical use of a photoelectric conversion device, it is very important to balance the photoelectric conversion efficiency and the durability. The photoelectric conversion device containing the buffer layer material of the invention can balance the photoelectric conversion efficiency and the durability from the fact that an improvement in the photoelectric conversion efficiency becomes possible through acceleration of charge migration, smoothening of the interface, reinforcement of a film-defective part, control of the work function of the metal electrode by the buffer material, and the like.

(Solar cell unit)

The photoelectric conversion device of the invention is preferably used as a thin-film solar cell as a solar cell device.
Fig. 2 is a cross-sectional view schematically showing a constitution of a thin-film solar cell as one embodiment of the invention.
As shown in Fig. 2, the thin-film solar cell 14 of the present embodiment is provided with a weather-resistant protective film 1, an ultraviolet ray-cutting film 2, a gas barrier film 3, a getter film 4, an encapsulating material 5, a solar cell device 6, an encapsulating material 7, a getter material film 8, a gas barrier film 9, and a back sheet 10 in this order, and further provided with a sealing material 11 which seals edge parts of the weather-resistant protective film 1 and the back sheet 10. Light is applied from the side (lower side in the figure) at which the weather-resistant protective film 1 is formed, and the solar cell device 6 generates electric power. In the case where a highly waterproof sheet such as a sheet obtained by adhering a fluorocarbon resin film on both sides of an aluminum foil is used as the back sheet 10 to be mentioned later, at least one of the getter material film 8 and the gas barrier film 9 may not be used depending on uses.

[Weather-resistant protective film 1]

The weather-resistant protective film 1 is a film which protects a solar cell device 6 from weather change. Among the constituting parts of the solar cell device 6, there are those which are deteriorated by temperature change, humidity change, natural light, erosion by weather, and the like. Thus, by covering the solar cell device 6 with the weather-resistant protective film 1, the solar cell device 6 and the like are protected from weather change and the like to maintain a high power generation ability.
Since the weather-resistant protective film 1 is located at the top layer of the thin-film solar cell 14, it is preferred to possess suitable performance as a surface covering material of the thin-film solar cell 14, e.g., weather resistance, heat resistance, transparency, water repellency, soil resistance, mechanical strength, and the like and further have a property of maintaining them for a long period of time under outdoor exposure.
Moreover, the weather-resistant protective film 1 is preferably one which transmits visible light from the viewpoint of not preventing the solar cell device 6 from absorbing light. For example, the light transmittance of visible light (wavelength: 360 to 830 nm) is preferably 80% or more, more preferably 90% or more, and particularly preferably 95% or more.
Furthermore, since the thin-film solar cell 14 is frequently heated with receiving light, the weather-resistant protective film 1 also preferably has durability against heat. From this viewpoint, the melting point of constituting material of the weather-resistant protective film 1 is usually preferably 100°C or higher, more preferably 120°C or higher, and further preferably 130°C or higher. Moreover, it is usually preferably 350°C or lower, more preferably 320°C or lower, and further preferably 300°C or lower. By controlling the melting point to a high temperature, a possibility that the weather-resistant protective film 1 might be melted/deteriorated can be reduced at the use of the thin-film solar cell 14.

The material constituting the weather-resistant protective film 1 is any one as long as it can protect the solar cell device 6 from weather change. Examples of the material include polyethylene resins, polypropylene resins, cyclic polyolefin resins, AS (acrylonitrile-styrene) resins, ABS (acrylonitrile-butadiene-styrene) resins, polyvinyl chloride resins, fluorocarbon-based resins, polyester resins such as polyethylene terephthalate and polyethylene naphthalate, phenol resins, polyacrylamide-based resins, polyamide resins such as various nylons, polyimide resins, polyamide-imide resins, polyurethane resins, cellulose-based resins, silicone-based resins, and polycarbonate resins, and the like.

Of these, fluorocarbon-based resins are preferred and specific examples thereof include polytetrafluoroethylene (PTFE), a 4-fluoroethylene-perchloroalkoxy copolymer (PFA), a 4-fluoroethylene-6-fluoropropylene copolymer (FEP), a 2-ethylene-4-fluoroethylene copolymer (ETFE), poly3-fluorochloroethylene (PCTFE), polyvinylidene fluoride (PVDF), polyvinyl fluoride (PVF), and the like.

Incidentally, the weather-resistant protective film 1 may be formed of one kind of material or two or more kinds of materials. Moreover, the weather-resistant protective film 1 may be formed of a monolayer film but may be a laminated film composed of a film having two or more layers.

The thickness of the weather-resistant protective film 1 is not particularly defined but is usually preferably 10 $\mu$m or more, more preferably 15 $\mu$m or more, and further preferably 20 $\mu$m or more. Moreover, it is usually preferably 200 $\mu$m or less, more preferably 180 $\mu$m or less, and further preferably 150 $\mu$m or less. By controlling the thickness to 10 $\mu$m or more, mechanical strength tends to increase. By controlling the thickness to 200 $\mu$m or less, flexibility tends to increase.

Moreover, the weather-resistant protective film 1 may be subjected to surface treatment such as corona treatment or plasma treatment for improving adhesiveness to the other film.

The weather-resistant protective film 1 is preferably provided at an outer side in the thin-film solar cell 14 as far as possible. This is because the constituting materials of the thin-film solar cell 14 can be protected as many as possible.

[Ultraviolet ray-cutting film 2]

The ultraviolet ray-cutting film 2 is a film which prevents transmission of an ultraviolet ray.

Among the constituting parts of the thin-film solar cell 14, there is one which is deteriorated by the ultraviolet ray. Moreover, some of the gas barrier films 3 and 9 and the like are deteriorated depending on the kind thereof by an ultraviolet ray. Therefore, by providing the ultraviolet ray-cutting film 2 on the light-receiving part of the thin-film solar cell 14 and covering the light-receiving surface 6a of the solar cell device 6 with the ultraviolet ray-cutting film 2, the solar cell device 6 and, if necessary, the gas barrier films 3 and 9 and the like can be protected from an ultraviolet ray and the photoelectric conversion efficiency can be maintained high.

With regard to the degree of the ultraviolet ray transmission-suppressing ability required for the ultraviolet ray-cutting film 2, the transmittance of an ultraviolet ray (e.g., wavelength of 300 nm) is preferably 50% or less, more preferably 30% or less, and particularly preferably 10% or less.

Moreover, the ultraviolet ray-cutting film 2 is preferably one which transmits visible light from the viewpoint of not preventing the solar cell device 6 from absorbing light. For example, the light transmittance of visible light (wavelength: 360 to 830 nm) is preferably 80% or more, more preferably 90% or more, and particularly preferably 95% or more.

Furthermore, since the thin-film solar cell 14 is frequently heated with receiving light, the ultraviolet ray-cutting film 2 also preferably has durability against heat. From this viewpoint, the melting point of constituting material of the ultraviolet ray-cutting film 2 is usually preferably 100°C or higher, more preferably 120°C or higher, and further preferably 130°C or higher. Moreover, it is usually preferably 350°C or lower, more preferably 320°C or lower, and further preferably 300°C or lower. By controlling the melting point to 100°C or higher, a possibility that the ultraviolet ray-cutting film 2 might be melted can be prevented at the use of the thin-film solar cell 14.

Moreover, the ultraviolet ray-cutting film 2 is preferably one which has a high flexibility and a good adhesiveness to an adjacent film and can cut water vapor and oxygen.

The material constituting the ultraviolet ray-cutting film 2 is any one as long as it can weaken the intensity of an ultraviolet ray. Examples of the material include films formed with blending an ultraviolet absorber into epoxy-based, acrylic, urethane-based, and ester-based resins and the like. Moreover, there may be used a film obtained by forming a layer containing an ultraviolet absorber dispersed or dissolved in a resin (hereinafter, appropriately referred to as "ultraviolet absorbing layer") on a base material film.

As the ultraviolet absorber, for example, salicylic acid-based, benzophenone-based, benzotriazole-based, and cyanoacrylate-based ones can be used. Of these, benzophenone-based and benzotriazole-based ones are preferred.

Examples thereof include benzophenone-based, benzotriazole-based various aromatic organic compounds and the like. Incidentally, one kind of the ultraviolet absorber may be used or two or more kinds thereof may be simultaneously used in any combination and ratio.

As mentioned above, as an ultraviolet absorption film, a film in which an ultraviolet absorption layer is formed

on a base material film can be also used. Such a film can be prepared, for example, by applying a coating liquid containing an ultraviolet absorber on the base material film and drying it.

The material of the base material film is not particularly limited but, in view of obtaining a film having a good balance of heat resistance and flexibility, for example, a polyester may be mentioned.

Coating can be performed by any methods. Examples thereof include a reverse roll coating method, a gravure coating method, a kiss coating method, a roll brushing method, a spray coating method, an air-knife coating method, a wire bar-bar coating method, a pipe doctor method, an impregnation-coating method, and a curtain coating method, and the like. One kind of these methods may be performed singly or two or more thereof can be performed in any combination.

The solvent use for the coating liquid is not particularly limited as long as it can dissolve or disperse the ultraviolet absorber homogeneously. For example, a liquid resin can be used as the solvent and examples thereof include various synthetic resins such as polyester-based, acrylic, polyamide-based, polyurethane-based, polyolefin-based, polycarbonate-based, and polystyrene-based ones and the like.

Moreover, for example, natural polymers such as gelatin and cellulose derivatives, water, and alcohol-mixed solutions such as water and ethanol can be also used as the solvents. Furthermore, organic solvents may be used as the solvents. When the organic solvents are used, it becomes possible to dissolve or disperse a pigment or a resin and thus coating ability can be improved. One kind of the solvents may be used or two or more kinds thereof can be simultaneously used in any combination and ratio.

The coating liquid may further contain a surfactant. By using the surfactant, dispersibility of an ultraviolet absorbing coloring matter into a resin is improved. Thereby, in the ultraviolet absorption layer, occurrence of missings by tiny bubbles, dents by attachment of foreign matter, repelling in a drying step, and the like is suppressed.

As the surfactant, known surfactants (cationic surfactants, anionic surfactants, and nonionic surfactants) can be used. Of these, silicon-based surfactants and fluorine-based surfactants are preferred. One kind of the surfactants may be used or two or more kinds thereof can be simultaneously used in any combination and ratio.

For drying after the coating liquid is applied on the base material film, known drying methods such as hot-air drying and drying with an infrared heater can be adopted. Of these, the hot-air drying showing a fast drying speed is suitable.

As examples of specific commercial products of the ultraviolet ray-cutting film 2, Cut Ace (MKV plastic Co., Ltd.) and the like may be mentioned.

Incidentally, the ultraviolet ray-cutting film 2 may be formed of one kind of material or two or more kinds of materials. Moreover, the ultraviolet ray-cutting film 2 may be formed of a monolayer film but may be a laminated film composed of a film having two or more layers.

The thickness of the ultraviolet ray-cutting film 2 is not particularly defined but is usually preferably 5 μm or more, more preferably 10 μm or more, and further preferably 15 μm or more. Moreover, it is usually preferably 200 μm or less, more preferably 180 μm or less, and further preferably 150 μm or less. By controlling the thickness to 5 μm or more, absorption of an ultraviolet ray tends to increase. By controlling the thickness to 200 μm or less, transmittance of visible light tends to increase.

The ultraviolet ray-cutting film 2 may be provided at a position where at least a part of the light receiving surface 6a of the solar cell device 6 is covered but preferably, is provided at a position where the whole light receiving surface 6a of the solar cell device 6 is covered.

However, the ultraviolet ray-cutting film 2 may be provided at a position other than the position where the light receiving surface 6a of the solar cell device 6 is covered.

[Gas barrier film 3]

The gas barrier film 3 is a film which prevents permeation of water and oxygen.

The solar cell device 6 tends to be weak against humidity and oxygen and particularly, the transparent electrode such as ZnO:Al, a compound semiconductor-based solar cell device, and an organic solar cell device are sometimes deteriorated by water and oxygen. Therefore, by covering the solar cell device 6 with the gas barrier film 3, the solar cell device 6 can be protected from water and oxygen and the photoelectric conversion efficiency can be maintained high.

The degree of moisture proof ability required for the gas barrier film 3 varies depending on the kind of the solar cell device 6. For example, in the case where the solar cell device 6 is a compound semiconductor-based solar cell device, the water vapor permeability per unit area (1 $m^2$) per day is preferably $1\times10^{-1}$ g/$m^2$/day or less, more preferably $1\times10^{-2}$ g/$m^2$/day or less, further preferably $1\times10^{-3}$ g/$m^2$/day or less, furthermore preferably $1\times10^{-4}$ g/$m^2$/day or less, notably preferably $1\times10^{-5}$ g/$m^2$/day or less, and particularly preferably $1\times10^{-6}$ g/$m^2$/day or less.

Moreover, in the case where the solar cell device 6 is an organic solar cell device, the water vapor permeability per unit area (1 $m^2$) per day is preferably $1\times10^{-1}$ g/$m^2$/day or less, more preferably $1\times10^{-2}$ g/$m^2$/day or less, further preferably $1\times10^{-3}$ g/$m^2$/day or less, furthermore preferably $1\times10^{-4}$ g/$m^2$/day or less, notably preferably $1\times10^{-5}$ g/$m^2$/day or less, and particularly preferably $1\times10^{-6}$ g/$m^2$/day or less. As the permeation of water vapor decreases, the deterioration

of the solar cell device 6 and the transparent electrode such as ZnO:Al of the device 6 induced by the reaction with water is suppressed, so that the photoelectric conversion efficiency is increased and also the life is extended.

The degree of oxygen permeability required for the gas barrier film 3 varies depending on the kind of the solar cell device 6. For example, in the case where the solar cell device 6 is a compound semiconductor-based solar cell device, the oxygen permeability per unit area (1 $m^2$) per day is preferably $1\times10^{-1}$ cc/$m^2$/day/atm or less, more preferably $1\times10^{-2}$ cc/$m^2$/day/atm or less, further preferably $1\times10^{-3}$ cc/$m^2$/day/atm or less, furthermore preferably $1\times10^{-4}$ cc/$m^2$/day/atm or less, notably preferably $1\times10^{-5}$ cc/$m^2$/day/atm or less, and particularly preferably $1\times10^{-6}$ cc/$m^2$/day/atm or less.

Moreover, in the case where the solar cell device 6 is an organic solar cell device, the oxygen permeability per unit area (1 $m^2$) per day is preferably $1\times10^{-1}$ cc/$m^2$/day/atm or less, more preferably $1\times10^{-2}$ cc/$m^2$/day/atm or less, further preferably $1\times10^{-3}$ cc/$m^2$/day/atm or less, furthermore preferably $1\times10^{-4}$ cc/$m^2$/day/atm or less, notably preferably $1\times10^{-5}$ cc/$m^2$/day/atm or less, and particularly preferably $1\times10^{-6}$ cc/$m^2$/day/atm or less. As the permeation of oxygen decreases, the deterioration of the solar cell device 6 and the transparent electrode such as ZnO:Al of the device 6 by oxidation is suppressed.

Since the gas barrier film 3 having such a high moisture barrier and oxygen-blocking ability was hitherto difficult to mount, it was difficult to realize a solar cell provided with an excellent solar cell device such as a compound semiconductor-based solar cell device or an organic solar cell device. However, by applying such a gas barrier film 3, it becomes easy to actually use a thin-film solar cell 14 with making the best use of excellent properties of the compound semiconductor-based solar cell device, the organic solar cell device, or the like.

Moreover, the gas barrier film 3 is preferably one which transmits visible light from the viewpoint of not preventing the solar cell device 6 from absorbing light. For example, the light transmittance of visible light (wavelength: 360 to 830 nm) is usually preferably 60% or more, more preferably 70% or more, further preferably 75% or more, notably preferably 80% or more, more notably preferably 85% or more, particularly preferably 90% or more, notably particularly preferably 95% or more, and most preferably 97% or more. This is determined for converting a larger amount of solar light into electric energy.

Furthermore, since the thin-film solar cell 14 is frequently heated with receiving light, the gas barrier film 3 also preferably has durability against heat. From this viewpoint, the melting point of constituting material of the gas barrier film 3 is usually preferably 100°C or higher, more preferably 120°C or higher, and further preferably 130°C or higher. Moreover, it is usually preferably 350°C or lower, more preferably 320°C or lower, and further preferably 300°C or lower. By controlling the melting point to 100°C or higher, a possibility that the gas barrier film 3 might be melted/deteriorated can be reduced at the use of the thin-film solar cell 14.

Specific constitution of the gas barrier film 3 is arbitrary as long as the solar cell device 6 can be protected from water. However, since the cost for producing a film capable of reducing amounts of water vapor and oxygen permeable through the solar cell device 6 increases with the increase of reducible amounts thereof, it is preferred to use suitable one with comprehensively considering these points.

The following will explain the constitution of the gas barrier film 3 with reference to examples.

As the constitution of the gas barrier film 3, two examples may be preferably mentioned.

The first example is a film having an inorganic barrier layer disposed on a plastic film base material.

On this occasion, the inorganic barrier layer may be formed only on one side of the plastic film base material or may be formed on both sides of the plastic film base material. When the layer is formed on both sides, the numbers of the inorganic barrier layers to be formed on both sides may be coincident with each other or different.

The second example is a film in which a unit layer composed of two layers where the inorganic barrier layer and a polymer layer are mutually adjacently disposed is formed. On this occasion, the unit layer composed of two layers where the inorganic barrier layer and a polymer layer are mutually adjacently disposed is regarded as one unit, and the unit layer may form only one unit (a meaning that one layer of the inorganic barrier layer and one layer of the polymer layer are put together to be one unit) but may form two or more units. For example, two to five units may be laminated.

The unit layer may be formed only on one side of the plastic film base material or may be formed on both sides of the plastic film base material. When the layer is formed on both sides, the numbers of the inorganic barrier layers to be formed on both sides may be coincident with each other or different.

Moreover, in the case where the unit layer is formed on the plastic film base material, the inorganic barrier layer may be formed and then the polymer layer may be formed thereon or the polymer layer may be formed and then the inorganic barrier layer may be formed.

(Plastic film base material)

The plastic film base material to be used in the gas barrier film 3 is not particularly limited as long as it is a film capable of holding the above inorganic barrier layer and polymer layer, and can be appropriately selected depending on the purpose of use of the gas barrier film 3.

As examples of the material of the plastic film base material, polyester resins, polyacrylate resins, polyether sulfone resins, fluorene ring-modified polycarbonate resins, aliphatic ring-modified polycarbonate resins, and acryloyl compounds may be mentioned.

Moreover, it is also preferred to use a condensed polymer including spirobiindane and spirobichroman. Among the polyester resins, polyethylene terephthalate (PET) subjected to biaxial orientation and also polyethylene naphthalate (PEN) subjected to biaxial orientation are preferably used as the plastic film base materials since they are excellent in thermal dimensional stability.

Incidentally, one kind of the material of the plastic film base material may be used or two or more kinds thereof may be simultaneously used in any combination and ratio.

The thickness of the plastic film base material is not particularly defined but is usually preferably 10 μm or more, more preferably 15 μm or more, and further preferably 20 μm or more. Moreover, it is usually preferably 200 μm or less, more preferably 180 μm or less, and further preferably 150 μm or less. By increasing the thickness, mechanical strength tends to increase. By decreasing the thickness, flexibility tends to increase.

The plastic film base material is preferably one which transmits visible light from the viewpoint of not preventing the solar cell device 6 from absorbing light. For example, the light transmittance of visible light (wavelength: 360 to 830 nm) is usually preferably 60% or more, more preferably 70% or more, further preferably 75% or more, notably preferably 80% or more, more notably 85% or more, particularly preferably 90% or more, notably particularly preferably 95% or more, and most preferably 97% or more. This is determined for converting a larger amount of solar light into electric energy.

In the plastic film base material, a layer of an anchor coat agent (anchor coat layer) may be formed for improving adhesiveness to the inorganic barrier layer. Usually, the anchor coat layer is formed by applying the anchor coat agent.

Examples of the anchor coat agent include polyester resins, urethane resins, acryl resins, oxazoline group-containing resins, carbodiimide group-containing resins, epoxy group-containing resins, and isocyanate-containing resins as well as copolymers thereof and the like.

Of these, a combination of one or more kinds of polyester resins, urethane resins, and acryl resins and one or more kinds of oxazoline group-containing resins, carbodiimide group-containing resins, epoxy group-containing resins, and isocyanate-containing resins is preferred. Incidentally, one kind of the anchor coat agent may be used or two or more kinds thereof may be simultaneously used in any combination and ratio.

The thickness of the anchor coat layer is usually preferably 0.005 μm or more, more preferably 0.01 μm or more, and usually preferably 5 μm or less, more preferably 1 μm or less. When the thickness is the upper limit of the range or less, sliding properties are good and peeling from the plastic film base material by internal stress of the anchor coat layer itself hardly occurs. Moreover, when the thickness is the lower limit of the range or more, uniform thickness can be maintained and thus the case is preferred.

Moreover, in order to improve coating properties and adhesiveness of the anchor coat agent to the plastic film base material, the plastic film base material may be subjected to usual surface treatment such as chemical treatment, discharging treatment, or the like before the application of the anchor coat agent.

(Inorganic barrier layer)

The inorganic barrier layer is usually a layer formed of a metal oxide, nitride, or oxynitride. Incidentally, one kind of the metal oxide, nitride, and oxynitride which form the inorganic barrier layer may be used or two or more kinds thereof may be simultaneously used in any combination and ratio.

Examples of the metal oxide include oxide, nitride, oxynitride, and the like of Si, Al, Mg, In, Ni, Sn, Zn, Ti, Cu, Ce, Ta, and the like. Of these, in order to satisfy both of high barrier properties and high transparency, it is preferred to include aluminum oxide or silicon oxide and, particularly from the viewpoint of permeability of water and light transmittance, it is preferred to contain silicon oxide.

The ratio of each metal atom to an oxygen atom is also arbitrary but, for improving the transparency of the inorganic barrier layer and preventing coloration, it is preferred that the ratio of the oxygen atom is not extremely lowered from a stoichiometric ratio of the metal oxide. On the other hand, for improving denseness of the inorganic barrier layer and increasing barrier properties, it is preferred to decrease the oxygen atom.

From this viewpoint, for example, in the case where $SiO_x$ is used as the metal oxide, the value of x is particularly preferably 1.5 to 1.8. Moreover, for example, in the case where $AlO_x$ is used as the metal oxide, the value of x is particularly preferably 1.0 to 1.4.

Moreover, in the case where the inorganic barrier layer is constituted by two or more kinds of metal oxides, it is preferred to include aluminum oxide and silicon oxide as metal oxides. Particularly, in the case where the inorganic barrier layer is composed of aluminum oxide and silicon oxide, the ratio of the aluminum to silicon in the inorganic barrier layer can be arbitrarily set but the ratio of Si/Al is usually preferably 1/9 or more and more preferably 2/8 or more. Moreover, the ratio is usually preferably 9/1 or less and more preferably 2/8 or less.

When the thickness of the inorganic barrier layer is increased, there is a tendency of increasing the barrier

properties. However, in order to hardly generate cracks and prevent breakage when it is bended, it is preferred to decrease the thickness. An appropriate thickness of the inorganic barrier layer is usually preferably 5 nm or more and more preferably 10 nm or more. Also, it is usually preferably 1000 nm or less and more preferably 200 nm or less.

The film-forming process of the inorganic barrier layer is not limited but the film formation is generally performed by a sputtering method, a vacuum deposition method, an ion plating method, a plasma CVD method, or the like. For example, in the sputtering method, the formation can be performed, using one kind or a plurality of metal targets and an oxygen gas as starting materials, by a reactive sputtering method using plasma.

(Polymer layer)

In the polymer layer, any polymer can be used and, for example, one capable of film formation in a vacuum chamber can be also used. Incidentally, one kind of the polymer constituting the polymer layer may be used or two or more kinds thereof may be simultaneously used in any combination and ratio.

As the compound affording the above polymer, various ones can be used but, for example, the following (i) to (vii) may be exemplified. Incidentally, one kind of the monomer may be used or two or more kinds thereof may be simultaneously used in any combination and ratio.

(i) For example, siloxanes such as hexamethyldisiloxane may be mentioned.
As an example of the method for forming the polymer layer in the case of using hexamethyldisiloxane, hexamethyldisiloxane is introduced, as a vapor, into a parallel flat plate-type plasma apparatus using an RF electrode, a polymerization is induced in plasma to cause deposition on the plastic film base material, thereby forming the polymer layer as a polysiloxane thin film.

(ii) For example, paraxylylenes such as diparaxylylene may be mentioned.
As an example of the method for forming the polymer layer in the case of using diparaxylylene, a vapor of diparaxylylene is first thermally decomposed by heating it at 650°C to 700°C under high vacuum to generate thermal radicals. Then, the radical monomer vapor is introduced into a chamber and is adsorbed on the plastic film base material and simultaneously a radical polymerization reaction is allowed to proceed to deposit polyparaxylylene, thereby forming the polymer layer.

(iii) For example, monomers capable of repeated addition polymerization of two kinds of monomers alternatively may be mentioned. The polymer thereby obtained is a polyaddition polymer. Examples of the polyaddition polymer include polyurethanes (diisocyanate/glycol), polyureas (diisocyanate/diamine), polythioureas (dithioisocyanate/diamine), polythioether urethanes (bisethyleneurethane/dithiol), polyimines (bisepoxy/primary amine), polypeptideamides (bisazolactone/diamine), polyamides (diolefin/diamide), and the like.

(iv) For example, acrylate monomers may be mentioned. The acrylate monomers include monofunctional, difunctional, and polyfunctional ones but any one may be used. However, in order to obtain suitable vaporization rate, degree of cure, curing rate, and the like, it is preferred to use a combination of two or more of the above acrylate monomers simultaneously.

Moreover, examples of the monofunctional acrylate monomer include aliphatic acrylate monomers, alicyclic acrylate monomers, ether-based acrylate monomers, cyclic ether-based acrylate monomers, aromatic acrylate monomers, hydroxyl group-containing acrylate monomers, carboxyl group-containing acrylate monomers, and the like. Any of them can be used.

(v) For example, monomers such as epoxy-based and oxetane-based ones from which photo cation cured polymers are obtained may be mentioned. Examples of the epoxy-based monomers include alicyclic epoxy-based monomers, difunctional monomers, polyfunctional monomers, and the like. Moreover, examples of the oxetane-based monomers include monofunctional oxetanes, difunctional oxetanes, and oxetanes having a silsesquioxane structure, and the

like.

(vi) For example, vinyl acetate may be mentioned. When vinyl acetate is used as a monomer, polyvinyl alcohol is obtained by saponifying a polymerized compound thereof and the polyvinyl alcohol can be used as the polymer.

(vii) For example, unsaturated carboxylic acids such as acrylic acid, methacrylic acid, ethacrylic acid, fumaric acid, maleic acid, itaconic acid, monomethyl maleate, monoethyl maleate, maleic anhydride, and itaconic anhydride may be mentioned.

they may be formed into copolymers with ethylene and the copolymers can be used as the polymers. Furthermore, mixtures thereof, mixtures in which glycidyl ether compounds are mixed, and mixtures with epoxy compounds can be also used as the polymers.

At the time when the above monomer(s) is polymerized to form a polymer, the method for polymerizing the monomer(s) is not limited. However, polymerization is usually performed after a composition containing the monomer (s) is applied or deposited to form a film. As examples of the polymerization method, polymerization is started by contact heating by a heater or the like; heating by a radiation such as an infrared ray or microwave; or the like, when a thermal polymerization initiator is used. Moreover, when a photo polymerization initiator is used, polymerization is started by irradiation with an active energy ray.

In the case of irradiation with an active energy ray, various light sources can be used and, for example, a mercury arc lamp, a xenon arc lamp, a fluorescence lamp, a carbon arc lamp, a tungsten-halogen radiation lamp, an irradiation light by sun light, and the like can be used. Moreover, electron beam irradiation and atmospheric pressure plasma treatment can be also performed.

Examples of the method for forming the polymer layer include a coating method, a vacuum film-forming process, and the like.

In the case where the polymer layer is formed by the coating method, for example, method of roll coating, gravure coating, knife coating, dip coating, curtain flow coating, spray coating, and bar coating can be used. Moreover, a coating liquid for polymer layer formation may be applied as a mist. The average particle diameter in this case may be adjusted in a suitable range and for example, in the case where the layer is formed by applying a coating liquid containing a polymerizable monomer as a mist to form a film on the plastic film base material, the average particle diameter is preferably 5 μm or less and more preferably 1 μm or less.

On the other hand, in the case where the polymer layer is formed by the vacuum film-forming process, for example, film-forming processs such as vapor deposition and plasma CVD may be mentioned.

The thickness of the polymer layer is not particularly limited but is usually preferably 10 nm or more. Moreover, it is usually preferably 5000 nm or less, more preferably 2000 nm or less, and particularly preferably 1000 nm or less.

By controlling the thickness of the polymer layer to 10 nm or more, evenness of the thickness is easy to obtain, structural defect of the inorganic barrier layer can be efficiently filled with the polymer layer, and thus the barrier properties tends to be improved. Moreover, by controlling the thickness of the polymer layer to 5000 nm or less, the barrier properties can be improved since crack generation of the polymer layer itself by an external force such as bending is difficult to occur.

Examples of particularly suitable gas barrier film 3 include films in which base material films such as polyethylene terephthalate (PET) and polyethylene naphthalate (PEN) are subjected to vacuum deposition with $SiO_x$; and the like.

Incidentally, the gas barrier film 3 may be formed of one kind of material or two or more kinds of materials. Moreover, the gas barrier film 3 may be formed of a monolayer film but may be a laminated film composed of a film having two or more layers.

The thickness of the gas barrier film 3 is not particularly defined but is usually preferably 5 μm or more, more preferably 10 μm or more, and further preferably 15 μm or more. Moreover, it is usually preferably 200 μm or less, more preferably 180 μm or less, and further preferably 150 μm or less. By controlling the thickness to 5 μm or more, the gas barrier properties tend to increase. By controlling the thickness to 200 μm or less, flexibility increases and transmittance of visible light tends to increase.

With regard to the gas barrier film 3, the position at which it is formed is not limited as long as it can cover the solar cell device 6 to protect it from moisture and oxygen but it is preferred to cover the front face (a face at the light-receiving side, a lower face in Fig. 2) and the back face (a face opposite to the light-receiving side, an upper face in Fig. 2) of the solar cell device 6.

This is because the front and back faces thereof are frequently formed in an area larger than the other faces in the thin-film solar cell 14. In the present embodiment, the gas barrier film 3 covers the front face of the solar cell device

6 and the gas barrier film 9 to be mentioned later covers the back face of the solar cell device 6.

Also, edge parts of the gas barrier films 3 and 9 are sealed with the sealing material 11 and the solar cell device 6 is housed in a space surrounded by the gas barrier film 3 and 9 and the sealing material 11, whereby the solar cell device 6 can be protected from moisture and oxygen. In the case where a highly waterproof sheet such as a sheet in which a fluorocarbon-based resin film is adhered to both faces of an aluminum foil is used as the back sheet 10 to be mentioned later, at least one of the getter material film 8 and the gas barrier film 9 may not be used depending on uses.

[Getter material film 4]

The getter material film 4 is a film which absorbs at least one of water and oxygen. Among the constituting parts of the solar cell device 6, there are those which are deteriorated by water as mentioned above and those which are deteriorated by oxygen. Therefore, by covering the solar cell device 6 with the getter material film 4, the solar cell device 6 and the like are protected from at least one of water and oxygen to maintain the photoelectric conversion efficiency high.

Here, the getter material film 4 is different from the gas barrier film 3 as mentioned above and does not prevent the permeation of water but absorbs water. By using a film which absorbs water, in the case where the solar cell device 6 is covered with the gas barrier film 3 and the like, the getter material film 4 traps water entering into the space formed by the gas barrier films 3 and 9 and the sealing material 11 in a little amount and thus the influence of water on the solar cell device 6 can be extruded.

The degree of the water-absorbing power of the getter material film 4 is usually preferably 0.1 $mg/cm^2$ or more, more preferably 0.5 $mg/cm^2$ or more, and further preferably 1 $mg/cm^2$. The higher the numeric value is, the higher the water-absorbing power is. Thus, such a getter material film 4 can suppress the deterioration of the solar cell device 6. Moreover, the upper limit is not limited but is usually 10 $mg/cm^2$ or less.

Moreover, by the absorption of oxygen with the getter material film 4, in the case where the solar cell device 6 is covered with the gas barrier films 3 and 9 and the like, the getter material film 4 traps oxygen entering into the space formed by the gas barrier films 3 and 9 and the sealing material 11 in a little amount and thus the influence of oxygen on the solar cell device 6 can be extruded.

Furthermore, the getter material film 4 is preferably one which transmits visible light from the viewpoint of not preventing the solar cell device 6 from absorbing light. For example, the light transmittance of visible light (wavelength: 360 to 830 nm) is usually preferably 60% or more, more preferably 70% or more, further preferably 75% or more, notably preferably 80% or more, more notably 85% or more, particularly preferably 90% or more, notably particularly preferably 95% or more, and most preferably 97% or more. This is determined for converting a larger amount of solar light into electric energy.

Furthermore, since the thin-film solar cell 14 is frequently heated with receiving light, the getter material film 4 also preferably has durability against heat. From this viewpoint, the melting point of constituting material of the getter material film 4 is usually preferably 100°C or higher, more preferably 120°C or higher, and further preferably 130°C or higher. Moreover, it is usually preferably 350°C or lower, more preferably 320°C or lower, and further preferably 300°C or lower. By controlling the melting point to a high temperature, a possibility that the getter material film 4 might be melted/deteriorated can be reduced at the use of the thin-film solar cell 14.

The material constituting the getter material film 4 is any one as long as it can absorb at least one of water and oxygen. Examples of the material include, as substances absorbing water, alkali metals, alkaline earth metals, oxides of alkaline earth metals, hydroxides of alkali metals and alkaline earth metals, silica gel, zeolite-based compounds, sulfate salts such as magnesium sulfate, sodium sulfate, and nickel sulfate, as well as organometallic compounds such as aluminum metal complexes and aluminum oxide octylate, and the like.

Specifically, as the alkaline earth metals, Ca, Sr, Ba, and the like may be mentioned. As the oxides of the alkaline earth metals, CaO, SrO, BaO, and the like may be mentioned. In addition, Zr-Al-BaO, aluminum metal complexes, and the like may be also mentioned. As specific trade names, for example, OleDry (manufactured by Futaba Corporation) and the like may be mentioned.

As substances which absorbs oxygen, activated carbon, silica gel, activated alumina, molecular sieves, magnesium oxide, iron oxide, and the like may be mentioned. Moreover, Fe, Mn, and Zn as well as inorganic salts such as sulfate salts, chloride salts, and nitrate salts of these metals may be also mentioned.

The getter material film 4 may be formed of one kind of material or two or more kinds of materials. Moreover, the getter material film 4 may be formed of a monolayer film but may be a laminated film composed of a film having two or more layers.

The thickness of the getter material film 4 is not particularly defined but is usually preferably 5 μm or more, more preferably 10 μm or more, and further preferably 15 μm or more. Moreover, it is usually preferably 200 μm or less, more preferably 180 μm or less, and further preferably 150 μm or less. By increasing the thickness, the mechanical strength tends to increase. By reducing the thickness, flexibility tends to increase.

With regard to the getter material film 4, the position at which it is formed is not limited as long as the position is within the space surrounded by the gas barrier film 3 and 9 and the sealing material 11 but it is preferred to cover the front face (a face at the light-receiving side, a lower face in Fig. 2) and the back face (a face opposite to the light-receiving side, an upper face in Fig. 2) of the solar cell device 6.

Since the front and back faces thereof are frequently formed in an area larger than the other faces in the thin-film solar cell 14, there is a tendency that water and oxygen tend to enter through these faces. From this viewpoint, the getter material film 4 is preferably provided between the gas barrier film 3 and the solar cell device 6.

In the present embodiment, the getter material film 4 covers the front face of the solar cell device 6, the getter material film 8 to be mentioned later covers the back face of the solar cell device 6, and the getter material films 4 and 8 are located between the solar cell device 6 and the gas barrier films 3 and 9, respectively.

In the case where a highly waterproof sheet such as a sheet in which a fluorocarbon-based resin film is adhered to both faces of an aluminum foil is used as the back sheet 10 to be mentioned later, at least one of the getter material film 8 and the gas barrier film 9 may not be used depending on uses.

The getter material film 4 can be formed by any method depending on a water absorbent or a drying agent. For example, a method of attaching a film containing the water absorbent or the drying agent dispersed therein with a method of applying a solution of the water absorbent or the drying agent by a spin coating method, an ink-jet method, a dispenser method, or the like, and the like can be used. Moreover, film-forming processs such as a vacuum deposition method and a sputtering method may be used.

As the film for the water absorbent or the drying agent, for example, polyethylene-based resins, polypropylene-based resins, cyclic polyolefin-based resins, polystyrene-based resins, acrylonitrile-styrene copolymers (AS resins), acrylonitrile-butadiene-styrene copolymers (ABS resins), polyvinyl chloride-based resins, fluorocarbon-based resins, poly(meth)acrylic resins, polycarbonate-based resins, and the like can be used.

Of these, films of polyethylene-based resins, fluorocarbon-based resins, cyclic polyolefin-based resins, and polycarbonate-based resins are preferred. Incidentally, one kind of the above resin may be used or two or more kinds thereof may be simultaneously used in any combination and ratio.

[Encapsulating material 5]

The encapsulating material 5 is a film which reinforces the solar cell device 6. Since the solar cell device 6 is thin, it usually has a weak strength and, as a result, the strength of the thin-film solar cell tends to be weak but the strength can be maintained high by the encapsulating material 5.

Moreover, the encapsulating material 5 preferably has a high strength from the viewpoint of maintaining the strength of the thin-film solar cell 14.

Specific strength thereof also relates to the strength of the weather-resistant protective film 1 or the back sheet 10 other than the encapsulating material 5 and thus is difficult to categorically define but the encapsulating material 5 preferably has such strength that the whole thin-film solar cell 14 has a good bending processability and no peeling at the bent part is generated.

Moreover, the encapsulating material 5 is preferably one which transmits visible light from the viewpoint of not preventing the solar cell device 6 from absorbing light. For example, the light transmittance of visible light (wavelength: 360 to 830 nm) is usually preferably 60% or more, more preferably 70% or more, further preferably 75% or more, notably preferably 80% or more, more notably 85% or more, particularly preferably 90% or more, notably particularly preferably 95% or more, and most preferably 97% or more. This is determined for converting a larger amount of solar light into electric energy.

Furthermore, since the thin-film solar cell 14 is frequently heated with receiving light, the encapsulating material 5 also preferably has durability against heat. From this viewpoint, the melting point of constituting material of the encapsulating material 5 is usually preferably 100°C or higher, more preferably 120°C or higher, and further preferably 130°C or higher. Moreover, it is usually preferably 350°C or lower, more preferably 320°C or lower, and further preferably 300°C or lower. By controlling the melting point to a high temperature, a possibility that the encapsulating material 5 might be melted/deteriorated can be reduced at the use of the thin-film solar cell 14.

The thickness of the encapsulating material 5 is not particularly defined but is usually preferably 100 μm or more, more preferably 150 μm or more, and further preferably 200 μm or more. Moreover, it is usually preferably 700 μm or less, more preferably 600 μm or less, and further preferably 500 μm or less. By increasing the thickness, the strength of the whole thin-film solar cell 14 tends to increase. By decreasing the thickness, flexibility is increased and transmittance of visible light tends to increase.

As materials constituting the encapsulating material 5, for example, one obtained by forming an ethylene-vinyl acetate copolymer (EVA) resin composition into a film (EVA film) and the like can be used. Into the EVA film, usually, for improving weather resistance, a crosslinking agent is blended to form a crosslinked structure.

As the crosslinking agent, generally, an organic peroxide, which generates radicals at 100°C or higher, is used.

As such an organic peroxide, for example, 2,5-dimethylhexane; 2,5-dihydroperoxide; 2,5-dimethyl-2,5-di(t-butylperoxy) hexane; 3-dit-butyl peroxide; and the like can be used. The blending amount of the organic peroxide is usually preferably 5 parts by weight or less, more preferably 3 parts by weight or less and usually preferably 1 part by weight or more based on 100 parts by weight of the EVA resin. Incidentally, one kind of the crosslinking agent may be used or two or more kinds thereof may be simultaneously used in any combination and ratio.

Into the EVA resin composition, for the purpose of improving adhesive force, a silane coupling agent may be included. Examples of the silane coupling agent to be provided for the purpose include γ-chloropropyltrimethoxysilane; vinyltrichlorosilane; vinyl triethoxysilane; vinyl-tris-(β-methoxyethoxy)silane; γ-methacryloxypropyltrimethoxysilane; β-(3,4-ethoxycyclohexyl)ethyltrimethoxysilane, and the like. The blending amount of these silane coupling agents is usually preferably 5 parts by weight or less, more preferably 2 parts by weight or less, and usually preferably 0.1 part by weight or more based on 100 parts by weight of the EVA resin.

Incidentally, one kind of the silane coupling agent may be used or two or more kinds thereof may be simultaneously used in any combination and ratio.

Furthermore, in order to improve the gel fraction of the EVA resin and improve durability, a crosslinking aid may be included in the EVA resin composition. Examples of the crosslinking aid to be provided for the purpose include monofunctional crosslinking aids of trifunctional crosslinking aids such as triallyl isocyanurate and triallyl isocyanate and the like.

The blending amount of these crosslinking aids is usually preferably 10 parts by weight or less, more preferably 5 parts by weight or less based on 100 parts by weight of the EVA resin. Also, it is usually preferably 1 part by weight or more. Incidentally, one kind of the crosslinking aid may be used or two or more kinds thereof may be simultaneously used in any combination and ratio.

Furthermore, for the purpose of improving the stability of the EVA resin, for example, hydroquinone; hydroquinone monomethyl ether; p-benzoquinone; methylhydroquinone; and the like may be included in the EVA resin composition. The mixing amount thereof is usually preferably 5 parts by weight or less based on 100 parts by weight of the EVA resin.

However, since the crosslinking treatment of the EVA resin requires relatively such a long time as about 1 to 2 hours, the treatment causes lowering of production rate and production efficiency of the thin-film solar cell 14 in some cases. Moreover, at long-term use, a decomposition gas (acetic acid gas) of the EVA resin composition or vinyl acetate group contained in the EVA resin itself may exert an adverse influence on the solar cell device 6 to lower the photoelectric conversion efficiency.

Therefore, as the encapsulating material 5, other than the EVA film, a copolymer film composed of a propylene-ethylene-α-olefin copolymer can be also used. As the copolymer, for example, a thermoplastic resin composition blended with the following ingredients 1 and 2 may be mentioned.

Ingredient 1: a propylene-based polymer usually in an amount of preferably 0 part by weight or more, more preferably 10 parts by weight or more. Moreover, the amount is usually preferably 70 parts by weight or less, more preferably 50 parts by weight or less.

Ingredient 2: a soft propylene-based copolymer in an amount of preferably 30 parts by weight or more, more preferably 50 parts by weight or more. Moreover, the amount is usually preferably 100 parts by weight or less, more preferably 90 parts by weight or less.

Incidentally, the total amount of the ingredients 1 and 2 is 100 parts by weight. When the ingredients 1 and 2 lie within the preferable ranges as mentioned above, forming ability of the encapsulating material 5 into a sheet is good and also heat resistance, transparency, and flexibility of the resulting encapsulating material 5 becomes good, so that it is suitable for the thin-film solar cell 14.

The thermoplastic resin composition blended with the above ingredients 1 and 2 usually preferably has a melt flow rate (ASTM D 1238, 230°, load of 2.16 g) of 0.0001 g/10 minutes or more. Moreover, the melt flow rate is usually preferably 1000 g/10 minutes or less, more preferably 900 g/10 minutes or less, and further preferably 800 g/10 minutes or less.

The melting point of the thermoplastic resin composition blended with the above ingredients 1 and 2 is usually preferably 100°C or higher and more preferably 110°C or higher. Moreover, it is usually preferably 140°C or lower and more preferably 135°C or lower.

Furthermore, the density of the thermoplastic resin composition blended with the above ingredients 1 and 2 is usually preferably 0.98 g/$cm^3$ or less, more preferably 0.95 g/$cm^3$ or less, and further preferably 0.94 g/$cm^3$ or less.

In the encapsulating material 5, it is possible to blend a coupling agent, as an adhesion accelerator to a plastic, into the above ingredients 1 and 2. As the coupling agent, silane-based, titanate-based, and chromium-based coupling agents are preferably used and particularly, silane-based coupling agents (silane coupling agents) are suitably used.

As the above silane coupling agent, known ones can be used and there is no limitation. Examples thereof include vinyltriethoxysilane, vinyltrimethoxysilane, vinyl-tris-(β-methoxy-ethoxysilane), γ-glycidoxypropyl-tripyltri-methoxysilane, γ-aminopropyltriethoxysilane, and the like. Incidentally, one kind of the silane coupling agent may be used or

two or more kinds thereof may be simultaneously used in any combination and ratio.

Moreover, the content of the above silane coupling agent is usually preferably 0.1 part by weight or more and usually preferably 5 parts by weight or less and more preferably 3 parts by weight or less based on 100 parts by weight of the thermoplastic resin composition (total amount of the ingredients 1 and 2).

Furthermore, the above coupling agent may be grafted to the thermoplastic resin composition using an organic peroxide. In this case, it is preferred to include the above coupling agent in an amount of 0.1 to 5 parts by weight based on 100 parts by weight of the thermoplastic resin composition (total amount of the ingredients 1 and 2). Even when the silane-grafted thermoplastic resin composition is used, adhesiveness to glass and plastics, which is equal to or higher than that in the case of the silane coupling agent blend, is obtained.

In the case where an organic peroxide is used, the organic peroxide is in an amount of usually preferably 0.001 part by weight and more preferably 0.01 part by weight or more based on 100 parts by weight of the thermoplastic resin composition (total amount of the ingredients 1 and 2). Also, it is usually preferably 5 parts by weight or less and more preferably 3 parts by weight or less.

Moreover, as the encapsulating material 5, a copolymer composed of an ethylene-α-olefin copolymer can be used. As the copolymer, there is exemplified a laminate film having a hot tackiness of 5 to 25°C, which is formed by laminating a resin composition for encapsulating material composed of the ingredients A and B shown below and a base material.

Ingredient A: an ethylene-based resin.

Ingredient B: a copolymer of ethylene and an α-olefin, which has the following properties (a) to (d).

(a) Density is 0.86 to 0.935 g/cm$^3$.
(b) A melt flow rate (MFR) is 1 to 50 g/10 minutes.
(c) One peak is present in an elution curve obtained by temperature rising elution fractionation (TREF); the peak temperature is 100°C or lower.
(d) An integral elution amount by the temperature rising elution fractionation (TREF) is 90% or more at 90°C.

The blending ratio of the ingredient A and the ingredient B (ingredient A/ingredient B) is usually preferably 50/50 or more, more preferably 55/45 or more, and further preferably 60/40 or more. Also, it is usually preferably 99/1 or less, more preferably 90/10 or less, and further preferably 85/15 or less. By increasing the blending amount of the ingredient B, transparency and heat sealing ability tend to increase. By decreasing the blending amount of the ingredient B, workability of the film tends to increase.

The melt flow rate (MFR) of the resin composition for encapsulating material blended with the ingredients A and B is usually preferably 2 g/10 minutes or more, more preferably 3 g/10 minutes or more and usually preferably 50 g/10 minutes or less, more preferably 40 g/10 minutes or less. Incidentally, the measurement and evaluation of MFR can be carried out by a method in accordance with JIS K7210 (190°C, load of 2.16 kg).

The melting point of the resin composition for encapsulating material is usually preferably 50°C or higher, more preferably 55°C or higher and usually preferably 300°C or lower, more preferably 250°C or lower, and further preferably 200°C or lower. By controlling the melting point to a higher temperature, a possibility that the composition might be melted/deteriorated can be reduced at the use of the thin-film solar cell 14.

The density of the resin composition for encapsulating material is usually preferably 0.80 g/cm$^3$ or more, more preferably 0.85 g/cm$^3$ or more and preferably 0.98 g/cm$^3$ or less, more preferably 0.95 g/cm$^3$ or less, and further preferably 0.94 g/cm$^3$ or less. Incidentally, the measurement and evaluation of the density can be carried out by a method in accordance with JIS K7112.

Furthermore, in the encapsulating material 5 using the ethylene-α-olefin copolymer, it is possible to use a coupling agent as in the case where the above propylene-ethylene-α-olefin copolymer is used.

Since the aforementioned encapsulating material 5 does not generate any decomposition gas derived from its material, no adverse influence on the solar cell device 6 is observed and the material has good heat resistance, mechanical strength, flexibility (solar cell encapsulating ability), and transparency. Moreover, since a crosslinking step of the material is not necessary, the production time at sheet formation and for the thin-film solar cell 14 can be shortened to a large extent and also recycle of the thin-film solar cell 14 after use becomes easy.

Incidentally, the encapsulating material 5 may be formed of one kind of material or two or more kinds of materials. Moreover, the encapsulating material 5 may be formed of a monolayer film but may be a laminated film composed of a film having two or more layers.

The thickness of the encapsulating material 5 is not particularly defined but is usually preferably 2 μm or more, more preferably 5 μm or more, and further preferably 10 μm or more. Moreover, it is usually preferably 500 μm or less, more preferably 300 μm or less, and further preferably 100 μm or less. By increasing the thickness, mechanical strength tends to increase. By decreasing the thickness, flexibility increases and light transmittance tends to increase.

The position at which the encapsulating material 5 is provided is not limited but it is usually provided so as to

sandwich the solar cell device 6. It is because the solar cell device 6 is surely protected. In the present embodiment, the encapsulating materials 5 and 7 are provided on the front face and the back face of the solar cell device 6, respectively.

[Solar cell device 6]

The solar cell device 6 is the same as the above photoelectric conversion device.

Connection of solar cell devices one another

Only one piece of the solar cell device 6 may be provided per one cell of the thin-film solar cell 14 but usually, two or more pieces of the solar cell device 6 are provided. Specific number of pieces of the solar cell device 6 may be arbitrarily set. In the case where a plurality of pieces of the solar cell device 6 are provided, the solar cell device 6 is frequently provided with aligning it in an array shape.

In the case where a plurality of pieces of the solar cell device 6 are provided, usually, the pieces of the solar cell device 6 are electrically connected to one another and electricity generated from a group of the connected solar cell devices 6 is extracted from terminals (not shown in the figures). On this occasion, for increasing voltage, usually, the solar cell devices are serially connected.

In the case where the solar cell devices 6 are thus connected to one another, distance between the solar cell devices 6 is preferably small and, as a result, the gap between the solar cell device 6 and the solar cell device 6 is preferably narrow. The reason is that the light-receiving area of the solar cell device 6 is broadened and light income is increased to increase the electric power generation of the thin-film solar cell 14.

[Encapsulating material 7]

The encapsulating material 7 is a film the same as the aforementioned encapsulating material 5. The same one as the encapsulating material 7 can be similarly used except that the position to be provided is different.

Moreover, since the constituting members present at the back face side from the solar cell device 6 do not necessarily transmit visible light, one which does not transmit visible light can be also used.

[Getter material film 8]

The getter material film 8 is a film the same as the aforementioned getter material film 4. The same one as the getter material film 4 can be similarly used except that the position to be provided is different.

Moreover, since the constituting members present at the back face side from the solar cell device 6 do not necessarily transmit visible light, one which does not transmit visible light can be also used. Also, it becomes possible to use a film containing the water or oxygen absorber in a larger amount than the amount included in the getter material film 4. As such an absorber, there may be mentioned CaO, BaO, and Zr-Al-BaO as the water absorbers and activated carbon, molecular sieves, and the like as the oxygen absorbers.

[Gas barrier film 9]

The gas barrier film 9 is a film the same as the aforementioned gas barrier film 3. The same one as the gas barrier film 9 can be similarly used except that the position to be provided is different.

Moreover, since the constituting members present at the back face side from the solar cell device 6 do not necessarily transmit visible light, one which does not transmit visible light can be also used.

[Back sheet 10]

The back sheet 10 is a film the same as the aforementioned weather-resistant protective film 1. The same one as the weather-resistant protective film 1 can be similarly used except that the position to be provided is different. When the back sheet 10 is difficult to permeate water and oxygen, it is also possible to function the back sheet as a gas barrier layer.

Moreover, since the constituting members present at the back face side from the solar cell device 6 do not necessarily transmit visible light, one which does not transmit visible light can be also used. Therefore, as the back sheet 10, it is particularly preferred to use (i) to (iv) to be explained below.

(i) As the back sheet 10, films or sheets of various resins excellent in strength and excellent in weather resistance,

heat resistance, water resistance, and light resistance can be used. For example, use can be made of sheets of various resins such as polyethylene-based resins, polypropylene-based resins, cyclic polyolefin-based resins, polystyrene-based resins, acrylonitrile-styrene copolymers (AS resins), acrylonitrile-butadiene-styrene copolymers (ABS resins), polyvinyl chloride-based resins, fluorocarbon-based resins, poly(meth)acrylic resins, polycarbonate-based resins, polyester-based resins such as polyethylene terephthalate and polyethylene naphthalate, polyamide-based resins such as various nylons, polyimide-based resins, polyamideimide-based resins, polyaryl phthalate-based resins, silicon-based resins, polysulfone-based resins, polyphenylene sulfide-based resins, polyether sulfone-based resins, polyurethane-based resins, polyacetal-based resins, cellulose-based resins, and the like.

Of the sheets of these resins, use of the sheets of fluorocarbon-based resins, cyclic polyolefin-based resins, polycarbonate-based resins, poly(meth)acrylic resins, polyamide-based resins, and polyester-based resins is preferred. Incidentally, one kind of them may be used or two or more kinds thereof may be simultaneously used in any combination and ratio.

(ii) As the back sheet 10, a metal thin film can be also used. Examples thereof include aluminum metal foils subjected to anticorrosion, stainless steel-made thin films, and the like. Incidentally, one kind of the above metals may be used or two or more kinds thereof may be simultaneously used in any combination and ratio.

(iii) As the back sheet 10, for example, a highly waterproof sheet in which a fluorocarbon-based resin film is adhered to both faces of an aluminum foil may be used. Examples of the fluorocarbon-based resin include ethylene monofluoride (trade name: Tedler, manufactured by E.I. du Pont de Nemours and Company), polytetrafluoroethylene (PTFE), copolymers of tetrafluoroethylene and ethylene or propylene (ETFE), vinylidene fluoride-based resins (PVDF), vinyl fluoride-based resins (PVF), and the like. Incidentally, one kind of the fluorocarbon-based resins may be used or two or more kinds thereof may be simultaneously used in any combination and ratio.

(iv) As the back sheet 10, for example, use may be made of one in which a vapor deposited film of an inorganic oxide is provided on one or both sides of a base material film and further a heat-resistant polypropylene-based resin film is laminated on both sides of the base material film provided with the above vapor deposited film of an inorganic oxide. Usually, in the case where the polypropylene-based resin film is laminated on the base material film, the lamination is performed by attachment with an adhesive for lamination. By providing the vapor deposited film of an inorganic oxide, the laminated film can be used as the back sheet 10 excellent in moisture barrier properties, which prevents intrusion of water, oxygen, and the like.

Base material film

As the base material film, fundamentally, films of various resins excellent in close adhesiveness to the vapor deposited film of an inorganic oxide, excellent in strength, and excellent in weather resistance, heat resistance, water resistance, and light resistance can be used.

For example, use can be made of films of various resins such as polyethylene-based resins, polypropylene-based resins, cyclic polyolefin-based resins, polystyrene-based resins, acrylonitrile-styrene copolymers (AS resins), acrylonitrile-butadiene-styrene copolymers (ABS resins), polyvinyl chloride-based resins, fluorocarbon-based resins, poly(meth)acrylic resins, polycarbonate-based resins, polyester-based resins such as polyethylene terephthalate and polyethylene naphthalate, polyamide-based resins such as various nylons, polyimide-based resins, polyamideimide-based resins, polyaryl phthalate-based resins, silicon-based resins, polysulfone-based resins, polyphenylene sulfide-based resins, polyether sulfone-based resins, polyurethane-based resins, polyacetal-based resins, cellulose-based resins, and the like.

Of these, use of the sheets of fluorocarbon-based resins, cyclic polyolefin-based resins, polycarbonate-based resins, poly(meth)acrylic resins, polyamide-based resins, and polyester-based resins is preferred.

Of the films of various resins as above, for example, use of the films of the fluorocarbon-based resins such as polytetrafluoroethylene (PTFE), vinylidene fluoride-based resins (PVDF), and vinyl fluoride-based resins (PVF) is more preferred.

Furthermore, of the films of the fluorocarbon-based resins, particularly, vinyl fluoride-based resins (PVF) or a copolymer of tetrafluoroethylene and ethylene or propylene (ETFE) is particularly preferred from the viewpoint of strength

and the like. Incidentally, one kind of the above resins may be used or two or more kinds thereof may be simultaneously used in any combination and ratio.

Moreover, of the films of various resins as above, use of the films of the cyclic polyolefin-based resins such as cyclopentadiene and derivatives thereof and cyclohexadiene and derivatives thereof is also more preferred. The film thickness of the base material film is usually preferably 12 μm or more, more preferably 20 μm or more and usually preferably 300 μm or less, more preferably 200 μm or less.

Vapor deposited film of inorganic oxide

As the vapor deposited film of an inorganic oxide, fundamentally, any thin film on which a metal oxide is vapor deposited can be used. For example, vapor deposited films of oxides of silicon (Si) and aluminum (Al) can be used. On this occasion, $SiO_x$ (x = 1.0 to 2.0) can be, for example, used as silicon oxide and $AlO_x$ (x = 0.5 to 1.5) can be, for example, used as aluminum oxide.

Incidentally, the kind of each of the metal and the inorganic oxide may be a single kind, or two or more kinds thereof may be simultaneously used in any combination and ratio.

The film thickness of the vapor deposited film of the inorganic oxide is usually preferably 50 angstrom or more, more preferably 100 angstrom or more and usually preferably 4000 angstrom or less, more preferably 1000 angstrom or less.

As methods of making the vapor deposited films, use can be made of chemical vapor deposition methods (CVD methods) such as a plasma chemical vapor growth method, a thermochemical vapor growth method, and photochemical vapor growth method can be used. Specifically, a vapor deposited film of an inorganic oxide such as silicon oxide can be formed on one face of a base material film using a monomer gas for vapor deposition such as an organic silicon compound as a starting material, employing an inert gas such as argon gas or helium gas as a carrier gas, further using oxygen gas or the like as an oxygen-supply gas, and using a low-temperature plasma chemical vapor growth method which utilizes a low-temperature plasma generating apparatus or the like.

Polypropylene-based resin film

As the polypropylene-based resin, for example, a propylene homopolymer; copolymers of propylene and other monomers (e.g., α-olefins) can be used. Moreover, as the polypropylene-based resin, isotactic polymers can be also used.

The melting point of the polypropylene-based resin is usually preferably 164°C to 170°C, the specific gravity thereof is usually preferably 0.90 to 0.91, and the molecular weight thereof is usually preferably 100,000 to 200, 000.

The nature of the polypropylene-based resin is dependent on crystallinity thereof to a large extent. A polymer having a high isotacticity is excellent in tensile strength and impact strength, has a good heat resistance and fatigue strength from flexing, and has an extremely good processability.

Adhesive

In the case where a polypropylene-based resin film is laminated on a base material film, an adhesive for lamination is usually used. Thereby, the base material film and the polypropylene-based resin film are laminated through a layer of the adhesive for lamination.

Examples of the adhesive for constituting the layer of the adhesive for lamination include polyvinyl acetate-based adhesives, polyacrylate ester-based adhesives, cyanoacrylate-based adhesives, ethylene copolymer-based adhesives, cellulose-based adhesives, polyester-based adhesives, polyamide-based adhesives, polyimide-based adhesives, amino resin-based adhesives, phenol resin-based adhesives, epoxy-based adhesives, polyurethane-based adhesives, reactive (meth)acrylic adhesives, silicon-based adhesives, and the like. Incidentally, one kind of the adhesives may be used or two or more kinds thereof may be simultaneously used in any combination and ratio.

The composition system of the above adhesive may be any composition form of an aqueous type, a solution type, an emulsion type, a dispersion type, and the like. Moreover, the shape thereof may be any form of a film/sheet shape, a powder, a solid, and the like. Furthermore, with regard to the adhesion mechanism, any mode of a chemical reaction type, a solvent evaporation type, a thermal melting type, a thermal pressure type, and the like may be possible.

The above adhesive can be, for example, applied by coating methods such as a roll coating method, a gravure coating method, a kiss coating method, and the like, as well as a printing method and the like. The coating amount is preferably 0.1 $g/m^2$ to 10 $g/m^2$ in a dried state.

[Sealing material 11]

The sealing material 11 is a sealing member which seals edge parts of the aforementioned weather-resistant

protective film 1, ultraviolet ray-cutting film 2, gas barrier film 3, getter material film 4, encapsulating material 5, encapsulating material 7, getter material film 8, encapsulating material 9, and back sheet 10 so that moisture and oxygen do not enter into a space covered with these films.

With regard to the degree of moisture proof ability required for the sealing material 11, water vapor permeability per unit area (1 $m^2$) per day is preferably 0.1 g/$m^2$/day or less and more preferably 0.05 g/$m^2$/day or less.

Since the sealing material 11 having such a high moisture proof ability was hitherto difficult to mount, it was difficult to realize a solar cell provided with an excellent solar cell device such as a compound semiconductor-based solar cell device or an organic solar cell device. However, by applying such a sealing material 11, it becomes easy to actually use a thin-film solar cell 14 with making the best use of excellent properties of the compound semiconductor-based solar cell device and the organic solar cell device.

Furthermore, since the thin-film solar cell 14 is frequently heated with receiving light, the sealing material 11 also preferably has durability against heat. From this viewpoint, the melting point of constituting material of the sealing material 11 is usually preferably 100°C or higher, more preferably 120°C or higher, and further preferably 130°C or higher. Moreover, it is usually preferably 250°C or lower, more preferably 200°C or lower, and further preferably 180°C or lower. By controlling the melting point to 100°C or higher, a possibility that the sealing material 11 might be melted can be reduced at the use of the thin-film solar cell 14.

Examples of the material constituting the sealing material 11 include polymers such as fluorocarbon-based resins, silicon-based resins, and acrylic resins.

Incidentally, the sealing material 11 may be formed of one kind of material or two or more kinds of materials.

The sealing material 11 is provided on a position at which the edge parts of at least the gas barrier films 3 and 9 can be sealed. Thereby, a space surrounded with at least the gas barrier films 3 and 9 and the sealing material 11 can be sealed so that moisture and oxygen cannot be penetrated into the space.

The method for forming the sealing material 11 is not limited but, for example, it can be formed by injecting its material between the weather-resistant protective film 1 and the back sheet 10. As a specific example of the forming method, the following method may be mentioned.

Namely, for example, on the way of the proceeding of curing of the encapsulating material 5, the thin-film solar cell 14 in a semi-cured state is taken out of the above lamination apparatus, a liquid polymer is injected into a part between the weather-resistant protective film 1 and the back sheet 10, which is an outer peripheral part of the solar cell device 6, and then the polymer is cured together with the encapsulating material 5.

Moreover, after the curing of the encapsulating material 5 is finished, the solar cell is taken out of the above lamination apparatus and the polymer may be singly cured. The temperature range for crosslinking/curing the above polymer is usually preferably 130°C or higher and more preferably 140°C or higher. Also, it is usually preferably 180°C or lower and more preferably 170°C or lower.

[Size etc.]

The thin-film solar cell 14 of the present embodiment is usually a film-shaped thin member. By thus forming the thin-film solar cell 14 as a film-shaped member, the thin-film solar cell 14 can be easily placed in building materials, automobiles, the interior, and the like. The thin-film solar cell 14 is light and is hardly broken and thus a highly safe solar cell is obtained. In addition, the solar cell is applicable to a curved face and hence can be used in further larger number of uses. Since it is thin and light, it is also preferred in view of distribution, e.g., transportation and storage. Furthermore, owing to the film-shape, it is possible to produce it in a roll-to-roll fashion and thus drastic cost reduction is possible.

Specific size of the thin-film solar cell 14 is not limited but the thickness is usually preferably 300 μm or more, more preferably 500 μm or more, and further preferably 700 μm or more. Also, it is usually preferably 3000 μm or less, more preferably 2000 μm or less, and further preferably 1500 μm or less.

[Production method]

The production method of the thin-film solar cell 14 of the present embodiment is not limited but, for example, it can be produced by laminating one in which one piece or two or more pieces of the solar cell device 6 are connected serially or in parallel between the weather-resistant protective film 1 and the back sheet 10, together with the ultraviolet ray-cutting film 2, the gas barrier films 3 and 9, getter material films 4 and 8, and the encapsulating materials 5 and 7 by means of a common vacuum laminating apparatus.

On this occasion, the heating temperature is usually preferably 130°C or higher and more preferably 140°C or higher. Also, it is usually preferably 180°C or lower and more preferably 170°C or lower.

Moreover, the heating time is usually preferably 10 minutes or more and more preferably 20 minutes or more. Also, it is usually preferably 100 minutes or less and more preferably 90 minutes or less.

The pressure is usually preferably 0.001 MPa or more and more preferably 0.01 MPa or more. Also, it is usually

preferably 0.2 MPa or less and more preferably 0.1 MPa or less. By controlling the pressure to the range, encapsulation is surely performed and film thickness decrease owing to extrusion of the encapsulating materials 5 and 7 from the edge parts and over pressurization is suppressed, so that dimensional stability can be secured.

[Uses]

Uses of the aforementioned thin-film solar cell 14 are not limited and arbitrary. For example, as schematically shown in Fig. 3, it is sufficient that a solar cell unit 13 in which the thin-film solar cell 14 is provided on some base material 12 is prepared and it is placed at a service space and used. As a specific example, in the case where a board for building material is used as the base material 12, it is sufficient that the thin-film solar cell 14 is provided on the surface of the board to make a solar cell panel as the solar cell unit 13 and the solar cell panel is placed on an outer wall of a building and used.

The base material 12 is a supporting member which supports the solar cell device 6. Examples of the material for forming the base material 12 include inorganic materials such as glass, sapphire, and titania; organic materials such as polyethylene terephthalate, polyethylene naphthalate, polyether sulfones, polyimides, nylons, polystyrene, polyvinyl alcohol, ethylene-vinyl alcohol copolymers, fluorocarbon resin films, vinyl chloride, polyethylene, cellulose, polyvinylidene chloride, aramide, polyphenylene sulfide, polyurethanes, polycarbonates, polyarylates, and polynorbornene; paper materials such as paper and synthetic paper; composite materials such as those in which metals such as stainless steel, titanium, and aluminum are surface-coated or laminated for imparting insulating properties; and the like.

Incidentally, one kind of the material of the base material may be used or two or more kinds thereof may be simultaneously used in any combination and ratio. Moreover, these organic materials or paper materials may be included with carbon fibers to increase mechanical strength.

As examples of the field to which the thin-film solar cell is applied, the cell is suitably used as solar cells for building materials, solar cells for automobiles, solar cells for the interior, solar cells for railroads, solar cells for marine vessels, solar cells for aircraft, solar cells for space craft, solar cells for household electric appliances, solar cells for cellular phones, solar cells for toys, and the like. As specific examples, the following may be mentioned.

1. Building Use

1.1 Solar cell as house roof material

In the case where a board for roof or the like is used as a base material, it is sufficient that the thin-film solar cell is provided on the surface of the board to make a solar cell panel as a solar cell unit and the solar cell panel is placed on the roof of a house and used. Moreover, a tile can be also directly used as a base material. Making the best use of the characteristic property that the solar cell of the invention has flexibility, the cell can be closely adhered to the curve of the tile, so that the cell is suitable.

1.2 Rooftop

The cell can be also attached to the rooftop of a building. A solar cell unit having the thin-film solar cell provided on a base material is prepared and the unit can be also placed on the rooftop of a building. On this occasion, it is preferred to simultaneously use a waterproof sheet together with the base material to exhibit waterproof action. Furthermore, making the best use of the characteristic property that the thin-film solar cell of the invention has flexibility, the cell can be closely adhered to a non-flat roof, for example, a folded-plate roof. Also in this case, it is preferred to simultaneously use a waterproof sheet.

1.3 Top light

The thin-film solar cell of the invention can be used at entrances and well hole parts as the exterior. At entrances and the like subjected to some design processing, curves are frequently used, and the best use of the flexibility of the thin-film solar cell of the invention is made in such cases. Moreover, there is a case of a see-through entrance or the like. In such a case, since designed beauty is also obtained, the greenish color of the organic solar cell is suitable in an age where environmental measures are emphasized.

1.4 Wall

In the case where a board for building material is used as a base material, it is sufficient that the thin-film solar cell is provided on the surface of the board to make a solar cell panel as a solar cell unit and the solar cell panel is placed

on the outer wall and the like of the building and used. Moreover, the unit can be also placed on a curtain wall. In addition, the unit is also possible to attach it to spandrels, mullions, and the like.

In this case, the shape of the base material is not limited but usually, a board is used. Moreover, the material, size, and the like of the base material may be arbitrarily set depending on the usage environment. As examples of such a base material, ALPOLIC (registered trademark; manufactured by Mitsubishi Plastics, Inc.) and the like may be mentioned.

1.5 Window

Moreover, the cell can be also used for see-through windows. Since designed beauty is also obtained, the greenish color of the organic solar cell is suitable in an age where environmental measures are emphasized.

1.6 Others

As the other building exterior, the cell can be also used for eaves, louvers, handrails, and the like. Also in such cases, the flexibility of the thin-film solar cell of the invention is suitable for these uses.

2. Interior

The thin-film solar cell of the invention can be also attached to slats of blinds. Since the thin-film solar cell of the invention is light in weight and rich in flexibility, such uses becomes possible. Moreover, with regard to windows for contents, the cell can be used with making the best use of the characteristic property that the organic solar cell device is see-through.

3. Vegetable plant

The number of vegetable plants in which lighting such as a fluorescent light is utilized is increasing but it is an actual situation that cultivation costs are difficult to reduce owing to electricity expense required for lighting, costs for replacing light sources, and the like. Therefore, the thin-film solar cell of the invention can be placed in the vegetable plants and a lighting system in combination with LED or fluorescent lamps can be made.

At that time, when use is made of a lighting system in which the solar cell of the invention is combined with LED having a life longer than that of a fluorescent lamp, the system is suitable because the costs required for lighting can be reduced by about 30% as compared with the current system. Moreover, the solar cell of the invention can be used on the roof and sidewalls of reefer containers which transport vegetables and the like at a constant temperature.

4. Road material/civil engineering

The thin-film solar cell of the invention can be also used on outer walls of parking spaces, sound barriers of expressways, and outer walls of water purification plants, and the like.

5. Automobile

The thin-film solar cell of the invention can be used on the surfaces of hoods, roofs, trunk lids, doors, front fenders, rear fenders, pillars, bumpers, rearview mirrors, and the like. The obtained electric power can be supplied to any of drive motors, batteries for motor drive, electrical equipment, batteries for electrical equipment. By providing a control means selected according to a power generating state in the solar cell panel and an electricity using state in the drive motor, the batteries for motor drive, the electrical equipment, and the batteries for electrical equipment, the obtained electric power can be properly and efficiently used.

In the case described above, the shape of the base material 12 is not limited but usually, a board is used. Moreover, the material, size, and the like of the base material 12 may be arbitrarily set depending on the usage environment.

As examples of such a base material 12, ALPOLIC (registered trademark; manufactured by Mitsubishi Plastics, Inc.) and the like may be mentioned.

[Examples]

The following will specifically explain the invention with reference to Examples but the invention is not limited to the following examples unless it exceeds the gist thereof.

(Synthetic Example 1)

Synthetic Example of $POPy_2$
[Chem 65]

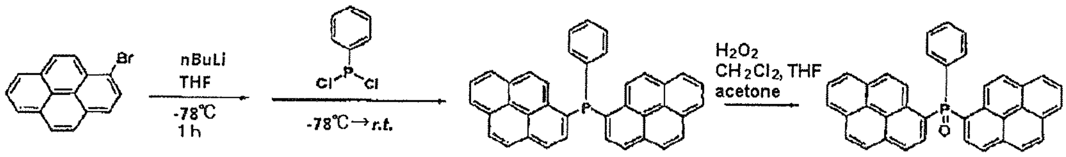


($POPy_2$)

Under a nitrogen atmosphere, after 1-bromopyrene (Tokyo Chemical Industry Co., Ltd.: 14 g, 50 mmol) was dissolved in dehydrated THF (Kanto Chemical Co., Inc.: 200 mL) and cooled to -78°C, n-BuLi (Kanto Chemical Co., Inc.: 33 mL, 1.6M) was slowly added dropwise, followed by stirring for 30 minutes with maintaining - 78°C. Subsequently, after dichlorophenylphosphine (Tokyo Chemical Industry Co., Ltd.: 4.3 g, 9.0 mmol) was added dropwise and the whole was sufficiently stirred, the temperature was elevated to room temperature, followed by stirring for 1.5 h. Then, 30 mL of methanol (Junsei Chemical Co., Ltd.) was added to the resulting reaction solution and the resulting raw purified product was filtrated and recrystallized from benzene to thereby obtain 10.7 g of the objective compound.
The compound obtained here was dissolved in 350 mL of THF (Junsei Chemical Co., Ltd.), 300 mL of $CH_2Cl_2$ (Kanto Chemical Co., Inc.), and 100 mL of acetone (Kanto Chemical Co., Inc.), and a hydrogen peroxide solution (Wako Pure Chemical Industries, Ltd.: 10 mL of a 30% by weight solution) was added, followed by stirring at room temperature for 30 minutes. After 30 mL of water was added to the reaction solution and the whole was concentrated to 600 mL, filtration was performed to thereby obtain 7.5 g of the objective compound ($POPy_2$).

(Synthetic Example 2)

Synthesis of F-$POPy_2$
[Chem 66]

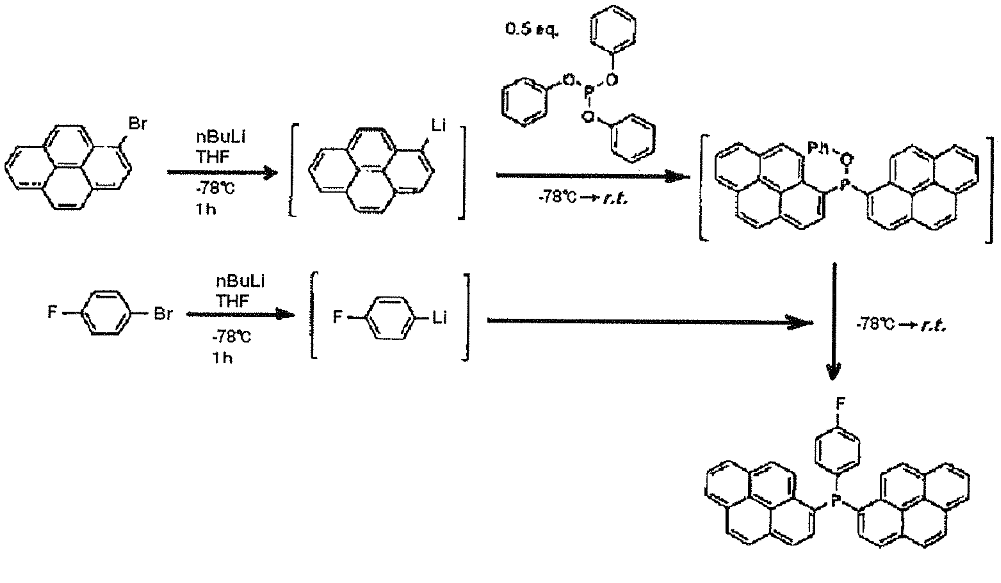


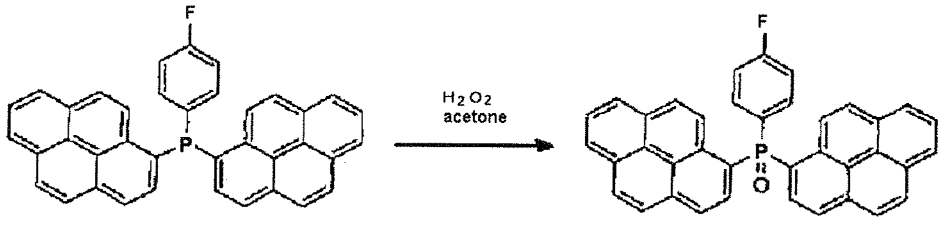


(F-POPy2)

Under a nitrogen atmosphere, after 1-bromopyrene (Tokyo Chemical Industry Co., Ltd.: 5.6 g, 20 mmol) was dissolved in dehydrated THF (Kanto Chemical Co., Inc.: 100 mL) and cooled to -78°C, n-BuLi (Kanto Chemical Co., Inc.: 13 mL, 1.6M) was slowly added dropwise, followed by stirring for 45 minutes with maintaining - 78°C. Subsequently, after triphenyl phosphite (Wako Pure Chemical Industries, Ltd.: 3.1 g, 10 mmol) was added dropwise and the whole was sufficiently stirred, the temperature was elevated to room temperature and the whole was stirred for 1.5 h and then again cooled to -78°C. On the other hand, 4-fluorobromobenzene (Tokyo Chemical Industry Co., Ltd.: 3.5 g, 20 mmol) was dissolved in dehydrated THF (50 mL) in another reaction vessel and n-BuLi (Kanto Chemical Co., Inc.: 13 mL, 1.6M) was added in a state of -78°C under a nitrogen atmosphere, followed by stirring for 30 minutes. Thereafter, the solution was added dropwise to the first vessel and the temperature was elevated to room temperature, followed by stirring for 1 hour.

Then, 20 mL of water was added to the resulting reaction solution, THF was removed by evaporation under reduced pressure, and extraction was performed with methylene dichloride. After magnesium sulfate was added to the organic layer and the layer was dried, it was filtrated and concentrated and purification was performed by column chromatography (eluent: hexane) to thereby obtain 3.7 g of an objective compound. The compound obtained here was dissolved in acetone (Kanto Chemical Co., Inc.: 150 mL) and a hydrogen peroxide solution (Wako Pure Chemical Industries, Ltd.: 2 mL of a 30% by weight solution) was added, followed by stirring at room temperature. After 20 mL of water was added to the reaction solution and the mixture was concentrated, washing with acetonitrile was performed to thereby obtain 1.9 g of the objective compound (F-POPy$_2$).

(Synthetic Example 3)

Synthesis of BINAPO

[Chem 67]

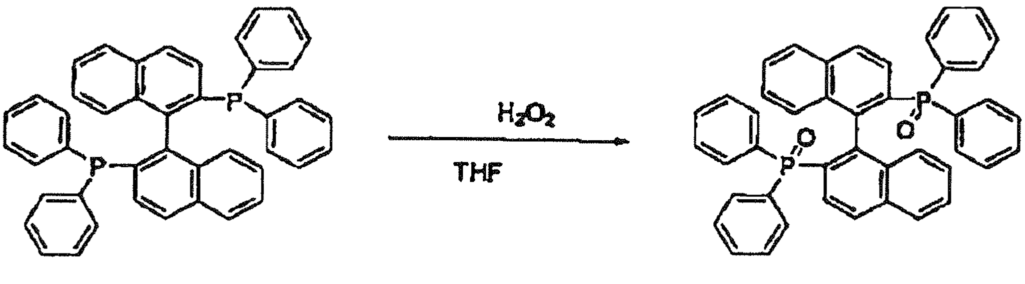


(BINAP) (BINAPO)

A 30% by weight hydrogen peroxide solution (Wako Pure Chemical Industries, Ltd.: 3 mL) was added to a THF (80 mL) solution of BINAP (Wako Pure Chemical Industries, Ltd.: 1.86 g, 3 mmol), followed by stirring for 2.5 hours. Water was added in an amount of 20 mL, THF was removed by evaporation under reduced pressure, and the resulting raw purified product was washed with methanol and filtrated to thereby obtain objective BINAPO (1.78 g, 2.7 mmol) in 91% yield. The obtained product was identified by mass spectrometry.

(Synthetic Example 4)

Synthesis of POSFPO

[Chem 68]

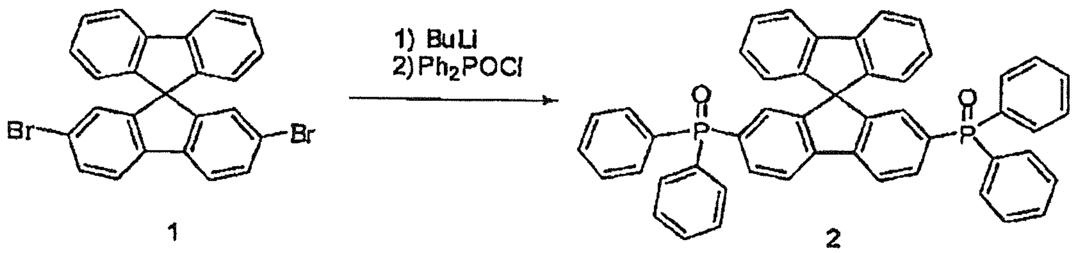


1 2

(POSFPO)

A THF solution of dibromospirofluorene (948 mg, 2 mmol) was cooled at - 78°C under a nitrogen atmosphere and n-BuLi (2.5 mL, 1.6M) was slowly added dropwise. After stirring for 30 minutes, diphenylphosphinic acid chloride (970 mg, 4.1 mmol) was added and the temperature was elevated to room temperature, followed by stirring for 6 hours. After the precipitated raw purified product was filtrated, purification was performed using column chromatography (eluent $CH_2C_2$/MeOH (10/1) and further recrystallization was performed from methanol to thereby obtain objective POSFPO (440 mg, 0.6 mmol) in 30% yield. The obtained product was identified by mass spectrometry. The purity by HPLC method was 99% or more.

(Synthetic Example 5)

Synthesis of POMXPO

[Chem 69]

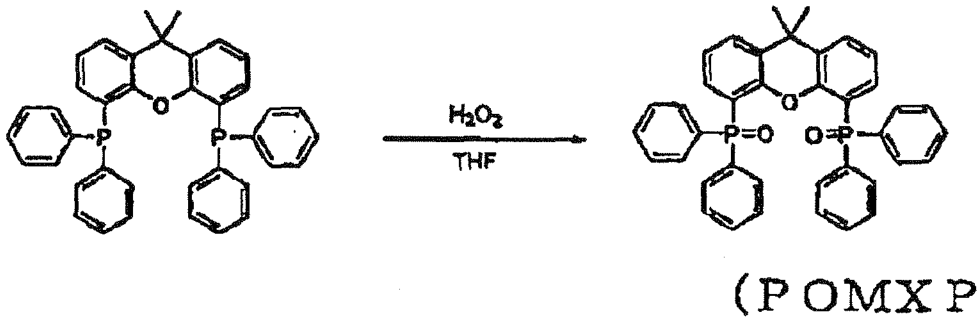


(POMXPO)

To 300 mL flask were added 2 g (3.45 mmol) of 4,5-bis(diphenylphosphino)-9,9-dimethylxanthene and 120 mL of tetrahydrofuran, the whole was stirred to form a homogeneous solution. After 5 mL of a 30% by weight hydrogen peroxide solution was added and the whole was stirred for 20 minutes, disappearance of the starting material was confirmed by TLC. After the solution was concentrated by evaporation under reduced pressure, it was transformed into a suspension solution with water and a white powder was collected by filtration. Using mass spectrometry (DEI, DCI method), m/z:610[M] coincident with the molecular weight of the objective compound (POMXPO) was detected.

(Synthetic Example 6)

Synthesis of POFBPO

[Chem 70]

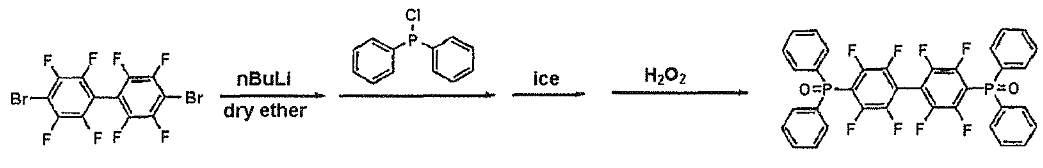


(POFBPO)

To a 200 mL three-necked flask was added 3 g (6.6 mmol) of 4,4'-dibromooctafluorobiphenyl, and $N_2$ replacement was performed. Dehydrated THF was added in an amount of 50 mL to form a solution, which was then cooled over a dry ice-acetone bath. After the inner temperature was confirmed to be -65°C, 10.3 mL (16.5 mmol) of nBuLi (1.6 mol/l in hexane) was slowly added to the system, followed by stirring for 1 hour without further treatment. Thereafter, 2.7 mL (14.5 mmol) of chlorodiphenylphosphine was slowly added and stirring was continued for 30 minutes, the bath was removed and the whole was stirred for 9 hours with elevating the temperature to room temperature. When ice was added until an increase of the inner temperature ceased, 12 mL of a 30% by weight hydrogen peroxide solution was added, and stirring was continued, a white powder was precipitated. When water was added, collection by filtration was performed, and vacuum drying was performed at 80°C, 4.3 g of the objective compound (LC purity of 95%) was obtained. By DEI method, m/z:689[M] coincident with the molecular weight of the objective compound was detected.

(Synthetic Example 7)

Synthesis of SIMEF

[Chem 71]

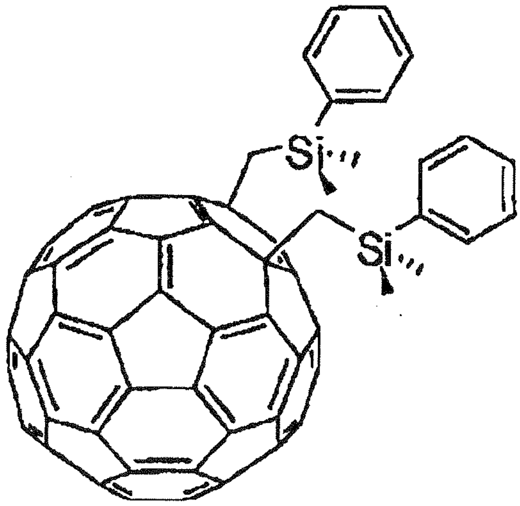

(SIMEF)

Synthesis of SIMEF was performed by the method described in W02009/008323.

(Synthetic Example 8)

Synthesis of $C_{60}(Ind)_2$

[Chem 72]

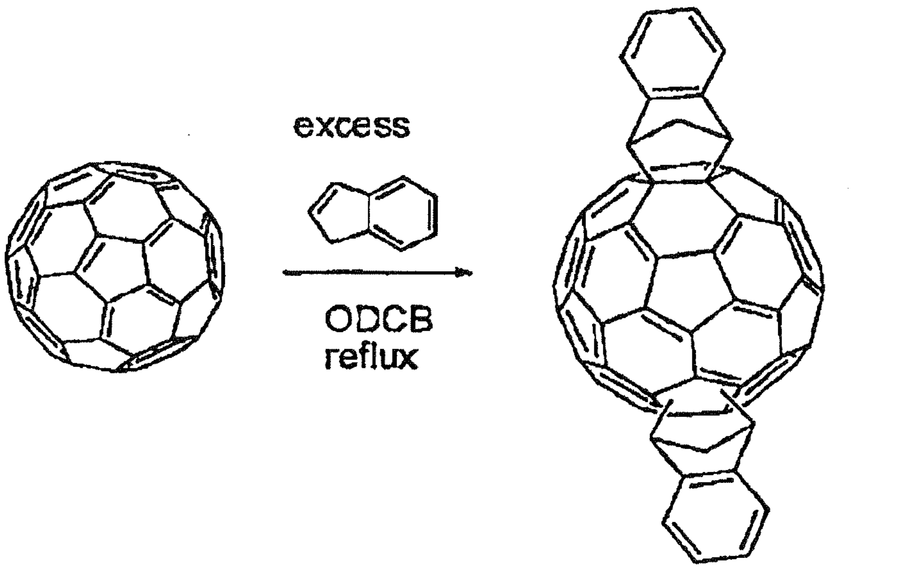


($C_{60}$(Ind)$_2$)

Synthesis of $C_{60}(Ind)_2$ was performed with reference to Patent Document (WO2008/018931) By separation and purification by GPC, the compound was obtained as an isomer mixture of the bis-adduct. By mass spectrometry

(APCI method, negative), m/z:952[M$^-$] coincident with the molecular weight of the objective compound was detected.

(Synthetic Example 9)

Synthesis of $CF_3$-POPy$_2$

[Chem 73]

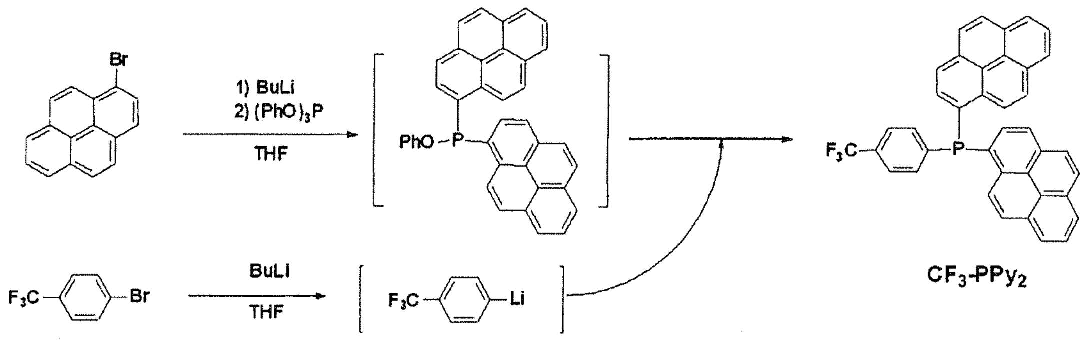


Under a nitrogen atmosphere, after 1-bromopyrene (Tokyo Chemical Industry Co., Ltd.: 5.6 g, 20 mmol) was dissolved in dehydrated THF (Kanto Chemical Co., Inc.: 100 mL) and cooled to -78°C, n-BuLi (Kanto Chemical Co., Inc.: 13 mL, 1.6M) was slowly added dropwise, followed by stirring for 45 minutes with maintaining - 78°C. Subsequently, after triphenyl phosphite (Wako Pure Chemical Industries, Ltd.: 3.1 g, 10 mmol) was added dropwise and the whole was sufficiently stirred, the temperature was elevated to room temperature and the whole was stirred for 1.5 h and then again cooled to -78°C. On the other hand, 4-trifluoromethylbromobenzene (Tokyo Chemical Industry Co., Ltd.: 4.4 g, 20 mmol) was dissolved in dehydrated THF (50 mL) in another reaction vessel and n-BuLi (Kanto Chemical Co., Inc.: 13 mL, 1.6M) was added in a state of -78°C under a nitrogen atmosphere, followed by stirring for 30 minutes. Thereafter, the solution was added dropwise to the first vessel and the temperature was elevated to room temperature, followed by stirring for 1 hour.

Then, 20 mL of water was added to the resulting reaction solution, THF was removed by evaporation under reduced pressure, and extraction was performed with methylene dichloride. After magnesium sulfate was added to the organic layer and the layer was dried, it was filtrated and concentrated and purification was performed by column chromatography (eluent: hexane) to thereby obtain 2.9 g (yield 50%) of the objective compound precursor ($CF_3$-PPy$_2$). In this regard, the identification of the compound was performed using NMR.

[Chem 74]

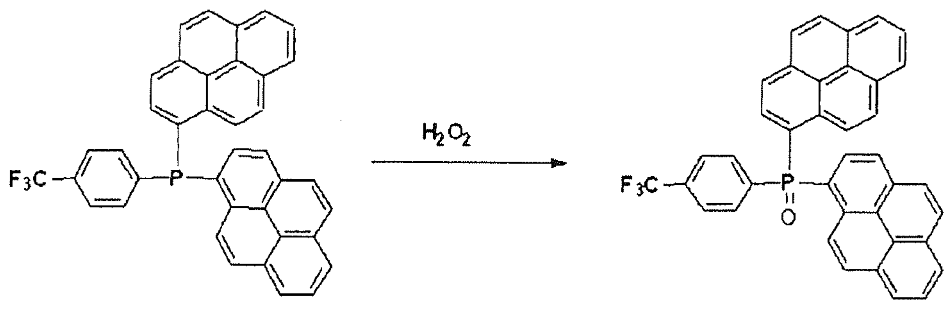


$CF_3-POPy_2$

Then, 2.9 g of the compound obtained above was dissolved in acetone (Kanto Chemical Co., Inc.: 150 mL) and a hydrogen peroxide solution (Wako Pure Chemical Industries, Ltd.: 2 mL of a 30% by weight solution) was added, followed by stirring at room temperature. After 20 mL of water was added to the reaction solution and the mixture was concentrated, washing with acetonitrile was performed to thereby obtain 2.4 g (yield 80%) of the objective compound ($CF_3$-$POPy_2$). The obtained product was confirmed by NMR.

(Synthetic Example 10)

Synthesis of $(CF3)_2$-$POPy_2$

[Chem 75]

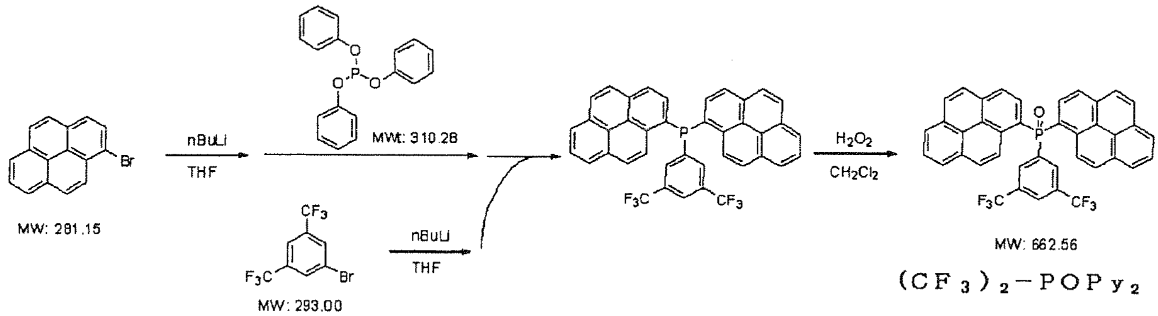


$(CF_3)_2-POPy_2$

Under a nitrogen atmosphere, after 1-bromopyrene (Tokyo Chemical Industry Co., Ltd.: 5.6 g, 20 mmol) was dissolved in dehydrated THF (Kanto Chemical Co., Inc.: 100 mL) and cooled to -78°C, n-BuLi (Kanto Chemical Co., Inc.: 13 mL, 1.6M) was slowly added dropwise, followed by stirring for 30 minutes with maintaining - 78°C. Subsequently, after triphenyl phosphite (Wako Pure Chemical Industries, Ltd.: 3.1 g, 10 mmol) was added dropwise and the whole was sufficiently stirred, the temperature was elevated to room temperature and the whole was stirred for 1.5 h and then again cooled to -78°C.

On the other hand, 3,5-bistrifluoromethylbromobenzene (Tokyo Chemical Industry Co., Ltd.: 5.8 g, 20 mmol) was dissolved in dehydrated THF (50 mL) in another reaction vessel and n-BuLi (Kanto Chemical Co., Inc.: 13 mL, 1.6M) was added in a state of -78°C under a nitrogen atmosphere, followed by stirring for 30 minutes. Thereafter, the solution was added dropwise to the first vessel and the temperature was elevated to room temperature, followed by stirring for 12 hours. Then, 20 mL of water was added to the resulting reaction solution, THF was removed by evaporation under reduced pressure, and extraction was performed with dichloromethane. After magnesium sulfate was added to the organic layer and the layer was dried, it was filtrated and concentrated and purification was performed by column chromatography (eluent: a mixed solvent of hexane and dichloromethane) to thereby obtain 0.9 g of the objective compound precursor. In this regard, the identification of the compound was performed using NMR.

Then, 0.9 g of the compound obtained above was dissolved in dichloromethane (Kanto Chemical Co., Inc.: 100 mL) and a hydrogen peroxide solution (Wako Pure Chemical Industries, Ltd.: 2 mL of a 30% by weight solution) was added, followed by stirring at room temperature. After 20 mL of water was added to the reaction solution and, after

extraction, drying was performed with sodium sulfate and the solvent was removed by evaporation under reduced pressure. Washing with hexane and methanol was performed to thereby obtain 0.6 g (yield 9%) of the objective compound ($(CF3)_2$-$POPy_2$). The obtained product was confirmed by NMR.

(Synthetic Example 11)

Synthesis of PO(TPP)PO

[Chem 76]

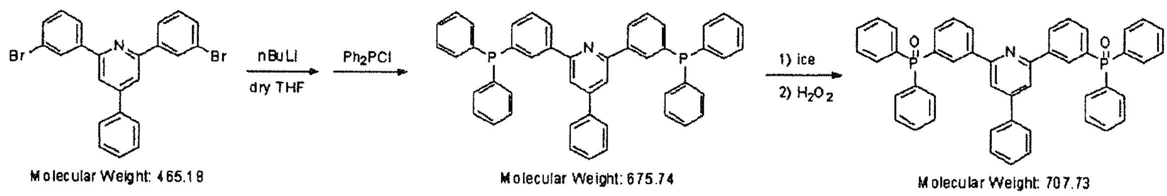


(PO (TPP) PO)

To a 300 mL four-necked flask was added 2.0 g (4.3 mmol) of the starting dibromo compound, and nitrogen replacement was performed. Dehydrated THF was added in an amount of 30 mL to form a solution, which was then cooled over a dry ice-acetone bath. After the inner temperature was confirmed to be -70°C, 6.7 mL (10.8 mmol) of nBuLi (Kanto Chemical Co., Inc.) (1.6 mol/l in hexane) was slowly added to the system, followed by stirring for 1 hour without further treatment. Thereafter, after 1.8 mL (9.5 mmol) of chlorodiphenylphosphine (Tokyo Chemical Industry Co., Ltd.) was slowly added and stirring was continued for 30 minutes without further treatment, the bath was removed and the whole was stirred for 6 hours with elevating the temperature to room temperature. Ice was added until elevation of the inner temperature ceased, 7 mL of a 30% by weight hydrogen peroxide solution (Kanto Chemical Co., Inc.) was added, and stirring was continued. After washing with brine, the mixture was concentrated by evaporation under reduced pressure and a precipitated white powder was collected by filtration. The objective compound having an LC purity of 98% (PO(TPP)PO) was obtained in an amount of 0.6 g. By DEI method, m/z:707[M] coincident with the mass of the objective compound was detected.

(Synthetic Example 12)

Synthesis of $Ph_2POPy$

[Chem 77]

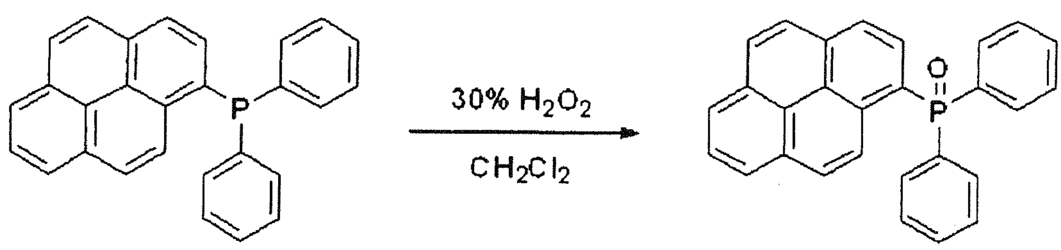


MW: 386.42

MW: 402.42

($Ph_2POPy$)

To 1.0 g (2.6 mmol) of diphenyl-1-pyrenylphosphine (Tokyo Chemical Industry Co., Ltd.) were added 60 mL of dichloromethane and 2.5 mL of a 30% by weight hydrogen peroxide solution, followed by stirring for 30 minutes. Thereafter, after extraction and washing with dichloromethane and brine, drying was performed over magnesium sulfate. Filtration was performed and the solvent was removed by evaporation to obtain a colorless transparent oil. Then, 10 mL of ethanol was added and the whole was stirred to precipitate the objective compound. Filtration and vacuum drying at room temperature afforded 1.0 g (yield 96%) of the objective compound ($Ph_2POPy$).

(Synthetic Example 13)

Synthesis of $BuPOPy_2$
[Chem 78]

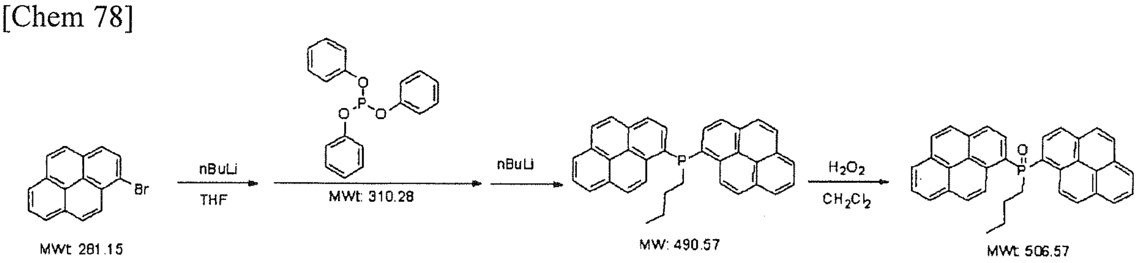


($BuPOPy_2$)

Under a nitrogen atmosphere, after 1-bromopyrene (Tokyo Chemical Industry Co., Ltd.: 5.6 g, 20 mmol) was dissolved in dehydrated THF (Kanto Chemical Co., Inc.: 100 mL) and cooled to -78°C, n-BuLi (Kanto Chemical Co., Inc.: 13 mL, 1.6M) was slowly added dropwise, followed by stirring for 30 minutes with maintaining - 78°C. Subsequently, after triphenyl phosphite (Wako Pure Chemical Industries, Ltd.: 3.1 g, 10 mmol) was added dropwise and the whole was thoroughly stirred, the temperature was elevated to room temperature and the whole was stirred for 1.5 h and then again cooled to -78°C. n-BuLi (Kanto Chemical Co., Inc.: 13 mL, 1.6M) was added and, after stirring for 30 minutes), temperature was elevated to room temperature, followed by stirring for 4 hours. Then, 20 mL of water was added to the resulting reaction solution, THF was removed by evaporation under reduced pressure, and extraction was performed with dichloromethane. After magnesium sulfate was added to the organic layer and the layer was dried, purification was performed by column chromatography (eluent: a mixed solvent of hexane and dichloromethane).

The compound obtained above was dissolved in dichloromethane (Kanto Chemical Co., Inc.: 100 mL) and a hydrogen peroxide solution (Wako Pure Chemical Industries, Ltd.: 5 mL of a 30% by weight solution) was added, followed by stirring at room temperature. After 20 mL of water was added to the reaction solution and, after extraction, the extract was dried over sodium sulfate and the solvent was removed by evaporation under reduced pressure. Recrystallization from hexane and methanol was performed to obtain 1.45 g (yield 29%) of the objective compound ($BuPOPy_2$). The obtained product was confirmed by NMR.

(Synthetic Example 14)

Synthesis of 1,4-$(POPh_2)_2$Py, 1,6-$(POPh_2)_2$Py
[Chem 79]

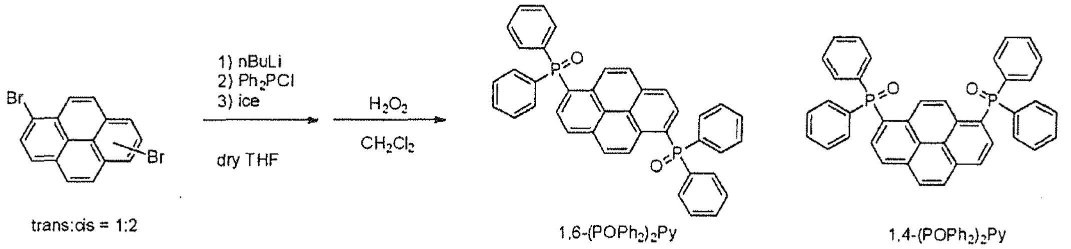


1,6-$(POPh_2)_2$Py

1,4-$(POPh_2)_2$Py

To a 100 mL multi-necked flask were added 1.1 g (3.0 mmol) and 25 mL of dehydrated THF (Kanto Chemical Co., Inc.) and the whole was cooled over a dry ice-acetone bath. After thorough cooling was confirmed, 4.75 mL of an nBuLi/hexane solution (Kanto Chemical Co., Inc.: 1.6 mol/L) was slowly added and cooling was continued at low temperature for 1 hour. Thereafter, 1.2 mL (6.6 mmol) of chlorodiphenylphosphine (Tokyo Chemical Industry Co., Ltd.) was slowly added and stirring was continued at low temperature for 30 minutes. Then, the temperature was elevated to room temperature and stirring was performed for 3 hours.

After quenching with additional water, THF was removed by evaporation and the residue was dissolved in dichloromethane. After 5 mL of a 30% by weight hydrogen peroxide solution (Kanto Chemical Co., Inc.) was added and stirring was performed for 4 hours, extraction and washing with dichloromethane and brine were performed and the extract was dried over magnesium sulfate. After dichloromethane was removed by evaporation under reduced pressure, methanol was added and a precipitated light yellow powder was collected by filtration to obtain 620 mg (1.0 mmol) of 1,6-$(POPh_2)_2$Py after drying. The resulting filtrate was concentrated and then purified by GPC and methanol was added. A precipitated white powder was collected by filtration to obtain 450 mg (0.74 mmol) of 1,4-$(POPh_2)_2$Py after drying.

(Synthetic Example 15)

Synthesis of $AnPOPy_2$

[Chem 80]

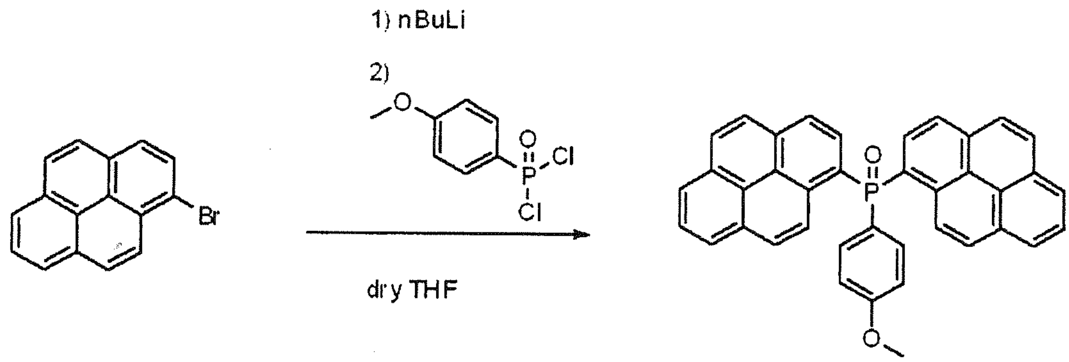


$AnPOPy_2$

Under a nitrogen atmosphere, after 1-bromopyrene (Tokyo Chemical Industry Co., Ltd.: 8.4 g, 30 mmol) and 180 mL of dehydrated THF (Kanto Chemical Co., Inc.) were added and the whole was cooled to -78°C, n-BuLi (Kanto Chemical Co., Inc.: 20 mL, 1.6M) was slowly added dropwise, followed by stirring for 1 hour with maintaining -78°C. Subsequently, after a THF 40 mL solution of 4-methoxyphenylphosphonic acid dichloride (Kanto Chemical Co., Inc.: 3.4 g, 15 mmol) was slowly added and the whole was stirred at low temperature for 30 minutes, the temperature was elevated to room temperature and the whole was stirred for 4 hours. After the reaction solution was filtrated, washing with hexane was performed and then purification was performed by column chromatography (eluent: dichloromethane, methanol) to obtain 2.8 g (yield 33%) of the objective compound ($AnPOPy_2$). The obtained product was confirmed by NMR.

(Synthetic Example 16)

Synthesis of SIMEF2

[Chem 81]

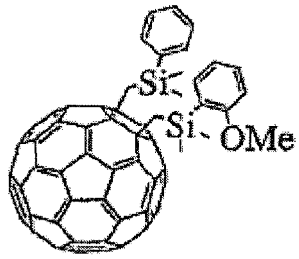

(SIMEF2)

The synthesis of SIMEF2 was performed as follows.

[Intermediate 1]

Chloromethyl(2-methoxyphenyl)dimethylsilane, (o-An)$Me_2SiCH_2Cl$

[Chem 82]

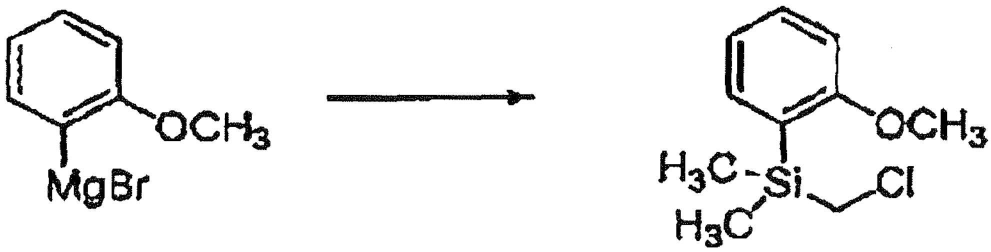

To a 500 mL three-necked flask was placed a 1.0M THF solution of 2-methoxyphenylmagnesium bromide (100 mL, 0.1 mol), followed by stirring at room temperature. Chloromethyldimethylchlorosilane (11.25 mL, 0.085 mmol) was slowly added dropwise thereto. After stirring at room temperature for 1 hour, the whole was stirred at 40°C for 3 hours. The temperature was returned to room temperature and water was slowly added. After extraction with ethyl acetate and washing with brine, the extract was dried over sodium sulfate, filtrated, and concentrated under reduced pressure. The resulting liquid was distilled under reduced pressure to thereby obtain the objective compound (chloromethyl(2-methoxyphenyl)dimethylsilane, (o-An)$Me_2SiCH_2Cl$) as a colorless liquid in 52% yield (11.2 g, 0.0522 mol).

[Intermediate 2]

1-(Dimethylphenylsilylmethyl)-1,9-dihydro($C_{60}$-$I_h$)[5,6]fullerene, $C_{60}(CH_2SiMe_2Ph)H$

[Chem 83]

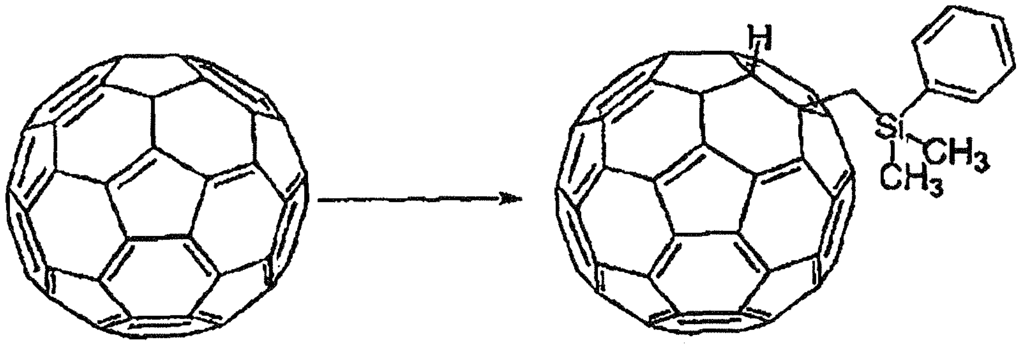

Under a nitrogen atmosphere, N,N-dimethylformamide (6.45 mL, 83.3 mmol), fullerene $C_{60}$ (2.00 g, 2.78 mmol), and a 1,2-dichlorobenzene solution (500 mL) were mixed and degassed, and then the pressure was restored with nitrogen. Thereto was added at 25°C a THF solution of a Grignard reagent ($PhMe_2SiCH_2MgCl$, 9.80 mL, 0.850M, 8.33 mmol) prepared from (chroromethyl)dimethylphenylsilane. After stirring for 10 minutes, a degassed aqueous saturated ammonium chloride solution (1.0 mL) was added and the mixture was stirred. After the resulting solution was concentrated, the concentrate was dissolved in toluene (200 mL) and, after passing though a silica gel filtration column, the solution was concentrated. Methanol (about 100 to 200 mL) was added to cause reprecipitation, whereby a brown solid was obtained.

The obtained solid was fractionated by HPLC (Buckyprep column, eluent: toluene/2-propanol = 7/3) to obtain objective 1-(dimethylphenylsilylmethyl)-1,9-dihydro($C_{60}$-$I_h$)[5,6]fullerene ($C_{60}(CH_2SiMe_2Ph)H$, 1.99 g, 2.28 mmol, analytically pure) in 82% yield.

[Synthesis of SIMEF2 ($C_{60}(CH_2SiMe_2Ph)[CH_2SiMe_2(o\text{-}An)]$)]

[Chem 84]

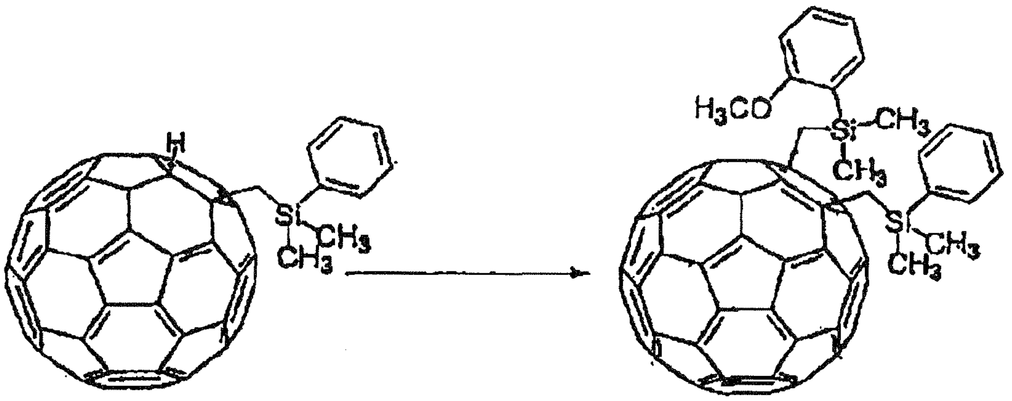

Under a nitrogen atmosphere, after a benzonitrile solution of 1-(dimethylphenylsilylmethyl)-1,9-dihydro($C_{60}$-$I_h$)[5,6]fullerene ($C_{60}(CH_2SiMe_2Ph)H$, 1.02 g, 1.17 mmol) was degassed, a THF solution of potassium t-butoxide (1.41 mL, 1.0M, 1.41 mmol) was added at 25°C. After stirring for 10 minutes, chloromethyl(2-methoxyphenyl)dimethylsilane ((o-An)$Me_2SiCH_2Cl$, 5.03 g, 23.4 mmol) obtained in the production of the intermediate 1 and potassium iodide were added and the mixture was stirred at 110°C for 17 hours. Then, 1.0 mL of an aqueous saturated ammonium chloride solution was added to the resulting solution, followed by concentration. After toluene (100 mL) was added to the resulting crude product and the mixture was filtrated and concentrated, methanol (ca. 50 to 100 mL) was added to cause reprecipitation.

The resulting crude product was subjected to silica gel column chromatography (eluent: CS2/hexane = 1/1) purification and subsequently, HPLC fractionation (Buckyprep column, eluent: toluene/2-propanol = 7/3) purification was

performed to thereby obtain the objective compound (SIMEF2) (0.810 g, 0.772 mmol) in 66% yield.

(Synthetic Example 17)

Synthesis of $C_{60}(QM)_2$

[Chem 85]

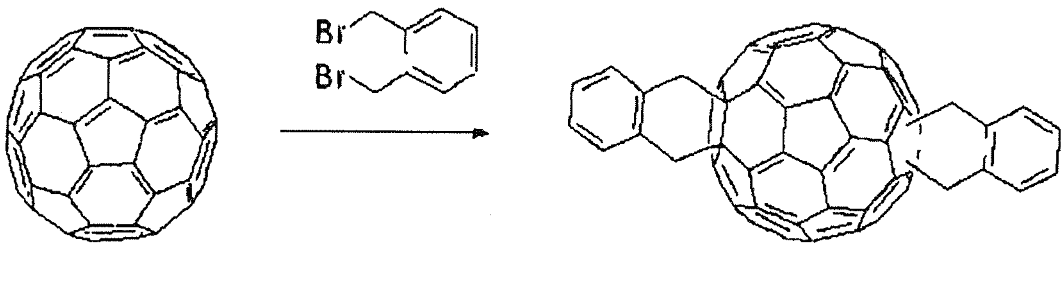

($C_{60}$(QM)$_2$)

Under a nitrogen atmosphere, fullerene $C_{60}$ (500 mg, 0.694 mmol), tetra-n-butylammonium iodide (TBAI; 1.28 g, 3.47 mmol, 5 equivalents), and toluene (230 mL) were placed in a 500 mL three-necked eggplant flask. After degassing under reduced pressure, α,α'-dibromo-o-xylene (916 mg, 3.47 mmol, 5 equivalents) was added and the whole was heated under reflux. After 10 hours, the mixture was cooled to room temperature and subjected to silica gel filtration column (toluene), followed by concentration. After the concentrate was subjected to silica gel column chromatography (sulfur disulfide:hexane = 1:2), the objective compound was obtained in 47% yield (304 g, 0.328 mmol) by performing GPC purification (chloroform). By mass spectrometry (APCI method, negative), m/z:928[$M^-$] coincident with the molecular weight of the objective compound was detected.

(Synthetic Example 18)

Synthesis of c-HexPOPy$_2$

[Chem 86]

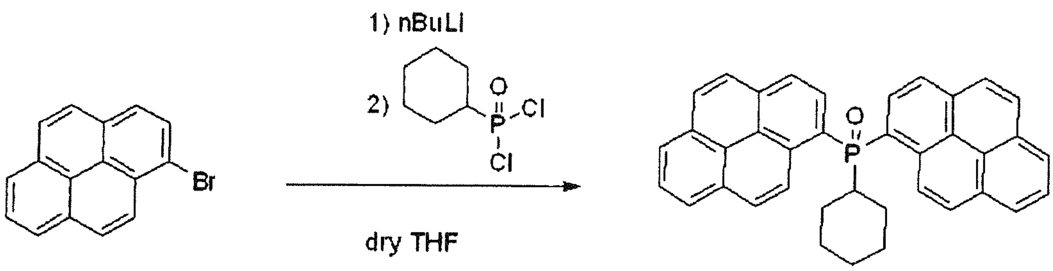


MW: 532.61

(c-HexPOPy$_2$)

Under a nitrogen atmosphere, after 1-bromopyrene (Tokyo Chemical Industry Co., Ltd.: 5.6 g, 20 mmol) and 100 mL of dehydrated THF (Kanto Chemical Co., Inc.) were added and the whole was cooled to -78°C, n-BuLi (Kanto Chemical Co., Inc.: 13 mL, 1.6M) was slowly added dropwise, followed by stirring for 1 hour with maintaining -78°C.

Then, after 2.0 g (10 mmol) of a THF 40 mL solution of cyclohexylphosphonic acid dichloride (WAKO) was slowly added and the mixture was stirred at a low temperature for 30 minutes, the temperature was elevated to room temperature and the mixture was stirred for 6 hours. A precipitated yellow powder was collected by filtration and washed with hexane to obtain 1.9 g (yield 36%) of the objective compound (c-HexPOP$y_2$). The obtained product was confirmed by NMR.

(Synthetic Example 19)

Synthesis of $C_{60}$(F-QM)$_2$

[Chem 87]

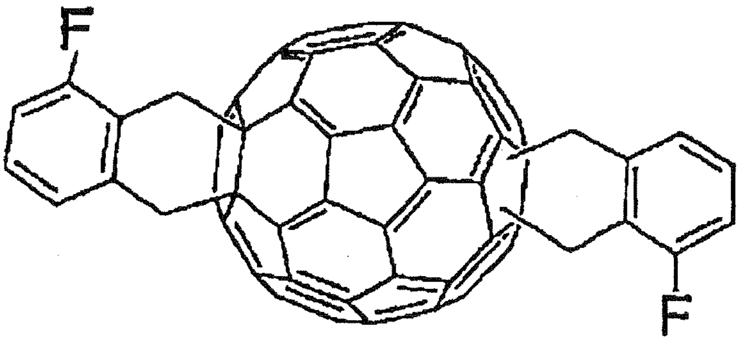

($C_{60}$ (F−QM) $_2$)

The synthesis of $C_{60}$(F-QM)$_2$ was performed as follows.

[Intermediate 3]

Synthesis of 1,2-bis(hydroxymethyl)-3-fluorobenzene

[Chem 88]

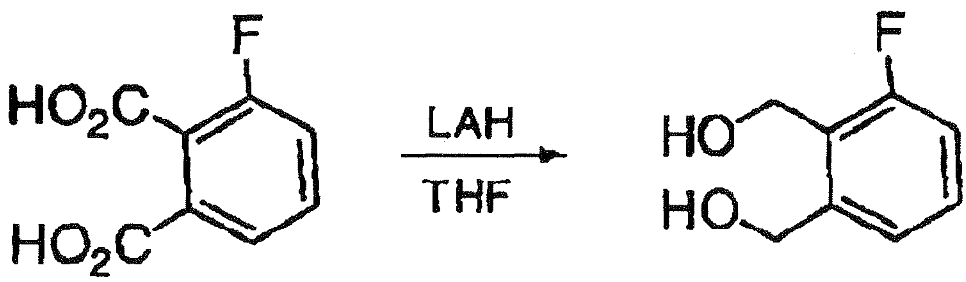


Under a nitrogen atmosphere, lithium aluminum hydride (5.16 g, 136 mmol) and dehydrated tetrahydrofuran (60 ml) were placed in a 500 ml four-necked flask, the mixture was stirred on an ice bath at 5°C or lower, and 20 mL of a tetrahydrofuran solution of 3-fluoro-1,2-phthalic acid (5.0 g, 27.2 mmol) was gradually added. Thereafter, the temperature was spontaneously elevated to room temperature and the mixture was stirred for 12 hours. Then, after ice cooling, water (5.2 ml) was gradually added and, after the temperature was returned to room temperature, a 15% by weight aqueous sodium hydroxide solution (5.2 ml) was added, and the mixture was thoroughly stirred, water (15.5 ml) was added. A resulting precipitate was removed by filtration and the precipitate was washed with 150 mL of THF. After the obtained filtrate was concentrated, methylene dichloride (20 ml) and anhydrous magnesium sulfate were added and the mixture was filtrated, followed by concentration of the filtrate. Using neutral silica gel, purification (methanol:methylene chloride = 5:95 volume ratio) was performed. The yielded amount was 3.32 g and the yield was 78%. (1H-nmr (CDCl3): δ 3.50 (2H, s), 4.68 (2H), 4.77 (2H), 7.03 (1H, t), 7.11 (1H, d), 7.26 (1H, m))

[Intermediate 4]

Synthesis of 1,2-bis(bromomethyl)-3-fluorobenzene

[Chem 89]

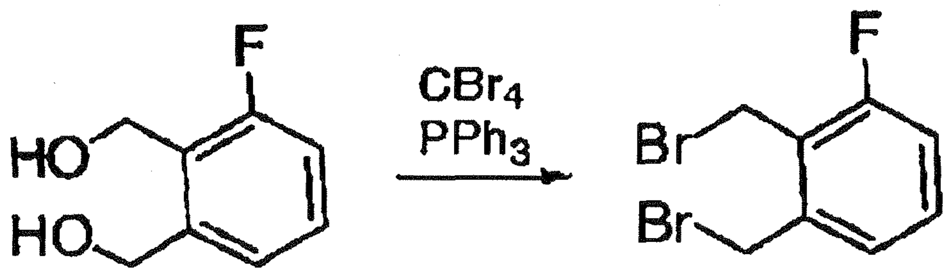


Under a nitrogen atmosphere, 1,2-bis(hydroxymethyl)-3-fluorobenzene (3.32 g, 21.2 mmol)obtained in the production of the intermediate 3, carbon tetrabromide (17.6 g, 53.2 mmol), and collidine (6.4 g, 52.8 mmol) were placed in a 200 ml four-necked flask, they were dissolved in methylene dichloride (50 ml). The solution was cooled with ice and a methylene dichloride solution (30 ml) of triphenylphosphine (14.0 g, 53.3 mmol) was added dropwise. After complete addition, the mixture was stirred at room temperature for 6 hours. It was poured into water and the organic layer was washed with an aqueous sodium bicarbonate solution and water and dried over anhydrous magnesium sulfate, followed by concentration. The concentrate was diluted with hexane and filtrated and the filtrate was concentrated. Using neutral silica gel, purification (hexane) was performed. The yielded amount was 3.59 g and the yield was 60%. (1H-NMR (CDCl3): δ 4.66 (2H, s), 4.70 (2H, s), 7.04 (1H, t), 7.16 (1H, d), 7.27 (1H, m))

[Synthesis of $C_{60}$(F-QM)$_2$]

[Chem 90]

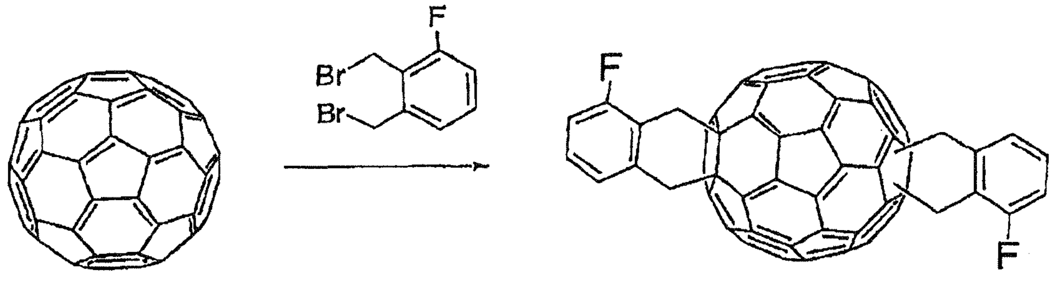

Fullerene $C_{60}$ (0.5 g, 0.694 mmol) manufactured by Frontier Carbon Corporation, 1,2-bis(bromomethyl)-3-fluorobenzene (0.98 g, 3.47 mmol) obtained in the production of the intermediate 4, tetra-n-butylammonium iodide (1.28 g, 3.47 mmol), and toluene (200 ml) were placed in a 500 ml flask and nitrogen replacement under reduced pressure was performed. Then, the whole was heated to reflux for 14 hours under a nitrogen stream. After cooling, the solution was filtrated by passing through silica gel and the silica gel was washed with chloroform, followed by concentration. The concentrate was dissolved in carbon disulfide and absorbed on silica gel, which was eluted with toluene, followed by concentration. By GPC purification (solvent: $CHCl_3$), the concentrate was separated into a mono-adduct, a bis-adduct, and a tris-adduct. The mono adduct ($C_{60}$(F-QM)) was 63 mg (yield 11 %), the bis-adduct ($C_{60}$(F-QM)$_2$) was 259 mg (yield 39%), and the tris-adduct ($C_{60}$(F-QM)$_3$) was 63 mg (yield 8%). By performing mass spectrometry (APCI method, negative), m/z:964[$M^-$]($C_{60}$(F-QM)$_2$) coincident with the mass of the objective compound and 1086[$M^-$]($C_{60}$(F-QM)$_3$) were detected. Decomposition temperature of the bis-adduct was 410°C. Glass transition temperature was not observed at 200°C or lower.

[Chem 91]

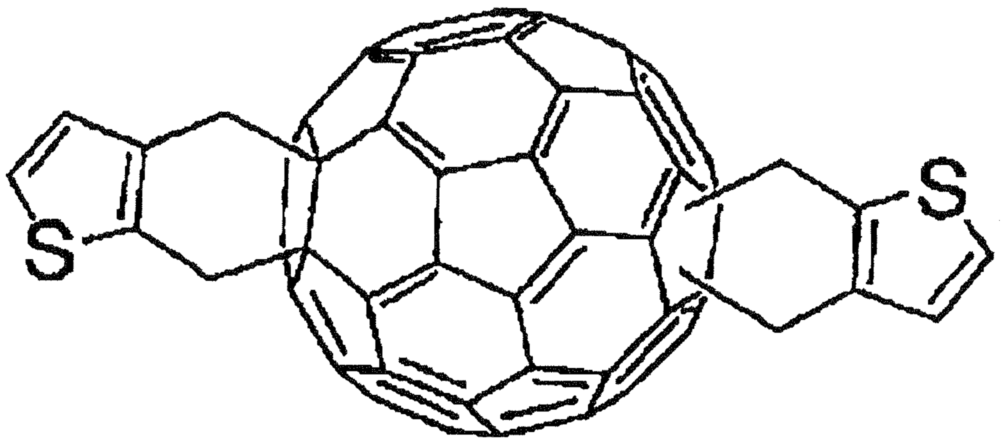

($C_{60}$ (Th-QM) $_2$)

The synthesis of $C_{60}$(Th-QM)$_2$ was performed as follows.

[Intermediate 5]

Synthesis of thiphene-2,3-dicarboxylic acid

[Chem 92]

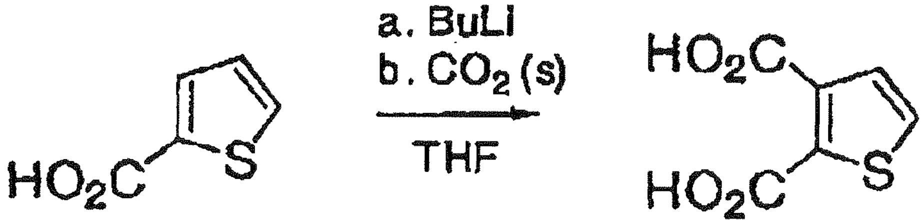


Under a nitrogen atmosphere, 2-thiophenecarboxylic acid (10 g, 0.064 mol) and THF (300 mL) were placed in

a 1 L four-necked flask and the mixture was stirred. After cooling to -75°C, n-BuLi (2.6M in hexane, 64 mL) was gradually added by means of a dropping funnel. Stirring was continued for 5 minutes without further treatment, dry ice was added until heat generation ceased, and then the temperature was gradually elevated to room temperature without further treatment. Thereafter, 1N hydrochloric acid (200 mL) was gradually added to terminate the reaction. After the organic layer was separated, washed with saturated brine, and dried over sodium sulfate, the solvent was removed by evaporation under reduced pressure. After the residue was suspended in hexane, objective thiphene-2,3-dicarboxylic acid was obtained by collection by filtration in an amount of 12.8 g as a mixture containing about 10% of thiphene-2,5-dicarboxylic acid.

[Intermediate 6]

Synthesis of 2,3-bis(hydroxymethyl)thiophene

[Chem 93]

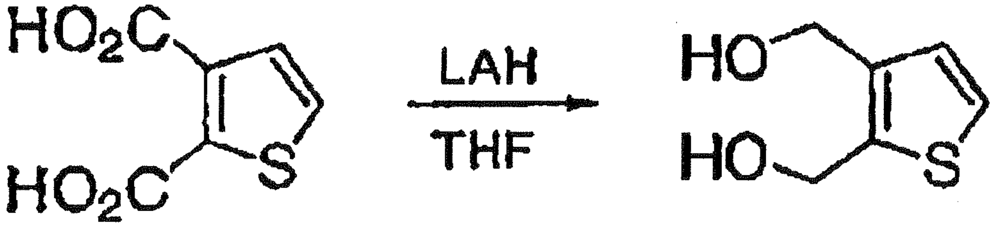


Under a nitrogen atmosphere, lithium aluminum hydride (8.3 g, 0.22 mol) and THF (223 ml) were placed in a 500-mL four-necked flask and the mixture was cooled to 5°C or lower. After thiphene-2,3-dicarboxylic acid (7.5 g, 0.044 mol) obtained in the production of the intermediate 5 was gradually added, the temperature was gradually elevated to room temperature and the mixture was stirred for further 7 hours. Water (5.3 ml) and a 1N aqueous sodium hydroxide solution (30 mL) were gradually added. After insoluble matter was removed by filtration through celite, the solvent was removed by evaporation under reduced pressure. By performing column chromatographic purification using neutral silica gel, a regioisomer was separated and objective 2,3-bis(hydroxymethyl)thiophene was obtained in 53% yield (3.31 g).

[Intermediate 7]

Synthesis of 2,3-bis(bromomethyl)thiophene

[Chem 94]

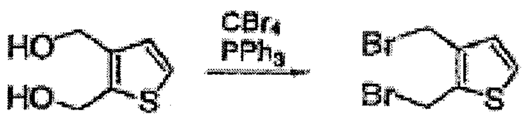


Under a nitrogen atmosphere, 2,3-bis(hydroxymethyl)thiophene (3.31 g, 0.023 mol) obtained in the production of the intermediate 6, triphenylphosphine (18 g, 0.069 mol), and THF (67 ml) were placed in a 200-mL four-necked flask and the mixture was cooled to 5°C or lower on an ice bath. After carbon tetrabromide (19 g, 0.057 mol) was added portionwise, the mixture was stirred at room temperature for 3 hours. The mixture was diluted with ethyl acetate and, after a precipitate was removed by filtration, the solvent was removed by evaporation under reduced pressure. By performing column chromatographic purification using basic silica gel, objective 2,3-bis(bromomethyl)thiophene was obtained.

[Synthesis of $C_{60}$(Th-QM)$_2$]

[Chem 95]

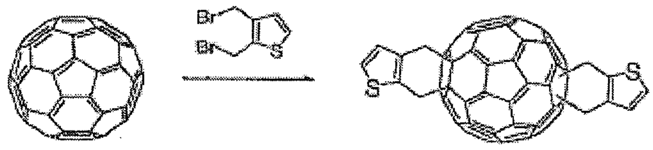

Fullerene $C_{60}$ (0.32 g, 0.0004 mol) manufactured by Frontier Carbon Corporation, toluene (157 ml), tetra-n-butylammonium iodide (0.66 g, 0.00178 mol), and 2,3-bis(bromomethyl)thiophene (0.48 g, 0.00178 mol) obtained in the production of the intermediate 7 were placed in a 300-mL four-necked flask. After degassed under reduced pressure, the mixture was heated to reflux for 5 hours under a nitrogen atmosphere. Silica gel filtration column (toluene, chloroform) was performed and the solvent was removed by evaporation. After the mixture was subjected to silica gel column chromatographic purification (carbon disulfide), GPC purification (chloroform) was further performed to thereby obtain each of a mono-adduct, a bis-adduct, and a tris-adduct. The yield of the bis-adduct ($C_{60}$(Th-QM)$_2$) was 22% (91 mg) and the yield of the tris-adduct ($C_{60}$(Th-QM)$_3$) was 6% (29 mg). By performing mass spectrometry (MALDI method, positive) on each compound, m/z:940[$M^+$](bis-adduct $C_{60}$(Th-QM)$_2$) and m/z:1050[$M^+$]($C_{60}$(Th-QM)$_3$) coincident with the mass of each objective compound were detected.

(Synthetic Example 21)

Synthesis of $C_{60}$(PCBM)(QM)
[Chem 96]

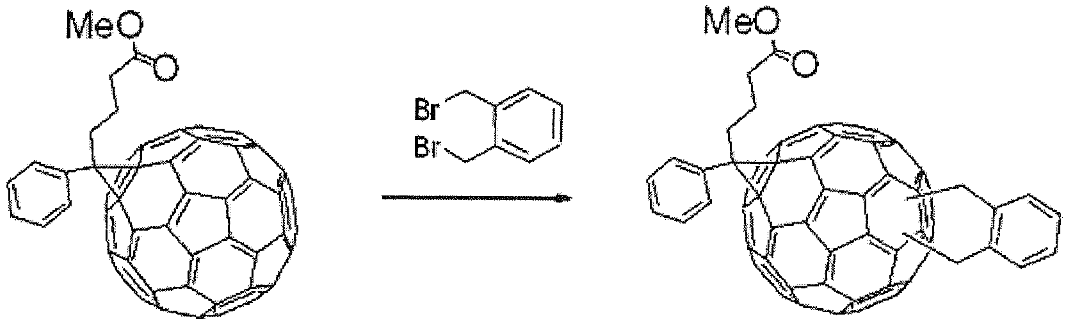

($C_{60}$ (PCBM) (QM))

Under a nitrogen atmosphere, PCBM (Frontier Carbon E100H, 1.0 g, 1.098 mmol), tetra-n-butylammonium iodide (TBAI; 2.03 g, 5.49 mmol, 5 equivalents), and toluene (200 mL) were placed in a 500 mL three-necked flask. After degassed under reduced pressure, $\alpha,\alpha'$-dibromo-o-xylene (1.45 g, 5.49 mmol, 5 equivalents) was added and the mixture was heated to reflux. After 9 hours, the temperature was returned to room temperature and the mixture was subjected to silica gel filtration column (toluene), followed by concentration. After the concentrate was subjected to silica gel column chromatography (toluene), GPC purification (chloroform) was performed to thereby obtain the objective compound in 49% yield (545 mg, 0.537 mmol). By mass spectrometry (APCI method, negative), m/z:1014[$M^-$] coincident with the mass of the objective compound was detected.

(Synthetic Example 22)

Synthesis of $C_{70}$(Ind)$_2$

[Chem 97]

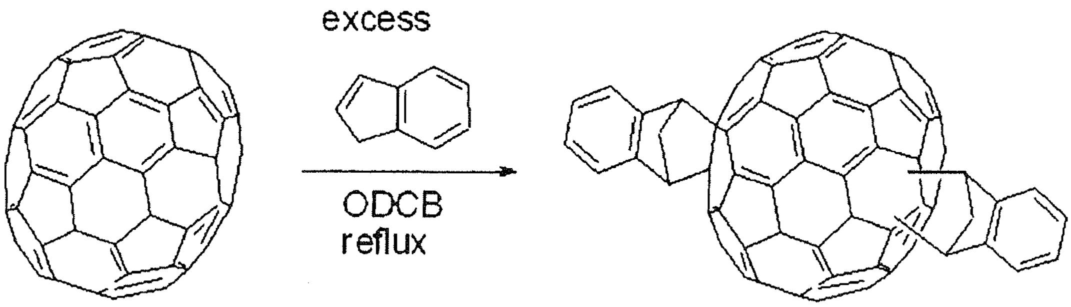


(C 70 (I n d) 2)

The synthesis of C70(Ind)$_2$ was performed with reference to Patent Document (WO2008/018931) and the compound was obtained as an isomer mixture. The mixture was purified by performing GPC purification (chloroform) and m/z:1072[M$^-$] coincident with the mass of the objective compound was detected by mass spectrometry (APCI method, negative).

(Synthetic Example 23)

Synthesis of PBDTTT-C
It was synthesized by the method described in J. Am. Chem. Soc, 2009, 131, 15586-15587.

(Synthetic Example 24)

Synthesis of POCzPO
[Chem 98]

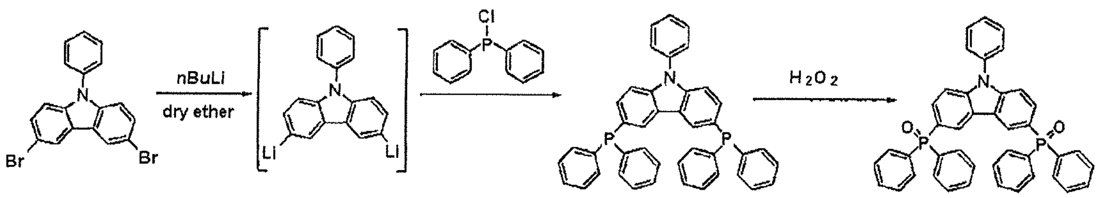


POCzPO

To a 200 ml three-necked flask was added 2.3 g (5.7 mmol) of 3,6-dibromo-9-phenylcarbazole, followed by nitrogen replacement. A homogeneous solution was obtained by adding 50 mL of dehydrated tetrahydrofuran and then cooled on a dry ice bath. When the temperature in the system was confirmed to be -70°C and 8.9 mL (14.3 mmol) of an nBuLi/hexane solution was gradually added, the system was changed from yellow to dark yellowish green. After stirring at low temperature for 1 hour without further treatment, 2.3 mL (12.5 mmol) of chlorodiphenylphosphine was gradually added and stirring was continued at low temperature for 30 minutes. Then, the dry ice bath was removed and the mixture was stirred at room temperature for 11 hours. Thereafter, quenching was performed by addition of ice and 10 mL of a 30% hydrogen peroxide solution was added, followed by stirring for 1 hour. After concentration, extraction and washing were performed with ethyl acetate-brine and the extract was dried over sodium sulfate. The extract was concentrated by evaporation under reduced pressure to obtain film-shaped objective compound (POCzPO). Using DEI, DCI methods as measuring methods, m/z:644[M+H] coincident with the mass of the objective compound was detected.

<LUMO measurement and solubility measurement of fullerene compounds)

Calculation of LUMO of various fullerene compounds was performed by cyclic voltammetry. The measurement was performed at room temperature and a glassy carbon electrode was used as a working electrode, a platinum electrode as a counter electrode, and $Ag/Ag^+$ as a reference electrode. As an electrolyte, a tetrahydrofuran (THF) solution containing tetrabutylammonium perchlorate (TBAP) (0.1M) or a mixed solution of o-dichlorobenzene and acetonitrile (4:1, volume ratio) was used. Concentration of the fullerene derivative was set at about 0.5mM. The potential was measured using oxidation-reduction potential of ferrocene as a standard. From the value of the obtained first reduction potential ($E_{1/2}^{red1}$), the calculation of LUMO was performed using the following equation (Non-Patent Document: Nat. Mater. 2007, 6, 521). Based on the value of the obtained first reduction potential, the value of LUMO was calculated from a relative value in the case where the value of LUMO of PCBM (manufactured by Frontier Carbon Corporation PCBM: 1-(3-methoxycarbonyl)propyl-1-phenyl(6,6)-C60) was taken as -3.80 eV (Non-Patent Document: J. Am. Chem. Soc. 2008, 130, 15429-15436). The results are shown in Table 1.

$$\text{LUMO level} = -(E_{1/2}^{red1} + 4.8)$$

However, $C_{60}$ is sparingly soluble in THF and the measurement was difficult to perform under the above conditions. Thus, using a mixed solvent of o-dichlorobenzene and acetonitrile (4:1, volume ratio) instead of THF, the cyclic voltammetry was performed. The value of LUMO of $C_{60}$ in Table 1 shows a value obtained by correction depending on the difference in solvent based on the relative values of the first reduction potential of $C_{60}$ and PCBM measured under the conditions.

With regard to the solubility of various fullerene compounds, a powder of a fullerene derivative and toluene were mixed at 40°C. The amount of toluene used at this time was a minimum amount at which dissolution was confirmed at 40°C. Thereafter, temperature was returned to 25°C and no precipitation was confirmed. The concentration of the toluene on this occasion was regarded as the solubility. In the case where precipitation was observed, toluene was further added until dissolution, and the concentration of the toluene at the time when dissolution was finally confirmed was regarded as the solubility. The results are shown in Table 1.

[Table 1]

| | LUMO (eV) Solvent: THF | LUMO (eV) of Solvent: mixed solvent of o-dichlorobenzene and acetonitrile | Solubility (% by weight) |
|---|---|---|---|
| PCBM (*1) | -3.80 | -3.80 | 1.5 |
| SIMEF | -3.75 | -3.76 | 0.8 |
| $C_{60}(Ind)_2$ | -3.60 | -3.63 | 7.5 |
| $C_{60}$ | -3.89 (corrected value) | -3.89 | 0.3 |
| SIMEF2 | - | -3.74 | 1.7 |
| $C_{60}(QM)_2$ | - | -3.63 | 5.0 |
| $C_{60}(F\text{-}QM)_2$ | - | -3.67 | >10 |
| $C_{60}(Th\text{-}QM)_2$ | - | -3.65 | 1.3 |
| $C_{60}$(PCBM)(QM) | - | -3.67 | >10 |
| $C_{70}(Ind)_2$ | - | -3.62 | 3 |
| *1 PCBM manufactured by Frontier Carbon Corporation: 1-(3-methoxycarbonyl)propyl-1-phenyl (6,6)-$C_{60}$ | | | |

<Measurement of electrical mobility of fullerene compound>

On an n-type silicon (Si) substrate (Sb dope, resitivity of 0.02 Ω.cm or less, manufactured by Sumitomo Metal Industries, Ltd.) on which an oxide film having a film thickness of 300 nm had been formed, a gold electrode having a gap having a length (L) of 100 μm and a width (W) of 500 μm was formed as a source, drain electrode by photolithography. Moreover, chromium was vapor-deposited on an Si part exposed by scraping off the oxide film at a position different

from the electrode and the part was utilized as a gate electrode for applying voltage to the silicon substrate.

The above substrate was immersed in a 0.6 mmol/L toluene solution of trichlorooctadecylsilane (manufactured by Aldrich Co.) at room temperature for 30 minutes. A 10 mmol/L chloroform solution of each fullerene compound was prepared and, by spin-coating thereof on the aforementioned substrate, a good semiconductor film was made. The obtained FET device was evaluated by means of a semiconductor parameter analyzer 4155C manufactured by Agilent Co. Each fullerene compound showed FET properties and saturation mobility thereof is shown in Table 2.

[Table 2]

| Fullerene compound | Electrical mobility [$cm^2/Vs$] |
|---|---|
| $C_{60}$PCBM | $2.6\times10^{-2}$ |
| $C_{70}$PCBM (*2) | $4.5\times10^{-4}$ |
| SIMEF2 | $2.3\times10^{-4}$ |
| $C_{60}(Ind)_2$ | $4.6\times10^{-4}$ |
| $C_{60}(QM)_2$ | $5.9\times10^{-4}$ |
| *2 PCBM manufactured by Frontier Carbon Corporation: 1-(3-methoxycarbonyl)propyl-1-phenyl (6,6)-$C_{70}$ | |

<Measurement of solubility of buffer material>

Materials of various buffer layers and solubility in methanol at room temperature are shown in the Table.

<Glass transition temperature of buffer material>

It was determined by placing about 4 mg of a sample in an aluminum-made sample container and measuring the temperature under conditions of an $N_2$ gas of 50 ml/minute and a temperature-elevating rate of 10°C/minute by means of a differential thermal scanning calorimetric analyzer manufactured by SII Nano Technology Inc. The results are shown in Table 3.

[Table 3]

| | Buffer material | Molecular weight | Solubility (MeOH, room temperature)/% by weight | Tg |
|---|---|---|---|---|
| Synthetic Example 4 | POSFPO | 716 | 0.5 | 124 |
| Synthetic Example 3 | BINAPO | 654 | 4 | 133 |
| Synthetic Example 24 | POCzPO | 643 | >8 | 106 |
| Synthetic Example 11 | PO(TPP)PO | 707 | >8 | 100 |
| Synthetic Example 6 | POFBPO | 698 | 1 | 92 |
| Manufactured by Tokyo Chemical Industry Co., Ltd. | $POPh_3$ *3 | 578 | >5.0 | Crystal |
| Synthetic Example 1 | $POPy_2$ | 526 | <0.01 | 141 |
| Manufactured by Dojindo Molecular Tech., Inc. | BCP | 360 | 0.1 | Crystal |
| Manufactured by Lumitech Co., Ltd.. | NBPhen *1 | 585 | <0.01 | 112 |
| Manufactured by Lumitech Co., Ltd.. | TPBi *2 | 655 | <0.01 | 118 |

[Chem 99]

(*1) NBPhen

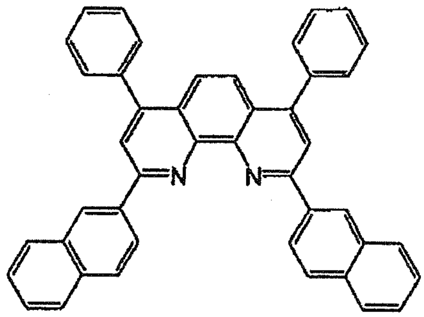

(*2) TPBi

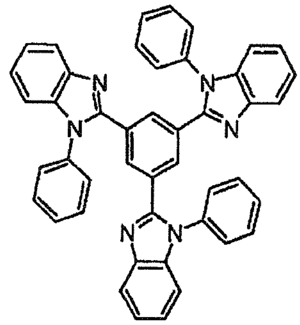

(*3) $POPh_3$

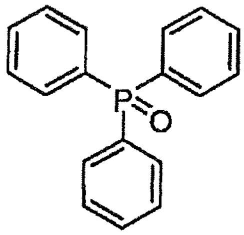

<Example 1>

After an aqueous dispersion of poly(3,4-ethylenedioxythiophene)poly(styrenesulfonic acid) (trade name "CLEVIOS™ P VP AI4083" manufactured by H C Stark Ltd.) as a hole collection layer was applied by spin coating on a glass substrate patterned with an ITO electrode, the substrate was subjected to heat treatment on a hot plate at 120°C in the air for 10 minutes. The film thickness was about 30 nm.

A compound represented by the following formula (A) (compound A), tetrabenzoporphyrin, was placed in a metal boat and was vacuum deposited on the substrate. Thereafter, by subjecting the above substrate to heat treatment at 180°C for 20 minutes under a nitrogen atmosphere, a p-type semiconductor layer of about 25 nm was formed on the hole collection layer.

[Chem 100]

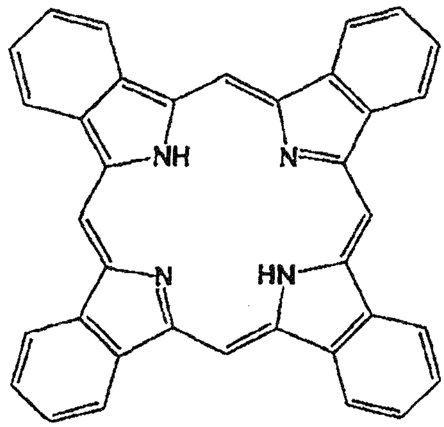

(A)

[Chem 101]

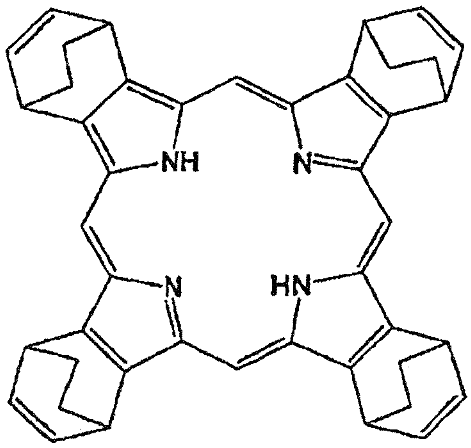

(B)

A liquid in which 0.6% by weight of the compound B and 1.4% by weight of the fullerene compound (SIMEF) obtained in Synthetic Example 7 were dissolved in a 1:1 mixed solvent (weight) of chloroform/monochlorobenzene was prepared and filtrated and the obtained filtrate was subjected to spin coating under a nitrogen atmosphere at 1500 rpm, followed by heating at 180°C for 20 minutes. Thereby, a mixture layer containing the tetrabenzoporphyrin (compound A) and the fullerene compound (SIMEF) of about 100 nm thickness was formed on the p-type semiconductor layer.

Then, a liquid in which 1.2% by weight of the fullerene compound (SIMEF) was dissolved in toluene was prepared and filtrated and the obtained filtrate was subjected to spin coating under a nitrogen atmosphere at 3000 rpm and subjected to heating treatment at 120°C for 5 minutes. Thereby, a layer of the fullerene compound (SIMEF) of about 50 nm was formed on the mixture layer.

Next, $POPy_2$ obtained in Synthetic Example 1 was placed in a metal boat located in a vacuum deposition apparatus, heated, and deposited until the film thickness became 6 nm to form a buffer layer on the layer of the fullerene compound (SIMEF).

Furthermore, after an aluminum electrode having a thickness of 80 nm was provided on the buffer layer by vacuum deposition, by heating the solar cell on a hot plate at 120°C for 10 minutes, a solar cell was made.

To the solar cell encapsulated using a glass plate as an encapsulating plate, a light having an intensity of 100

mW/cm$^2$ was applied by a solar simulator (AM 1.5G) from the ITO electrode side, and current-voltage properties between the ITO electrode and the aluminum electrode were measured by the source meter (2400-type manufactured by Keithley Inc.). Thereafter, light irradiation was continuously performed by means of an indoor solar cell durability tester ECL-350 manufactured by EKO INSTRUMENTS Co., Ltd. set at a substrate temperature of 85°C. By placing a sharp-cut filter (SCF-39L manufactured by SIGMA KOKI Co., Ltd.) on the solar cell, ultraviolet rays of 390 nm or less were cut. At the measurement of the current-voltage properties, the solar cell was once taken out of ECL-350 and the current-voltage properties (durability test) were measured at room temperature. The conversion efficiency (%) at each period and the conversion efficiency at each period when initial one is taken as 100%, which is regarded as durability (%), are shown in Table 4.

<Example 2>

A solar cell was made in the same manner as in Example 1 except that F-$POPy_2$ obtained in Synthetic Example 2 was used instead of $POPy_2$, and the durability test was performed. The conversion efficiency (%) and durability (%) at each period are shown in Table 4.

<Example 3>

Four layers until the layer of the fullerene compound (SIMEF) were formed on the substrate in the same manner as in Example 1. Then, 5.0 mg of BINAPO obtained in Synthetic Example 3 was dissolved in isopropanol with stirring at room temperature for 30 minutes to prepare a 0.05% by weight ink. The ink was subjected to spin coating at 3000 rpm and heated at 120°C for 5 minutes. Thereby, a buffer layer of about 6 nm was formed on the layer of the fullerene compound (SIMEF).

Furthermore, after an aluminum electrode having a thickness of 80 nm was provided on the buffer layer by vacuum deposition, by heating the solar cell on a hot plate at 120°C for 10 minutes, a solar cell was made, and the durability test was performed. The conversion efficiency (%) and durability (%) at each period are shown in Table 4.

<Example 4>

A solar cell was made in the same manner as in Example 1 except that POSFPO obtained in Synthetic Example 4 was used instead of $POPy_2$, and the durability test was performed. The conversion efficiency (%) and durability (%) at each period are shown in Table 4.

<Example 5>

A solar cell was made in the same manner as in Example 1 except that POMXPO obtained in Synthetic Example 5 was used instead of $POPy_2$ and heating was not performed after the aluminum electrode was provided, and the durability test was performed. The conversion efficiency (%) and durability (%) at each period are shown in Table 4.

<Example 6>

A solar cell was made in the same manner as in Example 1 except that POFBPO obtained in Synthetic Example 6 was used instead of $POPy_2$ and heating was performed at 120°C for 5 minutes after the aluminum electrode was provided, and the durability test was performed. The conversion efficiency (%) and durability (%) at each period are shown in Table 4.

<Example 7>

A solar cell was made in the same manner as in Example 1 except that $CF_3$-$POPy_2$ obtained in Synthetic Example 9 was used instead of $POPy_2$ and heating was performed at 120°C for 5 minutes after the aluminum electrode was provided, and the durability test was performed. The conversion efficiency (%) and durability (%) at each period are shown in Table 4.

<Example 8>

A solar cell was made in the same manner as in Example 1 except that $(CF3)_2$-$POPy_2$ obtained in Synthetic Example 10 was used instead of $POPy_2$ and heating was performed at 120°C for 5 minutes after the aluminum electrode was provided, and the durability test was performed. The conversion efficiency (%) and durability (%) at each period

are shown in Table 4.

<Example 9>

A solar cell was made in the same manner as in Example 1 except that PO(TPP)PO obtained in Synthetic Example 11 was used instead of $POPy_2$ and heating was performed at 120°C for 5 minutes after the aluminum electrode was provided, and the durability test was performed. The conversion efficiency (%) and durability (%) at each period are shown in Table 4.

<Example 10>

A solar cell was made in the same manner as in Example 1 except that $Ph_2POPy$ obtained in Synthetic Example 12 was used instead of $POPy_2$ and heating was performed at 120°C for 5 minutes after the aluminum electrode was provided, and the durability test was performed. The conversion efficiency (%) and durability (%) at each period are shown in Table 4.

<Example 11>

A solar cell was made in the same manner as in Example 1 except that $BuPOPy_2$ obtained in Synthetic Example 13 was used instead of $POPy_2$ and heating was performed at 80°C for 5 minutes after the aluminum electrode was provided, and the durability test was performed. The conversion efficiency (%) and durability (%) at each period are shown in Table 4.

<Example 12>

A solar cell was made in the same manner as in Example 1 except that 1,6-$(POPh_2)_2Py$ obtained in Synthetic Example 14 was used instead of $POPy_2$ and heating was performed at 120°C for 5 minutes after the aluminum electrode was provided, and the durability test was performed. The conversion efficiency (%) and durability (%) at each period are shown in Table 4.

<Example 13>

A solar cell was made in the same manner as in Example 1 except that $AnPOPy_2$ obtained in Synthetic Example 15 was used instead of $POPy_2$ and heating was performed at 120°C for 5 minutes after the aluminum electrode was provided, and the durability test was performed. The conversion efficiency (%) and durability (%) at each period are shown in Table 4.

<Example 14>

A solar cell was made in the same manner as in Example 3 except that $POPh_3$ obtained by sublimation purification of one manufactured by Tokyo Chemical Industry Co., Ltd. was used instead of BINAPO and heating was performed at 120°C for 20 minutes after the aluminum electrode was provided, and the durability test was performed. The conversion efficiency (%) and durability (%) at each period are shown in Table 4.

[Chem 102]

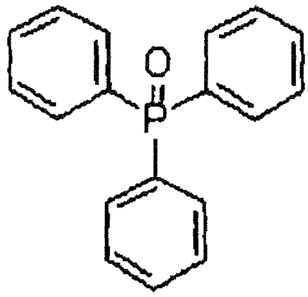

(POPh3)

<Example 15>

A solar cell was made in the same manner as in Example 1 except that 3TPYMB (manufactured by Lumitech Co., Ltd..) was used instead of $POPy_2$ and heating was performed at 120°C for 5 minutes after the aluminum electrode was provided, and the durability test was performed. The conversion efficiency (%) and durability (%) at each period are shown in Table 4.

<Example 16>

A solar cell was made in the same manner as in Example 1 except that PBD obtained by sublimation purification of one manufactured by Tokyo Chemical Industry Co., Ltd. was used instead of $POPy_2$ and heating was performed at 80°C for 5 minutes after the aluminum electrode was provided, and the durability test was performed. The conversion efficiency (%) and durability (%) at each period are shown in Table 4.

<Example 17>

After an aqueous dispersion of poly(3,4-ethylenedioxythiophene)poly(styrenesulfonic acid) (trade name "CLEVIOUS™ PVP AI4083" manufactured by H C Stark Ltd.) as a hole collection layer was applied by spin coating on a glass substrate patterned with an ITO electrode, the substrate was subjected to heat treatment on a hot plate at 120°C in the air for 10 minutes. The film thickness was about 30 nm.

Under a nitrogen atmosphere, after the above substrate was first subjected to heat treatment at 180°C for 3 minutes, a toluene solution containing 0.4% by weight of a solution processed transformation-type bicycloporphyrin compound (C) was filtrated and applied on the above substrate by spin coating at 1500 rpm. By subjecting the above substrate to heat treatment at 180°C under a nitrogen atmosphere, a layer of p-type semiconductor tetrabenzoporphyrin (A) of about 25 nm was formed on the hole collection layer.

[Chem 103]

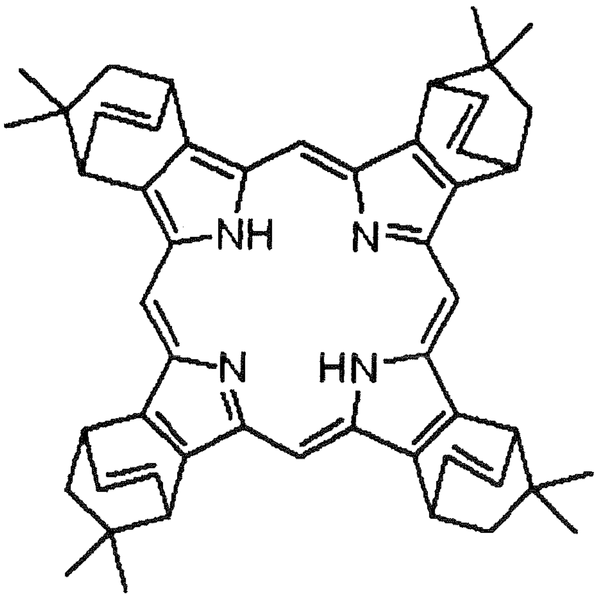

(C)

A liquid in which 0.75% by weight of the compound B and 1.75% by weight of the fullerene compound (SIMEF2) obtained in Synthetic Example 16 were dissolved in a 1:1 mixed solvent (weight) of chloroform/monochlorobenzene was prepared and filtrated and the obtained filtrate was subjected to spin coating under a nitrogen atmosphere at 1500 rpm, followed by heating at 180°C for 20 minutes. Thereby, a mixture layer of about 100 nm containing the tetrabenzoporphyrin (A) and the fullerene compound (SIMEF2) was formed on the p-type semiconductor layer.

Then, a liquid in which 0.65% by weight of $C_{60}(QM)_2$ obtained in Synthetic Example 17 was dissolved in toluene was prepared and filtrated and the obtained filtrate was subjected to spin coating under a nitrogen atmosphere at 3000 rpm and subjected to heating treatment at 120°C for 5 minutes. Thereby, the fullerene compound (SIMEF2) in the mixture layer was replaced by the fullerene compound ($C_{60}(QM)_2$) and a layer of the fullerene compound ($C_{60}(QM)_2$) was formed on the tetrabenzoporphyrin layer.

Next, $POPy_2$ obtained in Synthetic Example 1 was placed in a metal boat located in a vacuum deposition apparatus, heated, and vapor-deposited until the film thickness became 6 nm to form a buffer layer on the layer of the fullerene compound ($C_{60}(QM)_2$).

Furthermore, after an aluminum electrode having a thickness of 80 nm was provided on the buffer layer by vacuum deposition, by heating the solar cell on a hot plate at 120°C for 10 minutes, on a hot plate at 150°C for 10 minutes, on a hot plate at 180°C for 10 minutes, on a hot plate at 200°C for 10 minutes, on a hot plate at 210°C for 10 minutes, on a hot plate at 220°C for 10 minutes, on a hot plate at 230°C for 10 minutes, on a hot plate at 235°C for 5 minutes, and further heating it on a hot plate at 230°C for 5 minutes, on a hot plate at 235°C for 5 minutes, a solar cell was made.

To the solar cell encapsulated using a glass plate as an encapsulating plate, a light having an intensity of 100 mW/cm$^2$ was applied by a solar simulator (AM 1.5G) from the ITO electrode side, and current-voltage properties between the ITO electrode and the aluminum electrode were measured by the source meter (2400-type manufactured by Keithley Inc.). Thereafter, light irradiation was continuously performed by means of an indoor solar cell durability tester ECL-350 manufactured by EKO INSTRUMENTS Co., Ltd. set at a substrate temperature of 85°C. At the measurement of the current-voltage properties, the solar cell was once taken out of ECL-350 and the current-voltage properties (durability test) were measured at room temperature. The conversion efficiency (%) at each period and the conversion efficiency at each period when initial one is taken as 100%, which is regarded as durability (%), are shown in Table 4.

<Example 18>

A solar cell was made in the same manner as in Example 19 except that $C_{60}(Ind)_2$ obtained in Synthetic Example 8 was used instead of $C_{60}(QM)_2$, and the durability test was performed. The conversion efficiency (%) and durability (%) at each period are shown in Table 4.

<Comparative Example 1>

A solar cell was made in the same manner as in Example 1 except that BCP manufactured by Dojindo Molecular Tech., Inc. was used instead of $POPy_2$ and heating was not performed after the aluminum electrode was provided, and the durability test was performed. The conversion efficiency (%) and durability (%) at each period are shown in Table 4.
[Chem 104]

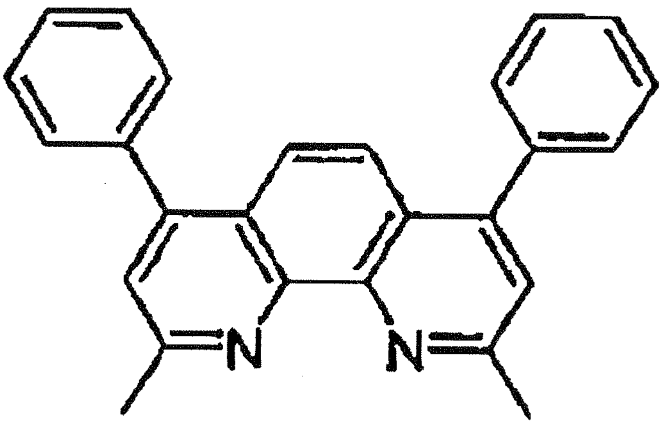

(BCP)

<Comparative Example 2>

A solar cell was made in the same manner as in Comparative Example 1 except that LiF (manufactured by Furuuchi Chemical Corporation) was used instead BCP and lamination was performed in a thickness of 0.5 nm, and the durability test was performed. The conversion efficiency (%) and durability (%) at each period are shown in Table 4.

<Comparative Example 3>

A solar cell was made in the same manner as in Comparative Example 1 except that BCP was not used, and the durability test was performed. The conversion efficiency (%) and durability (%) at each period are shown in Table 4.

<Comparative Example 4>

A solar cell was made in the same manner as in Example 19 except that BCP (manufactured by Dojindo Molecular Tech., Inc.) was used instead of $POPy_2$ and heating was not performed after the aluminum electrode was provided, and the durability test was performed. The conversion efficiency (%) and durability (%) at each period are shown in Table 4.

<Comparative Example 5>

A solar cell was made in the same manner as in Comparative Example 4 except that LiF (manufactured by Furuuchi Chemical Corporation) was used instead BCP and lamination was performed in a thickness of 0.5 nm, and the durability test was performed. The conversion efficiency (%) and durability (%) at each period are shown in Table 4.

<Comparative Example 6>

A solar cell was made in the same manner as in Comparative Example 4 except that BCP was not used, and the durability test was performed. The conversion efficiency (%) and durability (%) at each period are shown in Table 4.

<Comparative Example 7>

Copper phthalocyanine (manufactured by Aldrich Co.) was laminated on the ITO substrate described in Example 1 in a thickness of 30 nm by vacuum deposition and thereafter, fullerene ($C_{60}$ manufactured by Frontier Carbon Corporation) was laminated thereon in a thickness of 40 nm by vacuum deposition. Then, $POPy_2$ was laminated in a thickness of 6 nm on the fullerene layer to make a solar cell, and the durability test was performed. The conversion efficiency (%) and durability (%) at each period are shown in Table 4.

[Table 4]

| | p-type semiconductor | Fullerene | Buffer layer | | Initial | 24 hours | 72 hours |
|---|---|---|---|---|---|---|---|
| Example 1 | BP | SIMEF | $POPy_2$ | Conversion efficiency (%) | 3.9 | 3.84 | 3.81 |
| | | | | Durability (%) | 100 | 98.6 | 97.8 |
| Example 2 | BP | SIMEF | F-$POPy_2$ | Conversion efficiency (%) | 4.16 | 3.87 | 3.67 |
| | | | | Durability (%) | 100 | 93.1 | 88.3 |
| Example 3 | BP | SIMEF | BINAPO (coating method) | Conversion efficiency (%) | 3.93 | 3.69 | 3.48 |
| | | | | Durability (%) | 100 | 91.7 | 88.6 |
| Example 4 | BP | SIMEF | POSFPO | Conversion efficiency (%) | 3.67 | 3.35 | 3.24 |
| | | | | Durability (%) | 100 | 91.3 | 88.2 |
| Example 5 | BP | SIMEF | POMXPO | Conversion efficiency (%) | 3.04 | 3.52 | 3.48 |
| | | | | Durability (%) | 100 | 115.7 | 114.1 |
| Example 6 | BP | SIMEF | POFBPO | Conversion efficiency (%) | 4.12 | 3.72 | 3.44 |
| | | | | Durability (%) | 100 | 90.3 | 83.4 |
| Example 7 | BP | SIMEF | $CF_3$-$POPy_2$ | Conversion efficiency (%) | 4.18 | 3.86 | 3.64 |
| | | | | Durability (%) | 100 | 92.3 | 87.1 |
| Example 8 | BP | SIMEF | $(CF_3)zPOPy_2$ | Conversion efficiency (%) | 4.28 | 3.91 | 3.71 |
| | | | | Durability (%) | 100 | 91.4 | 86.7 |
| Example 9 | BP | SIMEF | PO(TPP)PO | Conversion efficiency (%) | 3.17 | 2.88 | 3.33 |
| | | | | Durability (%) | 100 | 90.9 | 105 |
| Example 10 | BP | SIMEF | $Ph_2POPy$ | Conversion (%) efficiency | 3.83 | 3.36 | 3.48 |
| | | | | Durability (%) | 100 | 87.7 | 90.9 |

(continued)

| | p-type semiconductor | Fullerene | Buffer layer | | Initial | 24 hours | 72 hours |
|---|---|---|---|---|---|---|---|
| Example 11 | BP | SIMEF | $BuPOPy_2$ | Conversion efficiency (%) | 4.08 | 3.39 | 3.34 |
| | | | | Durability (%) | 100 | 83.1 | 81.9 |
| Example 12 | BP | SIMEF | 1.6-$(POPh)_2Py$ | Conversion efficiency (%) | 3.1 | 2.71 | 2.6 |
| | | | | Durability (%) | 100 | 87.4 | 83.9 |
| Example 13 | BP | SIMEF | $AnPOPy_2$ | Conversion efficiency (%) | 3.57 | 3.24 | 3.15 |
| | | | | Durability (%) | 100 | 90.8 | 88.2 |
| Example 14 | BP | SIMEF | $POPh_3$ (coating method) | Conversion efficiency (%) | 3.25 | 3.13 | 2.76 |
| | | | | Durability (%) | 100 | 96.3 | 84.9 |
| Example 15 | BP | SIMEF | 3TPYMB | Conversion efficiency (%) | 3.2 | 3.52 | 3.39 |
| | | | | Durability (%) | 100 | 110 | 105.9 |
| Example 16 | BP | SIMEF | PBD | Conversion efficiency (%) | 3.9 | 3.68 | 3.32 |
| | | | | Durability (%) | 100 | 94.4 | 85.1 |
| Example 17 | BP | $C_{60}(QM)_2$ | $POPy_2$ | Conversion efficiency (%) | 4.87 | 4.75 | 4.65 |
| | | | | Durability (%) | 100 | 97.5 | 95.5 |
| Example 18 | BP | $C_{60}(ind)_2$ | $POPy_2$ | Conversion efficiency (%) | 3.71 | 3.61 | 3.48 |
| | | | | Durability (%) | 100 | 97.3 | 93.8 |
| Comparative Example 1 | BP | SIMEF | BCP | Conversion efficiency (%) | 3.44 | 3.06 | 2.78 |
| | | | | Durability (%) | 100 | 89.2 | 80.8 |
| Comparative Example 2 | BP | SIMEF | LiF | Conversion efficiency (%) | 2.69 | 0.22 | 0.12 |
| | | | | Durability (%) | 100 | 8.2 | 4.5 |
| Comparative Example 3 | BP | SIMEF | - | Conversion efficiency (%) | 0.39 | 0.12 | 0.13 |
| | | | | Durability (%) | 100 | 30.8 | 33.6 |
| Comparative Example 4 | BP | $C60(QM)_2$ | BCP | Conversion efficiency (%) | 3.68 | 1.61 | 0.95 |
| | | | | Durability (%) | 100 | 43.8 | 25.8 |
| Comparative Example 5 | BP | $C60(QM)_2$ | LiF | Conversion efficiency (%) | 3.72 | 0.02 | 0.01 |
| | | | | Durability (%) | 100 | 0 | 0 |

(continued)

| | p-type semiconductor | Fullerene | Buffer layer | | Initial | 24 hours | 72 hours |
|---|---|---|---|---|---|---|---|
| Comparative Example 6 | BP | C6o(QM)$_2$ | - | Conversion efficiency (%) | 2.54 | 0.89 | 0.54 |
| | | | | Durability(%) | 100 | 35 | 21.3 |
| Comparative Example 7 | CuPc | C60 | POPy$_2$ | Conversion efficiency (%) | 0.3 | 0.19 | 0.14 |
| | | | | Durability (%) | 100 | 64.4 | 45 |

From the results shown in Table 4, it was found that the photoelectric conversion device made using the compound of the invention as an electrode buffer material and using a soluble n-type semiconductor and a p-type small molecule based material is excellent in cell properties and is suitable as a photoelectric conversion device for solar cell uses, which has a remarkably excellent durability under vigorous conditions such as a substrate temperature of 85°C and solar simulator continuous irradiation.

<Example 19>

Regioregular poly-3-hexylthiophene (P3HT, manufactured by Rieke Metals Inc.) having an electron-donating molecular structure and 1-(3-methoxycarbonyl)propyl-1-phenyl (6,6)-C61) (PCBM, manufactured by Frontier Carbon Corporation) having an electron-withdrawing molecular structure were dissolved in a weight ratio of 1:0.8 in o-dichlorobenzene at a concentration of 2.1 % by weight. The resulting solution was stirred and mixed by a stirrer at 40°C in a nitrogen atmosphere for 4 hours. The solution was filtrated through a polytetrafluoroethylene (PTFE) filter of 0.45 μm to make a photoelectric conversion layer coating liquid.

A glass substrate deposited with an indium-tin oxide (ITO) transparent conductive film in a thickness of 155 nm was washed by ultrasonic washing with a surfactant, water-washing with ultrapure water, and ultrasonic washing with ultrapure water in this order, and subsequently dried by nitrogen blowing, followed by drying under heating at 120°C in the air for 5 minutes. Finally, ultraviolet ozone washing was performed.

After an aqueous dispersion of poly(3,4-ethylenedioxythiophene)poly(styrenesulfonic acid) (trade name "CLEVIOS™ P VP AI4083" manufactured by H C Stark Ltd.) filtrated through a polyvinylidene fluoride (PVDF) filter of 0.45 μm was applied on the transparent substrate by spin coating, the coated substrate was dried at 120°C in the air for 10 minutes. Furthermore, the above substrate was subjected to heat treatment at 180°C for 3 minutes under a nitrogen atmosphere. The film thickness was 60 nm.

An active layer having a thickness of 200 nm was formed by applying the above photoelectric conversion layer coating liquid on the glass substrate by spin coating under a nitrogen atmosphere. Annealing treatment was performed at 150°C for 10 minutes under a nitrogen atmosphere. Thereafter, POPy$_2$ (Synthetic Example 1) was formed into a film having a film thickness of 6 nm and further aluminum was formed into a film having a film thickness of 80 nm by a resistance heating vacuum deposition method, sequentially, to make a bulk heterojunction-type organic thin-film solar cell.

Using a solar simulator having an air mass (AM) of 1.5G and an irradiance of 100 mW/cm$^2$ as an irradiation source, current-voltage properties of the solar cell made were measured with attaching a metal mask 4 mm square by the source meter (2400-type manufactured by Keithley Inc.). For the durability test, evaluation was performed by continuous irradiation with solar simulator by means of an indoor solar cell durability tester ECL-350 manufactured by EKO INSTRUMENTS Co., Ltd. set at a substrate temperature of 85°C.

By placing a sharp-cut filter (SCF-39L manufactured by SIGMA KOKI Co., Ltd.) on the solar cell, ultraviolet rays of 390 nm or less were cut. The conversion efficiency (%) at each period and the conversion efficiency at each period when initial one is taken as 100%, which is regarded as durability (%), are shown in Table 5.

<Example 20>

A solar cell was made in the same manner as in Example 19 except that F-POPy$_2$ obtained in Synthetic Example 2 was used instead of POPy$_2$, and the durability test was performed. The conversion efficiency (%) and durability (%) at each period are shown in Table 5.

<Example 21>

A solar cell was made in the same manner as in Example 19 except that BINAPO obtained in Synthetic Example 3 was used instead of $POPy_2$, and the durability test was performed. The conversion efficiency (%) and durability (%) at each period are shown in Table 5.

<Example 22>

A solar cell was made in the same manner as in Example 21 except that the method of forming BINAPO into a film as a buffer layer was not the vapor deposition method but was changed to the following method. An active layer was applied on the substrate and was subjected to annealing treatment at 150°C for 10 minutes under a nitrogen atmosphere. Then, an ink in which BINAPO obtained in Synthetic Example 3 was dissolved in isopropanol in an amount of 0.05% by weight was subjected to spin coating at 2000 rpm, followed by heating at 80°C for 5 minutes. Thereby, a buffer layer of about 6 nm was formed on the active layer.

The durability test was performed in the same manner as in Example 19. The conversion efficiency (%) and durability (%) at each period are shown in Table 5.

<Example 23>

A solar cell was made in the same manner as in Example 19 except that $C_{60}(Ind)_2$ obtained in Synthetic Example 8 was used instead of PCBM as an n-type semiconductor, and the durability test was performed. The conversion efficiency (%) and durability (%) at each period are shown in Table 5.

<Example 24>

A solar cell was made in the same manner as in Example 19 except that SIMEF obtained in Synthetic Example 7 was used instead of PCBM as an n-type semiconductor, and the durability test was performed. The conversion efficiency (%) and durability (%) at each period are shown in Table 5.

<Comparative Example 8>

A solar cell was made in the same manner as in Example 19 except that BCP was used instead of $POPy_2$, and the durability test was performed. The conversion efficiency (%) and durability (%) at each period are shown in Table 5.

<Comparative Example 9>

A solar cell was made in the same manner as in Example 19 except that LiF (manufactured by Furuuchi Chemical Corporation) was laminated in a thickness of 0.4 nm instead $POPy_2$, and the durability test was performed. The conversion efficiency (%) and durability (%) at each period are shown in Table 5.

<Comparative Example 10>

A solar cell was made in the same manner as in Comparative Example 23 except that BCP was laminated in a thickness of 6 nm instead $POPy_2$, and the durability test was performed. The conversion efficiency (%) and durability (%) at each period are shown in Table 5.

[Table 5]

| | p-type semiconductor | Fullerene | Buffer layer | | Initial | 22 hours | 2000 hours |
|---|---|---|---|---|---|---|---|
| Example 19 | P3HT | PCBM | $POPy_2$ | Conversion efficiency (%) | 2.88 | 2.51 | - |
| | | | | Durability (%) | 100 | 87.4 | - |

(continued)

| | p-type semiconductor | Fullerene | Buffer layer | | Initial | 22 hours | 2000 hours |
|---|---|---|---|---|---|---|---|
| Example 20 | P3HT | PCBM | F-$POPy_2$ | Conversion efficiency (%) | 3.28 | 2.97 | - |
| | | | | Durability (%) | 100 | 90.7 | - |
| Example 21 | P3HT | PCBM | BINAPO (coating method) | Conversion efficiency (%) | 1.89 | 1.36 | - |
| | | | | Durability (%) | 100 | 72.2 | - |
| Example 22 | P3HT | PCBM | BINAPO (coating method) | Conversion efficiency (%) | 2.39 | 2.01 | - |
| | | | | Durability (%) | 100 | 84.2 | - |
| Example 23 | P3HT | $C_{60}(Ind)_2$ | $POPy_2$ | Conversion efficiency (%) | 4.59 | 4.53 | 4.51 |
| | | | | Durability (%) | 100 | 98.6 | 98.2 |
| Example 24 | P3HT | SIMEF | $POPy_2$ | Conversion efficiency (%) | 3.59 | 2.9 | - |
| | | | | Durability (%) | 100 | 81 | - |
| Comparative Example 8 | P3HT | PCBM | BCP | Conversion efficiency (%) | 2.17 | 0.52 | - |
| | | | | Durability (%) | 100 | 23.8 | - |
| Comparative Example 9 | P3HT | PCBM | LiF | Conversion efficiency (%) | 3.01 | 1.73 | - |
| | | | | Durability (%) | 100 | 57.6 | - |
| Comparative Example 10 | P3HT | $C_{60}(Ind)_2$ | BCP | Conversion efficiency (%) | 4.97 | 1.35 | - |
| | | | | Durability (%) | 100 | 27.2 | - |

From the results shown in Table 5, it was found that the photoelectric conversion device made using the compound of the invention as an electrode buffer material and using a soluble n-type semiconductor and a p-type polymer based material is excellent in cell properties and is suitable as a photoelectric conversion device for solar cell uses, which has a remarkably excellent durability under vigorous conditions such as a substrate temperature of 85°C and solar simulator continuous irradiation.

<Example 25>

A solar cell was made in the same manner as in Example 19 except that $C_{60}(QM)_2$ obtained in Synthetic Example 17 was used instead of PCBM as an n-type semiconductor, and the durability test for 24 hours was performed. The conversion efficiency (%) and durability (%) at each period are shown in Table 6.

<Example 26>

A solar cell was made in the same manner as in Example 25 except that F-$POPy_2$ obtained in Synthetic Example 2 was used instead of $POPy_2$, and the durability test for 24 hours was performed. The conversion efficiency (%) and durability (%) at each period are shown in Table 6.

<Example 27>

A solar cell was made in the same manner as in Example 25 except that $CF_3$-$POPy_2$ obtained in Synthetic Example 9 was used instead of $POPy_2$ and was laminated in a thickness of 3 nm, and the durability test for 24 hours

was performed. The conversion efficiency (%) and durability (%) at each period are shown in Table 6.

<Example 28>

A solar cell was made in the same manner as in Example 25 except that $(CF_3)_2$-$POPy_2$ obtained in Synthetic Example 10 was used instead of $POPy_2$, and the durability test for 24 hours was performed. The conversion efficiency (%) and durability (%) at each period are shown in Table 6.

<Example 29>

A solar cell was made in the same manner as in Example 25 except that PO(TPP)PO obtained in Synthetic Example 11 was used instead of $POPy_2$, and the durability test for 24 hours was performed. The conversion efficiency (%) and durability (%) at each period are shown in Table 6.

<Example 30>

A solar cell was made in the same manner as in Example 25 except that $Ph_2POPy$ obtained in Synthetic Example 12 was used instead of $POPy_2$, and the durability test for 24 hours was performed. The conversion efficiency (%) and durability (%) at each period are shown in Table 6.

<Example 31>

A solar cell was made in the same manner as in Example 25 except that BuPOPy obtained in Synthetic Example 13 was used instead of $POPy_2$, and the durability test for 24 hours was performed. The conversion efficiency (%) and durability (%) at each period are shown in Table 6.

<Example 32>

A solar cell was made in the same manner as in Example 25 except that 1,6-$(POPh_2)_2Py$ obtained in Synthetic Example 14 was used instead of $POPy_2$, and the durability test for 24 hours was performed. The conversion efficiency (%) and durability (%) at each period are shown in Table 6.

<Example 33>

A solar cell was made in the same manner as in Example 25 except that c-$HexPOPy_2$ obtained in Synthetic Example 18 was used instead of $POPy_2$, and the durability test for 24 hours was performed. The conversion efficiency (%) and durability (%) at each period are shown in Table 6.

<Example 34>

A solar cell was made in the same manner as in Example 25 except that PBD obtained by sublimation purification of one manufactured by Tokyo Chemical Industry Co., Ltd. was used instead of $POPy_2$, and the durability test for 24 hours was performed. The conversion efficiency (%) and durability (%) at each period are shown in Table 6.

<Example 35>

A solar cell was made in the same manner as in Example 19 except that $C_{60}(F\text{-}QM)_2$ obtained in Synthetic Example 19 was used instead of PCBM as an n-type semiconductor, and the durability test for 24 hours was performed. The conversion efficiency (%) and durability (%) at each period are shown in Table 6.

<Example 36>

A solar cell was made in the same manner as in Example 19 except that $C_{60}(Th\text{-}QM)_2$ obtained in Synthetic Example 20 was used instead of PCBM as an n-type semiconductor, and the durability test for 24 hours was performed. The conversion efficiency (%) and durability (%) at each period are shown in Table 6.

<Example 37>

A solar cell was made in the same manner as in Example 19 except that $C_{60}$(PCBM)(QM) obtained in Synthetic Example 21 was used instead of PCBM as an n-type semiconductor, and the durability test for 24 hours was performed. The conversion efficiency (%) and durability (%) at each period are shown in Table 6.

<Example 38>

A solar cell was made in the same manner as in Example 19 except that $C_{70}$(Ind)$_2$ obtained in Synthetic Example 22 was used instead of PCBM as an n-type semiconductor, and the durability test for 24 hours was performed. The conversion efficiency (%) and durability (%) at each period are shown in Table 6.

<Example 39>

A solar cell was made in the same manner as in Example 38 except that F-POPy$_2$ obtained in Synthetic Example 2 was used instead of POPy$_2$, and the durability test for 24 hours was performed. The conversion efficiency (%) and durability (%) at each period are shown in Table 6.

<Example 40>

A solar cell was made in the same manner as in Example 19 except that PBDTTT-C obtained in Synthetic Example 23 was used as a p-type semiconductor and $C_{60}$(QM)$_2$ obtained in Synthetic Example 18 was used instead of PCBM as an n-type semiconductor, and the durability test for 24 hours was performed. The conversion efficiency (%) and durability (%) at each period are shown in Table 6.

<Comparative Example 11>

A solar cell was made in the same manner as in Example 25 except that BCP (manufactured by Dojindo Molecular Tech., Inc.) was used instead of POPy$_2$, and the durability test for 24 hours was performed. The conversion efficiency (%) and durability (%) at each period are shown in Table 6.

<Comparative Example 12>

A solar cell was made in the same manner as in Example 25 except that LiF (manufactured by Furuuchi Chemical Corporation) was laminated in a thickness of 0.5 nm instead of POPy$_2$, and the durability test for 24 hours was performed. The conversion efficiency (%) and durability (%) at each period are shown in Table 6.

<Comparative Example 13>

A solar cell was made in the same manner as in Example 40 except that BCP (manufactured by Dojindo Molecular Tech., Inc.) was used instead of POPy$_2$, and the durability test for 24 hours was performed. The conversion efficiency (%) and durability (%) at each period are shown in Table 6.

<Comparative Example 14>

A solar cell was made in the same manner as in Example 40 except that LiF (manufactured by Furuuchi Chemical Corporation) was laminated in a thickness of 0.5 nm instead of POPy$_2$, and the durability test for 24 hours was performed. The conversion efficiency (%) and durability (%) at each period are shown in Table 6.

[Table 6]

| | p-type semiconductor | Fullerene | Buffer layer | | Initial | 24 hours |
|---|---|---|---|---|---|---|
| Example 25 | P3HT | $C_{60}$(QM)$_2$ | POPy$_2$ | Conversion efficiency (%) | 3.79 | 3.28 |
| | | | | Durability (%) | 100 | 86.5 |

(continued)

| | p-type semiconductor | Fullerene | Buffer layer | | Initial | 24 hours |
|---|---|---|---|---|---|---|
| Example 26 | P3HT | $C_{60}(QM)_2$ | $F\text{-}POPy_2$ | Conversion efficiency (%) | 4,11 | 3.51 |
| | | | | Durability (%) | 100 | 85.4 |
| Example 27 | P3HT | $C_{60}(QM)_2$ | $CF_3\text{-}POPy_2$ | Conversion efficiency (%) | 3.6 | 3.21 |
| | | | | Durability (%) | 100 | 89.2 |
| Example 28 | P3HT | $C_{60}(QM)_2$ | $(CF_3)_2POPy_2$ | Conversion efficiency (%) | 4.19 | 3.15 |
| | | | | Durability (%) | 100 | 75.2 |
| Example 29 | P3HT | $C_{60}(QM)_2$ | PO(TPP)PO | Conversion efficiency (%) | 3.89 | 3.14 |
| | | | | Durability (%) | 100 | 80.7 |
| Example 30 | P3HT | $C_{60}(QM)_2$ | $Ph_2POPy$ | Conversion efficiency (%) | 4.5 | 3.71 |
| | | | | Durability (%) | 100 | 82.4 |
| Example 31 | P3HT | $C_{60}(QM)_2$ | $BuPOPy_2$ | Conversion efficiency (%) | 4.02 | 3.36 |
| | | | | Durability (%) | 100 | 83.6 |
| Example 32 | P3HT | $C_{60}(QM)_2$ | $1,6\text{-}(POPh)_2Py$ | Conversion efficiency (%) | 3.62 | 2.46 |
| | | | | Durability (%) | 100 | 68 |
| Example 33 | P3HT | $C_{60}(QM)_2$ | $c\text{-}HexPOPy_2$ | Conversion efficiency (%) | 3.65 | 2.54 |
| | | | | Durability (%) | 100 | 69.6 |
| Example 34 | P3HT | $C_{60}(QM)_2$ | PBD | Conversion efficiency (%) | 4.01 | 3.46 |
| | | | | Durability (%) | 100 | 86.3 |
| Example 35 | P3HT | $C_{60}(F\text{-}QM)_2$ | $POPy_2$ | Conversion efficiency (%) | 3.41 | 2.65 |
| | | | | Durability (%) | 100 | 77.7 |
| Example 36 | P3HT | $C_{60}(Th\text{-} QM)_2$ | $POPy_2$ | Conversion efficiency (%) | 4.51 | 3.73 |
| | | | | Durability (%) | 100 | 82.7 |
| Example 37 | P3HT | $C_{60}(PCBM)(QM)$ | $POPy_2$ | Conversion efficiency (%) | 4.22 | 3.8 |
| | | | | Durability (%) | 100 | 90 |
| Example 38 | P3HT | $C_{60}(ind)_2$ | $POPy_2$ | Conversion efficiency (%) | 5.16 | 4.3 |
| | | | | Durability (%) | 100 | 83.3 |

(continued)

| | p-type semiconductor | Fullerene | Buffer layer | | Initial | 24 hours |
|---|---|---|---|---|---|---|
| Example 39 | P3HT | $C_{60}(ind)_2$ | F-$POPy_2$ | Conversion efficiency (%) | 5.27 | 4.47 |
| | | | | Durability (%) | 100 | 84.8 |
| Example 40 | PBDTTT-C | $C_{60}(QM)_2$ | $POPy_2$ | Conversion efficiency (%) | 3.24 | 2.46 |
| | | | | Durability (%) | 100 | 75.9 |
| Comparative Examples 11 | P3HT | $C_{60}(QM)_2$ | BCP | Conversion efficiency (%) | 3.17 | 0.74 |
| | | | | Durability (%) | 100 | 23.3 |
| Comparative Example 12 | P3HT | $C_{60}(QM)_2$ | LiF | Conversion efficiency (%) | 3.61 | 1.96 |
| | | | | Durability (%) | 100 | 54.3 |
| Comparative Example 13 | PBDTTT-C | $C_{60}(QM)_2$ | BCP | Conversion efficiency (%) | 3.09 | 0.17 |
| | | | | Durability (%) | 100 | 5.5 |
| Comparative Example 14 | PBDTTT-C | $C_{60}(QM)_2$ | LiF | Conversion efficiency (%) | 3.25 | 0.04 |
| | | | | Durability (%) | 100 | 1.2 |

From the results shown in Table 6, it was found that the photoelectric conversion device made using the compound of the invention as an electrode buffer material and using a soluble n-type semiconductor and a p-type polymer based material is excellent in cell properties and is suitable as a photoelectric conversion device for solar cell uses, which has a remarkably excellent durability under vigorous conditions such as a substrate temperature of 85°C and solar simulator continuous irradiation.

<Example 41>

After an aqueous dispersion of poly(3,4-ethylenedioxythiophene)poly(styrenesulfonic acid) (trade name "CLEVIOS™ P VP AI4083" manufactured by H C Stark Ltd.) as a hole collection layer was applied by spin coating on a glass substrate patterned with an ITO electrode as an electrode, the substrate was subjected to heat treatment on a hot plate at 120°C in the air for 10 minutes. The film thickness was about 30 nm.

A compound represented by the following formula (A) (compound A), tetrabenzoporphyrin, was placed in a metal boat and was vacuum deposited on the substrate. Thereafter, by subjecting the above substrate to heat treatment at 180°C for 20 minutes under a nitrogen atmosphere, a p-type semiconductor layer of about 25 nm was formed on the hole collection layer.

[Chem 105]

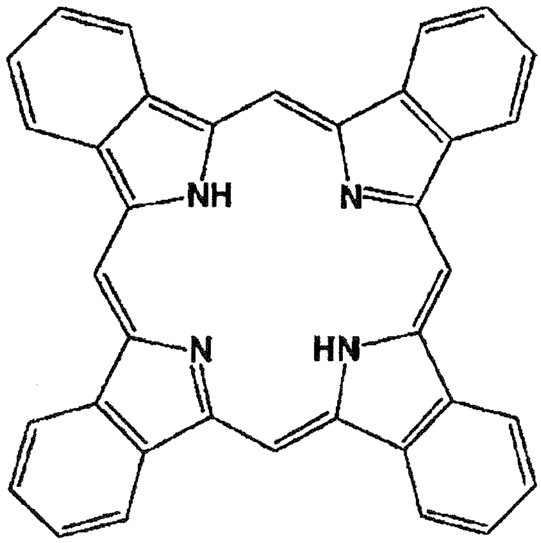

(A)

[Chem 106]

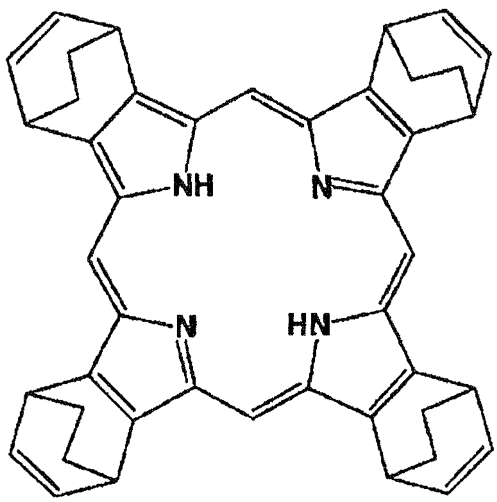

(B)

A liquid in which 0.6% by weight of the compound B and 1.4% by weight of the fullerene derivative A were dissolved in a 1:1 mixed solvent (weight) of chloroform/monochlorobenzene was prepared and filtrated and the obtained filtrate was subjected to spin coating under a nitrogen atmosphere at 1500 rpm, followed by heating at 180°C for 20 minutes. Thereby, a mixture layer containing tetrabenzoporphyrin (compound A) and the fullerene compound (SIMEF) obtained in Synthetic Example 7 was formed.

Then, a liquid in which 1.2% by weight of the fullerene derivative was dissolved in toluene was prepared and

filtrated and the obtained filtrate was subjected to spin coating under a nitrogen atmosphere at 3000 rpm and subjected to heating treatment at 120°C for 5 minutes. The substrate subjected to the substrate heat treatment was placed in a vacuum deposition apparatus, which was then evacuated by means of a cryopump. Thereby, a layer of the fullerene compound (SIMEF) was formed on the mixture layer.

Then, 3.0 mg of BINAPO obtained in Synthetic Example 3 was dissolved in isopropanol at room temperature with stirring for 30 minutes to prepare a 0.05% by weight ink. A buffer layer was formed on the layer of the fullerene derivative at a rotation number of 3000 rpm for 30 seconds by means of a spin coater of Mikasa MS-A100.

Furthermore, after an aluminum electrode having a thickness of 80 nm was provided on the electron collection layer by vacuum deposition, by heating the solar cell on a hot plate at 120°C for 15 minutes, a solar cell was made. To the solar cell made, a light having an intensity of 100 mW/cm$^2$ was applied by a solar simulator (AM 1.5G) from the ITO electrode side, and current-voltage properties between the ITO electrode and the aluminum electrode were measured on a source meter (2400 type manufactured by Keithley Inc.) and the photoelectric conversion efficiency was calculated. The results are shown in Table 7.

<Comparative Example 15>

A solar cell was made in the same manner as in Example 41 except that BINAPO was placed in a metal boat placed in a vacuum deposition apparatus and heated and vapor deposited until the film thickness reached 6 nm to form a buffer layer on the layer of the fullerene derivative in Example 41, instead of the method of forming the buffer layer by spin coating of the BINAPO ink.

To the solar cell made, a light having an intensity of 100 mW/cm$^2$ was applied by a solar simulator (AM 1.5G) from the ITO electrode side, and current-voltage properties between the ITO electrode and the aluminum electrode were measured on a source meter (2400 type manufactured by Keithley Inc.) and the photoelectric conversion efficiency was calculated. The results are shown in Table 7.

<Comparative Example 16>

A device was made in the same manner as in Example 43 except that BCP was used instead of BINAPO. To the solar cell made, a light having an intensity of 100 mW/cm$^2$ was applied by a solar simulator (AM 1.5G) from the ITO electrode side, and current-voltage properties between the ITO electrode and the aluminum electrode were measured on a source meter (2400 type manufactured by Keithley Inc.) and the photoelectric conversion efficiency was calculated. The results are shown in Table 7.

<Comparative Example 17>

A device was made in the same manner as in Comparative Example 15 except that BCP was used instead of BINAPO. To the solar cell made, a light having an intensity of 100 mW/cm$^2$ was applied by a solar simulator (AM 1.5G) from the ITO electrode side, and current-voltage properties between the ITO electrode and the aluminum electrode were measured on a source meter (2400 type manufactured by Keithley Inc.) and the photoelectric conversion efficiency was calculated. The results are shown in Table 7.

<Comparative Example 18>

A device was made in the same manner as in Comparative Example 15 except that BINAPO was not used. To the solar cell made, a light having an intensity of 100 mW/cm$^2$ was applied by a solar simulator (AM 1.5G) from the ITO electrode side, and current-voltage properties between the ITO electrode and the aluminum electrode were measured on a source meter (2400 type manufactured by Keithley Inc.) and the photoelectric conversion efficiency was calculated. The results are shown in Table 7.

[Table 7]

| | Short-circuit current (mA/cm$^2$) | Open voltage (V) | FF | Conversion efficiency (%) |
|---|---|---|---|---|
| Example 41 | 8.5 | 0.67 | 0.68 | 3.8 |
| Comparative Example 15 | 7.3 | 0.7 | 0.6 | 3.1 |
| Comparative Example 16 | 8 | 0.55 | 0.43 | 1.9 |

(continued)

| | Short-circuit current (mA/cm$^2$) | Open voltage (V) | FF | Conversion efficiency (%) |
|---|---|---|---|---|
| Comparative Example 17 | 7.9 | 0.68 | 0.65 | 3.5 |
| Comparative Example 18 | 6.1 | 0.19 | 0.33 | 0.39 |

<Example 42>

Regioregular poly-3-hexylthiophene (P3HT, manufactured by Aldrich Co.) having an electron-donating molecular structure and 1-(3-methoxycarbonyl)propyl-1-phenyl (6,6)-$C_{60}$ (PCBM, manufactured by Frontier Carbon Corporation) having an electron-accepting molecular structure were dissolved in a weight ratio of 1:0.8 in o-dichlorobenzene at a concentration of 2.1 % by weight.

The resulting solution was stirred and mixed by a stirrer at 45°C in a nitrogen atmosphere for 6 hours. The solution was filtrated through a polytetrafluoroethylene (PTFE) filter of 0.45 μm to make a photoelectric conversion layer coating liquid.

A glass substrate deposited with an indium-tin oxide (ITO) transparent conductive film in a thickness of 155 nm was washed by ultrasonic washing with a surfactant, water-washing with ultrapure water, and ultrasonic washing with ultrapure water in this order and subsequently dried by nitrogen blowing, followed by drying under heating at 120°C in the air for 5 minutes. Finally, ultraviolet ozone washing was performed.

After an aqueous dispersion of poly(3,4-ethylenedioxythiophene)poly(styrenesulfonic acid) (trade name "CLEVIOS™ P VP AI4083" manufactured by H C Stark Ltd.) filtrated through a polyvinylidene fluoride (PVDF) filter of 0.45 μm was applied on the transparent substrate by spin coating, the coated substrate was dried at 120°C in the air for 10 minutes. Furthermore, the above substrate was subjected to heat treatment at 180°C for 3 minutes under a nitrogen atmosphere. The film thickness was 60 nm.

An active layer having a thickness of 200 nm was formed by applying the above photoelectric conversion layer coating liquid on the glass substrate by spin coating under a nitrogen atmosphere. Annealing treatment was performed at 150°C for 10 minutes under a nitrogen atmosphere. Thereafter, BINAPO obtained in Synthetic Example 3 was dissolved in dehydrated isopropyl alcohol in an amount of 0.05% by weight to make a coating liquid. After the coating liquid was applied on the surface of the active layer by spin coating at 2000 rpm, the liquid was dried by standing at 25°C for 30 minutes. Aluminum having a film thickness of 80 nm was formed by a vacuum deposition method to make a bulk heterojunction-type organic thin-film solar cell 5 mm square. The organic thin-film solar cell made was subjected to annealing treatment at 80°C for 5 minutes under a nitrogen atmosphere.

Using a solar simulator having an air mass (AM) of 1.5G and an irradiance of 100 mW/cm$^2$, current-voltage properties of the solar cell made were evaluated by means of a source meter (2400 type manufactured by Keithley Inc.). The evaluation was performed with attaching a metal mask 4 mm square. The results are shown in Table 8.

<Example 43>

An organic thin-film solar cell was made in the same manner as in Example 42 except that the concentration of the coating liquid of BINAPO was changed from 0.05% by weight to 0.1% by weight, and the current-voltage properties were evaluated. The results are shown in Table 8.

<Comparative Example 19>

An organic thin-film solar cell was made in the same manner as in Example 42 except that a BINAPO layer of 6 nm was formed by a vapor deposition method in the same manner as Example 2, instead of the method of forming the buffer layer by spin coating of the BINAPO ink. The organic thin-film solar cell made was subjected to annealing treatment at 80°C for 5 minutes under a nitrogen atmosphere. The current-voltage properties of the resulting organic thin-film solar cell were evaluated. The results are shown in Table 8.

<Comparative Example 20>

An organic thin-film solar cell was made in the same manner as in Comparative Example 19 except that the deposition of the buffer layer was omitted. The current-voltage properties of the resulting organic thin-film solar cell were evaluated. The results are shown in Table 8.

[Table 8]

| | Buffer layer | BINAPO (% by weigh) | Number of rotation | Short-circuit current (mA/cm$^2$) | Open voltage (V) | FF | Conversion efficiency (%) |
|---|---|---|---|---|---|---|---|
| Example 42 | coating method | 0.05 | 2000 | 10.39 | 0.47 | 0.49 | 2.39 |
| Example 43 | coating method | 0.1 | 2000 | 8.87 | 0.48 | 0.49 | 2.08 |
| Comparative Example 19 | deposition method | - | - | 10.04 | 0.44 | 0.44 | 1.89 |
| Comparative Example 20 | none | | | 9.48 | 0.43 | 0.43 | 1.71 |

From the results shown in Tables 7 and 8, it was found that the ink of the invention can be widely utilized for organic electronic devices such as photoelectric conversion devices and particularly enables production of multilayered devices with organic materials.

Description of Reference Numerals and Signs

| | |
|---|---|
| 100 | substrate |
| 101 | transparent electrode |
| 102, 106 | buffer layer |
| 103 | p-type semiconductor |
| 104 | p-type semiconductor, n-type semiconductor mixed layer |
| 105 | n-type semiconductor |
| 107 | counter electrode |
| 1 | weather-resistant protective film |
| 2 | ultraviolet ray-cutting film |
| 3, 9 | gas barrier film |
| 4, 8 | getter material film |
| 5, 7 | encapsulating material |
| 6 | solar cell device |
| 10 | back sheet |
| 11 | sealing material |
| 12 | base material |
| 13 | solar cell unit |
| 14 | thin-film solar cell |

While the invention has been described in detail and with reference to specific embodiments thereof, it will be apparent to one skilled in the art that various changes and modifications can be made therein without departing from the spirit and scope thereof. The present application is based on Japanese Patent Application No. 2009-181888 filed on August 4, 2009, Japanese Patent Application No. 2009-182300 filed on August 5, 2009, Japanese Patent Application No. 2009-190069 filed on August 19, 2009, Japanese Patent Application No. 2009-214966 filed on September 16, 2009, and Japanese Patent Application No. 2009-251099 filed on October 30, 2009, and the contents are incorporated herein by reference.

## Claims

1. A photoelectric conversion device comprising a buffer layer and an active layer, wherein the buffer layer contains a compound represented by the following general formula (I), the active layer contains an n-type semiconductor, and the n-type semiconductor is a compound having a solubility in toluene of 0.5% by weight or more at 25°C and

an electron mobility of $1.0 \times 10^{-6}$ $cm^2/Vs$ or more:

[Chem 1]

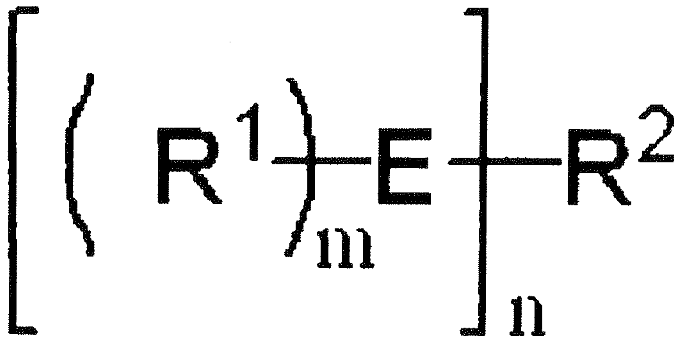

(I)

wherein E represents a divalent or higher valent electron-withdrawing group or electron-withdrawing atom selected from the group shown below; $R^1$ represents an alkyl group which may have a substituent, a cycloalkyl group which may have a substituent, a heterocyclic group which may have a substituent, an alkenyl group which may have a substituent, a cycloalkenyl group which may have a substituent, an alkynyl group which may have a substituent, an alkoxy group which may have a substituent, or an aromatic group which may have a substituent; $R^2$ represents an aliphatic hydrocarbon group which may have a substituent, an aromatic hydrocarbon group which may have a substituent, a heterocyclic group which may have a substituent, or a group where at least one of an aromatic hydrocarbon group which may have a substituent and a heterocyclic group which may have a substituent is linked; and m and n each independently represent an integer of 1 or more; and $R^1$ may be independently different when either m or n is 2 or more,
electron-withdrawing group: a silolediyl group, an oxazolediyl group, an oxadiazolediyl group, a thiazolediyl group, a thiadiazolediyl group, a diazolediyl group, a triazolediyl group, a thiazolediyl group, an isooxazolediyl group, an isothiazolediyl group, a pyrazinediyl group, a pyrimidinediyl group, a pyridazinediyl group, a pyridinediyl group, a benzothiadiazolediyl group, a quinolinediyl group, a carbonyl group, a sulfonyl group, and a phosphine oxide group;
electron-withdrawing atom: silicon and boron

**2.** The photoelectric conversion device according to claim 1, wherein LUMO of the n-type semiconductor calculated by cyclic voltammetry is -5 eV or more to -3 eV or less relative to vacuum level.

**3.** The photoelectric conversion device according to claim 1 or 2, wherein the compound represented by the above general formula (I) is a compound represented by the following general formula (II):

[Chem 2]

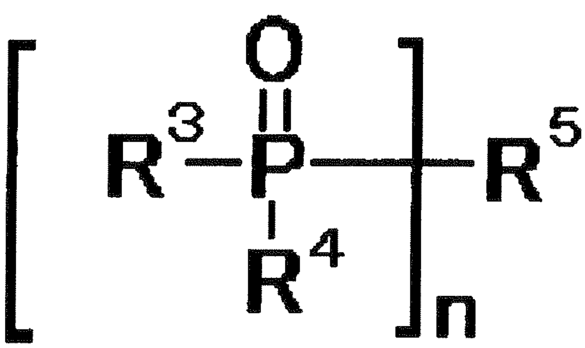

(II)

wherein $R^3$ and $R^4$ each independently represent an alkyl group which may have a substituent, a cycloalkyl group which may have a substituent, a heterocyclic group which may have a substituent, an alkenyl group which may have

a substituent, a cycloalkenyl group which may have a substituent, an alkynyl group which may have a substituent, an alkoxy group which may have a substituent, or an aromatic group which may have a substituent; $R^5$ represents an aliphatic hydrocarbon group which may have a substituent, an aromatic hydrocarbon group which may have a substituent, a heterocyclic group which may have a substituent, or a group where at least one of an aromatic hydrocarbon group which may have a substituent and a heterocyclic group which may have a substituent is linked; and n represents an integer of 1 or more.

**4.** The photoelectric conversion device according to claim 3, wherein $R^3$ and $R^4$ each independently represent a condensed polycyclic aromatic group or aromatic group, which may have a substituent and $R^5$ represents an aromatic group.

**5.** The photoelectric conversion device according to claim 1 or 2, wherein the compound represented by the above general formula (I) is a compound represented by the following general formula (III):

[Chem 3]

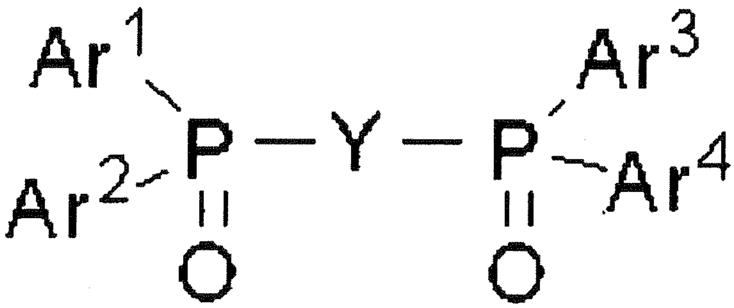

(III)

wherein $Ar^1$ to $Ar^4$ each independently represent an aromatic group which may have a substituent; $Ar^1$ and $Ar^2$ or $Ar^3$ and $Ar^4$ may form a ring directly or through a substituent; Y represents an aliphatic hydrocarbon group containing a spiro skeleton, which may have a substituent, an aromatic hydrocarbon group containing a spiro skeleton, which may have a substituent, or a heterocyclic group containing a spiro skeleton, which may have a substituent.

**6.** The photoelectric conversion device according to claim 1 or 2, wherein the compound represented by the above general formula (I) is a compound represented by the following general formula (IV):

[Chem 4]

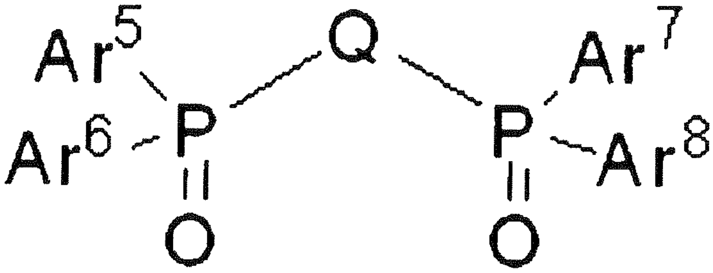

(IV)

wherein Q is a condensed ring group having a plurality of aromatic rings and represents a connecting group capable of taking a conformation in which an angle formed by extension lines of two bonding lines between two atoms bonded

to the phosphorus atoms in Q and the respective phosphorus atoms is 120° or less; and $Ar^5$ to $Ar^8$ each independently represent an aromatic group which may have a substituent.

**7.** The photoelectric conversion device according to claim 6, wherein, in the above general formula (IV), $Ar^5$ to $Ar^8$ each independently represent an aromatic hydrocarbon group which may have a substituent or an aromatic heterocyclic group which may have a substituent.

**8.** The photoelectric conversion device according to claim 1 or 2, wherein the compound represented by the above general formula (I) is a compound represented by the following general formula (V):

[Chem 5]

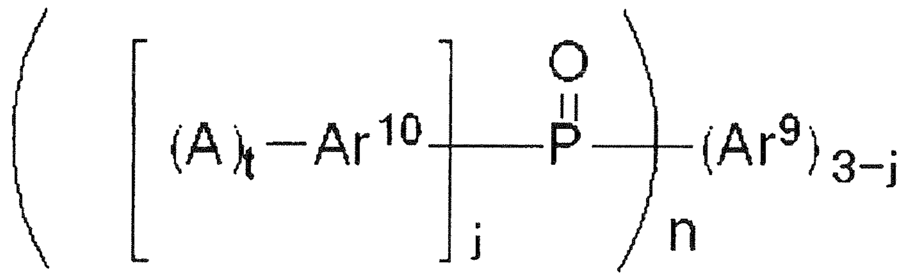

(V)

wherein $Ar^9$ is an aromatic hydrocarbon group which may have a substituent, an aromatic heterocyclic group which may have a substituent, or a group where they are linked; $Ar^{10}$ is an aromatic hydrocarbon group which may have a substituent or an aromatic heterocyclic group which may have a substituent; A represents a fluorine atom or a perfluoroalkyl group; t represents an integer of 1 to 5; j represents an integer of 1 to 3; n represents an integer of 1 or more; and $Ar^{10}$ may be independently different when either j or n is 2 or more, but n is 1 when j is 3.

**9.** The photoelectric conversion device according to any one of claims 1 to 8, wherein the active layer contains at least either of a porphyrin compound and a polymer semiconductor.

**10.** The photoelectric conversion device according to any one of claims 1 to 9, which at least comprises an electron collection layer and a hole collection layer as the buffer layer, wherein the electron collection layer contains a compound represented by any one of the above general formulae (I) to (V) and the hole collection layer contains a sulfonic acid group-containing compound.

**11.** The photoelectric conversion device according to any one of claims 1 to 10, wherein the n-type semiconductor is a fullerene compound.

**12.** The photoelectric conversion device according to claim 11, wherein LUMO of the fullerene compound calculated by cyclic voltammetry is -3.85 eV or more relative to vacuum level.

**13.** The photoelectric conversion device according to claim 11 or 12, wherein the fullerene compound has at least one of partial structures represented by the following general formulae (n4) to (n7):

[Chem 6]

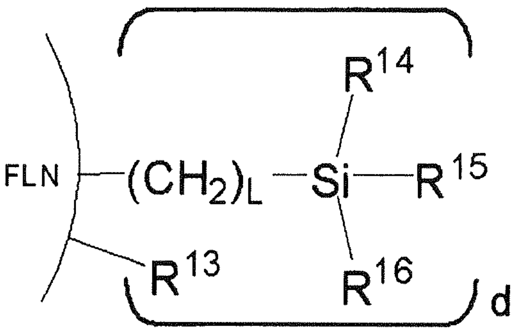

(n4)

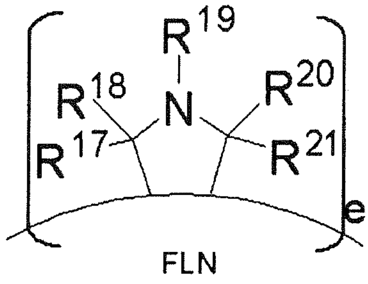

(n5)

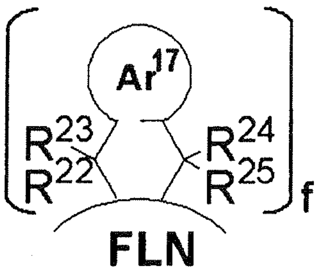

(n6)

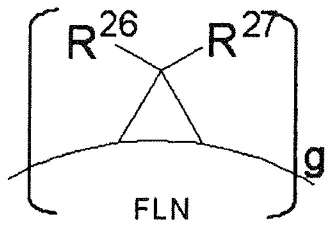

(n7)

wherein FLN in the general formulae (n4), (n5), (n6), and (n7) represents fullerene; the additional group in the general formulae (n4), (n5), (n6), and (n7) is added to the same five-membered ring or six-membered ring in the fullerene skeleton; d, e, f, and g each independently are an integer, L is an integer of 1 to 8; the number of the additional group in the general formulae (n4), (n5), (n6), and (n7) is 1 or more to 5 or less per molecule of the fullerene compound;

in the general formula (n4), $R^{13}$ is an alkyl group having 1 to 14 carbon atoms which may have a substituent, an alkoxy group having 1 to 14 carbon atoms which may have a substituent; $R^{14}$ to $R^{16}$ each independently are a hydrogen atom, an alkyl group having 1 to 14 carbon atoms which may have a substituent, a fluorinated alkyl group having 1 to 14 carbon atoms which may have a substituent, or an aromatic group which may have a substituent;

in the general formula (n5), $R^{17}$ to $R^{21}$ each independently are a hydrogen atom, an alkyl group having 1 to 14 carbon atoms which may have a substituent, or an aromatic group which may have a substituent;

in the general formula (n6), $Ar^{17}$ is an aromatic hydrocarbon group having 6 to 20 carbon atoms which may have a substituent or an aromatic heterocyclic group having 2 to 20 carbon atoms which may have a substituent; $R^{22}$ to $R^{25}$ each independently are a hydrogen atom, an alkyl group which may have a substituent, an amino group which may have a substituent, an alkoxy group which may have a substituent, or an alkylthio group which may have a substituent; $R^{22}$ or $R^{23}$ may be bonded to either one of $R^{24}$ or $R^{25}$ to form a ring; and

in the general formula (n7), $R^{26}$ to $R^{27}$ each independently are a hydrogen atom, an alkoxycarbonyl group, an alkyl group having 1 to 14 carbon atoms which may have a substituent, or an aromatic group which may have a substituent.

**14.** A solar cell comprising the photoelectric conversion device according to any one of claims 1 to 13.

**15.** An ink comprising: a compound which has a glass transition temperature of 90°C or higher and is represented by the following general formula (IX); and a polar solvent:

[Chem 7]

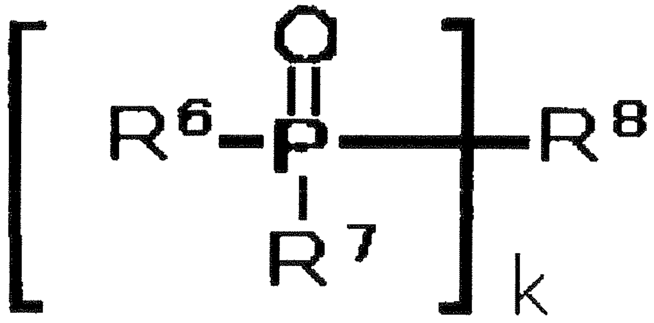

(IX)

wherein $R^6$ to $R^7$ each independently are an aromatic group which may have a substituent; k represents an integer of 2 or more; $R^8$ is a divalent or higher valent aromatic ring group in which the total number of rings is 3 or more.

**16.** The ink according to claim 15, wherein the solubility parameter of the polar solvent is 9.5 or more.

[Fig. 1]

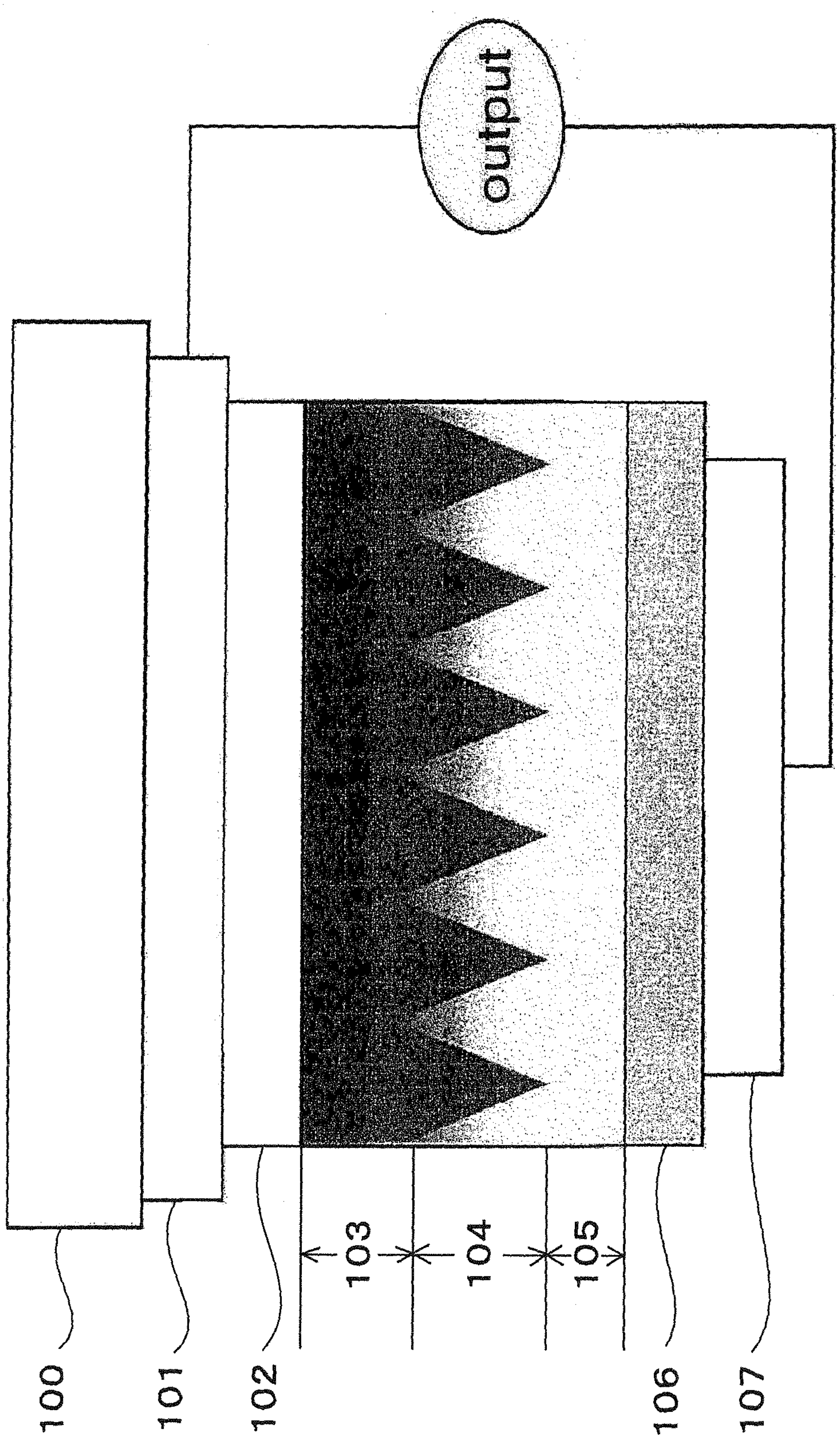

[Fig. 2]

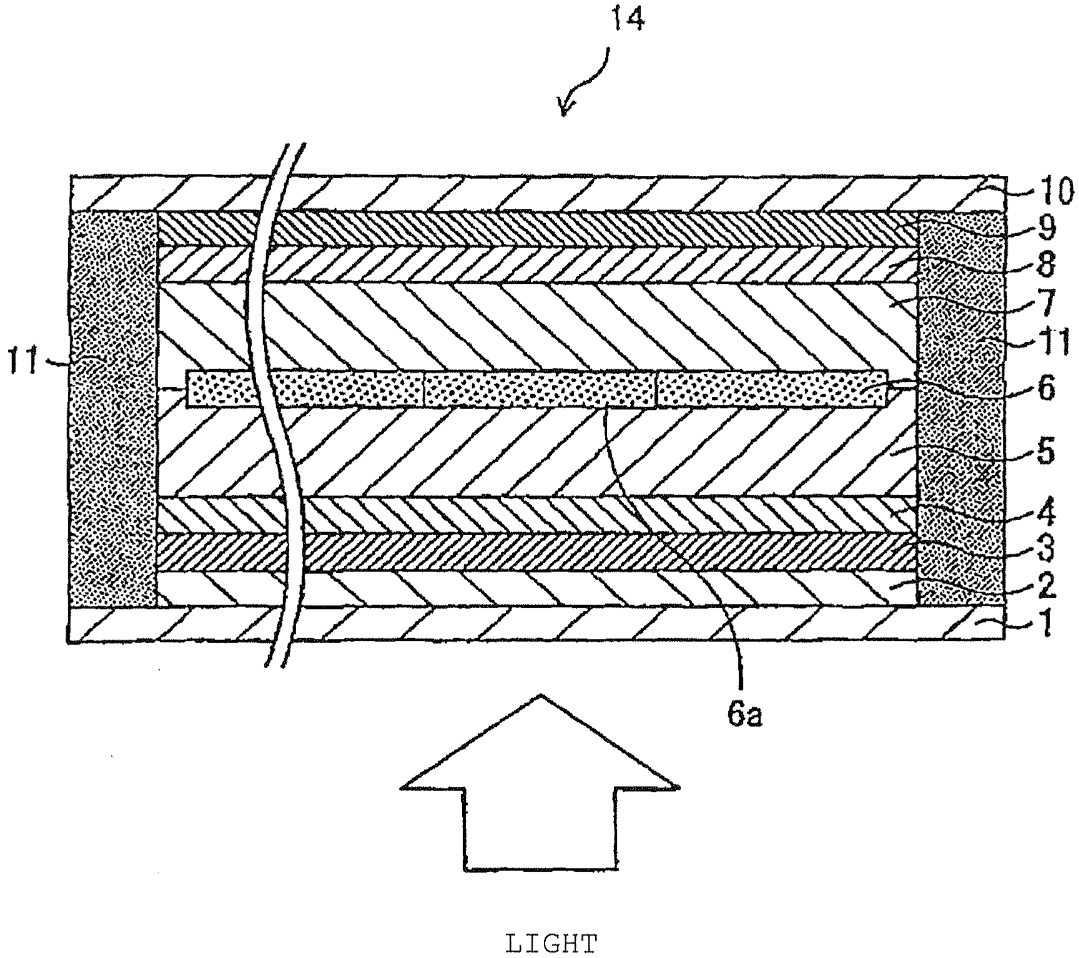

[Fig. 3]

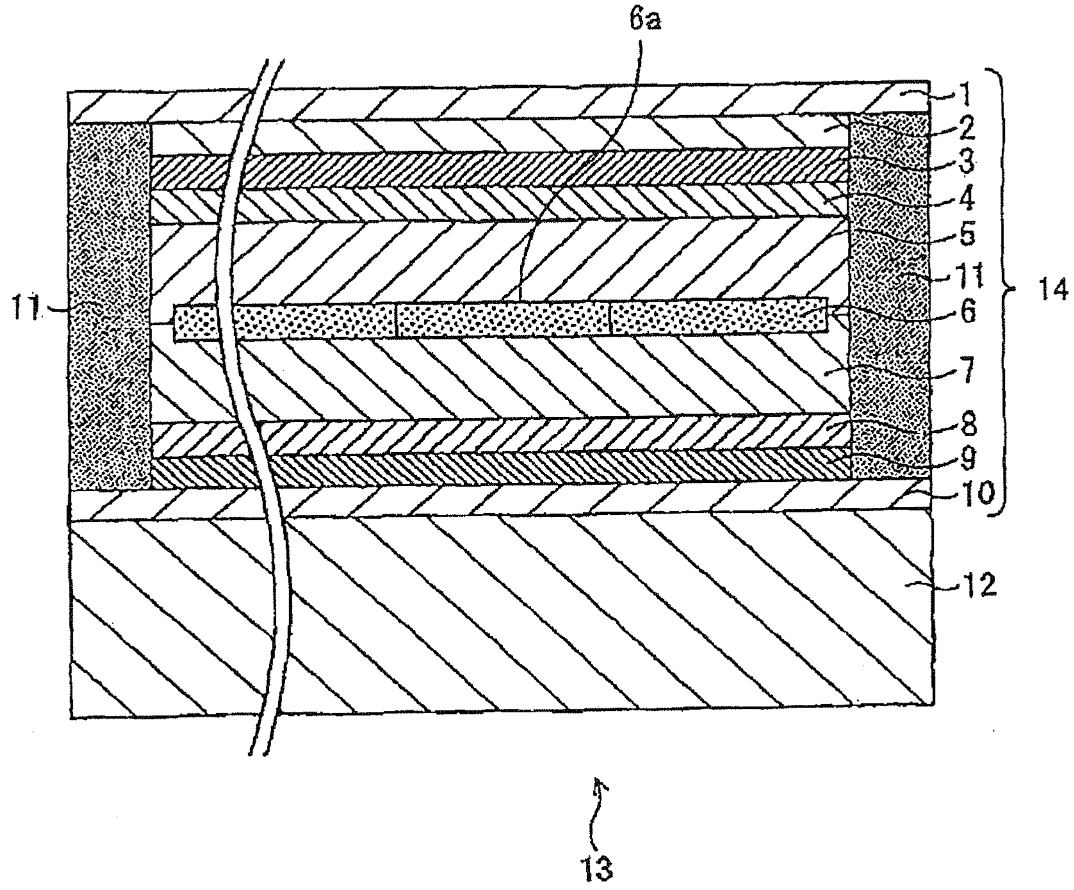

**INTERNATIONAL SEARCH REPORT**

International application No.
PCT/JP2010/063047

A. CLASSIFICATION OF SUBJECT MATTER
*H01L51/42*(2006.01)i, *C07F9/53*(2006.01)i, *C09D11/00*(2006.01)i, *H01L51/50*
(2006.01)i

According to International Patent Classification (IPC) or to both national classification and IPC

B. FIELDS SEARCHED

Minimum documentation searched (classification system followed by classification symbols)
H01L51/42, C07F9/53, C09D11/00, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
CAPlus/REGISTRY(STN), JSTPlus/JST7580(JDreamII)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2007-281039 A (Seiko Epson Corp.),<br>25 October 2007 (25.10.2007),<br>claims; paragraphs [0002], [0055] to [0072]<br>& US 2007/0228356 A1 & KR 2007/0099474 A<br>& CN 101055924 A | 15,16<br>1-7,9-14 |
| X<br>Y | JP 2006-73583 A (Toray Industries, Inc.),<br>16 March 2006 (16.03.2006),<br>claims; paragraphs [0033] to [0040], [0055]<br>(Family: none) | 15,16<br>1-5,9-14 |
| Y | JP 2007-527116 A (Merck Patent GmbH),<br>20 September 2007 (20.09.2007),<br>claims; paragraphs [0002], [0009], [0048]<br>& WO 2005/084082 A1 & EP 1716725 A1<br>& US 2007/0170419 A1 & DE 102004008304 A1<br>& CN 001922930 A & KR 2006/013 | 1-4,9-14 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>25 October, 2010 (25.10.10) | Date of mailing of the international search report<br>02 November, 2010 (02.11.10) |
| Name and mailing address of the ISA/<br>Japanese Patent Office<br><br>Facsimile No. | Authorized officer<br><br><br>Telephone No. |

Form PCT/ISA/210 (second sheet) (July 2009)

**INTERNATIONAL SEARCH REPORT**

International application No.
PCT/JP2010/063047

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2007/126102 A1 (Mitsubishi Chemical Corp.), 08 November 2007 (08.11.2007), entire text; all drawings & EP 2023419 A1 & US 2009/0308458 A & CN 101432904 A & KR 2009/0017552 A | 1-7,9-16 |
| Y | WO 2008/081845 A1 (Mitsubishi Chemical Corp.), 10 July 2008 (10.07.2008), entire text; all drawings & EP 2098549 A1 & KR 2009/0093975 A | 1-7,9-16 |
| Y | WO 2007/129768 A1 (Japan Science and Technology Agency), 15 November 2007 (15.11.2007), entire text; all drawings & US 2009/0101200 A1 | 1-7,9-16 |

Form PCT/ISA/210 (continuation of second sheet) (July 2009)

**INTERNATIONAL SEARCH REPORT**

International application No.
PCT/JP2010/063047

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The inventions claimed in claims 1-14 and the inventions claimed in claims 15 and 16 have no same or corresponding special technical feature. The claims include the following two inventions.

(Invention 1) The inventions claimed in claims 1-14.
[A photoelectric conversion element.]
(Invention 2) The inventions claimed in claims 15 and 16.
[An ink comprising a phosphine oxide compound having an aromatic group and a polar solvent.]

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.
PCT/JP2010/063047

The compound represented by general formula (I) recited in claim 1 includes a scope that goes beyond the matter disclosed in the meaning within PCT Article 5, and the scope of the compound is unclear (for example, compounds each having a triazinediyl group, a benzopyrazinediyl group or the like are mentioned in paragraph [0205] as examples of the compound represented by general formula (I) wherein "E" is not a phosphineoxide group, and therefore the correspondence relationship between the scope of "E" and the compound represented by general formula (I) is unclear; further, it cannot be considered that BCP having a benzopyrazinediyl group, which is a compound employed as a comparative example in the description, does not correspond to the compound represented by general formula (I); consequently, it cannot be considered as a whole that there is any specific statement based on effects or the like with regard to at least compounds other than the compounds represented by general formulae (II) to (V) wherein "E" is a phosphineoxide group). Therefore, the compound is not supported in the meaning within PCT Article 6.

Such being the case, the search was carried out on the scope supported by and disclosed in the description, i.e., a matter in which compounds represented by general formula (II) to (V) are used, among the compounds represented by general formula (I).

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008016834 A
- JP 2006073583 A
- WO 2008059771 A
- WO 2008018931 A
- WO 2009086210 A
- WO 2008063609 A
- WO 2009115513 A
- WO 2009098250 A
- WO 2009000756 A
- WO 2009091670 A
- WO 2007146250 A
- WO 2009098253 A
- WO 2010012710 A
- JP 2007324587 A
- WO 2009008323 A
- JP 2009181888 A
- JP 2009182300 A
- JP 2009190069 A
- JP 2009214966 A
- JP 2009251099 A


### Non-patent literature cited in the description


- *Organic Electronics,* 2008, vol. 9, 656-660
- *Sol. Energy Mater. Sol. Cells,* 2005, vol. 86, 499-516
- *Sol. Energy Mater. Sol. Cells,* 2008, vol. 92, 1476-1482
- *Journal of the American Chemical Society,* 1955, vol. 77, 1850-2
- *Journal of Organic Chemistry,* 1986, vol. 51 (4), 427-32
- *J. Am. Chem. Soc.,* 2008, vol. 130 (46), 15429-15436
- *J. Am. Chem. Soc.,* 1993, vol. 115, 9798-9799
- *Chem. Mater.,* 2007, vol. 19, 5363-5372
- *Chem. Mater.,* 2007, vol. 19, 5194-5199
- *Angew. Chem. Int. Ed. Engl.,* 1993, vol. 32, 78-80
- *Tetrahedron Lett.,* 1997, vol. 38, 285-288
- *J. Chem. Soc., Perkin Trans. 1,* 1997, 1595
- *Thin Solid Films,* vol. 489, 251-256
- *Adv. Funct. Mater.,* 2005, vol. 15, 1979-1987
- *J. Org. Chem.,* 1995, vol. 60, 532-538
- Handbook of Conducting Polymers. 2007, vol. 2
- *Materials Science and Engineering,* 2001, vol. 32, 1-40
- *Pure Appl. Chem.,* 2002, vol. 74, 2031-3044
- Handbook of THIOPHENE-BASED MATERIALS. 2009, vol. 2
- *J. Am. Chem. Soc,* 2009, vol. 131, 15586-15587
- *Nat. Mater.,* 2007, vol. 6, 521
- *J. Am. Chem. Soc.,* 2008, vol. 130, 15429-15436